# EUROPÄISCHE PATENTSCHRIFT

(11) **EP 3 102 650 B1**
(45) Veröffentlichungstag und Bekanntmachung des Hinweises auf die Patenterteilung: **29.08.2018**
(21) Anmeldenummer: 15700634.7
(22) Anmeldetag: 13.01.2015
(51) Int. Cl.: C09K 11/06, H01L 51/00, H05B 33/10, C07F 15/00, C09K 11/02, H01L 51/50

(54) **METALLKOMPLEXE**
METAL COMPLEXES
COMPLEXES MÉTALLIQUES

(30) Priorität: 05.02.2014 EP 14000417
(43) Veröffentlichungstag der Anmeldung: 14.12.2016
(73) Patentinhaber: Merck Patent GmbH, 64293 Darmstadt (DE)
(72) Erfinder: STOESSEL, Philipp, 60389 Frankfurt am Main (DE); KOENEN, Nils, 64347 Griesheim (DE)
(86) Internationale Anmeldenummer: PCT/EP2015/000043
(87) Internationale Veröffentlichungsnummer: WO 2015/117718

(56) Entgegenhaltungen:
- WO-A1-2014/094960
- WO-A2-2014/094962
- DATABASE CA [Online] CHEMICAL ABSTRACTS SERVICE, COLUMBUS, OHIO, US; 2011, STOESSEL, PHILIPP ET AL: "Transition metal cyclometalated 2-arylbenzimidazole complexes as blue phosphorescent materials for organic light-emitting devices", XP002736158, gefunden im STN Database accession no. 2011:1654765 & WO 2011/157339 A1 (MERCK PATENT GMBH [DE]; STOESSEL PHILIPP [DE]; HEIL HOLGER [DE]; JOOST) 22. Dezember 2011 (2011-12-22)
- DATABASE CA [Online] CHEMICAL ABSTRACTS SERVICE, COLUMBUS, OHIO, US; 16. Januar 2014 (2014-01-16), STOESSEL, PHILIPP ET AL: "Metal complexes with heterocyclic ligands and their preparation and use in electronic devices", XP002736159, gefunden im STN Database accession no. 2014:71438 & WO 2014/008982 A1 (MERCK PATENT GMBH [DE]) 16. Januar 2014 (2014-01-16)
- DATABASE CA [Online] CHEMICAL ABSTRACTS SERVICE, COLUMBUS, OHIO, US; 2009, LEE, KUM HEE ET AL: "Highly efficient green-emitting electrophosphorescent iridium complexes with enhanced steric hindrance", XP002736160, gefunden im STN Database accession no. 2009:1268195 & LEE, KUM HEE ET AL: "Highly efficient green-emitting electrophosphorescent iridium complexes with enhanced steric hindrance", JOURNAL OF NANOSCIENCE AND NANOTECHNOLOGY , 9(12), 7099-7103 CODEN: JNNOAR; ISSN: 1533-4880, 2009, XP8175036, DOI: 10.1166/JNN.2009.1659 10.1166/JNN.2009.1659

## Beschreibung

Die vorliegende Erfindung betrifft Metallkomplexe, welche sich für den Einsatz als Emitter in organischen Elektrolumineszenzvorrichtungen eignen.

In organischen Elektrolumineszenzvorrichtungen (OLEDs) werden als emittierende Materialien zunehmend metallorganische Komplexe eingesetzt, die Phosphoreszenz statt Fluoreszenz zeigen (M. A. Baldo et al., Appl. Phys. Lett. 1999, 75, 4-6). Aus quantenmechanischen Gründen ist unter Verwendung metallorganischer Verbindungen als Phosphoreszenzemitter eine bis zu vierfache Energie- und Leistungseffizienz möglich. Generell gibt es bei OLEDs, die Triplettemission zeigen, immer noch Verbesserungsbedarf, insbesondere im Hinblick auf Effizienz, Betriebsspannung und Lebensdauer. Dies gilt insbesondere für OLEDs, welche im kürzerwelligen Bereich, also grün und insbesondere blau, emittieren.

Gemäß dem Stand der Technik werden in phosphoreszierenden OLEDs als Triplettemitter vor allem Iridium- und Platinkomplexe eingesetzt. Als Iridiumkomplexe werden insbesondere bis- und tris-ortho-metallierte Komplexe mit aromatischen Liganden eingesetzt, wobei die Liganden über ein negativ geladenes Kohlenstoffatom und ein neutrales Stickstoffatom oder über ein negativ geladenes Kohlenstoffatom und ein neutrales Carben-Kohlenstoffatom an das Metall binden. Beispiele für solche Komplexe sind Tris(phenylpyridyl)iridium(III) und Derivate davon (z. B. gemäß US 2002/0034656 oder WO 2010/027583). Aus der Literatur ist eine Vielzahl verwandter Liganden und Iridium- bzw. Platinkomplexe bekannt, wie beispielsweise Komplexe mit 1- oder 3-Phenylisochinolinliganden (z. B. gemäß EP 1348711 oder WO 2011/028473), mit 2-Phenylchinolinen (z. B. gemäß WO 2002/064700 oder WO 2006/095943) oder mit Phenyl-carbenen (z. B. gemäß WO 2005/019373). Platinkomplexe sind beispielsweise aus der WO 2003/040257 bekannt. Auch wenn mit derartigen Metallkomplexen bereits gute Ergebnisse erzielt werden, sind hier noch weitere Verbesserungen wünschenswert.

Aufgabe der vorliegenden Erfindung ist daher die Bereitstellung neuer Metallkomplexe, welche sich als Emitter für die Verwendung in OLEDs eignen. Insbesondere ist die Aufgabe, Emitter bereitzustellen, welche verbesserte Eigenschaften in Bezug auf Effizienz, Betriebsspannung, Lebensdauer, Farbkoordinaten und/oder Farbreinheit, d. h. Breite der Emissionsbande, zeigen. Weiterhin ist es eine Aufgabe der vorliegenden Erfindung, Metallkomplexe bereitzustellen, die eine erhöhte Oxidationsstabilität, insbesondere in Lösung, aufweisen. Dies ist insbesondere daher wünschenswert, da bekannt ist, dass gerade ortho-metallierte Iridiumkomplexe gute Sensibilisatoren für die Erzeugung von Singulett-Sauerstoff sind, welcher wiederum ein sehr aggressives Oxidationsmittel ist, der die Metallkomplexe selber angreifen kann.

Weiterhin gibt es bei vielen Metallkomplexen gemäß dem Stand der Technik noch Verbesserungsbedarf in Bezug auf die Sublimierbarkeit und die Löslichkeit. Insbesondere tris-ortho-metallierte Komplexe weisen aufgrund des hohen Molekulargewichts häufig hohe Sublimationstemperaturen auf, was wiederum zu thermischer Zersetzung bei der Sublimation führen kann. Auch ist eine Vielzahl von Metallkomplexen gemäß dem Stand der Technik nicht ausreichend löslich, um eine Verarbeitung aus Lösung aus gängigen organischen Lösemitteln zu ermöglichen.

Überraschend wurde gefunden, dass bestimmte, unten näher beschriebene Metallchelatkomplexe, die mindestens einen ankondensierten aliphatischen 6- oder 7-Ring ohne benzylische Protonen enthalten, diese Aufgabe lösen und sich sehr gut für die Verwendung in einer organischen Elektrolumineszenzvorrichtung eignen. Diese Metallkomplexe und organische Elektrolumineszenzvorrichtungen, welche diese Komplexe enthalten, sind daher der Gegenstand der vorliegenden Erfindung.

Aus EP 1191613 sind Iridiumkomplexe bekannt, welche an der koordinierenden Phenylgruppe eines Phenylpyridinliganden einen ankondensierten aliphatischen Cyclus aufweisen. Die in diesem Dokument offenbarten Komplexe weisen jedoch eine hohe Oxidationsempfindlichkeit, insbesondere in Lösung, auf, so dass hier weitere Verbesserungen wünschenswert wären. Weiterhin sind hier auch noch Verbesserungen bezüglich der Eigenschaften der Komplexe bei Verwendung in einer organischen Elektrolumineszenzvorrichtung wünschenswert.

Aus US 2007/0231600 sind Iridiumkomplexe bekannt, die an jeder der beiden koordinierenden Aryl- bzw. Heteroarylgruppen einen Sechsring ankondensiert enthalten. Verbindungen mit rein aliphatischen Sechsringen ohne benzylische Protonen sind jedoch nicht offenbart.

K. H. Lee et al. (Journal of Nanoscience and Nanotechnology 2009, 9, 7099-7103) offenbaren einen heteroleptischen Ir(ppy)₂(acac) Komplex, der einen ankondensierten Tetramethylcyclohexanring enthält. Aufgrund der häufig geringeren Lebensdauer heteroleptischer Komplexe mit Acetylacetonat als Coliganden sind tris-ortho-metallierte Komplexe vorzuziehen, da diese im Allgemeinen eine höhere Lebensdauer aufweisen. Die tris-ortho-metallierten Komplexe weisen allerdings den Nachteil auf, dass sie durch das höhere Molekulargewicht im Vergleich zu Acetylacetonat-Komplexen bei höherer Temperatur sublimieren, was je nach genauer Struktur des Komplexes auch zu einer thermischen Zersetzung bei der Sublimation bzw. beim Aufdampfen bei der Herstellung der organischen Elektrolumineszenzvorrichtung führen kann. Hier sind daher weitere Verbesserungen wünschenswert.

Aus WO 2011/157339 und WO 2014/008982 sind Komplexe mit Imidazoisochinolin-Derivaten als Liganden bekannt, welche mit verschiedenen Substituenten substituiert sein können, wobei einzelne Verbindungen auch eine ankondensierte Tetramethylcyclohexan-Gruppe aufweisen. Die Anwesenheit des Imidazoisochinolin-Derivats als Ligand ist dabei das wesentliche Merkmal in diesen Dokumenten.

Gegenstand der Erfindung ist somit eine Verbindung gemäß Formel (1),

M(L)ₙ(L')ₘ Formel (1)

welche eine Teilstruktur M(L)ₙ der Formel (2) enthält: 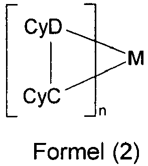 wobei für die verwendeten Symbole und Indizes gilt:
- M: ist Iridium oder Platin;
- CyC: ist eine Aryl- oder Heteroarylgruppe mit 5 bis 18 aromatischen Ring-atomen oder eine Fluorengruppe, welche jeweils über ein Kohlenstoffatom an M koordiniert und welche jeweils mit einem oder mehreren Resten R substituiert sein kann und welche jeweils über eine kovalente Bindung mit CyD verbunden ist;
- CyD: ist eine Heteroarylgruppe mit 5 bis 18 aromatischen Ringatomen, welche über ein neutrales Stickstoffatom oder über ein Carben-Kohlenstoffatom an M koordiniert und welche mit einem oder mehreren Resten R substituiert sein kann und welche über eine kovalente Bindung mit CyC verbunden ist;
- R: ist bei jedem Auftreten gleich oder verschieden H, D, F, Cl, Br, I, N(R¹)₂, CN, NO₂, OH, COOH, C(=O)N(R¹)₂, Si(R¹)₃, B(OR¹)₂, C(=O)R¹, P(=O)(R¹)₂, S(=O)R¹, S(=O)₂R¹, OSO₂R¹, eine geradkettige Alkyl-, Alkoxy- oder Thioalkoxygruppe mit 1 bis 20 C-Atomen oder eine Alkenyl- oder Alkinylgruppe mit 2 bis 20 C-Atomen oder eine verzweigte oder cyclische Alkyl-, Alkoxy- oder Thioalkoxygruppe mit 3 bis 20 C-Atomen, die jeweils mit einem oder mehreren Resten R¹ substituiert sein kann, wobei eine oder mehrere nicht benachbarte CH₂-Gruppen durch R¹C=CR¹, C≡C, Si(R¹)₂, C=O, NR¹, O, S oder CONR¹ ersetzt sein können und wobei ein oder mehrere H-Atome durch D, F, Cl, Br, I oder CN ersetzt sein können, oder ein aromatisches oder heteroaromatisches Ringsystem mit 5 bis 60 aromatischen Ringatomen, das jeweils durch einen oder mehrere Reste R¹ substituiert sein kann, oder eine Aryloxy- oder Heteroaryloxygruppe mit 5 bis 40 aromatischen Ringatomen, die durch einen oder mehrere Reste R¹ substituiert sein kann, oder eine Aralkyl- oder Heteroaralkylgruppe mit 5 bis 40 aromatischen Ringatomen, die durch einen oder mehrere Reste R¹ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R¹ substituiert sein kann; dabei können zwei benachbarte Reste R auch miteinander ein mono- oder polycyclisches, aliphatisches, aromatisches oder heteroaromatisches Ringsystem bilden, wobei benachbarte Reste entweder Reste sind, die an dasselbe Kohlenstoffatom gebunden sind, oder Reste, die an benachbarte Kohlenstoffatome gebunden sind, wobei benachbarte Kohlenstoffatome bedeutet, dass die Kohlenstoffatome direkt aneinander gebunden sind;
- R¹: ist bei jedem Auftreten gleich oder verschieden H, D, F, Cl, Br, I, N(R²)₂, CN, NO₂, Si(R²)₃, B(OR²)₂, C(=O)R², P(=O)(R²)₂, S(=O)R², S(=O)₂R², OSO₂R², eine geradkettige Alkyl-, Alkoxy- oder Thioalkoxygruppe mit 1 bis 20 C-Atomen oder eine Alkenyl- oder Alkinylgruppe mit 2 bis 20 C-Atomen oder eine verzweigte oder cyclische Alkyl-, Alkoxy- oder Thioalkoxygruppe mit 3 bis 20 C-Atomen, die jeweils mit einem oder mehreren Resten R² substituiert sein kann, wobei eine oder mehrere nicht benachbarte CH₂-Gruppen durch R²C=CR², C≡C, Si(R²)₂, C=O, NR², O, S oder CONR² ersetzt sein können und wobei ein oder mehrere H-Atome durch D, F, Cl, Br, I, CN oder NO₂ ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 40 aromatischen Ringatomen, die durch einen oder mehrere Reste R² substituiert sein kann, oder eine Aralkyl- oder Heteroaralkylgruppe mit 5 bis 40 aromatischen Ringatomen, die durch einen oder mehrere Reste R² substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R² substituiert sein kann; dabei können zwei oder mehrere benachbarte Reste R¹ miteinander ein mono- oder polycyclisches, aliphatisches Ringsystem bilden, wobei benachbarte Reste entweder Reste sind, die an dasselbe Kohlenstoffatom gebunden sind, oder Reste, die an benachbarte Kohlenstoffatome gebunden sind, wobei benachbarte Kohlenstoffatome bedeutet, dass die Kohlenstoffatome direkt aneinander gebunden sind;
- R²: ist bei jedem Auftreten gleich oder verschieden H, D, F oder ein aliphatischer, aromatischer und/oder heteroaromatischer Kohlenwasserstoffrest mit 1 bis 20 C-Atomen, in dem auch ein oder mehrere H-Atome durch F ersetzt sein können; dabei können zwei oder mehrere Substituenten R² auch miteinander ein mono- oder polycyclisches, aliphatisches Ringsystem bilden;
- L': ist gleich oder verschieden bei jedem Auftreten ein bidentater Ligand, der über ein Kohlenstoffatom und ein Stickstoffatom oder über zwei Kohlenstoffatome an M bindet;
- n: ist 1, 2 oder 3 für M = Iridium und ist 1 oder 2 für M = Platin;
- m: ist 0, 1 oder 2 für M = Iridium und ist 0 oder 1 für M = Platin;
dabei können CyC und CyD auch über eine Gruppe ausgewählt aus C(R¹)₂, C(R¹)₂-C(R¹)₂, NR¹, O oder S miteinander verknüpft sein;
dabei können auch mehrere Liganden L miteinander oder L mit L' über eine Einfachbindung oder eine bivalente oder trivalente Brücke verknüpft sein und so ein tetradentates oder hexadentates Ligandensystem aufspannen;
dadurch gekennzeichnet, dass CyD und/oder CyC zwei benachbarte Kohlenstoffatome aufweist, die jeweils mit Resten R substituiert sind,
wobei die jeweiligen Reste R zusammen mit den C-Atomen einen Ring der folgenden Formel (3) aufspannen, 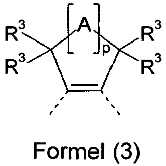 wobei R¹ und R² die oben genannten Bedeutungen aufweisen, die gestrichelten Bindungen die Verknüpfung der beiden Kohlenstoffatome im Liganden andeuten und weiterhin gilt:
- A: ist gleich oder verschieden bei jedem Auftreten C(R¹)₂, O, S, NR³ oder C(=O) mit der Maßgabe, dass in der Gruppe -(A)ₚ- nicht zwei Heteroatome direkt aneinander gebunden sind;
- R³: ist gleich oder verschieden bei jedem Auftreten eine geradkettige Alkyl- oder Alkoxygruppe mit 1 bis 20 C-Atomen, eine verzweigte oder cyclische Alkyl- oder Alkoxygruppe mit 3 bis 20 C-Atomen, die jeweils mit einem oder mehreren Resten R² substituiert sein kann, wobei eine oder mehrere nicht benachbarte CH₂-Gruppen durch R²C=CR², C≡C, Si(R²)₂, C=O, NR², O, S oder CONR² ersetzt sein können und wobei ein oder mehrere H-Atome durch D oder F ersetzt sein können, oder ein aromatisches oder heteroaromatisches Ringsystem mit 5 bis 24 aromatischen Ringatomen, das jeweils durch einen oder mehrere Reste R² substituiert sein kann, oder eine Aryloxy- oder Heteroaryloxygruppe mit 5 bis 24 aromatischen Ringatomen, die durch einen oder mehrere Reste R² substituiert sein kann, oder eine Aralkyl- oder Heteroaralkylgruppe mit 5 bis 24 aromatischen Ringatomen, die durch einen oder mehrere Reste R² substituiert sein kann; dabei können zwei Reste R³, welche an dasselbe Kohlenstoffatom gebunden sind, miteinander ein aliphatisches oder aromatisches Ringsystem bilden und so ein Spirosystem aufspannen; weiterhin kann R³ mit einem benachbarten Rest R oder R¹ ein aliphatisches Ringsystem bilden;
- p: ist gleich oder verschieden bei jedem Auftreten 2 oder 3.

Dabei ist die Anwesenheit einer Teilstruktur der Formel (3), also eines ankondensierten aliphatischen Sechs- oder Siebenrings, erfindungswesentlich. Wie aus der oben genannten Formel (3) hervorgeht, enthält der durch die vier C-Atome und die Gruppen A gebildete 6- bzw. 7-Ring keine benzylischen Protonen, da R³ ungleich Wasserstoff ist. In der oben abgebildeten Struktur der Formel (3) sowie den weiteren als bevorzugt genannten Ausführungsformen dieser Struktur wird formal eine Doppelbindung zwischen den zwei Kohlenstoffatomen abgebildet. Dies stellt eine Vereinfachung der chemischen Struktur dar, da diese beiden Kohlenstoffatome in das aromatische oder heteroaromatische System des Liganden eingebunden sind und somit die Bindung zwischen diesen beiden Kohlenstoffatomen formal zwischen dem Bindungsgrad einer Einfachbindung und dem einer Doppelbindung liegt. Das Einzeichnen der formalen Doppelbindung ist somit nicht limitierend für die Struktur auszulegen, sondern es ist dem Fachmann offensichtlich, dass hiermit eine aromatische Bindung gemeint ist.

Dabei bedeutet "benachbarte Kohlenstoffatome", dass die Kohlenstoffatome direkt aneinander gebunden sind. Weiterhin bedeutet "benachbarte Reste" in der Definition der Reste, dass diese Reste an dasselbe Kohlenstoffatom oder an benachbarte Kohlenstoffatome gebunden sind.

Wenn benachbarte Reste in den erfindungsgemäßen Strukturen ein aliphatisches Ringsystem bilden, dann ist es bevorzugt, wenn dieses aliphatische Ringsystem keine aziden benzylischen Protonen aufweist. Dies kann dadurch erreicht werden, dass die Kohlenstoffatome des aliphatischen Ringsystems, die direkt an eine Aryl- oder Heteroarylgruppe binden, vollständig substituiert sind und keine Wasserstoffatome gebunden enthalten. Dies kann weiterhin auch dadurch erreicht werden, dass die Kohlenstoffatome des aliphatischen Ringsystems, die direkt an eine Aryl- oder Heteroarylgruppe binden, die Brückenköpfe einer bi- oder polycyclischen Struktur sind. Die an Brückenkopfkohlenstoffatome gebundenen Protonen sind aufgrund der räumlichen Struktur des Bi- oder Polycyclus wesentlich weniger azide als benzylische Protonen an Kohlenstoffatomen, die nicht in einer bi- oder polycyclischen Struktur gebunden sind, und werden im Sinne der vorliegenden Erfindung als nicht-azide Protonen angesehen.

Eine Arylgruppe im Sinne dieser Erfindung enthält 6 bis 40 C-Atome; eine Heteroarylgruppe im Sinne dieser Erfindung enthält 2 bis 40 C-Atome und mindestens ein Heteroatom, mit der Maßgabe, dass die Summe aus C-Atomen und Heteroatomen mindestens 5 ergibt. Die Heteroatome sind bevorzugt ausgewählt aus N, O und/oder S. Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin, Thiophen, etc., oder eine kondensierte Aryl- oder Heteroarylgruppe, beispielsweise Naphthalin, Anthracen, Phenanthren, Chinolin, Isochinolin, etc., verstanden.

Ein aromatisches Ringsystem im Sinne dieser Erfindung enthält 6 bis 60 C-Atome im Ringsystem. Ein heteroaromatisches Ringsystem im Sinne dieser Erfindung enthält 1 bis 60 C-Atome und mindestens ein Heteroatom im Ringsystem, mit der Maßgabe, dass die Summe aus C-Atomen und Heteroatomen mindestens 5 ergibt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine nicht-aromatische Einheit (bevorzugt weniger als 10 % der von H verschiedenen Atome), wie z. B. ein C-, N- oder O-Atom oder eine Carbonylgruppe, unterbrochen sein können. So sollen beispielsweise auch Systeme wie 9,9'-Spirobifluoren, 9,9-Diarylfluoren, Triarylamin, Diarylether, Stilben, etc. als aromatische Ringsysteme im Sinne dieser Erfindung verstanden werden, und ebenso Systeme, in denen zwei oder mehrere Arylgruppen beispielsweise durch eine lineare oder cyclische Alkylgruppe oder durch eine Silylgruppe unterbrochen sind. Weiterhin sollen Systeme, in denen zwei oder mehrere Aryl- oder Heteroarylgruppen direkt aneinander gebunden sind, wie z. B. Biphenyl oder Terphenyl, ebenfalls als aromatisches bzw. heteroaromatisches Ringsystem verstanden werden.

Unter einer cyclischen Alkyl-, Alkoxy- oder Thioalkoxygruppe im Sinne dieser Erfindung wird eine monocyclische, eine bicyclische oder eine polycyclische Gruppe verstanden.

Im Rahmen der vorliegenden Erfindung werden unter einer C₁- bis C₄₀-Alkylgruppe, in der auch einzelne H-Atome oder CH₂-Gruppen durch die oben genannten Gruppen substituiert sein können, beispielsweise die Reste Methyl, Ethyl, n-Propyl, i-Propyl, Cyclopropyl, n-Butyl, i-Butyl, s-Butyl, t-Butyl, Cyclobutyl, 2-Methylbutyl, n-Pentyl, s-Pentyl, t-Pentyl, 2-Pentyl, neo-Pentyl, Cyclopentyl, n-Hexyl, s-Hexyl, t-Hexyl, 2-Hexyl, 3-Hexyl, neo-Hexyl, Cyclohexyl, 1-Methylcyclopentyl, 2-Methylpentyl, n-Heptyl, 2-Heptyl, 3-Heptyl, 4-Heptyl, Cycloheptyl, 1-Methylcyclohexyl, n-Octyl, 2-Ethylhexyl, Cyclooctyl, 1-Bicyclo[2,2,2]octyl, 2-Bicyclo[2,2,2]-octyl, 2-(2,6-Dimethyl)octyl, 3-(3,7-Dimethyl)octyl, Adamantyl, Trifluormethyl, Pentafluorethyl, 2,2,2-Trifluorethyl, 1,1-Dimethyl-n-hex-1-yl-, 1,1-Dimethyl-n-hept-1-yl-, 1,1-Dimethyl-n-oct-1-yl-, 1,1-Dimethyl-n-dec-1-yl-, 1,1-Dimethyl-n-dodec-1-yl-, 1,1-Dimethyl-n-tetradec-1-yl-, 1,1-Dimethyl-n-hexadec-1-yl-, 1,1-Dimethyl-n-octadec-1-yl-, 1,1-Diethyl-n-hex-1-yl-, 1,1-Diethyl-n-hept-1-yl-, 1,1-Diethyl-n-oct-1-yl-, 1,1-Diethyl-n-dec-1-yl-, 1,1-Diethyl-n-dodec-1-yl-, 1,1-Diethyl-n-tetradec-1-yl-, 1,1-Diethyln-n-hexadec-1-yl-, 1,1-Diethyl-n-octadec-1-yl-, 1-(n-Propyl)-cyclohex-1-yl-, 1-(n-Butyl)-cyclohex-1-yl-, 1-(n-Hexyl)-cyclohex-1-yl-, 1-(n-Octyl)-cyclohex-1-yl- und 1-(n-Decyl)-cyclohex-1-yl- verstanden. Unter einer Alkenylgruppe werden beispielsweise Ethenyl, Propenyl, Butenyl, Pentenyl, Cyclopentenyl, Hexenyl, Cyclohexenyl, Heptenyl, Cycloheptenyl, Octenyl, Cyclooctenyl oder Cyclooctadienyl verstanden. Unter einer Alkinylgruppe werden beispielsweise Ethinyl, Propinyl, Butinyl, Pentinyl, Hexinyl, Heptinyl oder Octinyl verstanden. Unter einer C₁- bis C₄₀-Alkoxygruppe werden beispielsweise Methoxy, Trifluormethoxy, Ethoxy, n-Propoxy, i-Propoxy, n-Butoxy, i-Butoxy, s-Butoxy, t-Butoxy oder 2-Methylbutoxy verstanden.

Unter einem aromatischen oder heteroaromatischen Ringsystem mit 5 - 60 aromatischen Ringatomen, welches noch jeweils mit den oben genannten Resten substituiert sein kann und welches über beliebige Positionen am Aromaten bzw. Heteroaromaten verknüpft sein kann, werden beispielsweise Gruppen verstanden, die abgeleitet sind von Benzol, Naphthalin, Anthracen, Benzanthracen, Phenanthren, Benzophenanthren, Pyren, Chrysen, Perylen, Fluoranthen, Benzfluoranthen, Naphthacen, Pentacen, Benzpyren, Biphenyl, Biphenylen, Terphenyl, Terphenylen, Fluoren, Spirobifluoren, Dihydrophenanthren, Dihydropyren, Tetrahydropyren, cis- oder trans-Indenofluoren, cis- oder trans-Monobenzoindenofluoren, cis- oder trans-Dibenzoindenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Indolocarbazol, Indenocarbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

Bevorzugt sind Verbindungen gemäß Formel (1), dadurch gekennzeichnet, dass diese nicht geladen, d. h. elektrisch neutral, sind. Dies wird auf einfache Weise dadurch erreicht, dass die Ladung der Liganden L und L' so gewählt werden, dass sie die Ladung des komplexierten Metallatoms M kompensieren.

In einer bevorzugten Ausführungsform der vorliegenden Erfindung ist CyC eine Aryl- oder Heteroarylgruppe mit 5 bis 14 aromatischen Ringatomen, besonders bevorzugt 6 bis 13 aromatischen Ringatomen, ganz besonders bevorzugt mit 6 bis 10 aromatischen Ringatomen, insbesondere bevorzugt mit 6 aromatischen Ringatomen, welche über ein Kohlenstoffatom an M koordiniert und welche mit einem oder mehreren Resten R substituiert sein kann und welche über eine kovalente Bindung mit CyD verbunden ist.

Bevorzugte Ausführungsformen der Gruppe CyC sind die Strukturen der folgenden Formeln (CyC-1) bis (CyC-19), wobei die Gruppe CyC jeweils an der durch # gekennzeichneten Position an CyD bindet und an der durch * gekennzeichneten Position an das Metall M koordiniert, 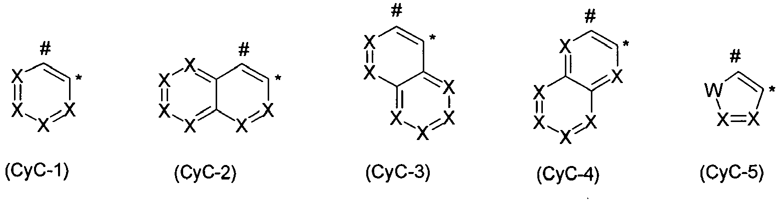 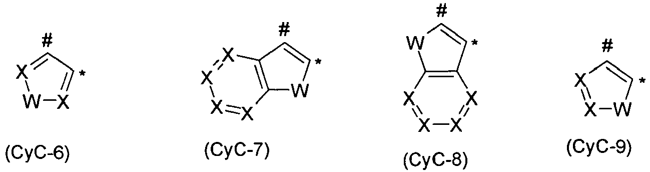 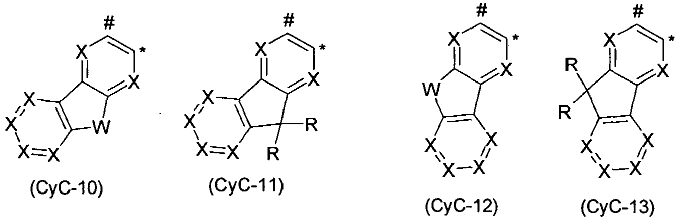 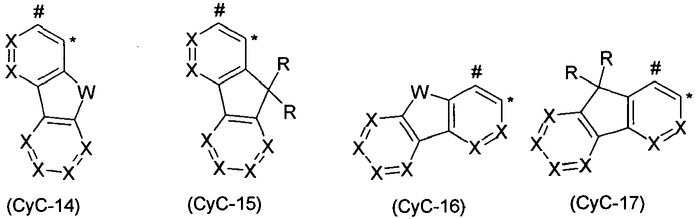 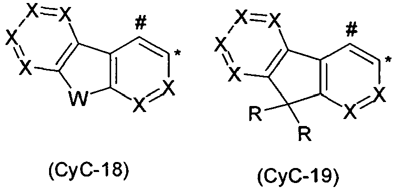 wobei R die oben genannten Bedeutungen aufweist und für die weiteren verwendeten Symbole gilt:
- X: ist bei jedem Auftreten gleich oder verschieden CR oder N;
- W: ist bei jedem Auftreten gleich oder verschieden NR, O oder S.

Falls die Gruppe der Formel (3) an CyC gebunden ist, stehen zwei benachbarte Gruppen X in CyC für CR und bilden zusammen mit den Resten R, die an diese Kohlenstoffatome gebunden sind, eine Gruppe der oben genannten bzw. unten genauer ausgeführten Formel (3).

Bevorzugt stehen maximal drei Symbole X in CyC für N, besonders bevorzugt stehen maximal zwei Symbole X in CyC für N, ganz besonders bevorzugt steht maximal ein Symbol X in CyC für N. Insbesondere bevorzugt stehen alle Symbole X für CR.

Besonders bevorzugte Gruppen CyC sind die Gruppen der folgenden Formeln (CyC-1a) bis (CyC-19a), 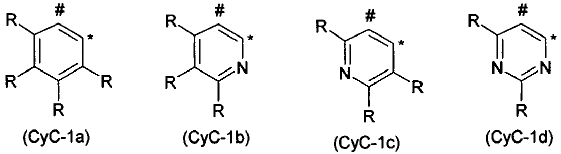 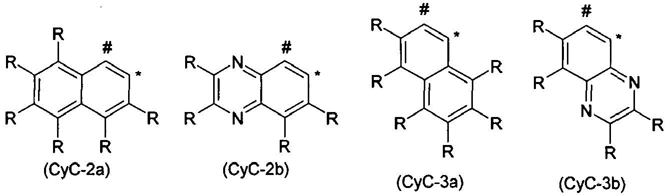 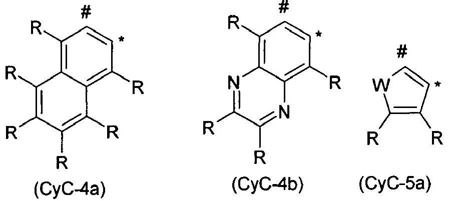 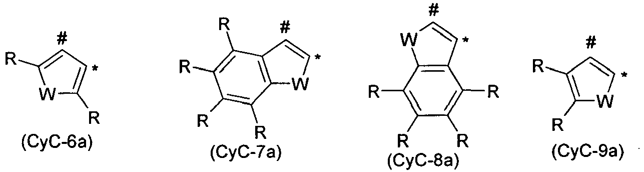 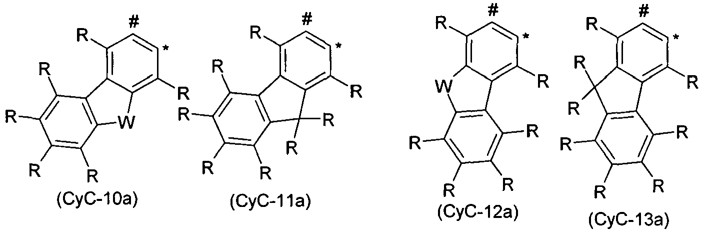 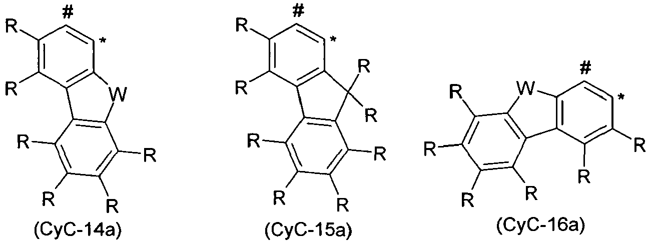 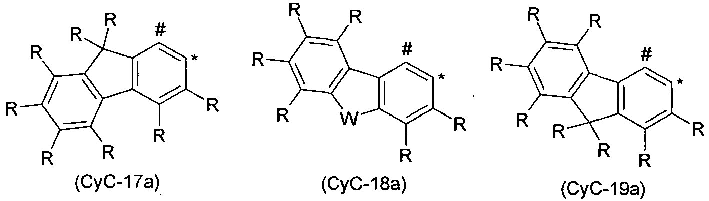 wobei die verwendeten Symbole die oben genannten Bedeutungen aufweisen. Wenn an CyC die Gruppe der Formel (3) vorliegt, spannen zwei benachbarte Reste R zusammen mit den Kohlenstoffatomen, an die sie binden, einen Ring der Formel (3) auf.

Bevorzugte Gruppen unter den Gruppen (CyC-1) bis (CyC-19) sind die Gruppen (CyC-1), (CyC-3), (CyC-8), (CyC-10), (CyC-12), (CyC-13) und (CyC-16), und besonders bevorzugt sind die Gruppen (CyC-1a), (CyC-3a), (CyC-8a), (CyC-10a), (CyC-12a), (CyC-13a) und (CyC-16a).

In einer weiteren bevorzugten Ausführungsform der Erfindung ist CyD eine Heteroarylgruppe mit 5 bis 13 aromatischen Ringatomen, besonders bevorzugt mit 5 bis 10 aromatischen Ringatomen, welche über ein neutrales Stickstoffatom oder über ein Carben-Kohlenstoffatom an M koordiniert und welche mit einem oder mehreren Resten R substituiert sein kann und welche über eine kovalente Bindung mit CyC verbunden ist.

Bevorzugte Ausführungsformen der Gruppe CyD sind die Strukturen der folgenden Formeln (CyD-1) bis (CyD-10), wobei die Gruppe CyD jeweils an der durch # gekennzeichneten Position an CyC bindet und an der durch * gekennzeichneten Position an das Metall M koordiniert, 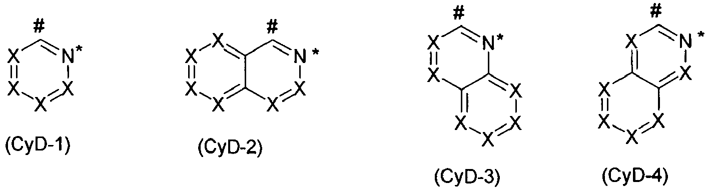 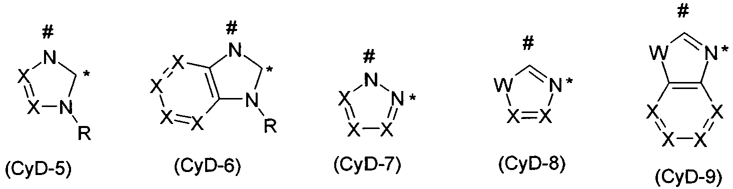 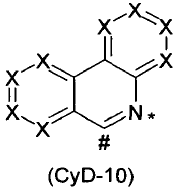 wobei X, W und R die oben genannten Bedeutungen aufweisen.

Falls die Gruppe der Formel (3) an CyD gebunden ist, stehen zwei benachbarte Gruppen X in CyD für CR und bilden zusammen mit den Resten R, die an diese Kohlenstoffatome gebunden sind, eine Gruppe der oben genannten bzw. unten genauer ausgeführten Formel (3).

Bevorzugt stehen maximal drei Symbole X in CyD für N, besonders bevorzugt stehen maximal zwei Symbole X in CyD für N, ganz besonders bevorzugt steht maximal ein Symbol X in CyD für N. Insbesondere bevorzugt stehen alle Symbole X für CR.

Besonders bevorzugte Gruppen CyD sind die Gruppen der folgenden Formeln (CyD-1a) bis (CyD-10a), 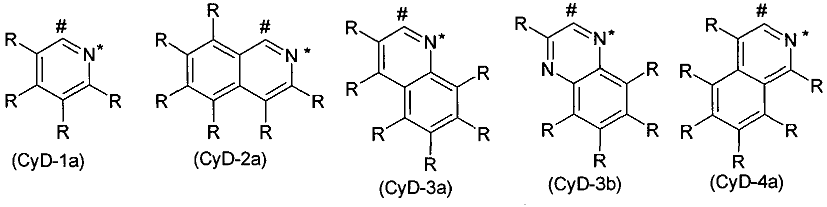 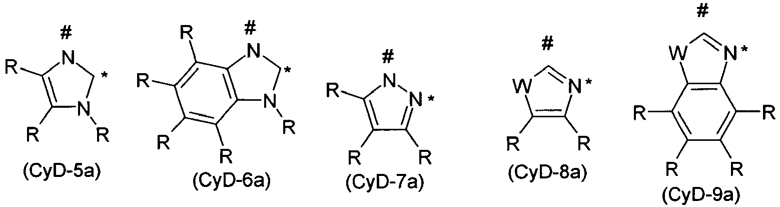 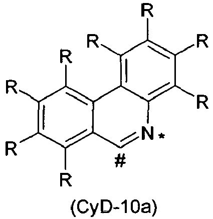 wobei die verwendeten Symbole die oben genannten Bedeutungen aufweisen. Wenn an CyD die Gruppe der Formel (3) vorliegt, spannen zwei benachbarte Reste R zusammen mit den Kohlenstoffatomen, an die sie binden, einen Ring der Formel (3) auf.

Bevorzugte Gruppen unter den Gruppen (CyD-1) bis (CyD-10) sind die Gruppen (CyD-1), (CyD-3), (CyD-4), (CyD-5) und (CyD-6), und besonders bevorzugt sind die Gruppen (CyD-1a), (CyD-3a), (CyD-4a), (CyD-5a) und (CyD-6a).

In einer bevorzugten Ausführungsform der vorliegenden Erfindung ist CyC eine Aryl- oder Heteroarylgruppe mit 5 bis 14 aromatischen Ringatomen und gleichzeitig ist CyD eine Heteroarylgruppe mit 5 bis 13 aromatischen Ringatomen. Besonders bevorzugt ist CyC eine Aryl- oder Heteroarylgruppe mit 6 bis 13 aromatischen Ringatomen, bevorzugt mit 6 bis 10 aromatischen Ringatomen, insbesondere mit 6 aromatischen Ringatomen, und gleichzeitig ist CyD eine Heteroarylgruppe mit 5 bis 10 aromatischen Ringatomen. Dabei können CyC und CyD mit einem oder mehreren Resten R substituiert sein.

Die oben genannten bevorzugten Gruppen CyC und CyD können beliebig miteinander kombiniert werden. Geeignet sind somit im Liganden L die folgenden Kombinationen aus CyC und CyD:

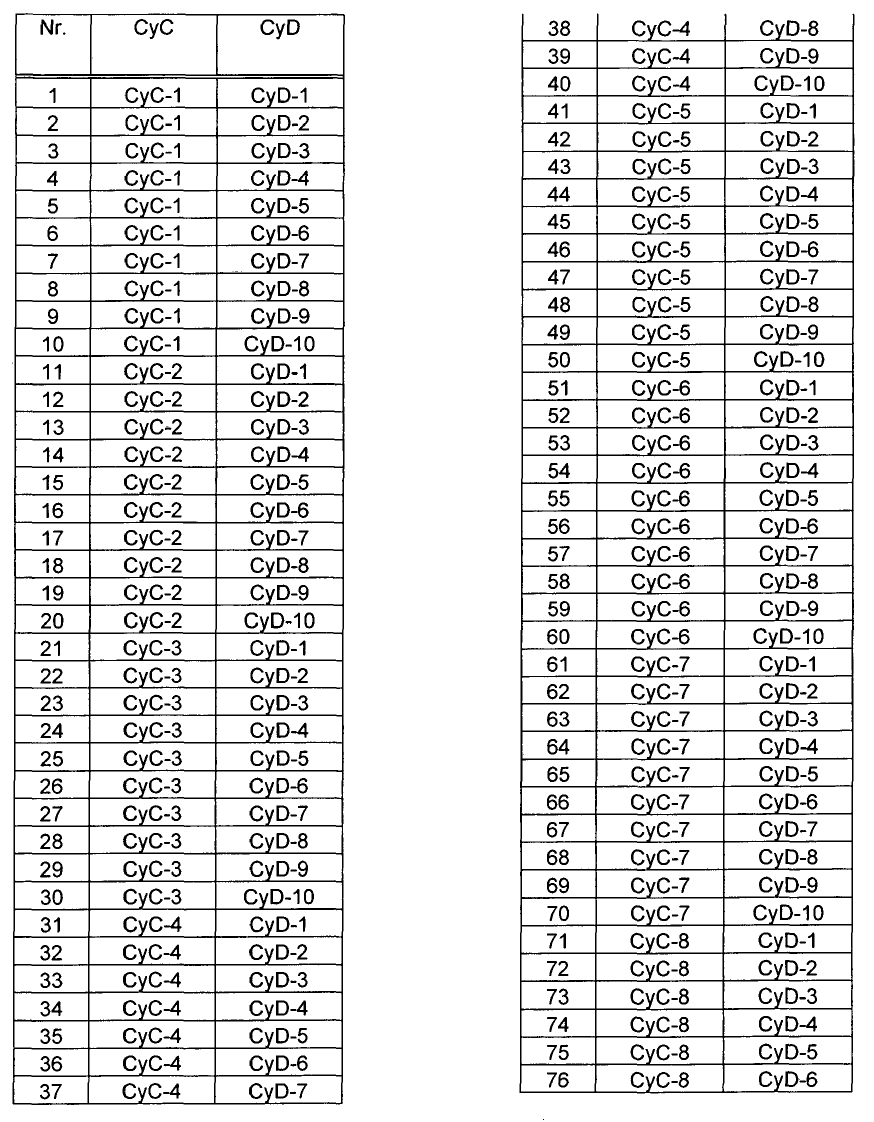

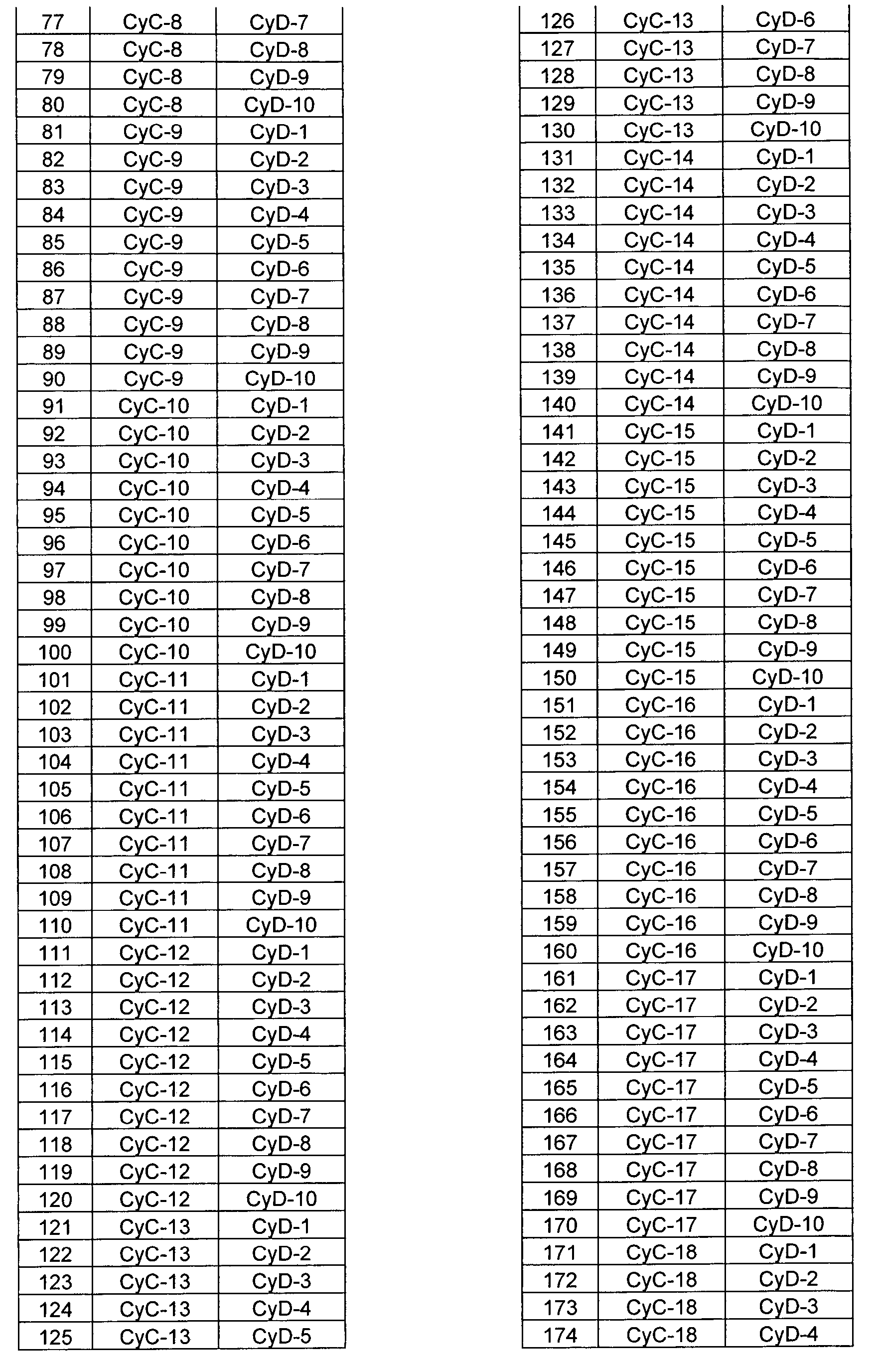

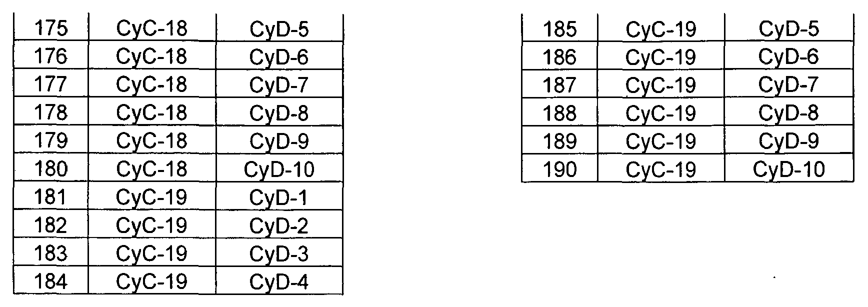

Insbesondere bevorzugt ist es, wenn die oben als besonders bevorzugt genannten Gruppen CyC und CyD miteinander kombiniert werden. Bevorzugt sind somit im Liganden L die folgenden Kombinationen aus CyC und CyD:

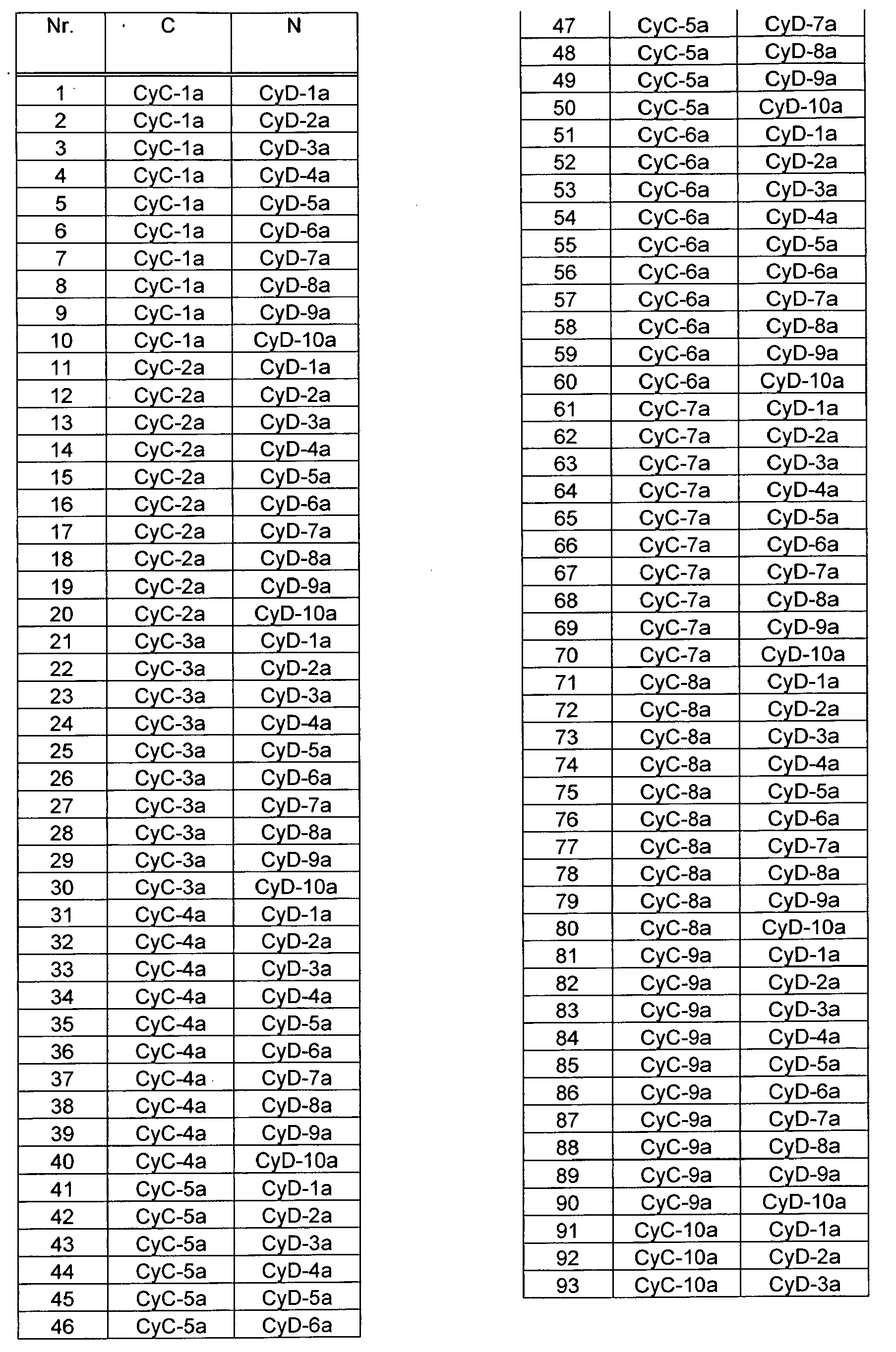

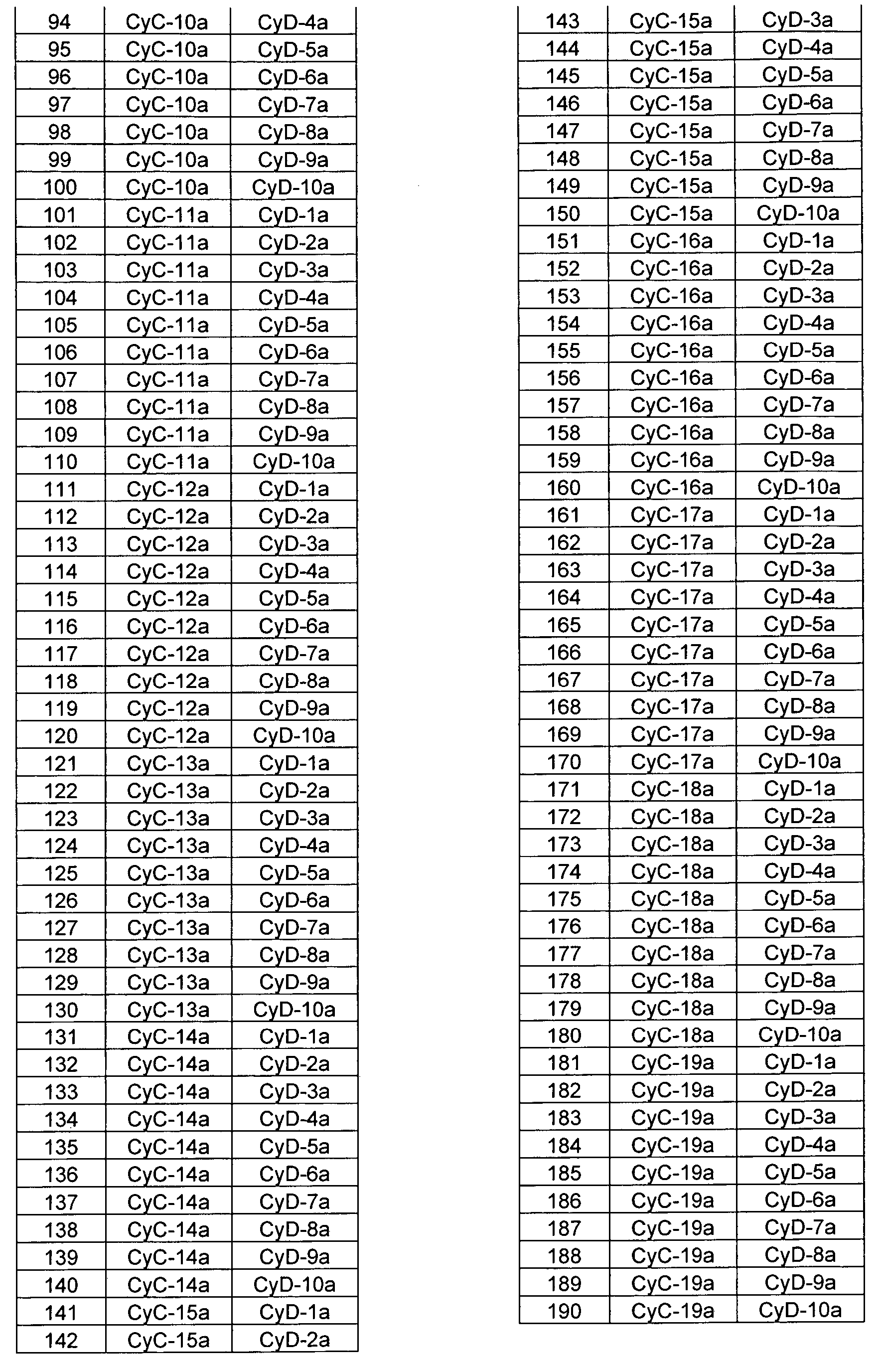

Wie oben beschrieben, ist es erfindungswesentlich, dass CyD und/oder CyC bzw. die oben aufgeführten bevorzugten Ausführungsformen zwei benachbarte Kohlenstoffatome aufweist, die jeweils mit Resten R substituiert sind, wobei die jeweiligen Reste R zusammen mit den C-Atomen einen Ring der oben genannten Formel (3) aufspannen.

In einer bevorzugten Ausführungsform der Erfindung enthält der Ligand L entweder genau eine Gruppe der Formel (3), oder er enthält zwei Gruppen der Formel (3), von denen eine an CyC und die andere an CyD gebunden ist. In einer besonders bevorzugten Ausführungsform enthält der Ligand L genau eine Gruppe der Formel (3). Dabei kann die Gruppe der Formel (3) entweder an CyC oder an CyD vorliegen, wobei die Gruppe der Formel (3) in jeder möglichen Position an CyC oder CyD gebunden sein.

In den folgenden Gruppen (CyC-1-1) bis (CyC-19-1) und (CyD-1-1) bis (CyD-10-1) sind jeweils die bevorzugten Positionen für benachbarte Gruppen X, welche für CR stehen, abgebildet, wobei die jeweiligen Reste R zusammen mit den C-Atomen, an die sie gebunden sind, einen Ring der oben genannten Formel (3) aufspannen, 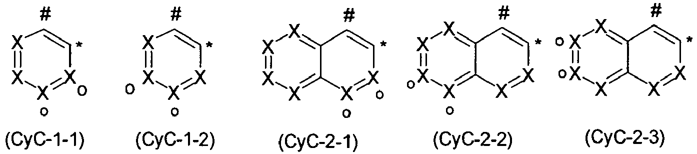 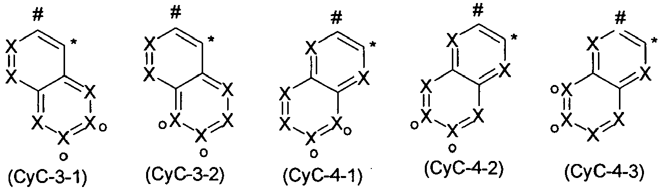 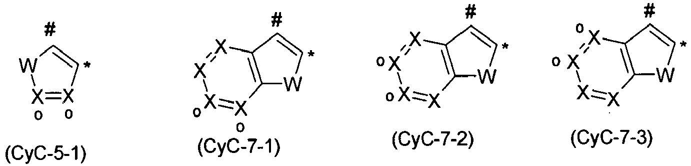 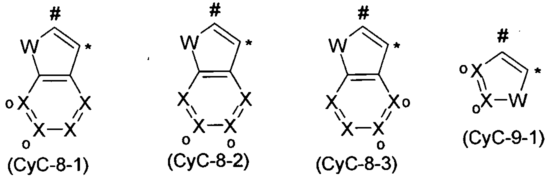 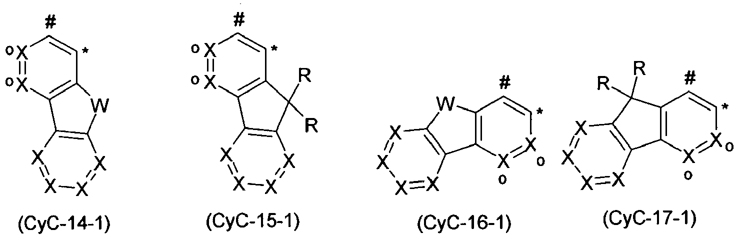 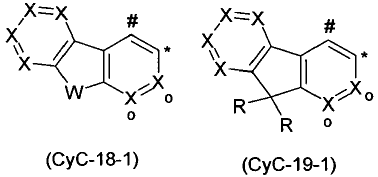 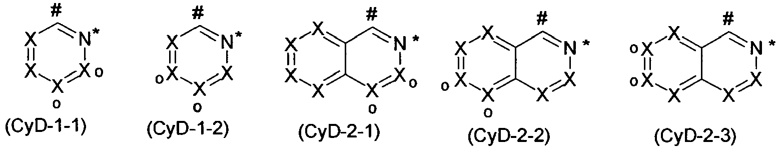 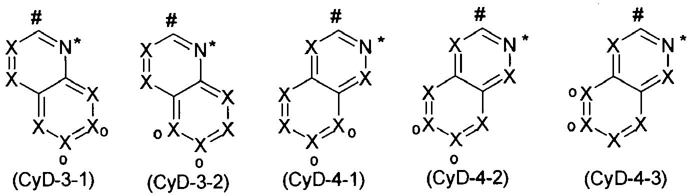 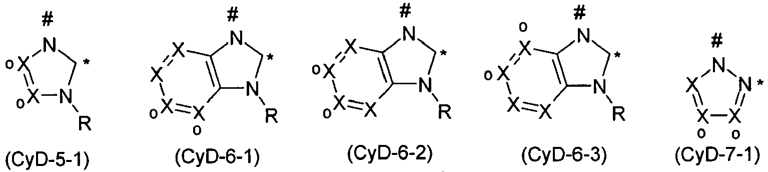 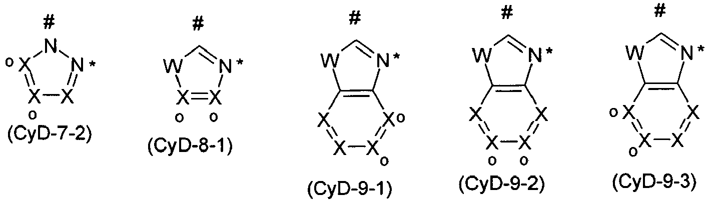 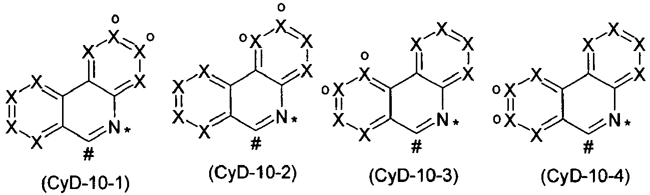 wobei die verwendeten Symbole und Indizes die oben genannten Bedeutungen aufweisen und ° jeweils die Positionen kennzeichnet, die für CR stehen, wobei die jeweiligen Reste R zusammen mit den C-Atomen, an die sie gebunden sind, einen Ring der oben genannten Formel (3) aufspannen.

Ebenso sind in den beiden oben aufgeführten Tabellen die Gruppen (CyC-1-1) bis (CyC-19-1) bzw. (CyD-1-1) bis (CyD-10-4) statt den in den Tabellen aufgeführten Gruppen (CyC-1) bis (CyC-19) oder (CyD-1) bis (CyD-19) bevorzugt.

Im Folgenden werden bevorzugte Ausführungsformen der Gruppen gemäß den Formel (3) ausgeführt. Wesentlich bei der Gruppe der Formel (3) ist, dass diese keine aziden benzylischen Protonen aufweist.

Wenn der Index p = 2 ist, handelt es sich bei der Gruppe der Formel (3) um eine Sechsringstruktur der folgenden Formel (4), und wenn der Index p = 3 ist, handelt es sich bei der Gruppe der Formel (3) um eine Siebenringstruktur der folgenden Formel (5), 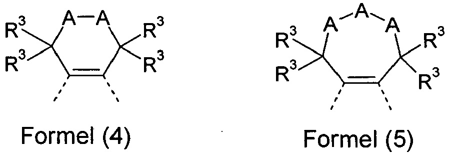 wobei die verwendeten Symbole die oben genannten Bedeutungen aufweisen.

In einer bevorzugten Ausführungsform der Erfindung ist p = 2, es handelt sich also bevorzugt um eine Struktur der Formel (4).

In einer bevorzugten Ausführungsform der Struktur gemäß Formel (3), (4) und (5) steht maximal eine der Gruppen A für ein Heteroatom, insbesondere für O oder NR³, und die andere Gruppe A für p = 2 bzw. die anderen beiden Gruppen A für p = 3 stehen für C(R¹)₂. In einer besonders bevorzugten Ausführungsform der Erfindung steht A gleich oder verschieden bei jedem Auftreten für C(R¹)₂.

Bevorzugte Ausführungsformen der Formel (4) sind somit die Strukturen der Formeln (4-A) und (4-B), wobei die Struktur der Formel (4-A) besonders bevorzugt ist, 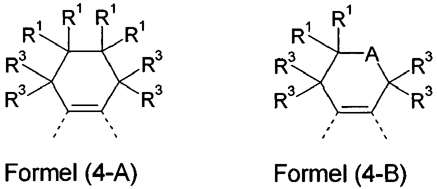 wobei R¹ und R³ die oben genannten Bedeutungen aufweisen und A für O oder NR³ steht.

Bevorzugte Ausführungsformen der Formel (5) sind die Strukturen der Formeln (5-A), (5-B) und (5-C), wobei die Struktur der Formel (5-A) besonders bevorzugt ist, 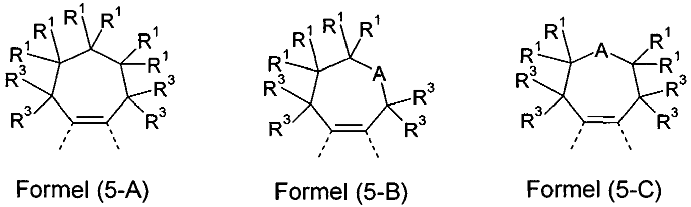 wobei R¹ und R³ die oben genannten Bedeutungen aufweisen und A für O oder NR³ steht.

In einer bevorzugten Ausführungsform der Formeln (4-A), (4-B), (5-A), (5-B) und (5-C) ist R¹ gleich oder verschieden bei jedem Auftreten H, D oder eine Alkylgruppe mit 1 bis 5 C-Atomen, besonders bevorzugt Methyl, in der auch ein oder mehrere H-Atome durch F ersetzt sein können, wobei zwei oder mehrere benachbarte Reste R¹ miteinander ein aliphatisches Ringsystem bilden können. Besonders bevorzugt steht R¹ für Wasserstoff.

In einer bevorzugten Ausführungsform der Erfindung steht R³ in der Gruppe der Formel (3) und in den bevorzugten Ausführungsformen gleich oder verschieden bei jedem Auftreten für eine geradkettige Alkyl- oder Alkoxygruppe mit 1 bis 10 C-Atomen oder eine verzweigte oder cyclische Alkyl- oder Alkoxygruppe mit 3 bis 10 C-Atomen, wobei jeweils eine oder mehrere nicht benachbarte CH₂-Gruppen durch R²C=CR² ersetzt sein können und ein oder mehrere H-Atome durch D oder F ersetzt sein können, oder ein aromatisches oder heteroaromatisches Ringsystem mit 5 bis 14 aromatischen Ringatomen, das jeweils durch einen oder mehrere Reste R² substituiert sein kann; dabei können zwei Reste R³, welche an dasselbe Kohlenstoffatom gebunden sind, miteinander ein aliphatisches oder aromatisches Ringsystem bilden und so ein Spirosystem aufspannen; weiterhin kann R³ mit einem benachbarten Rest R oder R¹ ein aliphatisches Ringsystem bilden.

In einer besonders bevorzugten Ausführungsform der Erfindung steht R³ in der Gruppe der Formel (3) und in den bevorzugten Ausführungsformen gleich oder verschieden bei jedem Auftreten für eine geradkettige Alkyl- oder Alkoxygruppe mit 1 bis 3 C-Atomen, insbesondere Methyl, oder eine verzweigte oder cyclische Alkyl- oder Alkoxygruppe mit 3 bis 5 C-Atomen oder ein aromatisches oder heteroaromatisches Ringsystem mit 6 bis 12 aromatischen Ringatomen, das jeweils durch einen oder mehrere Reste R² substituiert sein kann, bevorzugt aber unsubstituiert ist; dabei können zwei Reste R³, welche an dasselbe Kohlenstoffatom gebunden sind, miteinander ein aliphatisches oder aromatisches Ringsystem bilden und so ein Spirosystem aufspannen; weiterhin kann R³ mit einem benachbarten Rest R oder R¹ ein aliphatisches Ringsystem bilden.

Beispiele für geeignete Gruppen der Formel (4) sind die im Folgenden aufgeführten Gruppen (4-1) bis (4-16):

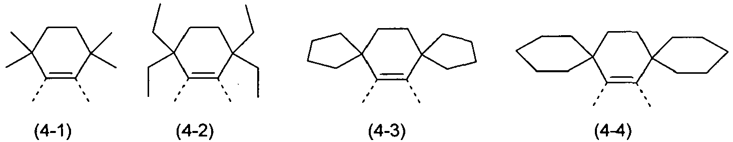

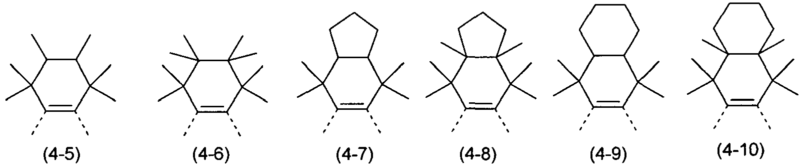

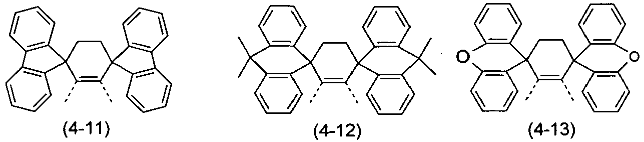

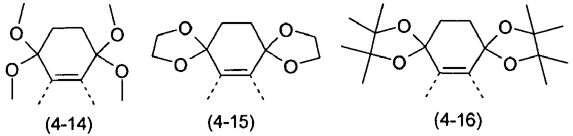

Beispiele für geeignete Gruppen der Formel (5) sind die im Folgenden aufgeführten Gruppen (5-1) bis (5-11):

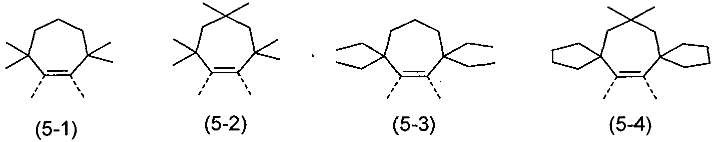

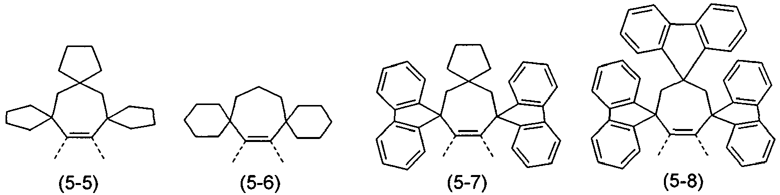

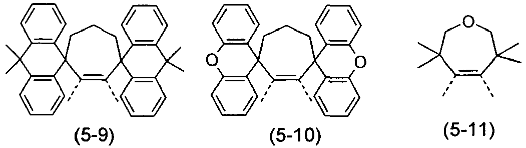

Wenn in der Teilstruktur der Formel (2) Reste R gebunden sind, so sind diese Reste R bei jedem Auftreten gleich oder verschieden bevorzugt ausgewählt aus der Gruppe bestehend aus H, D, F, Br, I, N(R¹)₂, CN, Si(R¹)₃, B(OR¹)₂, C(=O)R¹, einer geradkettigen Alkylgruppe mit 1 bis 10 C-Atomen oder einer Alkenylgruppe mit 2 bis 10 C-Atomen oder einer verzweigten oder cyclischen Alkylgruppe mit 3 bis 10 C-Atomen, die jeweils mit einem oder mehreren Resten R¹ substituiert sein kann, wobei ein oder mehrere H-Atome durch D oder F ersetzt sein können, oder einem aromatischen oder heteroaromatischen Ringsystem mit 5 bis 30 aromatischen Ringatomen, das jeweils durch einen oder mehrere Reste R¹ substituiert sein kann; dabei können zwei benachbarte Rest R oder R mit R¹ auch miteinander ein mono- oder polycyclisches, aliphatisches oder aromatisches Ringsystem bilden. Besonders bevorzugt sind diese Reste R bei jedem Auftreten gleich oder verschieden ausgewählt aus der Gruppe bestehend aus H, D, F, N(R¹)₂, einer geradkettigen Alkylgruppe mit 1 bis 6 C-Atomen oder einer verzweigten oder cyclischen Alkylgruppe mit 3 bis 10 C-Atomen, wobei ein oder mehrere H-Atome durch D oder F ersetzt sein können, oder einem aromatischen oder heteroaromatischen Ringsystem mit 5 bis 24 aromatischen Ringatomen, das jeweils durch einen oder mehrere Reste R¹ substituiert sein kann; dabei können zwei benachbarte Reste R oder R mit R¹ auch miteinander ein mono- oder polycyclisches, aliphatisches oder aromatisches Ringsystem bilden.

Reste R¹, die an R gebunden sind, sind bei jedem Auftreten gleich oder verschieden bevorzugt H, D, F, N(R²)₂, CN, eine geradkettige Alkyl- oder Alkoxygruppe mit 1 bis 10 C-Atomen oder eine Alkenylgruppe mit 2 bis 10 C-Atomen oder eine verzweigte oder cyclische Alkyl- oder Alkoxygruppe mit 3 bis 10 C-Atomen, die jeweils mit einem oder mehreren Resten R² substituiert sein kann, wobei eine oder mehrere nicht benachbarte CH₂-Gruppen durch R²C=CR² oder O ersetzt sein können und wobei ein oder mehrere H-Atome durch D oder F ersetzt sein können, oder ein aromatisches oder heteroaromatisches Ringsystem mit 5 bis 20 aromatischen Ringatomen, das jeweils durch einen oder mehrere Reste R² substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R² substituiert sein kann; dabei können zwei oder mehrere benachbarte Reste R¹ miteinander ein mono- oder polycyclisches, aliphatisches Ringsystem bilden. Besonders bevorzugte Reste R¹, die an R gebunden sind, sind bei jedem Auftreten gleich oder verschieden H, F, CN, eine geradkettige Alkylgruppe mit 1 bis 5 C-Atomen oder eine verzweigte oder cyclische Alkylgruppe mit 3 bis 5 C-Atomen, die jeweils mit einem oder mehreren Resten R² substituiert sein kann, oder ein aromatisches oder heteroaromatisches Ringsystem mit 5 bis 13 aromatischen Ringatomen, das jeweils durch einen oder mehrere Reste R² substituiert sein kann; dabei können zwei oder mehrere benachbarte Reste R¹ miteinander ein mono- oder polycyclisches, aliphatisches Ringsystem bilden.

Bevorzugte Reste R² sind bei jedem Auftreten gleich oder verschieden H, F oder ein aliphatischer Kohlenwasserstoffrest mit 1 bis 5 C-Atomen oder ein aromatischer Kohlenwasserstoffrest mit 6 bis 12 C-Atomen; dabei können zwei oder mehrere Substituenten R² auch miteinander ein mono- oder polycyclisches, aliphatisches Ringsystem bilden.

Wie oben beschrieben, kann auch statt einem der Reste R eine verbrückende Einheit vorhanden sein, die diesen Liganden L mit einem oder mehreren weiteren Liganden L bzw. L' verknüpft. In einer bevorzugten Ausführungsform der Erfindung ist statt einem der Reste R, insbesondere statt der Reste R, die in ortho- oder meta-Position zum koordinierenden Atom stehen, eine verbrückende Einheit vorhanden, so dass die Liganden dreizähnigen oder mehrzähnigen oder polypodalen Charakter aufweisen. Es können auch zwei solcher verbrückenden Einheiten vorhanden sein. Dies führt zur Bildung makrocyclischer Liganden bzw. zur Bildung von Kryptaten.

Bevorzugte Strukturen mit mehrzähnigen Liganden bzw. mit polydentaten Liganden sind die Metallkomplexe der folgenden Formeln (6) bis (11), 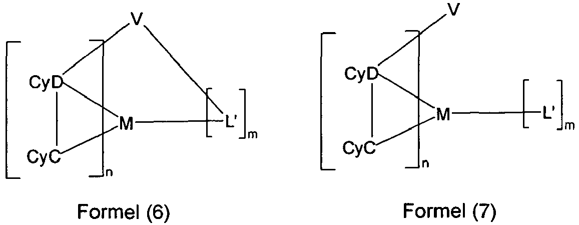 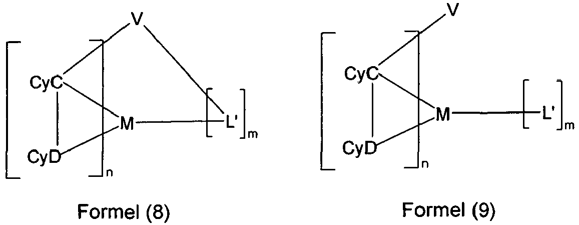 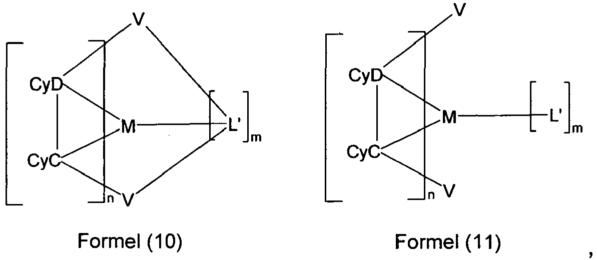 wobei die verwendeten Symbole und Indizes die oben genannten Bedeutungen aufweisen.

Dabei stellt in den Strukturen der Formeln (6) bis (11) V bevorzugt eine Einfachbindung oder eine verbrückende Einheit dar, enthaltend 1 bis 80 Atome aus der dritten, vierten, fünften und/oder sechsten Hauptgruppe (Gruppe 13, 14, 15 oder 16 gemäß IUPAC) oder einen 3- bis 6-gliedrigen Homo- oder Heterocyclus, die die Teilliganden L miteinander oder L mit L' miteinander kovalent verbindet. Dabei kann die verbrückende Einheit V auch unsymmetrisch aufgebaut sein, d. h. die Verknüpfung von V zu L bzw. L' muss nicht identisch sein. Die verbrückende Einheit V kann neutral, einfach, zweifach oder dreifach negativ oder einfach, zweifach oder dreifach positiv geladen sein. Bevorzugt ist V neutral oder einfach negativ oder einfach positiv geladen, besonders bevorzugt neutral. Dabei wird die Ladung von V bevorzugt so gewählt, dass insgesamt ein neutraler Komplex entsteht. Dabei gelten für die Liganden die oben für die Teilstruktur MLₙ genannten Bevorzugungen und n ist bevorzugt mindestens 2.

Die genaue Struktur und chemische Zusammensetzung der Gruppe V hat keinen wesentlichen Einfluss auf die elektronischen Eigenschaften des Komplexes, da die Aufgabe dieser Gruppe im Wesentlichen darin liegt, durch die Verbrückung von L miteinander bzw. mit L' die chemische und thermische Stabilität der Komplexe zu erhöhen.

Wenn V eine trivalente Gruppe ist, also drei Liganden L miteinander bzw. zwei Liganden L mit L' oder einen Liganden L mit zwei Liganden L' verbrückt, ist V bevorzugt gleich oder verschieden bei jedem Auftreten gewählt aus der Gruppe bestehend aus B, B(R¹)⁻, B(C(R¹)₂)₃, (R¹)B(C(R¹)₂)₃⁻, B(O)₃, (R¹)B(O)₃⁻, B(C(R¹)₂C(R¹)₂)₃, (R¹)B(C(R¹)₂C(R¹)₂)₃⁻, B(C(R¹)₂O)₃, (R¹)B(C(R¹)₂O)₃⁻, B(OC(R¹)₂)₃, (R¹)B(OC(R¹)₂)₃⁻, C(R¹), CO⁻, CN(R¹)₂, (R¹)C(C(R¹)₂)₃, (R¹)C(O)₃, (R¹)C(C(R¹)₂C(R¹)₂)₃, (R¹)C(C(R¹)₂O)₃, (R¹)C(OC(R¹)₂)₃, (R¹)C(Si(R¹)₂)₃, (R¹)C(Si(R¹)₂C(R¹)₂)₃, (R¹)C(C(R¹)₂Si(R¹)₂)₃, (R¹)C(Si(R¹)₂Si(R¹)₂)₃, Si(R¹), (R¹)Si(C(R¹)₂)₃, (R¹)Si(O)₃, (R¹)Si(C(R¹)₂C(R¹)₂)₃, (R¹)Si(OC(R¹)₂)₃, (R¹)Si(C(R¹)₂O)₃, (R¹)Si(Si(R¹)₂)₃, (R¹)Si(Si(R¹)₂C(R¹)₂)₃, (R¹)Si(C(R¹)₂Si(R¹)₂)₃, (R¹)Si(Si(R¹)₂Si(R¹)₂)₃, N, NO, N(R¹)⁺, N(C(R¹)₂)₃, (R¹)N(C(R¹)₂)₃⁺, N(C=O)₃, N(C(R¹)₂C(R¹)₂)₃, (R¹)N(C(R¹)₂C(R¹)₂)⁺, P, P(R¹)⁺, PO, PS, P(O)₃, PO(O)₃, P(OC(R¹)₂)₃, PO(OC(R¹)₂)₃, P(C(R¹)₂)₃, P(R¹)(C(R¹)₂)₃⁺, PO(C(R¹)₂)₃, P(C(R¹)₂C(R¹)₂)₃, P(R¹)(C(R¹)₂C(R¹)₂)₃⁺, PO(C(R¹)₂C(R¹)₂)₃, S⁺, S(C(R¹)₂)₃⁺, S(C(R¹)₂C(R¹)₂)₃⁺,
oder eine Einheit gemäß Formel (12) bis (16), 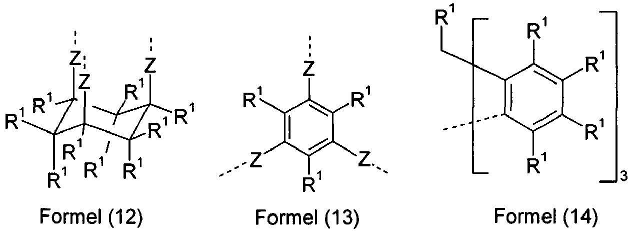 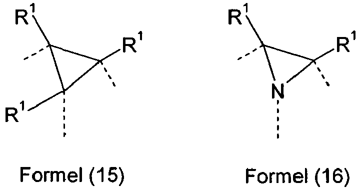 wobei die gestrichelten Bindungen jeweils die Bindung zu den Teilliganden L bzw. L' andeuten und Z gleich oder verschieden bei jedem Auftreten ausgewählt ist aus der Gruppe bestehend aus einer Einfachbindung, O, S, S(=O), S(=O)₂, NR¹, PR¹, P(=O)R¹, C(R¹)₂, C(=O), C(=NR¹), C(=C(R¹)₂), Si(R¹)₂ oder BR¹. Die weiteren verwendeten Symbole haben die oben genannten Bedeutungen.

Wenn V für eine Gruppe CR₂ steht, so können die beiden Reste R auch miteinander verknüpft sein, so dass auch Strukturen wie zum Beispiele 9,9-Fluoren geeignete Gruppen V sind.

Wenn V eine bivalente Gruppe ist, also zwei Liganden L miteinander bzw. einen Liganden L mit L' verbrückt, ist V bevorzugt gleich oder verschieden bei jedem Auftreten gewählt aus der Gruppe bestehend aus BR¹, B(R¹)₂⁻, C(R¹)₂, C(=O), Si(R¹)₂, NR¹, PR¹, P(R¹)₂⁺, P(=O)(R¹), P(=S)(R¹), O, S, Se, oder eine Einheit gemäß Formel (17) bis (26), 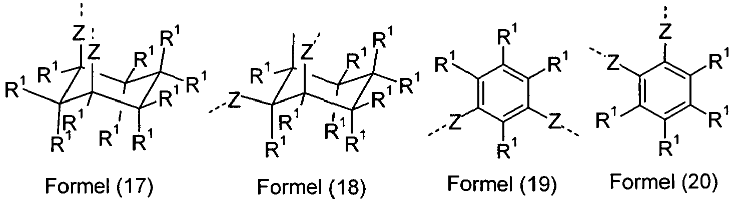 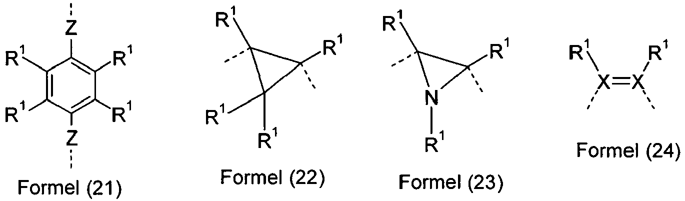 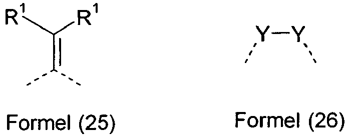 wobei die gestrichelten Bindungen jeweils die Bindung zu den Teilliganden L bzw. L' andeuten, Y bei jedem Auftreten gleich oder verschieden für C(R¹)₂, N(R¹), O oder S steht und die weiteren verwendeten Symbole jeweils die oben aufgeführten Bedeutungen haben.

Im Folgenden werden bevorzugte Liganden L' beschrieben, wie sie in Formel (1) vorkommen. Entsprechend können auch die Ligandengruppen L' gewählt sein, wenn diese über eine verbrückende Einheit V an L gebunden sind, wie in Formeln (6), (8) und (10) angedeutet.

Die Liganden L' sind bevorzugt monoanionische bidentate Liganden, die über ein neutrales Stickstoffatom und ein negativ geladenes Kohlenstoffatom oder über ein neutrales Kohlenstoffatom und ein negativ geladenes Kohlenstoffatom an M binden. Dabei ist es bevorzugt, dass die Liganden L' mit dem Metall einen cyclometallierten Fünfring oder Sechsring bilden, insbesondere einen cyclometallierten Fünfring. Wie oben beschrieben, können die Liganden L' auch über eine verbrückende Gruppe V an L gebunden sein. Die Liganden L' sind insbesondere Liganden, wie sie allgemein auf dem Gebiet der phosphoreszierenden Metallkomplexe für organische Elektrolumineszenzvorrichtungen verwendet werden, also Liganden vom Typ Phenylpyridin, Naphthylpyridin, Phenylchinolin, Phenylisochinolin, etc., welche jeweils durch einen oder mehrere Reste R substituiert sein können. Dem Fachmann auf dem Gebiet der phosphoreszierenden Elektrolumineszenzvorrichtungen ist eine Vielzahl derartiger Liganden bekannt, und er kann ohne erfinderisches Zutun weitere derartige Liganden als Ligand L' für Verbindungen gemäß Formel (1) auswählen. Generell eignet sich dafür besonders die Kombination aus zwei Gruppen, wie sie durch die folgenden Formeln (27) bis (50) dargestellt sind, wobei eine Gruppe über ein neutrales Stickstoffatom oder ein Carbenkohlenstoffatom bindet und die andere Gruppe bevorzugt über ein negativ geladenes Kohlenstoffatom bindet. Der Ligand L' kann dann aus den Gruppen der Formeln (27) bis (50) gebildet werden, indem diese Gruppen jeweils an der durch # gekennzeichneten Position aneinander binden. Die Position, an der die Gruppen an das Metall M koordinieren, sind durch * gekennzeichnet. Diese Gruppen können auch über eine oder zwei verbrückende Einheiten V an den Liganden L gebunden sein.

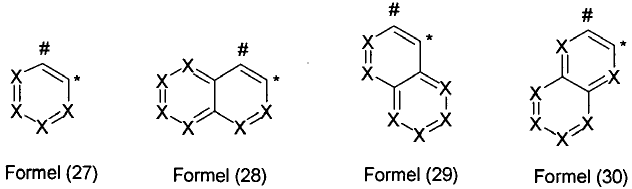

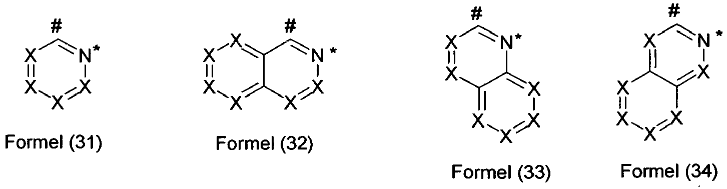

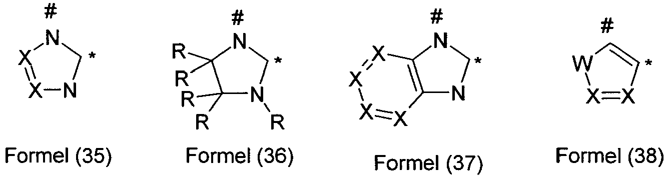

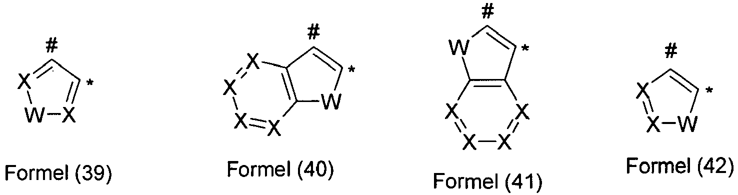

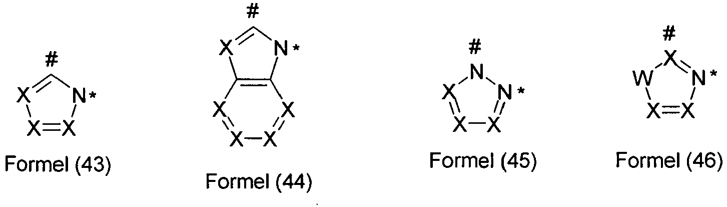

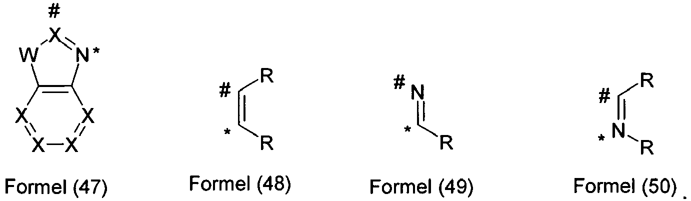

Dabei hat W die oben genannte Bedeutung und X steht bei jedem Auftreten gleich oder verschieden für CR oder N, wobei hier die oben genannte Limitierung, dass mindestens zwei benachbarte Gruppen X für CR stehen und die Reste R einen Ring der Formel (3) bilden, nicht gilt. R hat dieselbe Bedeutung wie oben beschrieben, wobei hier auch zwei Reste R, die an zwei unterschiedlichen Cyclen der oben genannten Formeln (27) bis (59) gebunden sind, miteinander auch ein aromatisches Ringsystem bilden können. Bevorzugt stehen maximal drei Symbole X in jeder Gruppe für N, besonders bevorzugt stehen maximal zwei Symbole X in jeder Gruppe für N, ganz besonders bevorzugt steht maximal ein Symbol X in jeder Gruppe für N. Insbesondere bevorzugt stehen alle Symbole X für CR.

Wenn zwei Reste R im Liganden L', die an zwei unterschiedlichen Cyclen der oben genannten Formeln (27) bis (50) gebunden sind, miteinander auch ein aromatisches Ringsystem bilden, können sich beispielsweise Liganden ergeben, die insgesamt eine einzige größere Heteroarylgruppe darstellen, wie beispielsweise Benzo[h]chinolin, etc.. Bevorzugte Liganden, die durch Ringbildung zweier Reste R an den unterschiedlichen Cyclen entstehen, sind die im Folgenden aufgeführten Strukturen der Formeln (51) bis (55), 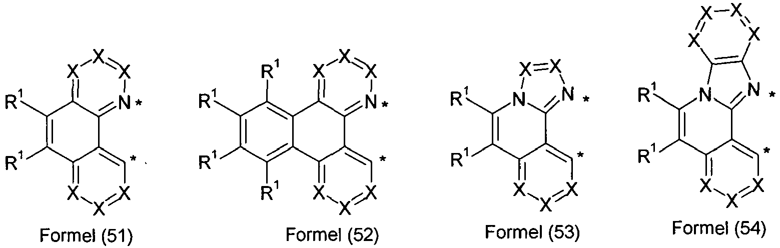 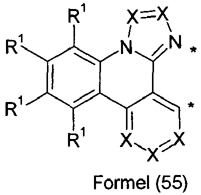 wobei die verwendeten Symbole die oben genannten Bedeutungen aufweisen.

Bevorzugte Reste R in den oben aufgeführten Strukturen von L' sind bei jedem Auftreten gleich oder verschieden ausgewählt aus der Gruppe bestehend aus H, D, F, Br, N(R¹)₂, CN, B(OR¹)₂, C(=O)R¹, P(=O)(R¹)₂, einer geradkettigen Alkylgruppe mit 1 bis 10 C-Atomen oder einer Alkenyl- oder Alkinylgruppe mit 2 bis 10 C-Atomen oder einer verzweigten oder cyclischen Alkylgruppe mit 3 bis 10 C-Atomen, die jeweils mit einem oder mehreren Resten R¹ substituiert sein kann, wobei ein oder mehrere H-Atome durch D oder F ersetzt sein können, oder einem aromatischen oder heteroaromatischen Ringsystem mit 5 bis 14 aromatischen Ringatomen, das jeweils durch einen oder mehrere Reste R¹ substituiert sein kann; dabei können zwei oder mehrere benachbarte Reste R auch miteinander ein mono- oder polycyclisches, aliphatisches, aromatisches und/oder benzoannelliertes Ringsystem bilden. Besonders bevorzugte Reste R sind bei jedem Auftreten gleich oder verschieden ausgewählt aus der Gruppe bestehend aus H, D, F, Br, CN, B(OR¹)₂, einer geradkettigen Alkylgruppe mit 1 bis 5 C-Atomen, insbesondere Methyl, oder einer verzweigten oder cyclischen Alkylgruppe mit 3 bis 5 C-Atomen, insbesondere iso-Propyl oder tert-Butyl, wobei ein oder mehrere H-Atome durch D oder F ersetzt sein können, oder einem aromatischen oder heteroaromatischen Ringsystem mit 5 bis 12 aromatischen Ringatomen, das jeweils durch einen oder mehrere Reste R¹ substituiert sein kann; dabei können zwei oder mehrere Reste R auch miteinander ein mono- oder polycyclisches, aliphatisches, aromatisches und/oder benzoannelliertes Ringsystem bilden.

Bevorzugte Reste R¹ in den oben aufgeführten Strukturen von L' sind analog zu den oben aufgeführten bevorzugten Resten R¹ definiert.

Die erfindungsgemäßen Komplexe können facial bzw. pseudofacial sein, oder sie können meridional bzw. pseudomeridional sein.

Die Liganden L und/oder L' können je nach Struktur auch chiral sein. Dies ist insbesondere dann der Fall, wenn sie Substituenten enthalten, beispielsweise Alkyl-, Alkoxy, Dialkylamino- oder Aralkylgruppen, welche ein oder mehrere Stereozentren aufweisen. Da es sich bei der Grundstruktur des Komplexes auch um eine chirale Struktur handeln kann, ist die Bildung von Diastereomeren und mehreren Enantiomerenpaaren möglich. Die erfindungsgemäßen Komplexe umfassen dann sowohl die Mischungen der verschiedenen Diastereomere bzw. die entsprechenden Racemate wie auch die einzelnen isolierten Diastereomere bzw. Enantiomere.

Die oben genannten bevorzugten Ausführungsformen sind beliebig miteinander kombinierbar. In einer besonders bevorzugten Ausführungsform der Erfindung gelten die oben genannten bevorzugten Ausführungsformen gleichzeitig.

Beispiele für geeignete Verbindungen gemäß Formel (1) sind die in der folgenden Tabelle aufgeführten Strukturen.

| | | |
|---|---|---|
| 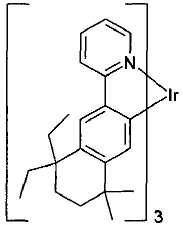 | 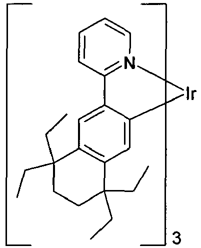 | 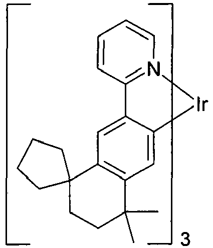 |
| 1 | 2 | 3 |
| 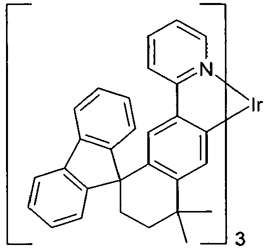 | 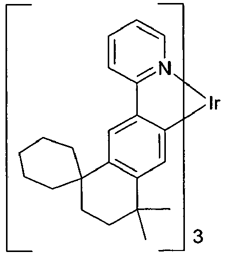 | 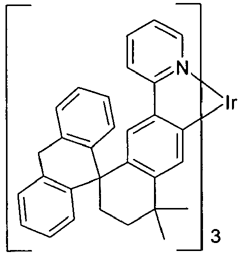 |
| 4 | 5 | 6 |
| 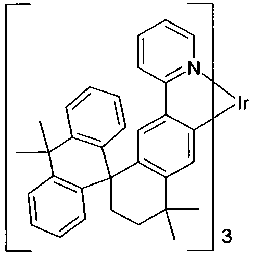 | 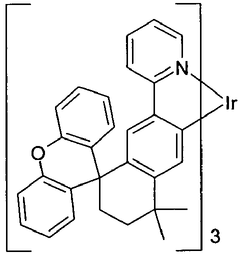 | 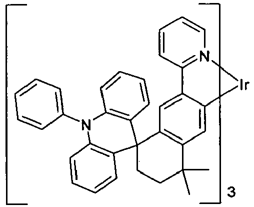 |
| 7 | 8 | 9 |
| 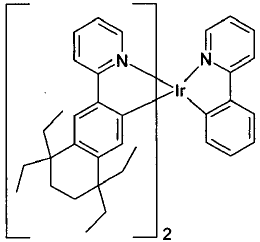 | 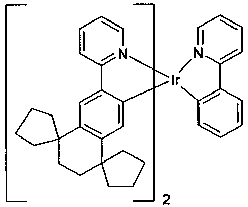 | 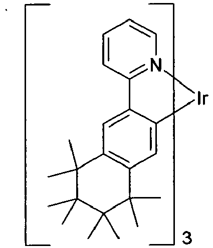 |
| 10 | 11 | 12 |
| 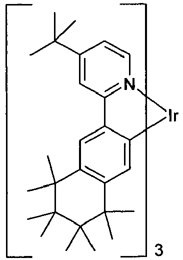 | 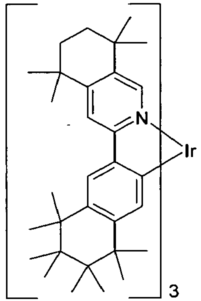 | 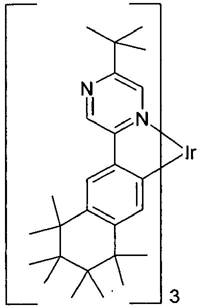 |
| 13 | 14 | 15 |
| 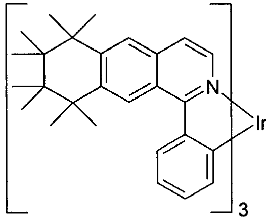 | 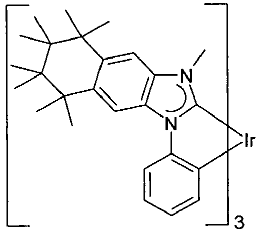 | 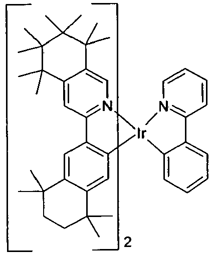 |
| 16 | 17 | 18 |
| 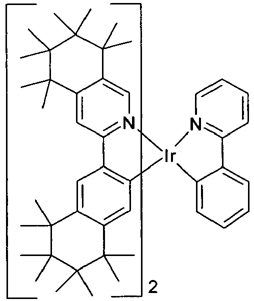 | 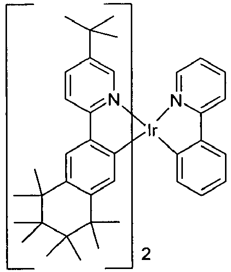 | 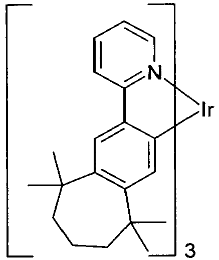 |
| 19 | 20 | 21 |
| 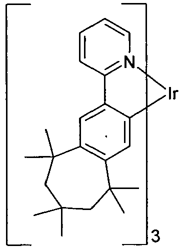 | 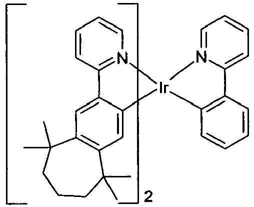 | 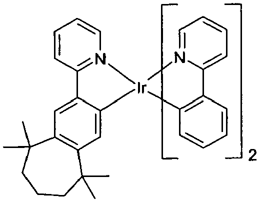 |
| 22 | 23 | 24 |
| 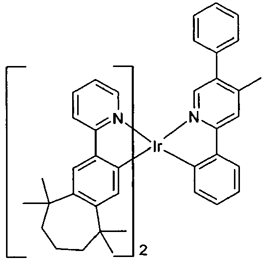 | 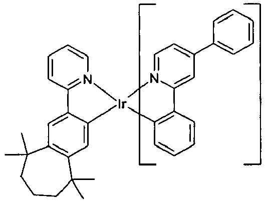 2 | 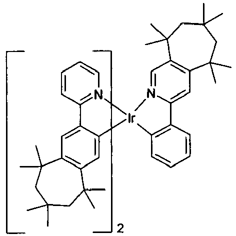 |
| 25 | 26 | 27 |

Die erfindungsgemäßen Metallkomplexe sind prinzipiell durch verschiedene Verfahren darstellbar. Es haben sich jedoch die im Folgenden beschriebenen Verfahren als besonders geeignet herausgestellt.

Daher ist ein weiterer Gegenstand der vorliegenden Erfindung ein Verfahren zur Herstellung der Metallkomplex-Verbindungen gemäß Formel (1) durch Umsetzung der entsprechenden freien Liganden L und gegebenenfalls L' mit Metallalkoholaten der Formel (67), mit Metallketoketonaten der Formel (68), mit Metallhalogeniden der Formel (69), mit dimeren Metallkomplexen der Formel (70) oder mit Metallkomplexen der Formel (71),

M(OR)ₙ Formel (67)

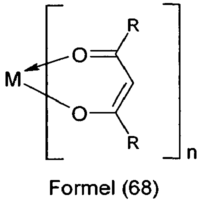

MHalₙ Formel (69)

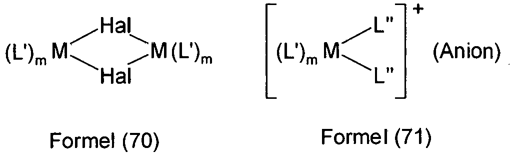

wobei die Symbole M, m, n und R die oben angegebenen Bedeutungen haben, Hal = F, Cl, Br oder I ist, L" für einen Alkohol, insbesondere für einen Alkohol mit 1 bis 4 C-Atomen oder ein Nitril, insbesondere Acetonitril oder Benzonitril, steht und (Anion) ein nicht-koordinierendes Anion ist, wie beispielsweise Triflat.

Es können ebenfalls Metallverbindungen, insbesondere Iridiumverbindungen, die sowohl Alkoholat- und/oder Halogenid- und/oder Hydroxy- wie auch Ketoketonatreste tragen, verwendet werden. Diese Verbindungen können auch geladen sein. Entsprechende Iridiumverbindungen, die als Edukte besonders geeignet sind, sind in WO 2004/085449 offenbart. Besonders geeignet sind [IrCl₂(acac)₂]⁻, beispielsweise Na[IrCl₂(acac)₂], Metallkomplexe mit Acetylacetonat-Derivaten als Ligand, beispielsweise Ir(acac)₃ oder Tris(2,2,6,6-Tetramethylheptan-3,5-dionato)iridium, und IrCl₃·xH₂O, wobei x üblicherweise für eine Zahl zwischen 2 und 4 steht.

Geeignete Platin-Edukte sind beispielsweise PtCl₂, K₂[PtCl₄], PtCl₂(DMSO)₂, Pt(Me)₂(DMSO)₂ oder PtCl₂(Benzonitril)₂.

Die Synthese kann auch durch Umsetzung der Liganden L mit Iridiumkomplexen der Formel [Ir(L')₂(HOMe)₂]A oder [Ir(L')₂(NCMe)₂]A oder durch Umsetzung der Liganden L' mit Iridiumkomplexen der Formel [Ir(L)₂(HOMe)₂]A oder [Ir(L)₂(NCMe)₂]A, wobei A jeweils ein nicht koordinierendes Anion, wie z. B. Triflat, Tetrafluoroborat, Hexafluorophosphat, etc., darstellt, in dipolar-protischen Lösungsmitteln, wie z. B. Ethylenglykol, Propylenglykol, Glycerin, Diethylenglykol, Triethylenglykol, etc., durchgeführt werden.

Die Synthese der Komplexe wird bevorzugt durchgeführt wie in WO 2002/060910 und in WO 2004/085449 beschrieben. Heteroleptische Komplexe können beispielsweise auch gemäß WO 05/042548 synthetisiert werden. Dabei kann die Synthese beispielsweise auch thermisch, photochemisch und/oder durch Mikrowellenstrahlung aktiviert werden. Weiterhin kann die Synthese auch im Autoklaven bei erhöhtem Druck und/oder erhöhter Temperatur durchgeführt werden.

Die Reaktionen können ohne Zusatz von Lösemitteln oder Schmelzhilfen in einer Schmelze der entsprechenden zu o-metallierenden Liganden durchgeführt werden. Gegebenenfalls können Lösemittel oder Schmelzhilfen zugesetzt werden. Geeignete Lösemittel sind protische oder aprotische Lösemittel, wie aliphatische und / oder aromatische Alkohle (Methanol, Ethanol, iso-Propanol, t-Butanol, etc.), Oligo- und Polyalkohole (Ethylenglykol, 1,2-Propandiol, Glycerin, etc.), Alkoholether (Ethoxyethanol, Diethylenglykol, Triethylenglycol, Polyethylenglykol, etc.), Ether (Di- und Triethylenglykoldimethylether, Diphenylether, etc.), aromatische, heteroaromatische und oder aliphatische Kohlenwasserstoffe (Toluol, Xylol, Mesitylen, Chlorbenzol, Pyridin, Lutidin, Chinolin, iso-Chinolin, Tridecan, Hexadecan, etc.), Amide (DMF, DMAC, etc.), Lactame (NMP), Sulfoxide (DMOS) oder Sulfone (Dimethylsulfon, Sulfolan, etc.). Geeignete Schmelzhilfen sind Verbindungen, die bei Rautemperatur fest vorliegen, jedoch beim Erwäremen der Reaktionsmischung schmelzen und die Reaktanden lösen, so dass eine homogene Schmelze entsteht. Besonders geeignet sind Biphenyl, m-Terphenyl, Triphenylen, 1,2-, 1,3-, 1,4-Bis-phenoxybenzol, Triphenylphosphinoxid, 18-Krone-6, Phenol, 1-Naphthol, Hydrochinon, etc..

Durch diese Verfahren, gegebenenfalls gefolgt von Aufreinigung, wie z. B. Umkristallisation oder Sublimation, lassen sich die erfindungsgemäßen Verbindungen gemäß Formel (1) in hoher Reinheit, bevorzugt mehr als 99 % (bestimmt mittels ¹H-NMR und/oder HPLC) erhalten.

Die erfindungsgemäßen Verbindungen können auch durch geeignete Substitution, beispielsweise durch längere Alkylgruppen (ca. 4 bis 20 C-Atome), insbesondere verzweigte Alkylgruppen, oder gegebenenfalls substituierte Arylgruppen, beispielsweise Xylyl-, Mesityl- oder verzweigte Terphenyl- oder Quaterphenylgruppen, löslich gemacht werden. Solche Verbindungen sind dann in gängigen organischen Lösemitteln, wie beispielsweise Toluol oder Xylol bei Raumtemperatur in ausreichender Konzentration löslich, um die Komplexe aus Lösung verarbeiten zu können. Diese löslichen Verbindungen eignen sich besonders gut für die Verarbeitung aus Lösung, beispielsweise durch Druckverfahren.

Die erfindungsgemäßen Verbindungen können auch mit einem Polymer gemischt werden. Ebenso ist es möglich, diese Verbindungen kovalent in ein Polymer einzubauen. Dies ist insbesondere möglich mit Verbindungen, welche mit reaktiven Abgangsgruppen, wie Brom, Iod, Chlor, Boronsäure oder Boronsäureester, oder mit reaktiven, polymerisierbaren Gruppen, wie Olefinen oder Oxetanen, substituiert sind. Diese können als Monomere zur Erzeugung entsprechender Oligomere, Dendrimere oder Polymere Verwendung finden. Die Oligomerisation bzw. Polymerisation erfolgt dabei bevorzugt über die Halogenfunktionalität bzw. die Boronsäurefunktionalität bzw. über die polymerisierbare Gruppe. Es ist weiterhin möglich, die Polymere über derartige Gruppen zu vernetzen. Die erfindungsgemäßen Verbindungen und Polymere können als vernetzte oder unvernetzte Schicht eingesetzt werden.

Weiterer Gegenstand der Erfindung sind daher Oligomere, Polymere oder Dendrimere enthaltend eine oder mehrere der oben aufgeführten erfindungsgemäßen Verbindungen, wobei ein oder mehrere Bindungen der erfindungsgemäßen Verbindung zum Polymer, Oligomer oder Dendrimer vorhanden sind. Je nach Verknüpfung der erfindungsgemäßen Verbindung bildet diese daher eine Seitenkette des Oligomers oder Polymers oder ist in der Hauptkette verknüpft. Die Polymere, Oligomere oder Dendrimere können konjugiert, teilkonjugiert oder nicht-konjugiert sein. Die Oligomere oder Polymere können linear, verzweigt oder dendritisch sein. Für die Wiederholeinheiten der erfindungsgemäßen Verbindungen in Oligomeren, Dendrimeren und Polymeren gelten dieselben Bevorzugungen, wie oben beschrieben.

Zur Herstellung der Oligomere oder Polymere werden die erfindungsgemäßen Monomere homopolymerisiert oder mit weiteren Monomeren copolymerisiert. Bevorzugt sind Copolymere, wobei die Einheiten gemäß Formel (1) bzw. die oben ausgeführten bevorzugten Ausführungsformen zu 0.01 bis 99.9 mol%, bevorzugt 5 bis 90 mol%, besonders bevorzugt 20 bis 80 mol% vorhanden sind. Geeignete und bevorzugte Comonomere, welche das Polymergrundgerüst bilden, sind gewählt aus Fluorenen (z. B. gemäß EP 842208 oder WO 2000/022026), Spirobifluorenen (z. B. gemäß EP 707020, EP 894107 oder WO 2006/061181), Para-phenylenen (z. B. gemäß WO 92/18552), Carbazolen (z. B. gemäß WO 2004/070772 oder WO 2004/113468), Thiophenen (z. B. gemäß EP 1028136), Dihydrophenanthrenen (z. B. gemäß WO 2005/014689), cis- und trans-Indenofluorenen (z. B. gemäß WO 2004/041901 oder WO 2004/113412), Ketonen (z. B. gemäß WO 2005/040302), Phenanthrenen (z. B. gemäß WO 2005/104264 oder WO 2007/017066) oder auch mehreren dieser Einheiten. Die Polymere, Oligomere und Dendrimere können noch weitere Einheiten enthalten, beispielsweise Lochtransporteinheiten, insbesondere solche basierend auf Triarylaminen, und/oder Elektronentransporteinheiten.

Für die Verarbeitung der erfindungsgemäßen Verbindungen aus flüssiger Phase, beispielsweise durch Spin-Coating oder durch Druckverfahren, sind Formulierungen der erfindungsgemäßen Verbindungen erforderlich. Diese Formulierungen können beispielsweise Lösungen, Dispersionen oder Emulsionen sein. Es kann bevorzugt sein, hierfür Mischungen aus zwei oder mehr Lösemitteln zu verwenden. Geeignete und bevorzugte Lösemittel sind beispielsweise Toluol, Anisol, o-, m- oder p-Xylol, Methylbenzoat, Mesitylen, Tetralin, Veratrol, THF, Methyl-THF, THP, Chlorbenzol, Dioxan, Phenoxytoluol, insbesondere 3-Phenoxytoluol, (-)-Fenchon, 1,2,3,5-Tetramethylbenzol, 1,2,4,5-Tetramethylbenzol, 1-Methylnaphthalin, 2-Methylbenzothiazol, 2-Phenoxyethanol, 2-Pyrrolidinon, 3-Methylanisol, 4-Methylanisol, 3,4-Dimethylanisol, 3,5-Dimethylanisol, Acetophenon, α-Terpineol, Benzothiazol, Butylbenzoat, Cumol, Cyclohexanol, Cyclohexanon, Cyclohexylbenzol, Decalin, Dodecylbenzol, Ethylbenzoat, Indan, Methylbenzoat, NMP, p-Cymol, Phenetol, 1,4-Diisopropylbenzol, Dibenzylether, Diethylenglycolbutylmethylether, Triethylenglycolbutylmethylether, Diethylenglycoldibutylether, Triethylenglycoldimethylether, Diethylenglycolmonobutylether, Tripropyleneglycoldimethylether, Tetraethylenglycoldimethylether, 2-Isopropylnaphthalin, Pentylbenzol, Hexylbenzol, Heptylbenzol, Octylbenzol, 1,1-Bis(3,4-dimethylphenyl)ethan oder Mischungen dieser Lösemittel.

Ein weiterer Gegenstand der vorliegenden Erfindung ist daher eine Formulierung, enthaltend mindestens eine erfindungsgemäße Verbindung bzw. mindestens ein erfindungsgemäßes Oligomer, Polymer oder Dendrimer und mindestens eine weitere Verbindung. Die weitere Verbindung kann beispielsweise ein Lösemittel sein, insbesondere eines der oben genannten Lösemittel oder eine Mischung dieser Lösemittel. Die weitere Verbindung kann aber auch eine weitere organische oder anorganische Verbindung sein, die ebenfalls in der elektronischen Vorrichtung eingesetzt wird, beispielsweise ein Matrixmaterial. Diese weitere Verbindung kann auch polymer sein.

Die oben beschriebenen Verbindungen gemäß Formel (1) bzw. die oben aufgeführten bevorzugten Ausführungsformen können in der elektronischen Vorrichtung als aktive Komponente verwendet werden. Ein weiterer Gegenstand der vorliegenden Erfindung ist somit die Verwendung einer erfindungsgemäßen Verbindung in einer elektronischen Vorrichtung. Nochmals ein weiterer Gegenstand der vorliegenden Erfindung ist eine elektronische Vorrichtung enthaltend mindestens eine erfindungsgemäße Verbindung.

Unter einer elektronischen Vorrichtung wird eine Vorrichtung verstanden, welche Anode, Kathode und mindestens eine Schicht enthält, wobei diese Schicht mindestens eine organische bzw. metallorganische Verbindung enthält. Die erfindungsgemäße elektronische Vorrichtung enthält also Anode, Kathode und mindestens eine Schicht, welche mindestens eine Verbindung der oben aufgeführten Formel (1) enthält. Dabei sind bevorzugte elektronische Vorrichtungen ausgewählt aus der Gruppe bestehend aus organischen Elektrolumineszenzvorrichtungen (OLEDs, PLEDs), organischen integrierten Schaltungen (O-ICs), organischen Feld-Effekt-Transistoren (O-FETs), organischen Dünnfilmtransistoren (O-TFTs), organischen lichtemittierenden Transistoren (O-LETs), organischen Solarzellen (O-SCs), organischen optischen Detektoren, organischen Photorezeptoren, organischen Feld-Quench-Devices (O-FQDs), lichtemittierenden elektrochemischen Zellen (LECs) oder organischen Laserdioden (O-Laser), enthaltend in mindestens einer Schicht mindestens eine Verbindung gemäß der oben aufgeführten Formel (1). Besonders bevorzugt sind organische Elektrolumineszenzvorrichtungen. Aktive Komponenten sind generell die organischen oder anorganischen Materialien, welche zwischen Anode und Kathode eingebracht sind, beispielsweise Ladungsinjektions-, Ladungstransport- oder Ladungsblockiermaterialien, insbesondere aber Emissionsmaterialien und Matrixmaterialien. Die erfindungsgemäßen Verbindungen zeigen besonders gute Eigenschaften als Emissionsmaterial in organischen Elektrolumineszenzvorrichtungen. Eine bevorzugte Ausführungsform der Erfindung sind daher organische Elektrolumineszenzvorrichtungen. Weiterhin können die erfindungsgemäßen Verbindungen zur Erzeugung von Singulett-Sauerstoff oder in der Photokatalyse eingesetzt werden.

Die organische Elektrolumineszenzvorrichtung enthält Kathode, Anode und mindestens eine emittierende Schicht. Außer diesen Schichten kann sie noch weitere Schichten enthalten, beispielsweise jeweils eine oder mehrere Lochinjektionsschichten, Lochtransportschichten, Lochblockierschichten, Elektronentransportschichten, Elektroneninjektionsschichten, Exzitonenblockierschichten, Elektronenblockierschichten, Ladungserzeugungsschichten und/oder organische oder anorganische p/n-Übergänge. Dabei ist es möglich, dass eine oder mehrere Lochtransportschichten p-dotiert sind, beispielsweise mit Metalloxiden, wie MoO₃ oder WO₃ oder mit (per)fluorierten elektronenarmen Aromaten, und/oder dass eine oder mehrere Elektronentransportschichten n-dotiert sind. Ebenso können zwischen zwei emittierende Schichten Interlayers eingebracht sein, welche beispielsweise eine Exzitonen-blockierende Funktion aufweisen und/oder die Ladungsbalance in der Elektrolumineszenzvorrichtung steuern. Es sei aber darauf hingewiesen, dass nicht notwendigerweise jede dieser Schichten vorhanden sein muss.

Dabei kann die organische Elektrolumineszenzvorrichtung eine emittierende Schicht enthalten, oder sie kann mehrere emittierende Schichten enthalten. Wenn mehrere Emissionsschichten vorhanden sind, weisen diese bevorzugt insgesamt mehrere Emissionsmaxima zwischen 380 nm und 750 nm auf, so dass insgesamt weiße Emission resultiert, d. h. in den emittierenden Schichten werden verschiedene emittierende Verbindungen verwendet, die fluoreszieren oder phosphoreszieren können. Insbesondere bevorzugt sind Dreischichtsysteme, wobei die drei Schichten blaue, grüne und orange oder rote Emission zeigen (für den prinzipiellen Aufbau siehe z. B. WO 2005/011013) bzw. Systeme, welche mehr als drei emittierende Schichten aufweisen. Es kann sich auch um ein Hybrid-System handeln, wobei eine oder mehrere Schichten fluoreszieren und eine oder mehrere andere Schichten phosphoreszieren.

In einer bevorzugten Ausführungsform der Erfindung enthält die organische Elektrolumineszenzvorrichtung die Verbindung gemäß Formel (1) bzw. die oben aufgeführten bevorzugten Ausführungsformen als emittierende Verbindung in einer oder mehreren emittierenden Schichten.

Wenn die Verbindung gemäß Formel (1) als emittierende Verbindung in einer emittierenden Schicht eingesetzt wird, wird sie bevorzugt in Kombination mit einem oder mehreren Matrixmaterialien eingesetzt. Die Mischung aus der Verbindung gemäß Formel (1) und dem Matrixmaterial enthält zwischen 0.1 und 99 Vol.-%, vorzugsweise zwischen 1 und 90 Vol.-%, besonders bevorzugt zwischen 3 und 40 Vol.-%, insbesondere zwischen 5 und 15 Vol.-% der Verbindung gemäß Formel (1) bezogen auf die Gesamtmischung aus Emitter und Matrixmaterial. Entsprechend enthält die Mischung zwischen 99.9 und 1 Vol.-%, vorzugsweise zwischen 99 und 10 Vol.-%, besonders bevorzugt zwischen 97 und 60 Vol.-%, insbesondere zwischen 95 und 85 Vol.-% des Matrixmaterials bezogen auf die Gesamtmischung aus Emitter und Matrixmaterial.

Als Matrixmaterial können generell alle Materialien eingesetzt werden, die gemäß dem Stand der Technik hierfür bekannt sind. Bevorzugt ist das Triplett-Niveau des Matrixmaterials höher als das Triplett-Niveau des Emitters.

Geeignete Matrixmaterialien für die erfindungsgemäßen Verbindungen sind Ketone, Phosphinoxide, Sulfoxide und Sulfone, z. B. gemäß WO 2004/013080, WO 2004/093207, WO 2006/005627 oder WO 2010/006680, Triarylamine, Carbazolderivate, z. B. CBP (N,N-Biscarbazolylbiphenyl), m-CBP oder die in WO 2005/039246, US 2005/0069729, JP 2004/288381, EP 1205527, WO 2008/086851 oder US 2009/0134784 offenbarten Carbazolderivate, Indolocarbazolderivate, z. B. gemäß WO 2007/063754 oder WO 2008/056746, Indenocarbazolderivate, z. B. gemäß WO 2010/136109 oder WO 2011/000455, Azacarbazole, z. B. gemäß EP 1617710, EP 1617711, EP 1731584, JP 2005/347160, bipolare Matrixmaterialien, z. B. gemäß WO 2007/137725, Silane, z. B. gemäß WO 2005/111172, Azaborole oder Boronester, z. B. gemäß WO 2006/117052, Diazasilolderivate, z. B. gemäß WO 2010/054729, Diazaphospholderivate, z. B. gemäß WO 2010/054730, Triazinderivate, z. B. gemäß WO 2010/015306, WO 2007/063754 oder WO 2008/056746, Zinkkomplexe, z. B. gemäß EP 652273 oder WO 2009/062578, Dibenzofuranderivate, z. B. gemäß WO 2009/148015, oder verbrückte Carbazolderivate, z. B. gemäß US 2009/0136779, WO 2010/050778, WO 2011/042107 oder WO 2011/088877.

Es kann auch bevorzugt sein, mehrere verschiedene Matrixmaterialien als Mischung einzusetzen, insbesondere mindestens ein elektronenleitendes Matrixmaterial und mindestens ein lochleitendes Matrixmaterial. Eine bevorzugte Kombination ist beispielsweise die Verwendung eines aromatischen Ketons, eines Triazin-Derivats oder eines Phosphinoxid-Derivats mit einem Triarylamin-Derivat oder einem Carbazol-Derivat als gemischte Matrix für den erfindungsgemäßen Metallkomplex. Ebenso bevorzugt ist die Verwendung einer Mischung aus einem ladungstransportierenden Matrixmaterial und einem elektrisch inerten Matrixmaterial, welches nicht bzw. nicht in wesentlichem Maße am Ladungstransport beteiligt ist, wie z. B. in WO 2010/108579 beschrieben.

Weiterhin bevorzugt ist es, eine Mischung aus zwei oder mehr Triplett-Emittern zusammen mit einer Matrix einzusetzen. Dabei dient der Triplett-Emitter mit dem kürzerwelligen Emissionsspektrum als Co-Matrix für den Triplett-Emitter mit dem längerwelligen Emissionsspektrum. So können beispielsweise die erfindungsgemäßen Komplexe gemäß Formel (1) als Co-Matrix für längerwellig emittierende Triplettemitter, beispielsweise für grün oder rot emittierende Triplettemitter, eingesetzt werden.

Die erfindungsgemäßen Verbindungen lassen sich auch in anderen Funktionen in der elektronischen Vorrichtung einsetzen, beispielsweise als Lochtransportmaterial in einer Lochinjektions- oder -transportschicht, als Ladungserzeugungsmaterial oder als Elektronenblockiermaterial. Ebenso lassen sich die erfindungsgemäßen Komplexe als Matrixmaterial für andere phosphoreszierende Metallkomplexe in einer emittierenden Schicht einsetzen.

Als Kathode sind Metalle mit geringer Austrittsarbeit, Metalllegierungen oder mehrlagige Strukturen aus verschiedenen Metallen bevorzugt, wie beispielsweise Erdalkalimetalle, Alkalimetalle, Hauptgruppenmetalle oder Lanthanoide (z. B. Ca, Ba, Mg, Al, In, Mg, Yb, Sm, etc.). Weiterhin eignen sich Legierungen aus einem Alkali- oder Erdalkalimetall und Silber, beispielsweise eine Legierung aus Magnesium und Silber. Bei mehrlagigen Strukturen können auch zusätzlich zu den genannten Metallen weitere Metalle verwendet werden, die eine relativ hohe Austrittsarbeit aufweisen, wie z. B. Ag, wobei dann in der Regel Kombinationen der Metalle, wie beispielsweise Mg/Ag, Ca/Ag oder Ba/Ag verwendet werden. Es kann auch bevorzugt sein, zwischen einer metallischen Kathode und dem organischen Halbleiter eine dünne Zwischenschicht eines Materials mit einer hohen Dielektrizitätskonstante einzubringen. Hierfür kommen beispielsweise Alkalimetall- oder Erdalkalimetallfluoride, aber auch die entsprechenden Oxide oder Carbonate in Frage (z. B. LiF, Li₂O, BaF₂, MgO, NaF, CsF, Cs₂CO₃, etc.). Ebenso kommen hierfür organische Alkalimetallkomplexe in Frage, z. B. Liq (Lithiumchinolinat). Die Schichtdicke dieser Schicht beträgt bevorzugt zwischen 0.5 und 5 nm.

Als Anode sind Materialien mit hoher Austrittsarbeit bevorzugt. Bevorzugt weist die Anode eine Austrittsarbeit größer 4.5 eV vs. Vakuum auf. Hierfür sind einerseits Metalle mit hohem Redoxpotential geeignet, wie beispielsweise Ag, Pt oder Au. Es können andererseits auch Metall/Metalloxid-Elektroden (z. B. Al/Ni/NiOₓ, Al/PtOₓ) bevorzugt sein. Für einige Anwendungen muss mindestens eine der Elektroden transparent oder teiltransparent sein, um entweder die Bestrahlung des organischen Materials (O-SC) oder die Auskopplung von Licht (OLED/PLED, O-LASER) zu ermöglichen. Bevorzugte Anodenmaterialien sind hier leitfähige gemischte Metalloxide. Besonders bevorzugt sind Indium-Zinn-Oxid (ITO) oder Indium-Zink-Oxid (IZO). Bevorzugt sind weiterhin leitfähige, dotierte organische Materialien, insbesondere leitfähige dotierte Polymere, z. B. PEDOT, PANI oder Derivate dieser Polymere. Bevorzugt ist weiterhin, wenn auf die Anode ein p-dotiertes Lochtransportmaterial als Lochinjektionsschicht aufgebracht wird, wobei sich als p-Dotanden Metalloxide, beispielsweise MoO₃ oder WO₃, oder (per)fluorierte elektronenarme Aromaten eignen. Weitere geeignete p-Dotanden sind HAT-CN (Hexacyano-hexaazatriphenylen) oder die Verbindung NPD9 von Novaled. Eine solche Schicht vereinfacht die Lochinjektion in Materialien mit einem tiefen HOMO, also einem betragsmäßig großen HOMO.

In den weiteren Schichten können generell alle Materialien verwendet werden, wie sie gemäß dem Stand der Technik für die Schichten verwendet werden, und der Fachmann kann ohne erfinderisches Zutun jedes dieser Materialien in einer elektronischen Vorrichtung mit den erfindungsgemäßen Materialien kombinieren.

Die Vorrichtung wird entsprechend (je nach Anwendung) strukturiert, kontaktiert und schließlich hermetisch versiegelt, da sich die Lebensdauer derartiger Vorrichtungen bei Anwesenheit von Wasser und/oder Luft drastisch verkürzt.

Weiterhin bevorzugt ist eine organische Elektrolumineszenzvorrichtung, dadurch gekennzeichnet, dass eine oder mehrere Schichten mit einem Sublimationsverfahren beschichtet werden. Dabei werden die Materialien in Vakuum-Sublimationsanlagen bei einem Anfangsdruck von üblicherweise kleiner 10⁻⁵ mbar, bevorzugt kleiner 10⁻⁶ mbar aufgedampft. Es ist auch möglich, dass der Anfangsdruck noch geringer oder noch höher ist, beispielsweise kleiner 10⁻⁷ mbar.

Bevorzugt ist ebenfalls eine organische Elektrolumineszenzvorrichtung, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen 10⁻⁵ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden (z. B. M. S. Arnold et al., Appl. Phys. Lett. 2008, 92, 053301).

Weiterhin bevorzugt ist eine organische Elektrolumineszenzvorrichtung, dadurch gekennzeichnet, dass eine oder mehrere Schichten aus Lösung, wie z. B. durch Spincoating, oder mit einem beliebigen Druckverfahren, wie z. B. Siebdruck, Flexodruck, Offsetdruck oder Nozzle-Printing, besonders bevorzugt aber LITI (Light Induced Thermal Imaging, Thermotransferdruck) oder Ink-Jet Druck (Tintenstrahldruck), hergestellt werden. Hierfür sind lösliche Verbindungen nötig, welche beispielsweise durch geeignete Substitution erhalten werden.

Die organische Elektrolumineszenzvorrichtung kann auch als Hybrid-system hergestellt werden, indem eine oder mehrere Schichten aus Lösung aufgebracht werden und eine oder mehrere andere Schichten aufgedampft werden. So ist es beispielsweise möglich, eine emittierende Schicht enthaltend eine Verbindung gemäß Formel (1) und ein Matrixmaterial aus Lösung aufzubringen und darauf eine Lochblockierschicht und/oder eine Elektronentransportschicht im Vakuum aufzudampfen.

Diese Verfahren sind dem Fachmann generell bekannt und können von ihm ohne Probleme auf organische Elektrolumineszenzvorrichtungen enthaltend Verbindungen gemäß Formel (1) bzw. die oben aufgeführten bevorzugten Ausführungsformen angewandt werden.

Die erfindungsgemäßen elektronischen Vorrichtungen, insbesondere organische Elektrolumineszenzvorrichtungen; zeichnen sich durch einen oder mehrere der folgenden überraschenden Vorteile gegenüber dem Stand der Technik aus:
1. Die erfindungsgemäßen Metallkomplexe weisen im Vergleich zu analogen Verbindungen, welche keine Struktureinheit gemäß Formel (3) enthalten, eine verringerte Sublimationstemperatur auf. Dies resultiert in deutlichen Vorteilen bei der Aufreinigung der Komplexe sowie bei der Herstellung von vakuumprozessierten Elektrolumineszenzvorrichtungen , da der thermische Stress, dem die Materialien bei der Sublimation ausgesetzt sind, deutlich reduziert wird. Alternativ sind bei Verwendung einer höheren Sublimationstemperatur höhere Sublimationsraten möglich, was einen Vorteil bei der technischen Herstellung der Komplexe darstellt. Dadurch wird für manche tris-ortho-metallierte Metallkomplexe erst die zersetzungsfreie bzw. weitgehend zersetzungsfreie Sublimation ermöglicht, die ansonsten durch die hohe Sublimationstemperatur nicht möglich ist.
2. Die erfindungsgemäßen Metallkomplexe weisen im Vergleich zu analogen Verbindungen, welche keine Struktureinheit gemäß Formel (3) enthalten, eine höhere Löslichkeit auf. So sind viele Verbindungen, die den erfindungsgemäßen Verbindungen ansonsten gleichen, jedoch keine Struktureinheit gemäß Formel (3) enthalten, nur schlecht bzw. in niedriger Konzentration in einer Vielzahl gängiger organischer Lösemittel löslich. Dagegen sind die erfindungsgemäßen Verbindungen in einer Vielzahl gängiger organischer Lösemittel in deutlich höherer Konzentration löslich, wodurch auch die Verarbeitung und Herstellung der Elektrolumineszenzvorrichtungen aus Lösung ermöglicht wird. Eine höhere Löslichkeit stellt weiterhin einen Vorteilung bei der Aufreinigung der Komplexe in der Synthese dar.
3. Die erfindungsgemäßen Metallkomplexe weisen teilweise ein sehr schmales Emissionsspektrum auf, was zu einer hohen Farbreinheit der Emission führt, wie sie insbesondere für Displayanwendungen wünschenswert ist.
4. Organische Elektrolumineszenzvorrichtungen enthaltend Verbindungen gemäß Formel (1) als emittierende Materialien weisen eine sehr gute Lebensdauer auf.
5. Organische Elektrolumineszenzvorrichtungen enthaltend Verbindungen gemäß Formel (1) als emittierende Materialien weisen eine hervorragende Effizienz auf. Insbesondere ist die Effizienz deutlich höher gegenüber analogen Verbindungen, die keine Struktureinheit gemäß Formel (3) enthalten.
6. Die erfindungsgemäßen Verbindungen weisen im Vergleich zu analogen Verbindungen, welche eeine Struktureinheit gemäß Formel (3) enthalten, in der ein oder mehrere Gruppen R³ für Wasserstoff stehen, eine höhere Oxidationsstabilität auf, insbesondere in Lösung.

Diese oben genannten Vorteile gehen nicht mit einer Verschlechterung der weiteren elektronischen Eigenschaften einher.

Die Erfindung wird durch die nachfolgenden Beispiele näher erläutert, ohne sie dadurch einschränken zu wollen. Der Fachmann kann aus den Schilderungen ohne erfinderisches Zutun weitere erfindungsgemäße elektronische Vorrichtungen herstellen und somit die Erfindung im gesamten beanspruchten Bereich ausführen.

### Beispiele:

Die nachfolgenden Synthesen werden, sofern nicht anders angegeben, unter einer Schutzgasatmosphäre in getrockneten Lösungsmitteln durchgeführt. Die Metallkomplexe werden zusätzlich unter Ausschluss von Licht bzw. unter Gelblicht gehandhabt. Die Lösungsmittel und Reagenzien können z. B. von Sigma-ALDRICH bzw. ABCR bezogen werden. Die jeweiligen Angaben in eckigen Klammern bzw. die zu einzelnen Verbindungen angegebenen Nummern beziehen sich auf die CAS-Nummern der literaturbekannten Verbindungen.

### A: Synthese der Synthone S, SP, SH, SB:

### Beispiel SP1: 1,1,3,3-Tetramethyl-indan-5-boronsäure-pinakolester Variante 1:

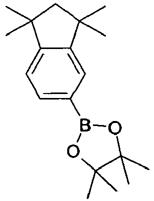

### A) 5-Brom-1,1,3,3-tetramethyl-indan [169695-24-3], SP1-Br

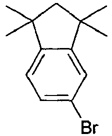

Eine auf 0 °C gekühlte Lösung von 87.2 g (500 mmol) 1,1,3,3-Tetramethyl-indan [4834-33-7] in 1000 ml Dichlormethan wird mit 0.6 g wasserfreiem Eisen(III)chlorid und dann unter Lichtausschluss tropfenweise mit einer Mischung von 25.6 ml (500 mol) Brom und 300 ml Dichlormethan so versetzt, dass die Temperatur + 5 °C nicht übersteigt. Man rührt die Reaktionsmischung 16 h bei Raumtemperatur nach, versetzt dann langsam mit 300 ml gesättigter Natriumsulfit-Lösung, trennt die wässrige Phase ab, wäscht die organische Phase dreimal mit je 1000 ml Wasser, trocknet über Natriumsulfat, filtriert über eine kurze Säule aus Kieselgel und zieht dann das Lösungsmittel ab. Abschießend wird der Feststoff einmal aus wenig (ca. 100 - 150 ml) Ethanol umkristallisiert. Ausbeute: 121.5 g (480 mmol), 96%; Reinheit: ca. 95%ig nach ¹H-NMR.

### B) 1,1,3,3-Tetramethyl-indan-5-boronsäure-pinakolester, SP1

Ein Gemisch von 25.3 g (100 mmol) S4-Br, 25.4 g (120 mmol) Bis(pinacolato)diboran [73183-34-3], 29.5 g (300) mmol Kaliumacetat, wasserfrei, 561 mg (2 mmol) Tricyclohexylphosphin und 249 mg (1 mmol) Palladium-(II)acetat und 400 ml Dioxan wird 16 h bei 80 °C gerührt. Nach Entfernen des Lösungsmittels im Vakuum wird der Rückstand in 500 ml Dichlormethan aufgenommen, über ein Celite-Bett filtriert, das Filtrat wird bis zur beginnenden Kristallisation im Vakuum eingeengt und abschließend noch tropfenweise mit ca. 100 ml Methanol versetzt, um die Kristallisation zu vervollständigen. Ausbeute: 27.9 g (93 mmol), 93%; Reinheit: ca. 95%ig nach ¹H-NMR. Als Öl anfallende Boronsäureester können auch ohne Reinigung weiter umgesetzt werden.

### Variante 2:

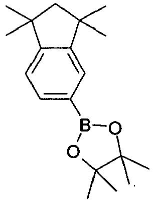

800 ml n-Heptan werden mit 3.3 g (5 mmol) Bis[(1,2,5,6-η)-1,5-cyclooctadien]di-µ-methoxydi-iridium(I) [12148-71-9], dann mit 2.7 g (10 mmol) 4,4'-Di-tert-butyl-[2,2']bipyridinyl [72914-19-3] und dann mit 5.1 g (10 mmol) Bis-(pinkolato)diboran versetzt und 15 min. bei Raumtemperatur gerührt. Anschließend gibt man 127.0 g (500 mmol) Bis(pinacolato)diboran und dann 87.2 g (500 mmol) 1,1,3,3-Tetramethyl-indan [4834-33-7] zu und erwärmt für 12 h auf 80 °C (DC-Kontrolle-Heptan:Ethylacetat 5:1). Nach Erkalten versetzt man die Reaktionsmischung mit 300 ml Ethylacetat, filtriert über ein Kieselgel-Bett ab und engt das Filtrat im Vakuum komplett ein. Das Rohprodukt wird zweimal aus Aceton (ca. 800 ml) umkristallisiert. Ausbeute: 136.6 g (455 mmol), 91%; Reinheit: ca. 99%ig nach ¹H-NMR.

Analog können folgende Verbindungen dargestellt werden:

| Bsp. | Edukt | Bromid | Produkt Boronsäureester Variante | Ausbeute |
|---|---|---|---|---|
| SP2 | 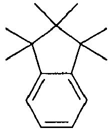 | 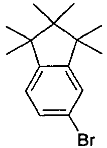 | 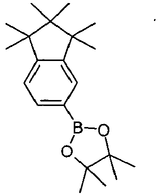 | 80% |
| | 91324-94-6 | SP2-Br | SP2 | |
| | | | 1 | |
| SP2 | 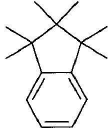 | --- | 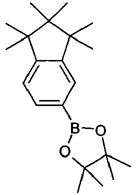 | 95% |
| | 91324-94-6 | | SP2 | |
| | | | 1 | |
| SP3 | 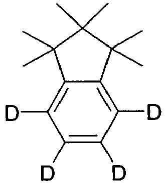 | 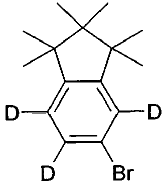 | 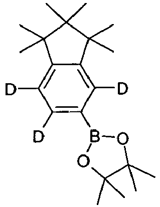 | 81% |
| | 142076-41-3 | SP3-Br | SP3 | |
| | | | 1 | |
| SP4 | 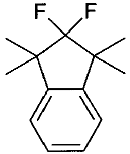 | 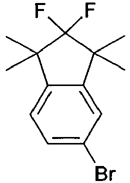 | 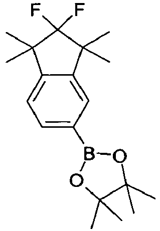 | 78% |
| | 59508-28-0 | SP4-Br | SP4 | |
| | | | 1 | |
| SP5 | 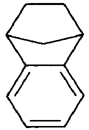 | 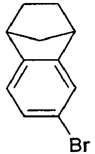 | 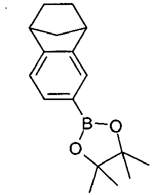 | 80% |
| | 4486-29-7 | 16499-72-2 | SP5 | |
| | | SP5-Br | 1 | |
| SP6 | 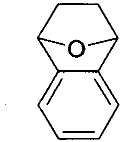 | 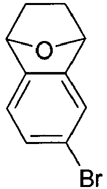 | 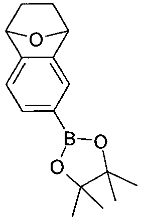 | 82% |
| | 35185-96-7 | SP6-Br | SP6 | |
| | | | 1 | |
| SP7 | 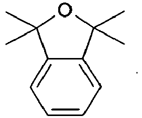 | 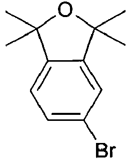 | 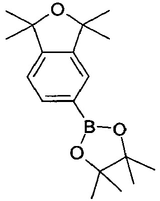 | 79% |
| | 113710-83-1 | SP7-Br | SP7 | |
| | | | 1 | |
| SP7 | 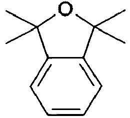 | | 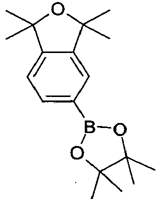 | 89% |
| | 113710-83-1 | --- | SP7 | |
| | | | 2 | |
| SH1 | 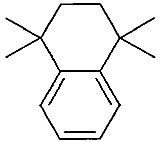 | 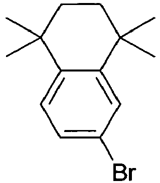 | 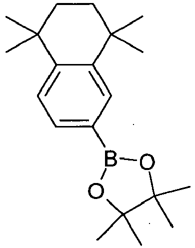 | 74% |
| | 6683-46-1 | SH1-Br 27452-17-1 | SH1 | |
| | | | 1 | |
| SH1 | 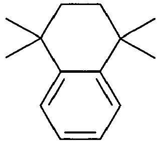 | --- | 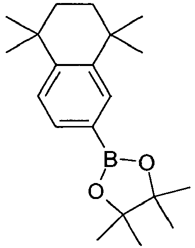 | 92% |
| | 6683-46-1 | | 2 | |
| | | | SH1 | |
| SB1 | 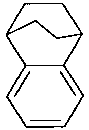 | 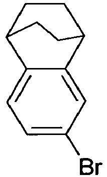 | 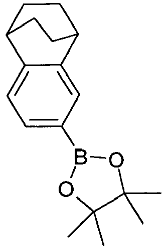 | 80% |
| | 4175-52-4 | SB1-Br | SB1 | |
| | | | 1 | |
| SB1 | 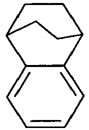 | --- | 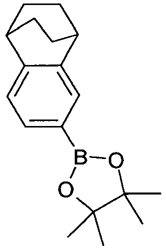 | 93% |
| | 4175-52-4 | | SB1 | |
| | | | 2 | |
| SB2 | 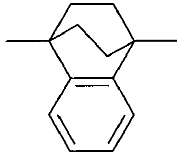 | 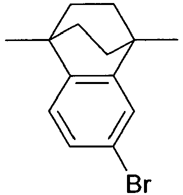 | 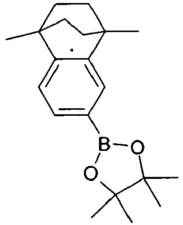 | 81% |
| | 2716-23-6 | SB2-Br | SB2 | |
| | | | 1 | |
| SB2 | 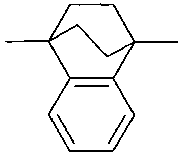 | --- | 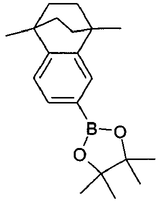 | 90% |
| | 2716-23-6 | | SB2 | |
| | | | 2 | |
| SB3 | 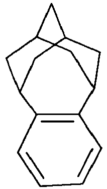 | 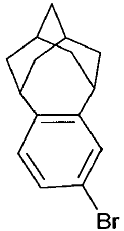 | 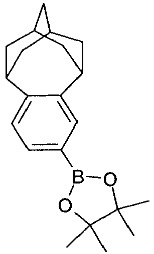 | 74% |
| | 60749-53-3 | SB3-Br | SB3 | |
| | | | 1 | |
| SB3 | 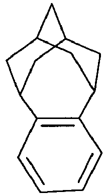 | --- | 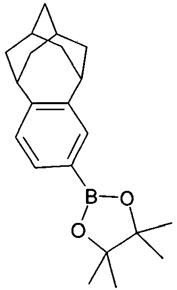 | 94% |
| | 60749-53-3 | | SB3 | |
| | | | 2 | |
| SH17 | 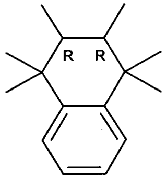 | --- | 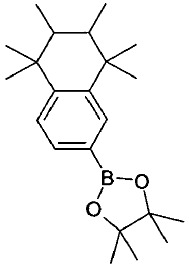 | 84% |
| | 853763-39-0 | | SH17 | |
| | | | 2 | |
| SH18 | 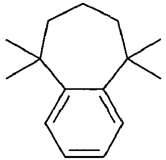 | --- | 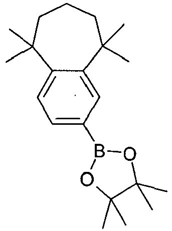 | 90% |
| | 872286-95-8 | | SH18 | |
| | | | 2 | |

### Beispiel SP8: 5,6-Dibrom-1,1,2,2,3,3-hexamethyl-indan

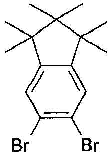

Eine Lösung von 101.2 g (500 mmol) 1,1,2,2,3,3-Hexamethyl-indan [91324-94-6] in 2000 ml Dichlormethan wird mit 1.3 g wasserfreiem Eisen-(III)chlorid und dann unter Lichtausschluss tropfenweise mit einer Mischung von 64.0 ml (1.25 mol) Brom und 300 ml Dichlormethan so versetzt, dass die Temperatur 25 °C nicht übersteigt. Gegebenenfalls wird mit einem Kaltwasserbad gegengekühlt. Man rührt die Reaktionsmischung 16 h bei Raumtemperatur nach, versetzt dann langsam mit 500 ml gesättigter Natriumsulfit-Lösung, trennt die wässrige Phase ab, wäscht die organische Phase dreimal mit je 1000 ml Wasser, trocknet über Natriumsulfat, filtriert über eine kurze Säule aus Kieselgel und zieht dann das Lösungsmittel ab. Abschließend wird der Feststoff einmal aus wenig (ca. 100 ml) Ethanol umkristallisiert. Ausbeute: 135.8 g (377 mmol), 75%; Reinheit: ca. 95%ig nach ¹H NMR.

Analog werden folgende Verbindungen dargestellt:

| Bsp. | Edukte | Produkt | Ausbeute |
|---|---|---|---|
| SP9 | 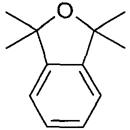 | 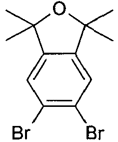 | 80% |
| | 113710-83-1 | SP9 | |
| SH2 | 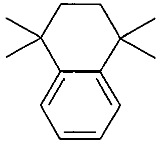 | 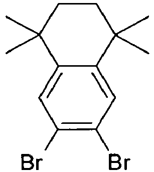 | 76% |
| | 6683-46-1 | 184885-74-3 | |
| | | SH2 | |
| SB4 | 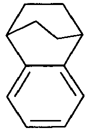 | 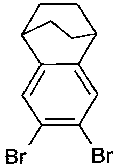 | 69% |
| | 4175-52-4 | SB4 | |
| SB5 | 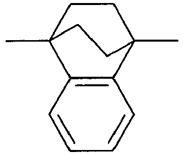 | 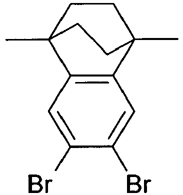 | 72% |
| | 2716-23-6 | SB5 | |
| SB6 | 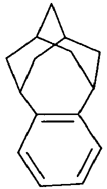 | 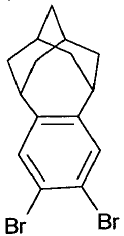 | 78% |
| | 60749-53-3 | SB6 | |

### Beispiel SP10: 5,6-Diamino-1,1,2,2,3,3-hexamethyl-indan

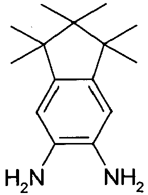

### A: 5,6-Dinitro-1,1,2,2,3,3-tetramethyl-indan, SP10a

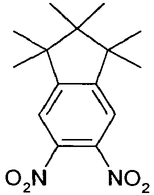

Zu einer gut gerührten, auf 0° C gekühlten Mischung aus 101.2 g (500 mmol) 1,1,2,2,3,3-Hexamethyl-indan [91324-94-6] und 350 ml 95 Gew.-%iger Schwefelsäure tropft man langsam 350 ml 100 Gew.-%ige Salpetersäure so zu, dass die Temperatur + 5° C nicht übersteigt. Anschließend lässt man während 2 - 3 h langsam auf Raumtemperatur erwärmen und gießt die Reaktionsmischung dann in ein gut gerührtes Gemisch aus 6 kg Eis und 2 kg Wasser. Man stellt durch Zugabe von 40 Gew.-%iger NaOH auf pH = 8-9 ein, extrahiert dreimal mit je 1000 ml Ethylacetat, wäscht die vereinigten organischen Phasen zweimal mit je 1000 ml Wasser, trocknet über Magnesiumsulfat, entfernt dann das Ethylacetat im Vakuum fast vollständig bis zur beginnenden Kristallisation und vervollständigt die Kristallisation durch Zusatz von 500 ml n-Heptan. Man saugt von den so erhaltenen beigefarbenen Kristallen ab und trocknet diese im Vakuum. Ausbeute: 136.2 g (466 mmol), 93%; Reinheit: ca. 94%ig nach ¹H-NMR.

### B: 5,6-Diamino-1,1,2,2,3,3-hexamethyl-indan, SP10

136.2 g (466 mmol) 5,6-Dinitro-1,1,2,2,3,3-hexamethyl-indan, SP10a werden bei Raumtemperatur in 1200 ml Ethanol an 10 g Palladium/Kohle bei 3 bar Wasserstoffdruck während 24 h hydriert. Die Reaktionsmischung wird zweimal über ein Celite-Bett filtriert, der nach Entferen des Ethanols erhaltene braune Feststoff wird Kugelrohr-destilliert (T ca. 160 °C, p ca. 10⁻⁴ mbar). Ausbeute: 98.5 g (424 mmol), 91%; Reinheit: ca. 95% nach ¹H-NMR.

Analog werdem folgende Verbindungen dargestellt:

| Bsp. | Edukte | Produkt | Ausbeute |
|---|---|---|---|
| SP11 | 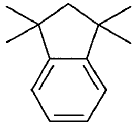 | 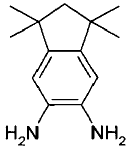 | 84% |
| | 4834-33-7 | SP11 | |
| SP12 | 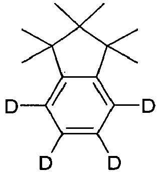 | 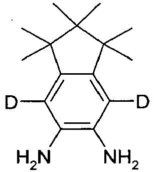 | 76% |
| | 142076-41-3 | SP11 | |
| SH3 | 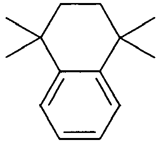 | 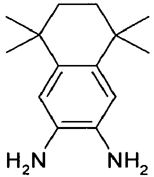 | 75% |
| | 6683-46-1 | SH3 | |
| SB7 | 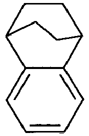 | 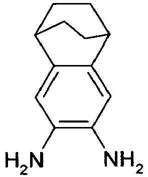 | 72% |
| | 4175-52-4 | SB7 | |
| SB8 | 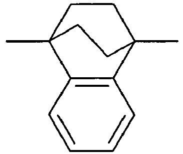 | 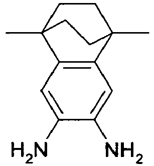 | 70% |
| | 2716-23-6 | SB8 | |
| SB9 | 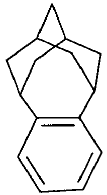 | 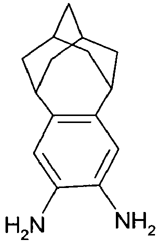 | 74% |
| | 60749-53-3 | SB9 | |

### Beispiel SP13: N-[2-(1,1,2,2,3,3-Hexamethylindan-5-yl)-ethyl]-benzamid

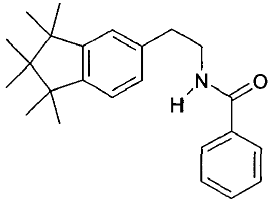

### A: 1,1,2,2,3,3-Hexamethylindan-5-carboxaldehyd, SP13a

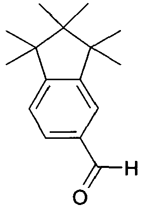

Eine auf -78 °C gekülte, gut gerührte Lösung von 140.6 g (500 mmol) 5-Brom-1,1,2,2,3,3-hexamethylindan, SP2-Br, in 1000 ml THF wird tropfenweise so mit 200 ml (500 mmol) n-BuLi, 2.5 M in n-Hexan versetzt, dass die Tempertur -55 °C nicht übersteigt. Nach beendeter Zugabe rührt man noch 30 min. nach und lässt dann eine Mischung aus 42.3 ml (550 mmol) DMF und 50 ml THF unter gutem Rühren zulaufen. Man rührt 1 h bei -78 °C nach, lässt dann auf Raumtemperatur erwärmen und quencht durch Zugabe von 300 ml gesättigter Ammoniumchlorid-Lösung. Man trennt die organische Phase ab, entfernt das THF im Vakuum, nimmt den Rückstand in 500 ml Ethylacetat auf, wäscht einmal mit 300 ml 5%iger Salzsäure, zweimal mit je 300 ml Wasser, einmal mit 300 ml gesättigter Kochsalzlösung, trocknet die organische Phase über Magnesiumsulfat und entfernt dann das Lösungsmittel im Vakuum. Der Rückstand wird ohne weitere Reinigung in Stufe B eingesetzt. Ausbeute: 107.1 g (465 mmol), 93%; Reinheit: ca. 95% nach ¹H-NMR.

Analog können folgende Verbindungen dargestellt werden:

| Bsp. | Edukt | Produkt | Ausbeute |
|---|---|---|---|
| SP14a | 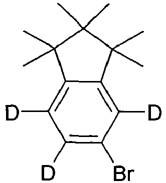 | 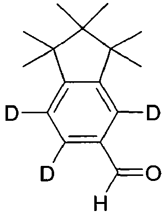 | 91% |
| | SP3-Br | SP14a | |
| SH4a | 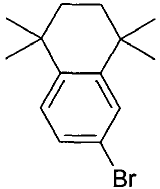 | 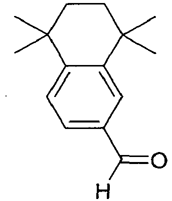 | 89% |
| | SH1-Br | SH4a | |
| SB10a | 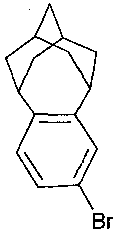 | 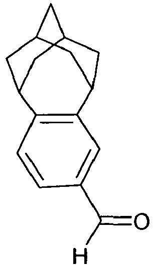 | 88% |
| | SB3-Br | SB10a | |

### B: 2-(1,1,2,2,3,3-Hexamethyl-5-indanyl)-ethylamin, SP13b

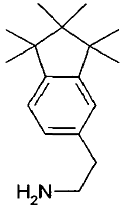

Ein Gemisch aus 80.6 g (350 mmol) 1,1,2,2,3,3-Hexamethylindan-5-carboxaldehyd, SP13a, 400 ml Nitromethan und 4.6 g (70 mmol) Ammoniumacetat, wasserfrei wird 2 h unter Rückfluss erhitzt, bis das Edukt verbraucht ist (DC-Kontrolle). Nach Erkalten gießt man die Reaktionsmischung in 1000 ml Wasser, extrahiert dreimal mit je 300 ml Dichlormethan, wäscht die vereinigten organischen Phasen dreimal mit gesättigter Natriumhydrogencarbonat-Lösung, dreimal mit je 300 ml Wasser und einmal mit 300 ml gesätigter Kochsalzlösung, trocknet über Magnesiumsulfat und entfernt das Lösungsmittel im Vakuum. Der dunkle ölige Rückstand wird in 1000 ml THF gelöst und unter Eiskühlung langsam zu einer Lösung von 38.0 g (1.0 mol) Lithiumaluminiumhydrid in 1000 ml THF getropft (Vorsicht: Exotherme Reaktion!). Nach beendeter Zugabe lässt man auf Raumtemperatur erwärmen und rührt die Reaktionsmischung 20 h bei Raumtemperatur nach. Die Reaktionsmischung wird unter Eiskühlung durch langsame Zugabe von 500 ml gesättigter Natriumsulfat-Lösung hydrolysiert. Man saugt von den Salzen ab, wäscht diese mit 500 ml THF nach, entfernt das THF im Vakuum, nimmt den Rückstand in 1000 ml Dichlormethan auf, wäscht die Lösung dreimal mit je 300 ml Wasser, einmal mit 300 ml gesättigter Kochsalzlösung, trocknet über Magnesiumsulfat und entfernt dann das Lösungsmittel im Vakuum. Die Reinigung erfolgt durch Kugelrohrdestillation (p ca. 10⁻⁴ mbar, T = 200 °C). Ausbeute: 67.0 g (273 mmol), 78%; Reinheit: ca. 95% nach ¹H-NMR.

Analog können folgende Verbindungen dargestellt werden:

| Bsp. | Edukt | Produkt | Ausbeute |
|---|---|---|---|
| SP14b | 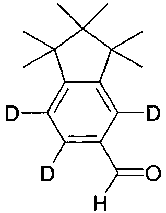 | 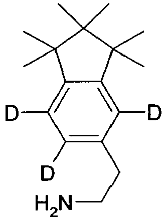 | 74% |
| | S14a | S14b | |
| SH4b | 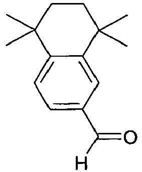 | 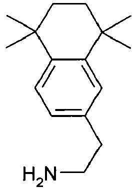 | 70% |
| | SH4a | SH4b | |
| SB10b | 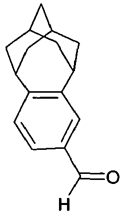 | 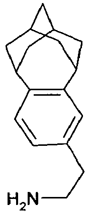 | 72% |
| | SB10a | SB10b | |

### C: N-[2-(1,1,2,2,3,3-Hexamethylindan-5-yl)-ethyl]-benzamid, SP13

Eine Mischung von 24.5 g (100 mmol) 2-(1,1,2,2,3,3-Hexamethyl-5-indanyl)-ethylamin, SP13b, 14.1 ml (100 mmol) Triethylamin und 150 ml Dichlormethan wird bei 0 °C mit einer Lösung von 14.1 g (100 mmol) Benzoesäurechlorid [98-88-4] in 100 ml Dichlormethan unter gutem Rühren tropfenweise so versetzt, dass die Temperatur 30 °C nicht übersteigt. Anschließend wird 1 h bei Raumtemperatur nachgerührt. Das Dichlormethan wird im Vakuum entfernt, der farblose Feststoff wird mit 100 ml Methanol versetzt, abgesaugt, dreimal mit 50 ml Methanol gewaschen und im Vakuum getrocknet. Ausbeute: 31.1 g (89 mmol), 89%; Reinheit: ca. 98% nach ¹H-NMR.

Analog können folgende Verbindungen dargestellt werden:

| Bsp. | Edukt | Carbonsäurechlorid | Produkt | Ausbeute |
|---|---|---|---|---|
| SP14 | 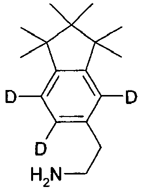 | 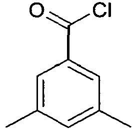 | 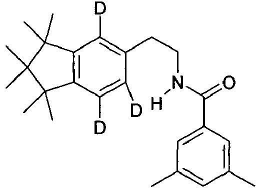 | 74% |
| | SP14b | 6613-441 | SP14 | |
| SP15 | 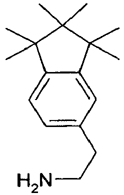 | 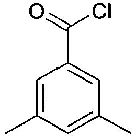 | 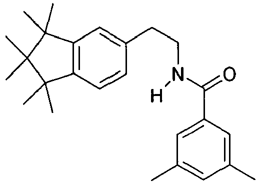 | 86% |
| | SP13b | 6613-441 | SP15 | |
| SP16 | 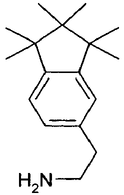 | 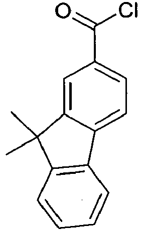 | 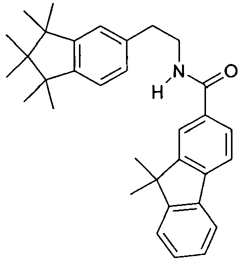 | 88% |
| | SP13b | 765314-57-6 | SP16 | |
| SP17 | 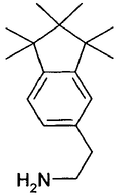 | 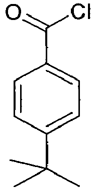 | 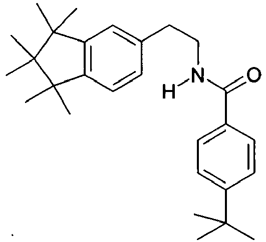 | 83% |
| | SP13b | 1710-98-1 | SP17 | |
| SP18 | 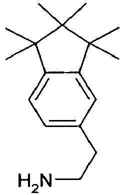 | 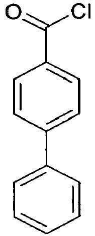 | 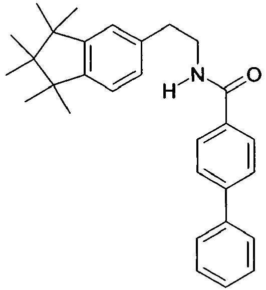 | 80% |
| | SP13b | 14002-51-8 | SP18 | |
| SH4 | 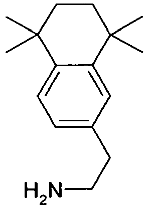 | 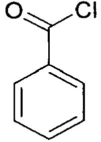 | 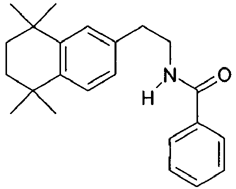 | 70% |
| | SH4b | 98-88-4 | SH4 | |
| SH5 | 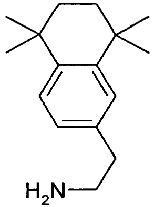 | 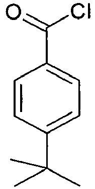 | 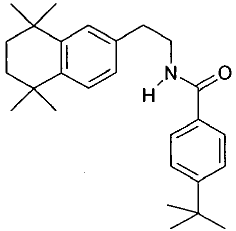 | 76% |
| | SH4b | 1710-98-1 | SH5 | |
| SH6 | 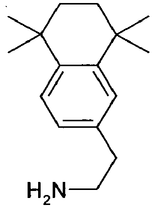 | 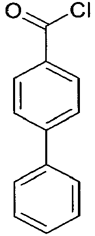 | 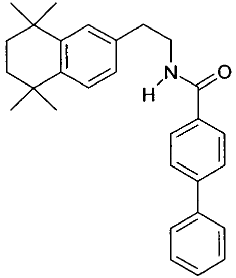 | 73% |
| | SH4b | 14002-51-8 | SH6 | |
| SH7 | 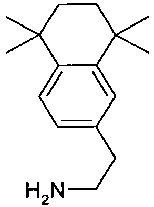 | 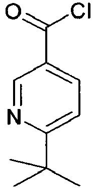 | 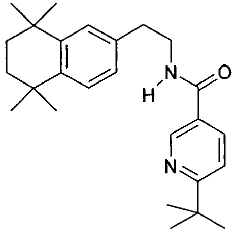 | 74% |
| | SH4b | 1005786-37-7 | SH7 | |
| SH8 | 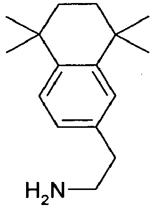 | 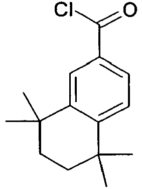 | 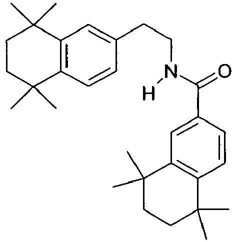 | 72% |
| | SH4b | 104224-50-2 | SH8 | |
| SH9 | 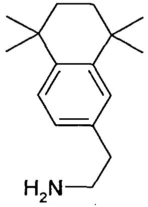 | 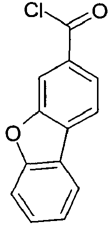 | 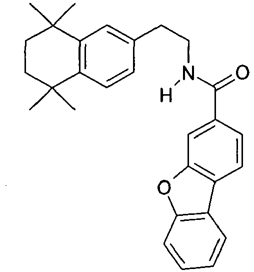 | 72% |
| | SH4b | 104224-50-2 | SH9 | |
| SH10 | 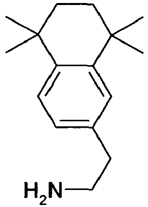 | 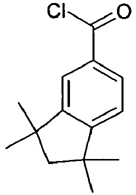 | 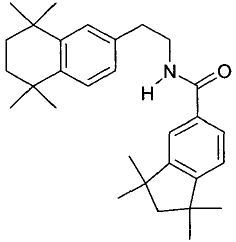 | 76% |
| | SH4b | 100793-48-4 | SH10 | |
| SB10 | 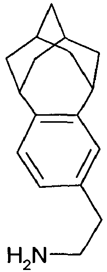 | 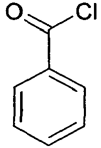 | 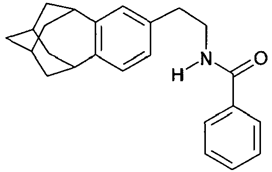 | 82% |
| | SB10b | 98-88-4 | SB10 | |

### Beispiel SP19: 7-Brom-1,2,3,4-tetrahydro-1,4-methano-naphthalin-6-carbaldehyd

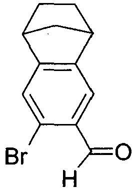

Durchführung analog L. S. Chen et al., J. Organomet. Chem. 1980, 193, 283-292. Eine auf-110 °C gekühlte Lösung von 30.2 g (100 mmol) 6,7-Dibrom-1,2,3,4-tetrahydro-1,4-methano-naphthalin [42810-32-2] in einem Gemisch aus 1000 ml THF und 1000 ml Diethylether wird so mit 40 ml (100 mmol) n-BuLi, 2.5 M in Hexan, vorgekühlt auf-110 °C, versetzt, dass die Temperatur -105 °C nicht übersteigt. Man rührt 30 min. nach, versetzt dann trofenweise mit einem auf °C vorgekühlten Gemisch aus 9.2 ml (120 mmol) DMF und 100 ml Diethylether, rührt dann 2 h nach, lässt auf -10 °C erwärmen, fügt 1000 ml 2 N HCl zu und rührt 2 h bei Raumtemperatur nach. Man trennt die organische Phase ab, wäscht diese einmal mit 500 ml Wasser, einmal mit 500 ml gesättigter Kochsalzlösung, trocknet über Magnesiumsulfat, entfernt das Lösungsmittel im Vakuum und unterwirft den Rückstand einer Kugelrohrdestillation (T ca. 90 °C, p ca. 10⁻⁴ mbar). Ausbeute: 15.8 g (63 mmol), 63%; Reinheit: ca. 95% nach ¹H-NMR.

Analog können folgende Verbindungen dargestellt werden:

| Bsp. | Edukte | Produkt | Ausbeute |
|---|---|---|---|
| SP20 | 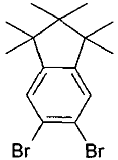 | 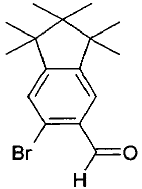 | 68% |
| | SP8 | SP20 | |
| SP21 | 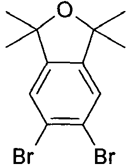 | 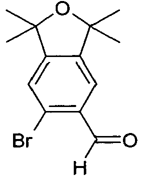 | 60% |
| | SP9 | SP21 | |
| SH11 | 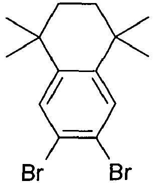 | 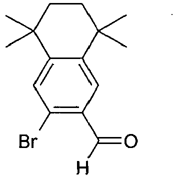 | 60% |
| | SH2 | SH11 | |
| SB11 | 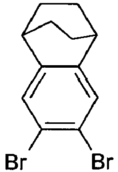 | 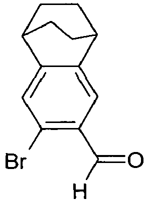 | 55% |
| | SB4 | SB11 | |
| SB12 | 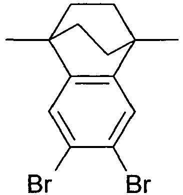 | 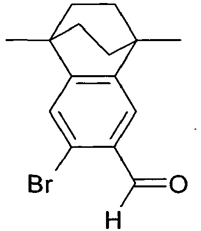 | 50% |
| | SB5 | SB12 | |
| SB13 | 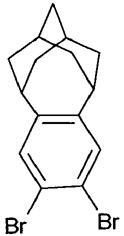 | 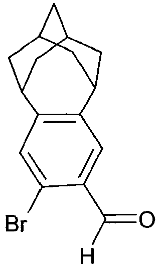 | 53% |
| | SB6 | SB13 | |

### Beispiel SP22: 7-Phenyl-ethynyl-1,2,3,4-tetrahydro-1,4-methanonaphthalin-6-carbaldehyd

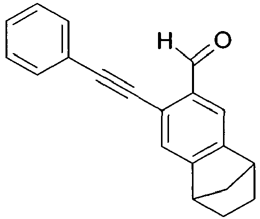

Eine Lösung von 25.1 g (100 mmol) 7-Brom-1,2,3,4-tetrahydro-1,4-methano-naphthalin-6-carbaldehyd, SP19 in einem Gemisch aus 200 ml DMF und 100 ml Triethylamin wird konsekutiv mit 1.6 g (6 mmol) Triphenylphosphin, 674 mg (3 mmol) Palladium(II)acetat, 571 mg (30 mmol) Kupfer-(I)iodid und 15.3 g (150 mmol) Phenylacetylen [536-74-3] versetzt und 4 h bei 65 °C gerührt. Nach Erkalten wird vom ausgefallenen Triethylammonium-hydrochlorid abgesaugt, dieses wird mit 30 ml DMF nachgewaschen. Das Filtrat wird im Vakuum von den Lösungsmitteln befreit. Der ölige Rückstand wird in 300 ml Ethylacetat aufgenommen, die Lösung wird fünfmal mit je 100 ml Wasser und einmal mit 100 ml gesättigter Kochsalzlösung gewaschen, und die organische Phase wird über Magnesiumsulfat getrocknet. Nach Entfernen des Ethylacetats im Vakuum wird der ölige Rückstand an Kieselgel chromatographiert (n-Heptan:Ethylacetat 99:1). Ausbeute: 19.6 g (72 mmol), 72%; Reinheit: ca. 97% nach ¹H-NMR.

Analog können folgende Derivate dargestellt werden:

| **Bsp.** | **Brom arylaldeyd** | **Alkin** | **Produkt** | **Aus beute** |
|---|---|---|---|---|
| SP23 | 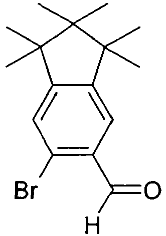 | 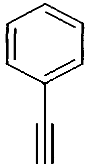 | 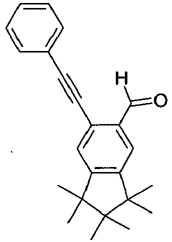 | 69% |
| | SP20 | 536-74-3 | SP23 | |
| SP24 | 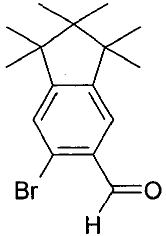 | 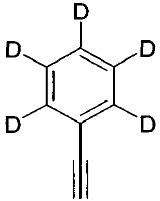 | 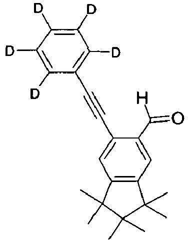 | 69% |
| | SP20 | 25837-46-1 | S24 | |
| SP25 | 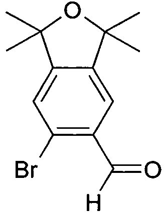 | 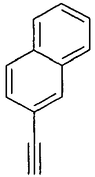 | 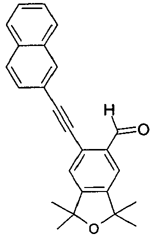 | 70% |
| | SP21 | 2949-26-0 | SP25 | |
| SH12 | 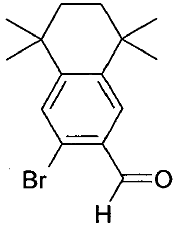 | 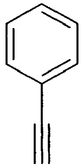 | 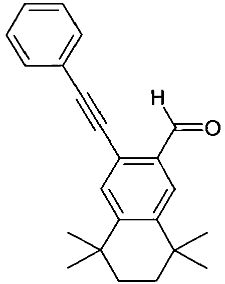 | 66% |
| | SH11 | 536-74-3 | SH12 | |
| SH13 | 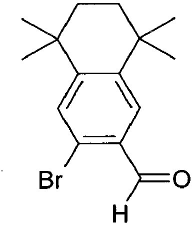 | 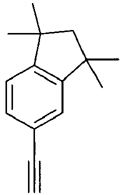 | 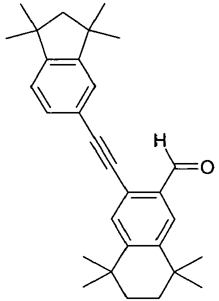 | 67% |
| | SH11 | 188889-51-2 | SH13 | |
| SB14 | 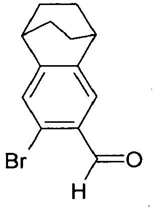 | 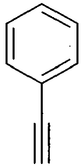 | 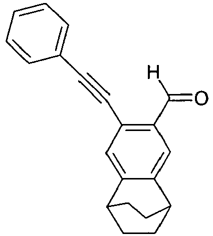 | 61% |
| | SB11 | 536-74-3 | SB14 | |
| SB15 | 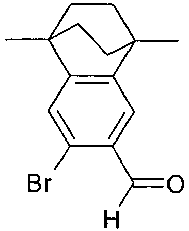 | 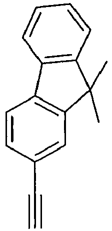 | 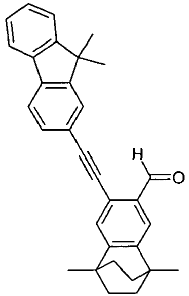 | 63% |
| | SB12 | 876726-86-2 | SB15 | |
| SB16 | 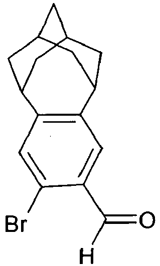 | 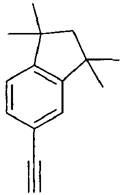 | 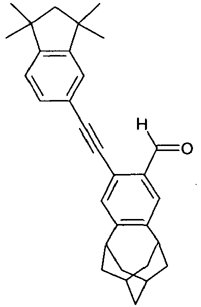 | 73% |
| | SB13 | 188889-51-2 | SB16 | |

### Beispiel SB17:

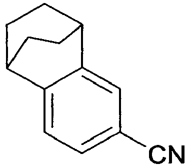

Durchführung analog G. Zhang et al., Ad. Synth. & Catal., 2011, 353(2+3), 291. Ein Gemisch aus 28.4 g (100 mmol) SB1, 9.4 g (105 mmol) Kupfer(I)-cyanid, 41.5 g (300 mmol) Kaliumcarbonat, 100 g Glaskugeln (3 mm Durchmesser) und 400 ml DMF und 3.6 ml Wasser wird 10 h bei 70 °C gerührt. Nach Erkalten entfernt man das DMF weitgehend im Vakuum, verdünnt den Rückstand mit 500 ml Dichlormethan, filtriert von den Salzen über ein Celite-Bett ab, wäscht das Filtrat dreimal mit 200 ml Wasser und einmal mit 100 ml gesättigter Kochsalzlösung und trocknet dann über Magnesiumsulfat. Der nach Entfernen des Dichlormethans verbleibende ölige Rückstand wird Kugelrohr-destilliert. Ausbeute: 11.5g (63 mmol), 63%; Reinheit: ca. 97%ig nach ¹H NMR.

Analog können folgende Verbindungen dargestellt werden:

| Bsp. | Edukt | Produkt | Ausbeute |
|---|---|---|---|
| SP26 | 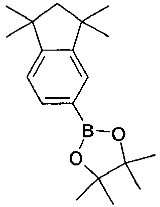 | 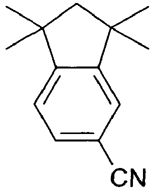 | 58% |
| | SP1 | SP26 | |
| SP27 | 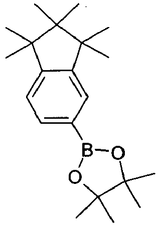 | 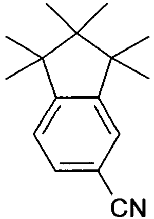 | 60% |
| | SP2 | SP27 | |
| SP28 | 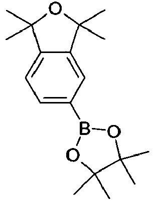 | 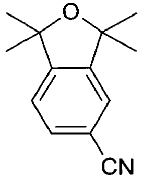 | 61% |
| | SP7 | S28 | |
| SH14 | 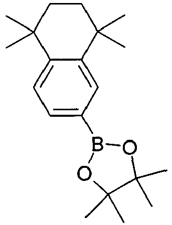 | 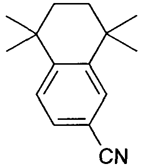 | 62% |
| | SH1 | SH14 | |
| SB18 | 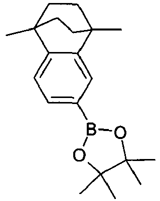 | 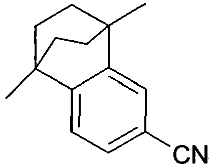 | 65% |
| | SB2 | SB18 | |
| SB19 | 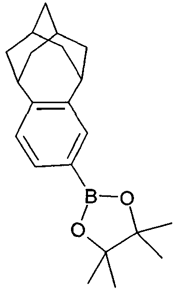 | 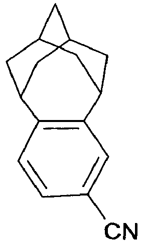 | 66% |
| | SB3 | SB19 | |

### Beispiel SH15: Bis-(1,1,4,4-tetramethyl-tetrahydro-naphth-6-yl)ether

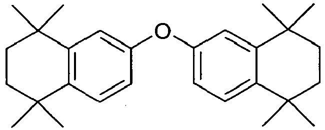

Durchführung analog zu G. Chen et al., Tetrahedron Letters 2007, 48, 3, 47. Ein gut gerührtes Gemisch aus 53.5 g (200 mmol) 6-Brom-1,1,4,4-tetramethyl-tetrahydro-naphthalin, SH1-Br, 212.2 g (800 mmol) Trikaliumphosphat-trihydrat, 300 Glaskugeln (3 mm Durchmesser), 449 mg (2 mmol) Palladium(II)-acetat, 809 mg (4 mmol) Tri-tert-butylphosphin und 1000 ml Dioxan wird 20 h unter Rückfluss erhitzt. Nach Erkalten saugt man von den Salzen ab, wäscht diese mit 300 ml Dioxan nach, engt das Filtrat im Vakuum ein, nimmt den Rückstand in 500 ml Ethylacetat auf, wäscht die Lösung dreimal mit je 300 ml Wasser, einmal mit 300 ml gesättigter Kochsalzlösung, trocknet über Magnesiumsulfat und entfernt dann das Ethylacetat im Vakuum. Der Rückstand wird durch Kugelrohrdestillation (p ca. 10⁻⁴ mbar, T ca, 180 °C) gereinigt. Ausbeute: 28.1 g (72 mmol), 72%; Reinheit: ca. 96% nach ¹H-NMR.

### Beispiel S1: 2,7-Di-tert-butyl-9,9'-(6-brompyridin-2-yl)xanthen, S1

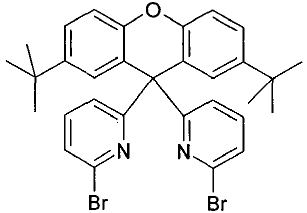

Eine Lösung von 84.7 g (300 mmol) Di(4-tert-butylphenyl)ether [24085-65-2] in 1500 ml Diethylether wird bei Raumtemperatur mit 120 ml (300 mmol) n-BuLi, 2.5 M in n-Hexan versetzt und dann 60 h unter Rückfluss gerührt. Nach Abkühlen auf-10 °C wird die Reaktionsmischung portionsweise mit 82.1 g (240mmol) Bis-(6-brom-pyridin-2-yl)methanon versetzt und dann 1.5 h bei -10 °C nachgerührt. Man quencht die Reaktionsmischung durch Zugabe von 30 ml Ethanol, rotiert das Lösungsmittel komplett im Vakuum ab, nimmt den Rückstand in 1000 ml Eisessig auf, gibt unter Rühren 150 ml Essigsäureanhydrid und dann tropfenweise 30 ml konz. Schwefelsäure zu und rührt 3 h bei 60 °C nach. Dann entfernt man das Lösungsmittel im Vakuum, nimmt den Rückstand in 1000 ml Dichlormethan auf und stellt unter Eiskühlung durch Zugabe von 10 Gew.-%iger, wässriger NaOH alkalisch. Man trennt die organische Phase ab, wäscht diese dreimal mit je 500 ml Wasser, trocknet über Magnesiumsulfat, engt die organische Phase komplett ein und nimmt den Rückstand in 500 ml Methanol auf, homogenisiert in der Wärme und rührt dann 12 h nach, wobei das Produkt kristallisiert. Der nach Absaugen erhaltene Feststoff wird in 1000 ml Dichlormethan gelöst, die Lösung wird über ein Celite-Bett filtriert, das Filtrat wird zur Tockene eingeengt, der Rückstand wird zweimal aus Toluol: Methanol (1:1) umkristallisiert und dann im Vakuum getrocknet. Ausbeute: 56.3 g (87 mmol), 36%; Reinheit: ca. 95% nach ¹H-NMR.

Analog kann folgende Verbindun dargestellt werden:

| Bsp. | Edukt | Produkt | Ausbeute |
|---|---|---|---|
| SH16 | 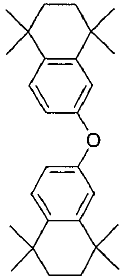 | 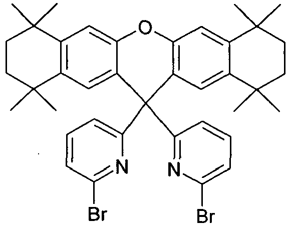 | 30% |
| | SH15 | SH16 | |

### B: Synthese der Liganden LP, LH und LB:

### Beispiel LP1: 2-(1,1,3,3-Tetramethyl-indan-5-yl)pyridine, LP1

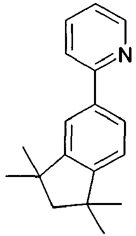

Ein Gemisch aus 30.0 g (100 mmol) 1,1,3,3-Tetramethyl-indan-5-boronsäure-pinakolester, SP1, 17.4 g (110 mmol) 2-Brompyridin [109-04-6], 46.1 g (200 mmol) Trikaliumphosphat-mono-hydrat, 300 ml Dioxan und 100 ml Wasser wird mit 821 mg (2 mmol) S-Phos und dann mit 249 mg (1 mmol) Palladium(II)acetat versetzt und 16 h unter Rückfluss erhitzt. Nach Erkalten trennt man die wässrige Phase ab, engt die organische zur Trockene ein, nimmt den Rückstand in 500 ml Ethylacetat auf, wäscht die organische Phase dreimal mit je 200 ml Wasser, einmal mit 200 ml gesättigter Kochsalzlösung, trocknet über Magnesiumsulfat, filtriert über ein Celite-Bett vom Trockenmittel ab und engt erneut zur Trockene ein. Das so erhaltene Öl wird durch zweimalige fraktionierte Kugelrohrdestillation von Leichtsiedern und nicht flüchtigen Nebenkomponenten befreit. Ausbeute: 15.3 g (61 mmol), 61%; Reinheit: ca. 99.5%ig nach ¹H NMR.

Analog werden folgende Verbindungen dargestellt. Feststoffe werden durch Umkristallistion und fraktionierte Sublimation (p ca. 10⁻⁴ - 10⁻⁵ mbar, T ca. 160 - 240 °C) von Leichtsiedern und nicht flüchtigen Nebenkomponenten befreit. Öle werden chromatographisch gereinigt, fraktioniert Kugelrohr-destilliert oder im Vakuum getrocknet, um Leichtsieder zu entfernen.

| Bsp. | Produkt Boronsäureester | Bromid | Ligand | Ausbeute |
|---|---|---|---|---|
| LP2 | 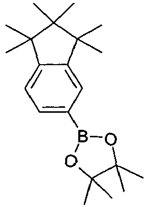 | 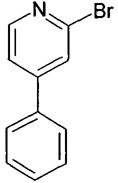 | 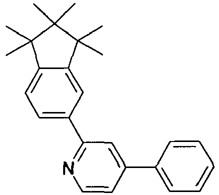 | 66% |
| | SP2 | 54151-74-5 | | |
| LP3 | 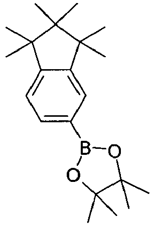 | 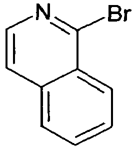 | 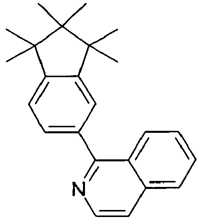 | 67% |
| | SP2 | 1532-71-4 | | |
| LP4 | 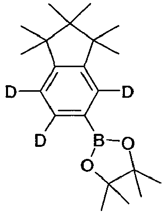 | 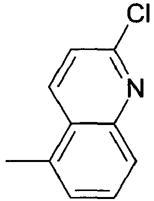 | 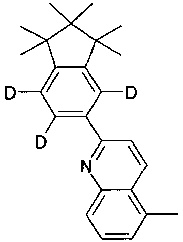 | 61% |
| | SP3 | 23952-31-0 | | |
| LP5 | 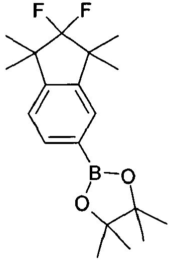 | 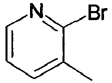 | 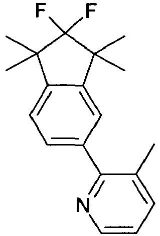 | 63% |
| | SP4 | 3430-17-9 | | |
| LP6 | 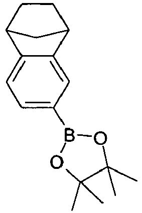 | 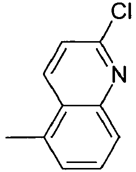 | 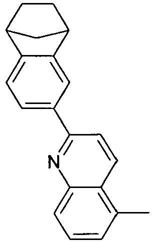 | 58% |
| | SP5 | 23952-31-0 | | |
| LP7 | 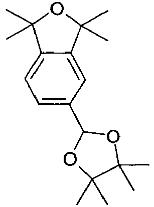 | 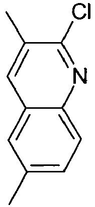 | 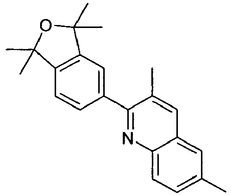 | 59% |
| | SP7 | 132118-28-6 | | |
| LH1 | 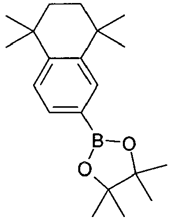 | 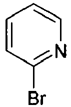 | 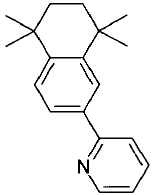 | 60% |
| | SH1 | 109-04-6 | | |
| LH2 | 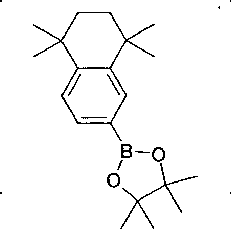 | 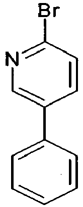 | 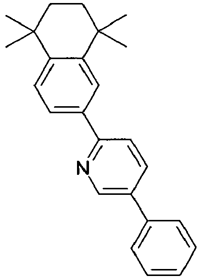 | 63% |
| | SH1 | 107351-82-6 | | |
| LH3 | 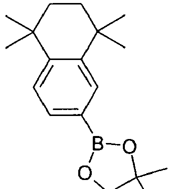 | 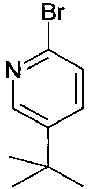 | 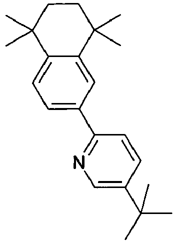 | 63% |
| | SH1 | 1142197-19-0 | | |
| LH4 | 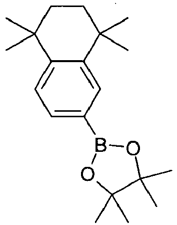 | 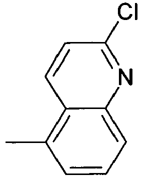 | 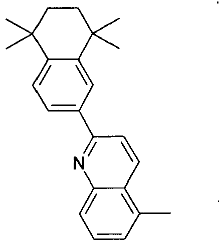 | 64% |
| | SH1 | 23952-31-0 | | |
| LH5 | 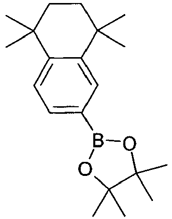 | 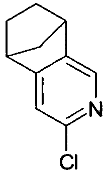 | 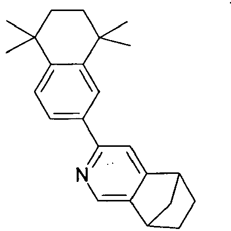 | 61% |
| | SH1 | 106203-65-0 | | |
| LH6 | 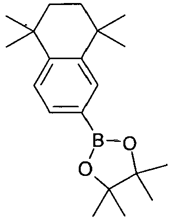 | 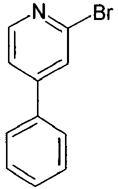 | 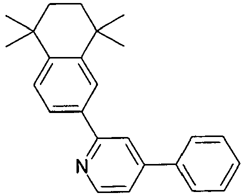 | 59% |
| | SH1 | 54151-74-5 | | |
| LH7 | 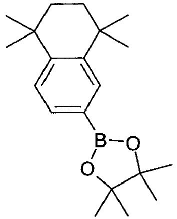 | 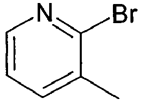 | 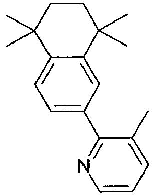 | 60% |
| | SH1 | 3430-17-9 | | |
| LH8 | 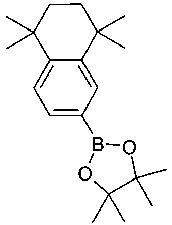 | 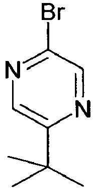 | 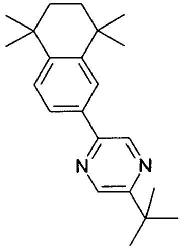 | 69% |
| | SH1 | 959238-69-8 | | |
| LH9 | 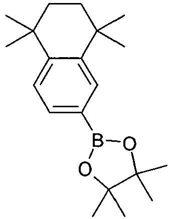 | 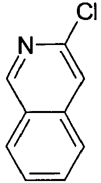 | 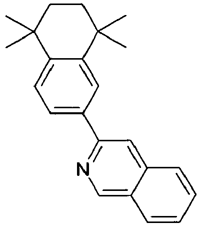 | 63% |
| | SH1 | 19493-45-9 | | |
| LH10 | 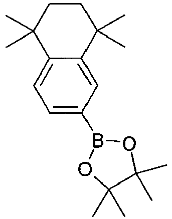 | 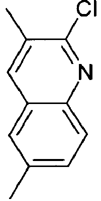 | 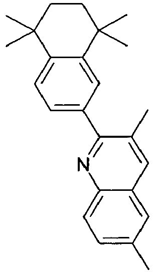 | 64% |
| | SH1 | 132118-28-6 | | |
| LH11 | 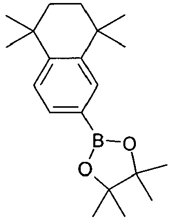 | 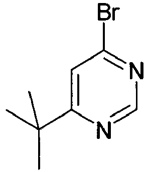 | 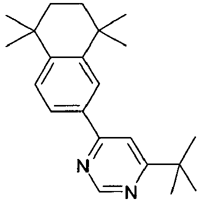 | 67% |
| | SH1 | 19136-36-8 | | |
| LH12 | 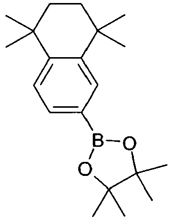 | 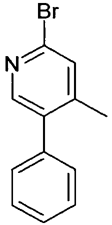 | 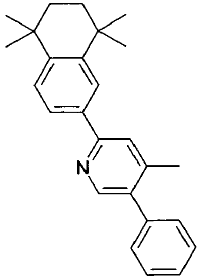 | 60% |
| | SH1 | 1438809-78-9 | | |
| LH13 | 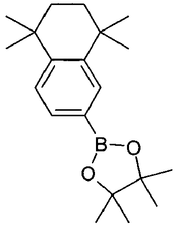 | 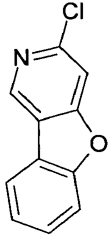 | 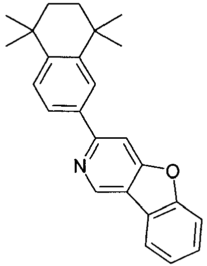 | 62% |
| | SH1 | 1251041-55-0 | | |
| LH14 | 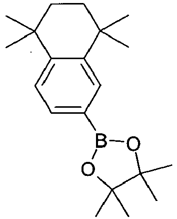 | 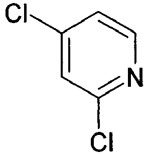 | 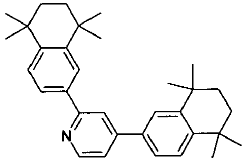 | 65% |
| | SH1 2.2 eq Boronsäure | 26452-80-2 | | |
| LH15 | 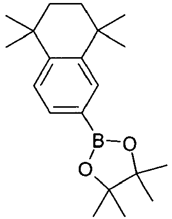 | 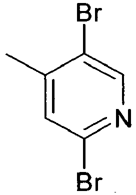 | 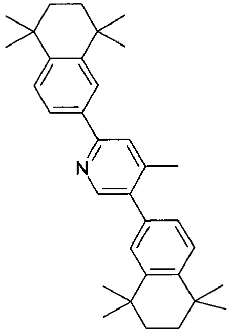 | 63% |
| | SH1 2.2 eq Boronsäure | 3430-26-0 | | |
| LB1 | 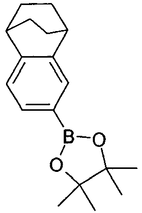 | 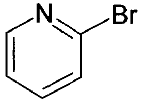 | 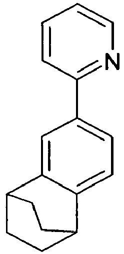 | 60% |
| | SB1 | 109-04-6 | | |
| LB2 | 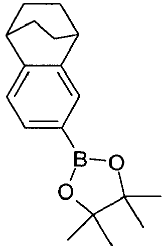 | 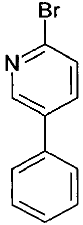 | 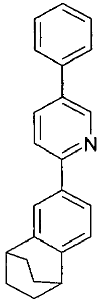 | 55% |
| | SB1 | 107351-82-6 | | |
| LB3 | 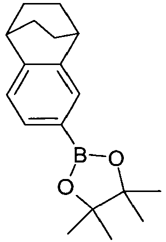 | 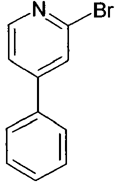 | 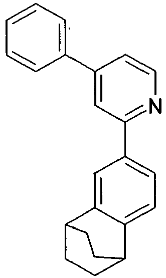 | 58% |
| | SB1 | 54151-74-5 | | |
| LB4 | 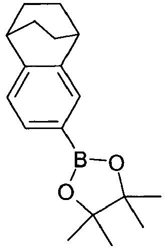 | 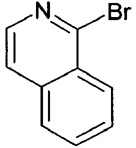 | 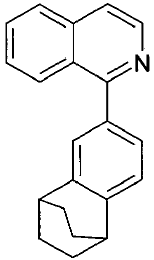 | 54% |
| | SB1 | 1532-71-4 | | |
| LB5 | 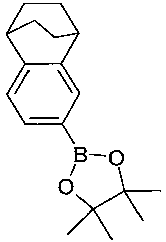 | 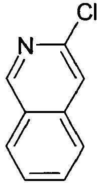 | 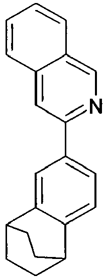 | 50% |
| | SB1 | 19493-45-9 | | |
| LB6 | 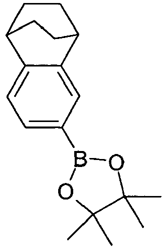 | 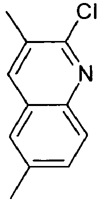 | 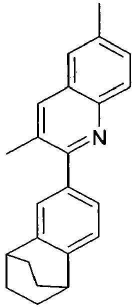 | 48% |
| | SB1 | 132118-28-6 | | |
| LB7 | 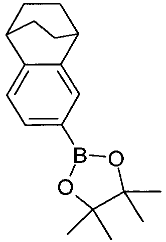 | 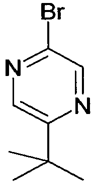 | 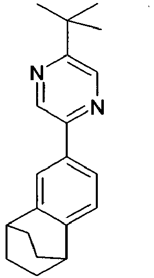 | 57% |
| | SB1 | 959238-69-8 | | |
| LB8 | 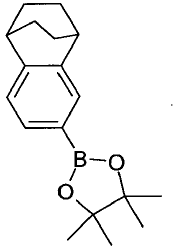 | 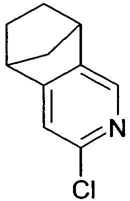 | 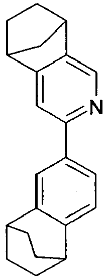 | 55% |
| | SB1 | 106203-65-0 | | |
| LB9 | 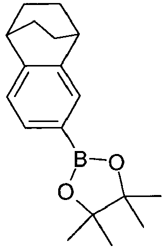 | 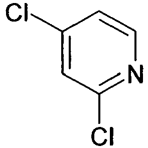 | 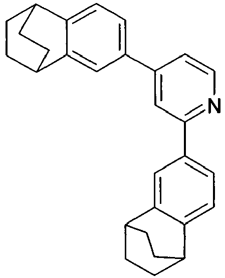 | 48% |
| | SB1 2.2 | 26452-80-2 | | |
| | eq | | | |
| | Boronsäure | | | |
| LB10 | 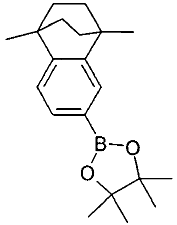 | 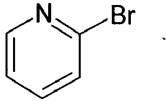 | 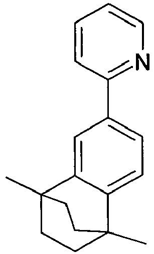 | 61% |
| | SB2 | 109-04-6 | | |
| LB11 | 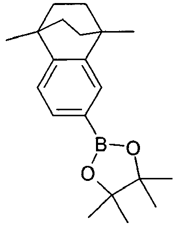 | 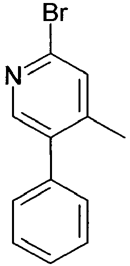 | 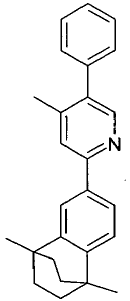 | 60% |
| | SB2 | 1438809-78-9 | | |
| LB12 | 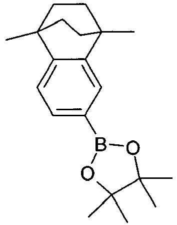 | 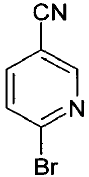 | 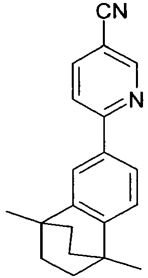 | 57% |
| | SB2 | 139585-70-9 | | |
| LB13 | 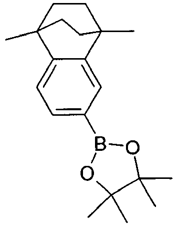 | 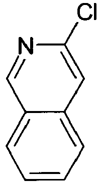 | 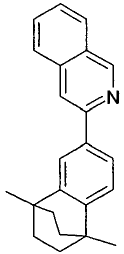 | 56% |
| | SB2 | 19493-45-9 | | |
| LB14 | 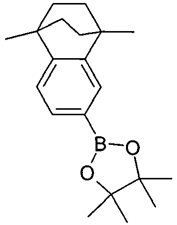 | 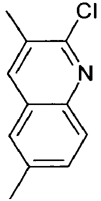 | 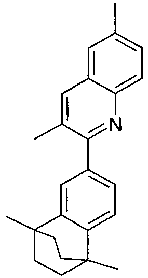 | 59% |
| | SB2 | 132118-28-6 | | |
| LB15 | 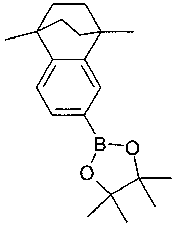 | 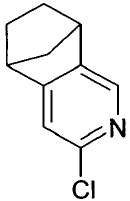 | 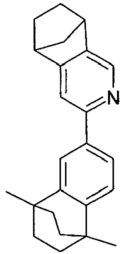 | 53% |
| | SB2 | 106203-65-0 | | |
| LB16 | 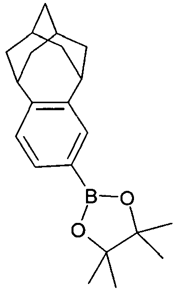 | 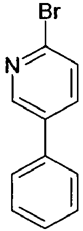 | 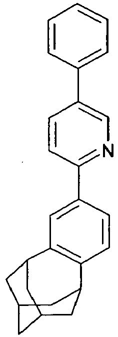 | 62% |
| | SB3 | 107351-82-6 | | |
| LB17 | 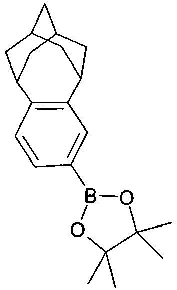 | 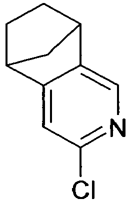 | 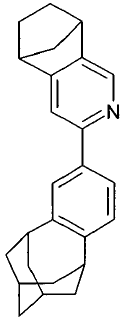 | 59% |
| | SB3 | 106203-65-0 | | |
| LB18 | 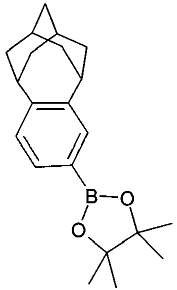 | 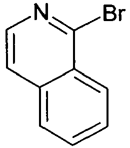 | 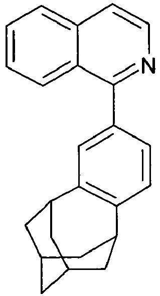 | 57% |
| | SB3 | 1532-71-4 | | |
| LB19 | 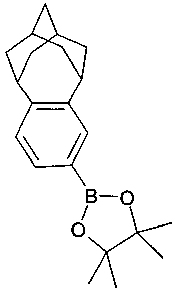 | 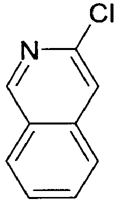 | 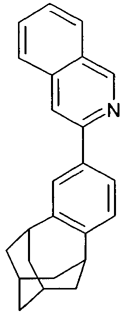 | 60% |
| | SB4 | 19493-45-9 | | |
| LB20 | 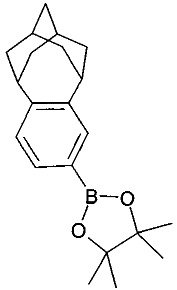 | 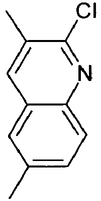 | 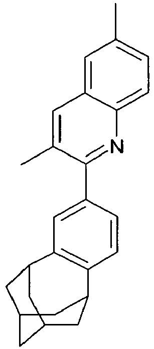 | 62% |
| | SB3 | 132118-28-6 | | |
| LB21 | 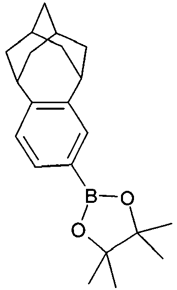 | 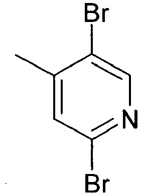 | 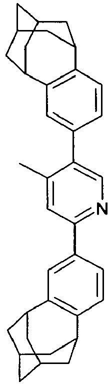 | 47% |
| | SB4 | 3430-26-0 | | |
| | 2.2eq Boronsäure | | | |
| LH53 | 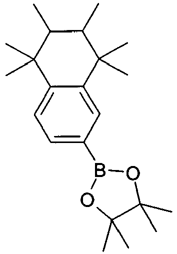 | 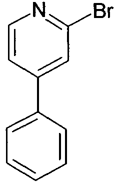 | 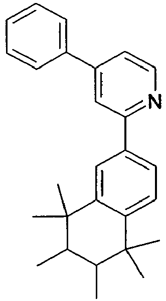 | 45% |
| | SH17 | 54151-74-5 | | |
| LH54 | 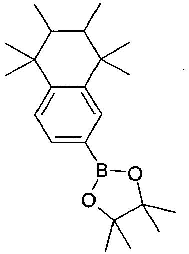 | 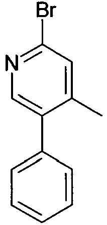 | 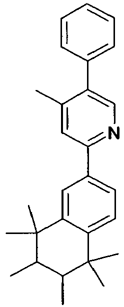 | 48% |
| | SH17 | 1438809-78-9 | | |
| LH55 | 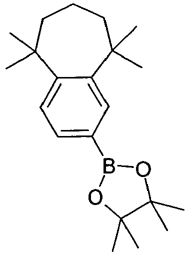 | 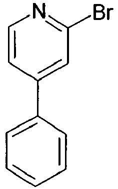 | 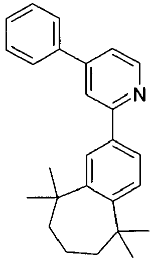 | 40% |
| | SH18 | | | |
| LH56 | 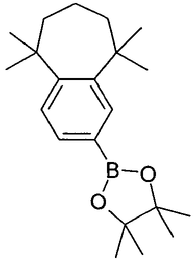 | 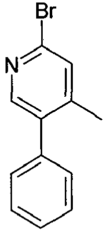 | 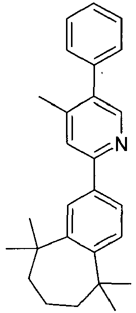 | 42% |
| | SH18 | 1438809-78-9 | | |

### Beispiel LP8: 5,5,7,7-Tetramethyl-3-phenyl-6,7-dihydro-5H-[2]pyridine

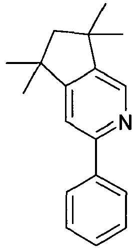

Durchführung analog A. Mazzanti et al., Eur. J. Org. Chem., 2011, 6725. Ein auf-78 °C gekühltes Gemisch aus 10.5 ml (100 mmol) Brombenzol und 500 ml Diethylether wird tropfenweise mit 40 ml (100 mmol) n-Butyllithium, 2.5 M in n-Hexan versetzt und 30 min. nachgerührt. Dann tropft man 17.5 g (100 mmol) 5,5,7,7-Tetramethyl-6,7-dihydro-5H-[2]pyridin [1562418-53-4] zu, lässt auf Raumtemperatur erwärmen, rührt 12 h nach, quencht durch Zugabe von 100 ml Wasser, trennt die organische Phase ab, trocknet diese über Magnsiumsulfat. Nach Entfernen das Lösungsmittels wird der ölige Rückstand an Kieselgel mit Diethylether:n-Heptan (3:7, v:v) chromatographiert und anschließend zweimal fraktioniert Kugelrohr-destilliert. Ausbeute: 12.1 g (48 mmol), 48%; Reinheit: ca. 99.5%ig nach ¹H NMR.

Analog können folgende Verbindungen dargestellt werden. Feststoffe werden durch Umkristallistion und fraktionierte Sublimation (p ca. 10⁻⁴ - 10⁻⁵ mbar, T ca. 160 - 240 °C) von Leichtsiedern und nicht flüchtigen Nebenkomponenten befreit werden. Öle werden chromatographisch gereinigt, fraktioniert Kugelrohr-destilliert oder im Vakuum getrocknet, um Leichtsieder zu entfernen.

| Bsp. | Pyridin | Bromid | Ligand | Ausbeute |
|---|---|---|---|---|
| LH16 | 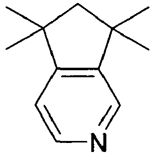 | 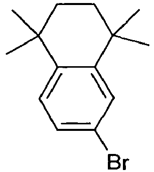 | 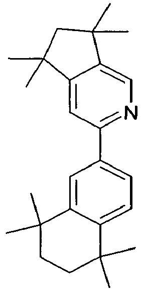 | 38% |
| | | SH1-Br | | |

### Beispiel LP9: 6,6,7,7,8,8-Hexamethyl-2-phenyl-7,8-dihydro-6H-cyclopenta[g]chinoxalin

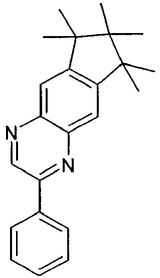

Durchführung analog S. V. More et al., Tetrahedron Lett. 2005, 46, 6345. Ein Gemisch aus 23.2 g (100 mmol) 1,1,2,2,3,3-Hexamethyl-indan-5,6-diamin, SP10, 13.4 g (100 mmol) Oxo-phenyl-acetaldehyd [1074-12-0], 767 mg (3 mmol) Iod und 75 ml Acetonitril wird 16 h bei Raumtemperatur gerührt. Man saugt vom ausgefallenen Feststoff ab, wäscht diesen einmal mit 20 ml Acetonitril, zweimal mit je 75 ml n-Heptan und kristallisiert dann zweimal aus Ethanol/Ethylacetat um. Abschließend wird der Feststoff durch fraktionierte Sublimation (p ca. 10⁻⁴ - 10⁻⁵ mbar, T ca. 220 °C) von Leichtsiedern und nicht flüchtigen Nebenkomponenten befreit. Ausbeute: 22.1 g (67 mmol), 67%; Reinheit: ca. 99.5%ig nach ¹H NMR.

Analog werden folgende Verbindungen dargestellt. Feststoffe werden durch Umkristallistion und fraktionierte Sublimation (p ca. 10⁻⁴ - 10⁻⁵ mbar, T ca. 160 - 240 °C) von Leichtsiedern und nicht flüchtigen Nebenkomponenten befreit werden. Öle werden chromatographisch gereinigt, fraktioniert Kugelrohr-destilliert oder im Vakuum getrocknet, um Leichtsieder zu entfernen.

| Bsp. | Diamin | Diketon | Ligand | Ausbeute |
|---|---|---|---|---|
| LP10 | 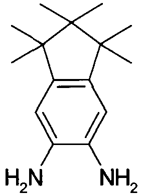 | 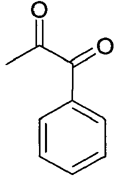 | 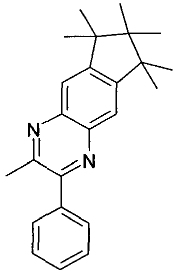 | 58% |
| | SP10 | 579-07-7 | | |
| LH17 | 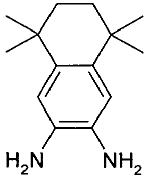 | 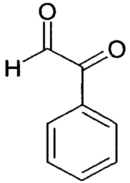 | 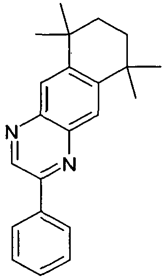 | 46% |
| | SH3 | 1074-12-0 | | |
| LH18 | 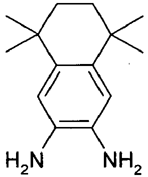 | 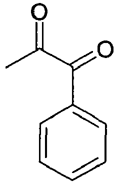 | 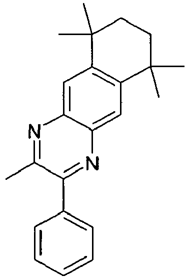 | 49% |
| | SH3 | 579-07-7 | | |
| LH19 | 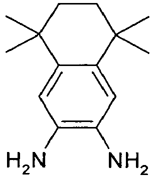 | 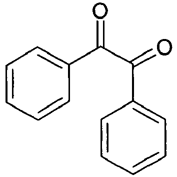 | 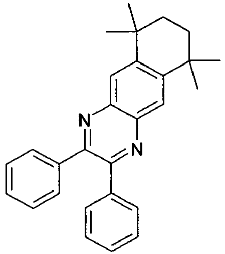 | 64% |
| | SH3 | 134-81-6 | | |
| LB22 | 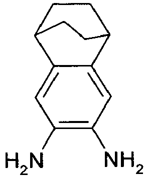 | 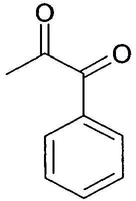 | 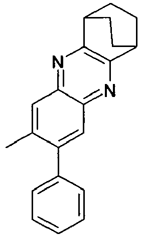 | 44% |
| | SB7 | 579-07 -7 | | |
| LB23 | 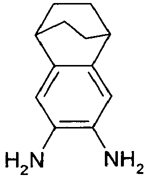 | 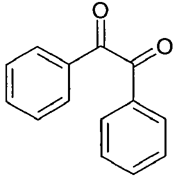 | 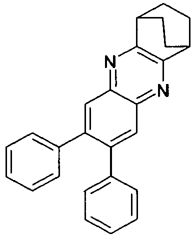 | 67% |
| | SB7 | 134-81-6 | | |
| LB24 | 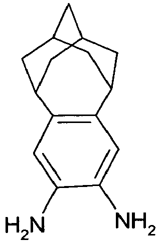 | 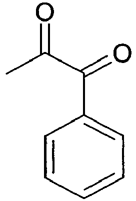 | 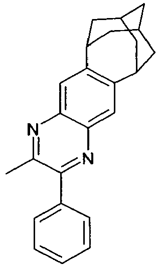 | 43% |
| | SB9 | 579-07-7 | | |
| LB25 | 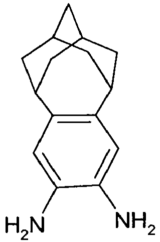 | 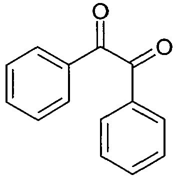 | 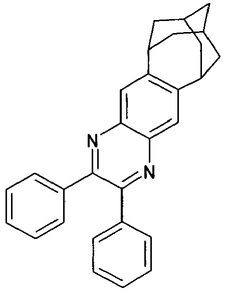 | 59% |
| | SB9 | 134-81-6 | | |

### Beispiel LP11: 5,5,6,6,7,7-Hexamethyl-1,2-diphenyl-1,5,6,7-tetrahydro-indeno[5,6-d]imidazol

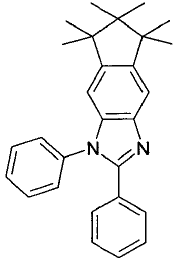

Durchführung analog D. Zhao et al., Org. Lett., 2011, 13, 24, 6516. Ein Gemisch aus 36.0 g (100 mmol) 5,6-Dibrom-1,1,2,2,3,3-hexamethyl-indan SP8 , 21.6 g (110 mmol) N-Phenyl-benzamidin [1527-91-9], 97.8 g (300 mmol) Caesiumcarbonat, 100 g Molsieb 4A, 1.2 g (2 mmol) Xanthphos, 449 mg (2 mmol) Palladium(II)acetat und 600 ml o-Xylol wird unter gutem Rühren 24 h unter Rückfluss erhitzt. Nach Erkalten saugt man von den Salzen über ein Celite-Bett ab, wäscht diese mit 500 ml o-Xylol nach, entfernt das Lösungsmittel im Vakuum und kristallisiert den Rückstand dreimal aus Cyclohexan/Ethylacetat um. Abschließend wird der Feststoff durch fraktionierte Sublimation (p ca. 10⁻⁴ - 10⁻⁵ mbar, T ca. 230 °C) von Leichtsiedern und nicht flüchtigen Nebenkomponenten befreit. Ausbeute: 28.0 g (71 mmol), 71%; Reinheit: ca. 99.5%ig nach ¹H NMR.

Analog werden folgende Verbindungen dargestellt. Feststoffe werden durch Umkristallistion und fraktionierte Sublimation (p ca. 10⁻⁴ - 10⁻⁵ mbar, T ca. 160 - 240 °C) von Leichtsiedern und nicht flüchtigen Nebenkomponenten befreit werden. Öle können chromatographisch gereinigt, fraktioniert Kugelrohr-destilliert oder im Vakuum getrocknet werden, um Leichtsieder zu entfernen.

| Bsp. | 1,2-DihalogenVerbindung | Benzamidin | Ligand | Ausbeute |
|---|---|---|---|---|
| LH20 | 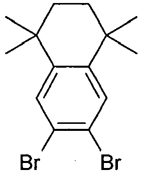 | 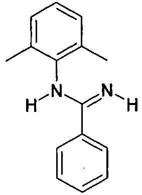 | 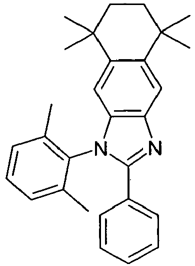 | 41% |
| | SH2 | 16239-27 -3 | | |
| LH21 | 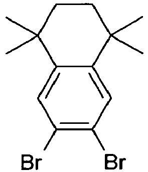 | 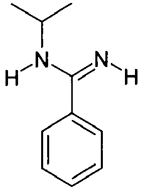 | 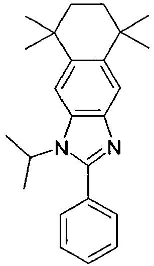 | 36% |
| | SH2 | 53510-31-9 | | |
| LH22 | 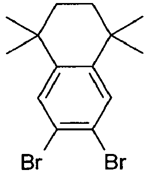 | 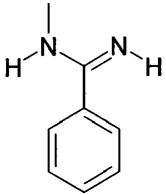 | 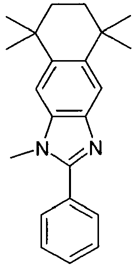 | 40% |
| | SH2 | 34028-17-6 | | |
| LB26 | 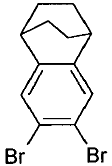 | 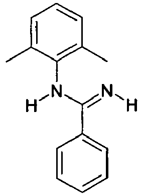 | 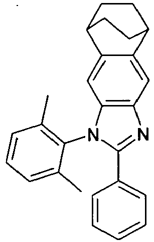 | 44% |
| | SB4 | 16239-27-3 | | |

### Beispiel LP12: 1,5,5,6,6,7,7-Heptamethyl-3-phenyl-1,5,6,7-tetrahydro-indeno[5,6-d]imidazolium-iodid, LP12

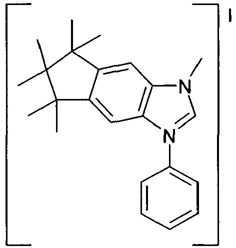

### A) 5,5,6,6,7,7-Hexamethyl-1,5,6,7-tetrahydro-indeno[5,6-d]imidazol

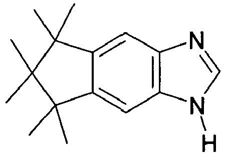

Durchführung analog Z.-H. Zhang et al., J. Heterocycl. Chem. 2007, 44, 6, 1509. Ein gut gerührtes Gemisch aus 116.2 g (500 mmol) 1,1,2,2,3,3-Hexamethyl-indan-5,6-diamin, SP10, 90.9 ml (550 mmol) Triethoxymethan [122-51-0] und 400 ml Acetonitril wird mit 1.3 g (5 mmol) Iod versetzt und 5 h bei Raumtemperatur gerührt. Man saugt vom ausgefallenen Feststoff ab, wäscht diesen einmal mit wenig Acetonitril, dreimal mit je 100 ml n-Heptan und trocknet im Vakuum. Ausbeute: 108.8 g (449 mmol), 90%; Reinheit: ca. 97%ig nach ¹H NMR.

### B) 5,5,6,6,7,7-Hexamethyl-1-phenyl-1,5,6,7-tetrahydro-indeno[5,6-d]-imidazol

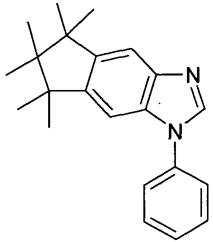

Durchführung analog S. Zhang et al., Chem. Commun. 2008, 46, 6170. Ein Gemisch aus 24.2 g (100 mmol) 5,5,6,6,7,7-Hexamethyl-1,5,6,7-tetrahydro-indeno[5,6-d]imidazol, A), 12.6 ml (120 mmol) Brombenzol [108-86-1], 27.6 g (200 mmol) Kaliumcarbonat, 952 mg (5 mmol) Kupfer(I)-iodid, 1.0 g (10 mmol) N,N-Dimethylglycin, 200 g Glaskugeln (3 mm Durchmesser) und 300 ml DMSO wird unter gutem Rühren 36 h auf 120 °C erhitzt. Nach Erkalten saugt man von den Salzen ab, wäscht diese mit 1000 ml Ethylacetat nach, wäscht die vereinigten organischen Phasen fünfmal mit je 500 ml Wasser, einmal mit 500 ml gesättigter Kochsalzlösung, trocknet über Magnesiumsulfat, entfernt das Lösungsmittel im Vakuum und kristallisiert den Rückstand zweimal aus Cyclohexan um. Ausbeute: 28.3 g (89 mmol), 89%; Reinheit: ca. 97%ig nach ¹H NMR.

### C) 1,5,5,6,6,7,7-Heptamethyl-3-phenyl-1,5,6,7-tetrahydro-indeno[5,6-d]imidazolium-iodid

Eine Suspension von 28.3 g (89 mmol) 5,5,6,6,7,7-Hexamethyl-1-phenyl-1,5,6,7-tetrahydro-indeno[5,6-d]imiazol, B), in 100 ml THF wird unter Rühren mit 12.6 ml (200 mmol) Methyliodid [74-88-4] versetzt und 24 h bei 45 °C gerührt. Nach Erkalten saugt man vom ausgefallenen Feststoff ab, wäscht diesen dreimal mit je 50 ml Ethanol und trocknet im Vakuum. Ausbeute: 23.5 g (51 mmol), 57%; Reinheit: ca. 99%ig nach ¹H NMR.

Analog werden folgende Verbindungen dargestellt:

| Bsp. | 1,2-Diamin | Bromaromat Alkylhalogenid | Ligand | Ausbeute über 3 Stufen |
|---|---|---|---|---|
| LP13 | 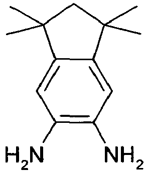 | 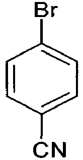 | 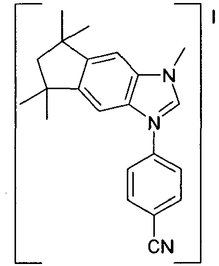 | 46% |
| | SP11 | 623-00-7 | | |
| | | Mel | | |
| LH23 | 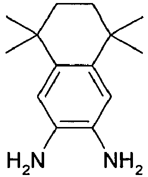 | 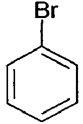 | 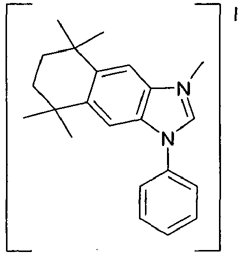 | 40% |
| | SH3 | 108-86-1 Mel | | |
| LH24 | 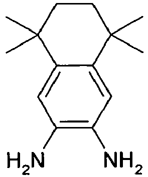 | 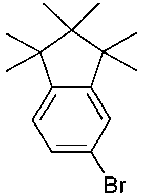 | 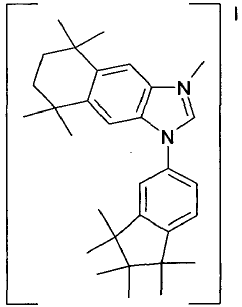 | 38% |
| | SH3 | SP2-Br Mel | | |
| LB27 | 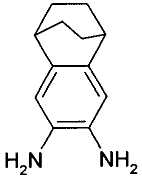 | 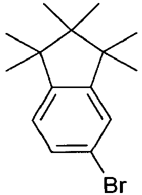 | 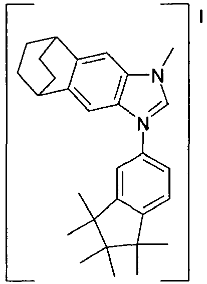 | 37% |
| | SB7 | SP2-Br Mel | | |
| LB28 | 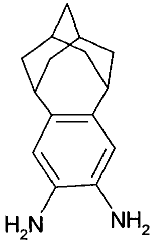 | 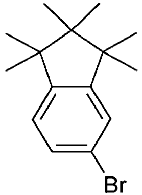 | 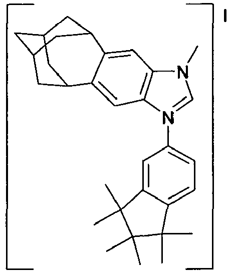 | 39% |
| | SB9 | SP2-Br Mel | | |

### Beispiel LP14: 1,4,4,6,6-Pentamethyl-3-phenyl-1,4,5,6-tetrahydrocyclopentaimidazolium-iodid

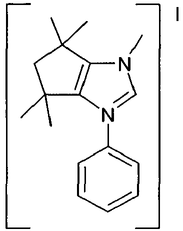

### A) 4,4,6,6-Tetrarnethyl-1,4,5,6-tetrahydro-cyclopentaimidazol

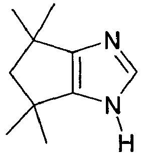

Darstellung analog G. Bratulescu, Synthesis, 2009, 14, 2319. Ein inniges Gemisch aus 1.54 g (10.0 mmol) 3,3,5,5-Tetramethyl-cyclophentan-1,2-dion [20633-06-1], 4.21 g (3.0 mmol) Urotropin, 7.7 g (10 mmol) Ammoniumacetat und 0.3 ml Eisessig wird in einer temperaturgesteuerten Mikrowelle so lange erhitzt, bis eine Innentemperatur von ca. 120 °C erreicht ist, und dann ca. 15 min. bei dieser Temperatur gehalten. Nach Erkalten gibt man die Masse in 150 ml Wasser, stellt unter Rühren mit wässriger Ammoniak-Lösung (10 Gew.-% ig) auf pH = 8 ein, saugt dann vom ausgefallenen Feststoff ab und wäscht diesen mit Wasser. Nach Trocknen wird aus Ethanol/Ethylacetat umkristallisiert. Ausbeute: 1.17 g (7.1 mmol), 71%; Reinheit: ca. 98%ig nach ¹H NMR.

### B) 4,4,6,6-Tetramethyl-1-phenyl-1,4,5,6-tetrahydro-cyclopenta-imidazol

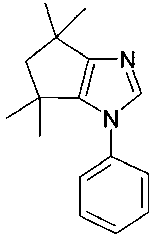

Darstellung analog LP12, B). Einsatz von 1.64 g (10.0 mmol) 4,4,6,6-Tetramethyl-1,4,5,6-tetrahydro-cyclopentaimidazol, A), die restlichen Edukte und Lösungsmittel werden entsprechend stöchiometrisch angepasst. Ausbeute: 1.53 g (6.3 mmol), 63%; Reinheit: ca. 98%ig nach ¹H NMR.

### C) 1,4,4,6,6-Pentamethyl-3-phenyl-1,4,5,6-tetrahydro-cyclopenta-imidazolium-iodid

Darstellung analog LP12, C). Einsatz von 2.4 g (10.0 mmol) 4,4,6,6-Tetramethyl-1-phenyl-1,4,5,6-tetrahydro-cyclopentaimidazol, B), die restlichen Edukte und Lösungsmittel werden entsprechend stöchiometrisch angepasst. Ausbeute: 2.26 g (5.9 mmol), 59%; Reinheit: ca. 99%ig nach ¹H NMR.

Analo werden folgende Verbindungen dargestellt.

| Bsp. | 1,2-Dion | Bromaromat Alkylhalogenid | Ligand | Ausbeute 3 Stufen |
|---|---|---|---|---|
| LH25 | 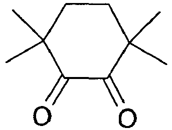 | 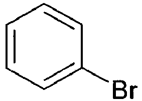 | 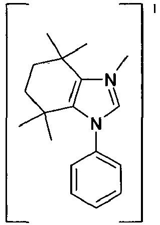 | 28% |
| | 20651-89-2 | 108-86-1 | | |
| LB29 | 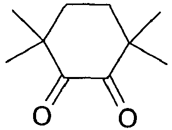 | 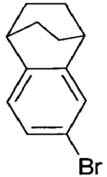 | 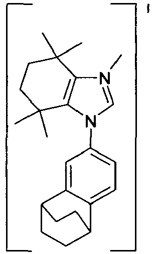 | 33% |
| | 20651-89-2 | SB1-Br | | |

### Beispiel LP15: 1,1,2,2,3,3-Hexamethyl-5-phenyl-2,3-dihydro-1H-6-aza-cyclopenta[b]naphthalin

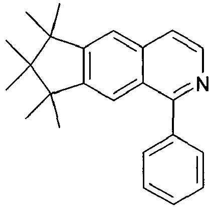

Eine Lösung von 34.8 g (100 mmol) N-[2-(1,1,2,2,3,3-Hexamethylindan-5-yl)-ethyl]-benzamid, SP13 in 150 ml o-Xylol wird bei 90 °C unter gutem Rühren portionsweise mit 17.0 g (120 mmol) Phosphorpentoxid versetzt. Zu dieser Reaktionsmischung tropft man 28.0 ml (300 mmol) Phosphorylchlorid zu und rührt weitere 4 h unter Rückfluss nach. Die auf 80 °C abgekühlte Reaktionsmischung wird unter gutem Rühren auf 1000 g Eis gegossen und dann durch Zugabe von fester NaOH alkalisch (pH ca. 12) gestellt. Man extrahiert das Gemisch dreimal mit je 300 ml Toluol, wäscht die organische Phase dreimal mit Wasser, trocknet über Magnesiumsulfat und entfernt das Lösungsmittel im Vakuum. Der ölige Rückstand wird in 200 ml o-Dichlorbenzol gelöst, die Lösung wird mit 86.9 g (1 mol) Mangandioxid versetzt und anschließend 16 h unter Rückfluss am Wasserabscheider gekocht. Nach Erkalten wird vom Mangandioxid über eine Celite-Schicht abfiltriert, der Feststoff wird mit 500 ml eines Gemischs aus Dichlormethan und Ethanol (10:1) gewaschen und die vereinigten Filtrate werden im Vakuum von den Lösungsmitteln befreit. Der Rückstand wird aus Cyclohexan / Ethylacetat umkristallisiert und abschließend durch fraktionierte Sublimation (p ca. 10⁻⁴ - 10⁻⁵ mbar, T ca. 230 °C) von Leichtsiedern und nicht flüchtigen Nebenkomponenten befreit. Ausbeute: 20.1 g (61 mmol), 61%; Reinheit: ca. 99.5%ig nach ¹H NMR.

Analog können folgende Verbindungen dargestellt werden:

| Bsp. | Edukt | Produkt | Ausbeute |
|---|---|---|---|
| LP16 | 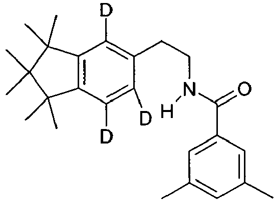 | 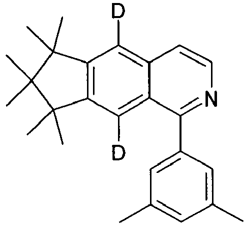 | 66% |
| | SP14 | | |
| LP17 | 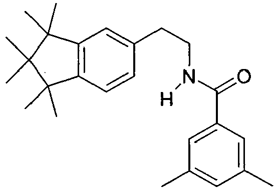 | 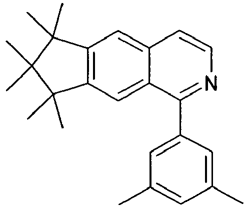 | 67% |
| | SP15 | | |
| LP18 | 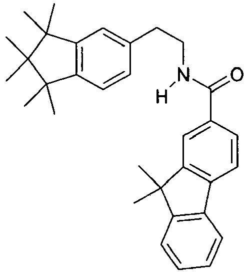 | 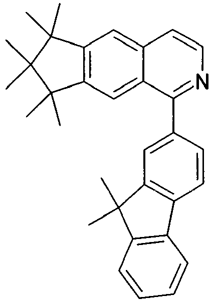 | 65% |
| | SP16 | | |
| LH26 | 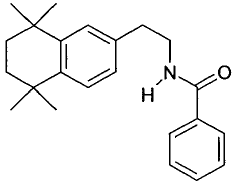 | 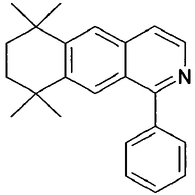 | 63% |
| | SH4 | | |
| LH27 | 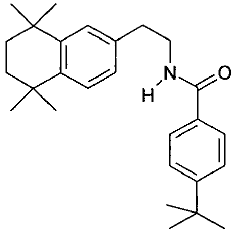 | 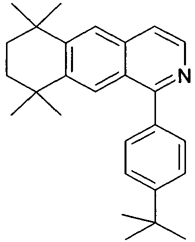 | 60% |
| | SH5 | | |
| LH28 | 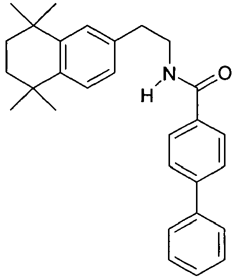 | 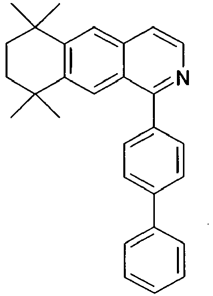 | 63% |
| | SH6 | | |
| LH29 | 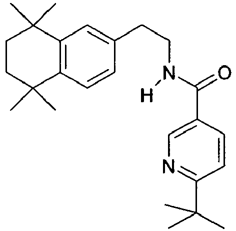 | 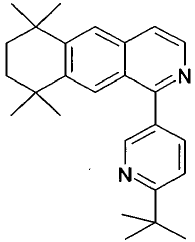 | 48% |
| | SH7 | | |
| LH30 | 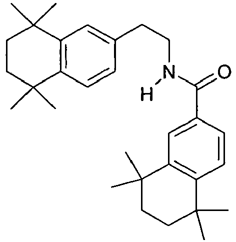 | 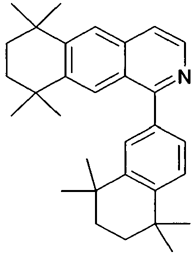 | 65% |
| | SH8 | | |
| LH31 | 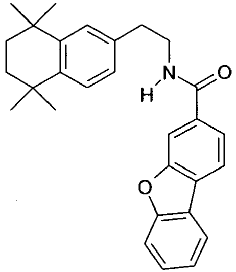 | 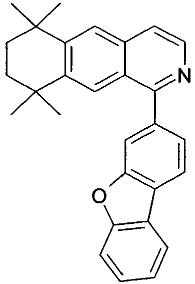 | 61% |
| | SH9 | | |
| LH32 | 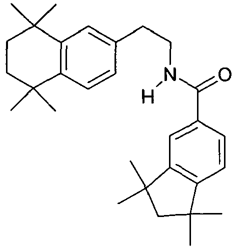 | 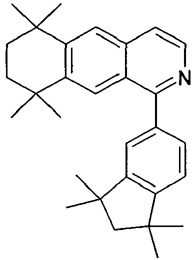 | 66% |
| | SH10 | | |
| LB30 | 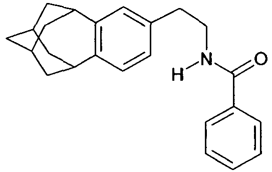 | 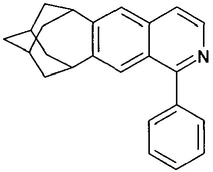 | 63% |
| | SB10 | | |

### Beispiel LP19: 7,8,9,10-Tetrahydro-7,10-methano-6-phenyl-phenanthridin

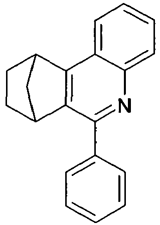

Ein gut gerührtes Gemisch aus 46.6 g (500 mmol) Anilin, 58.4 (550 mmol) Benzaldehyd, 94.2 g (1 mol) Norbornen und 1300 ml Dichlormethan wird tropfenweise mit 14.2 g (100 mmol) Bortrifluoridetherat versetzt und dann 40 h unter Rückfluss erhitzt. Nach Erkalten wäscht man die Reaktionsmischung zweimal mit je 400 ml Wasser, trocknet die orgische Phase über Magnesiumsulfat und entfernt dann das Dichlormethan im Vakuum. Der Rückstand wird in 1000 ml o-Dichlorbenzol aufgenommen, mit 435 g (5 mol) Mangandioxid versetzt und 16 h am Wasserabscheider unter Rückfluss erhitzt. Nach Erkalten fügt man 1000 ml Ethylacetat zu, saugt vom Mangandioxid über eine Celite-Schicht ab, wäscht das Mangandioxid mit 1000 ml Ethylacetat nach und befreit die vereinigten Filtrate im Vakuum von den Lösungsmitteln. Der Rückstand wird zweimal aus Cyclohexan umkristallisiert und abschließend durch fraktionierte Sublimation (p ca. 10⁻⁴ - 10⁻⁵ mbar, T ca. 230 °C) von Leichtsiedern und nicht flüchtigen Nebenkomponenten befreit. Ausbeute: 76.0 g (280 mmol), 56%; Reinheit: ca. 99.5%ig nach ¹H NMR.

Analog können folgende Verbindungen dargestellt werden:

| Bsp. | Edukt | Produkt | Ausbeute |
|---|---|---|---|
| LP20 | 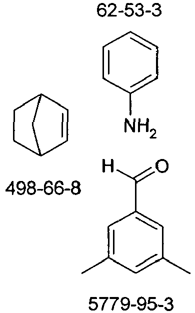 | 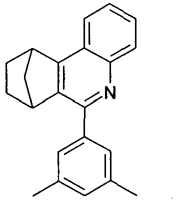 | 66% |
| LB31 | 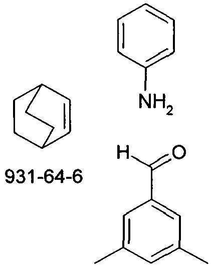 | 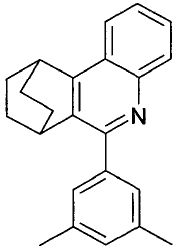 | 27% |
| LB32 | 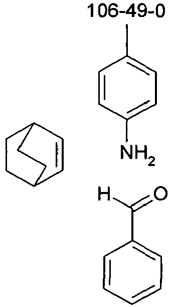 | 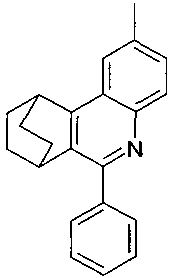 | 27% |

### Beispiel LP21: 5,8-Methano-5,6,7,8-tetrahydro-3-phenyl-2-aza-anthracen

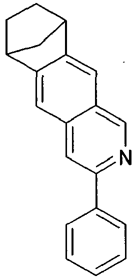

Ein Gemisch aus 13.6 g (50 mmol) 7-(3,3-Dimethyl-but-1-ynyl)-1,2,3,4-tetrahydro-1,4-methanonaphthalin-6-carbaldehyd, SP22 und 500 ml methanolische Ammoniak-Lösung (2M) wird in einem Autoklaven 5 h bei 140 °C gerührt. Nach Erkalten wird das Methanol im Vakuum entfernt, der ölige Rückstand wird an Kieselgel chromatographiert (n-Heptan:Ethylacetat 95:5) und abschließend durch fraktionierte Sublimation (p ca. 10⁻⁴ -10⁻⁵ mbar, T ca. 230 °C) von Leichtsiedern und nicht flüchtigen Nebenkomponenten befreit. Ausbeute: 5.1 g (17 mmol), 34%; Reinheit: ca. 99.5%ig nach ¹H NMR.

Analog können folgende Derivate dargestellt werden:

| **Bsp.** | **Edukt** | **Produkt** | **Ausbeute** |
|---|---|---|---|
| LP22 | 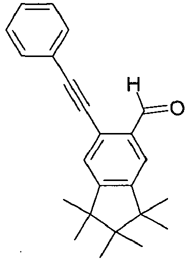 | 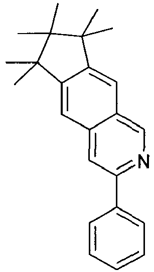 | 37% |
| | SP23 | | |
| LP23 | 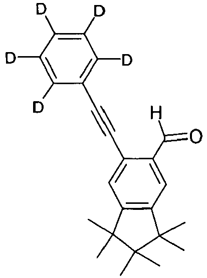 | 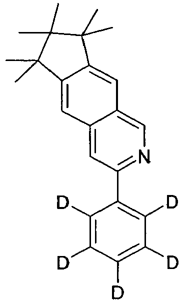 | 29% |
| | SP24 | | |
| LP24 | 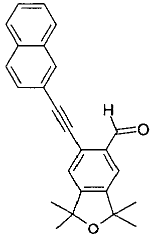 | 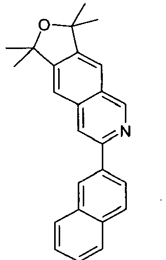 | 30% |
| | SP25 | | |
| LH33 | 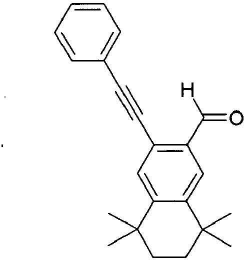 | 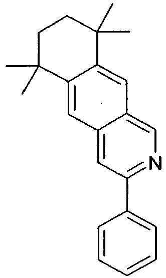 | 27% |
| | SH12 | | |
| LH34 | 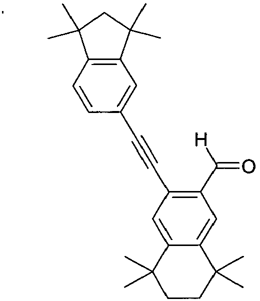 | 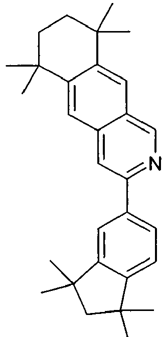 | 29% |
| | SH13 | | |
| LB33 | 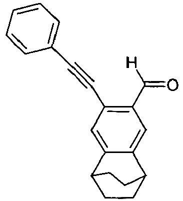 | 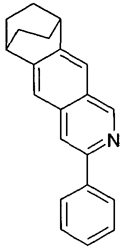 | 28% |
| | SB14 | | |
| LB34 | 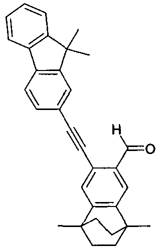 | 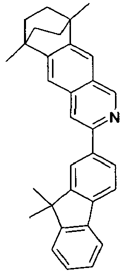 | 26% |
| | SB15 | | |
| LB35 | 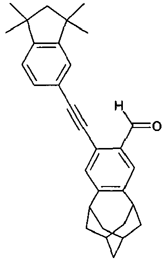 | 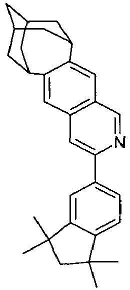 | 29% |
| | SB16 | | |

### Beispiel LP25: 1R,4S-Methano-1,2,3,4-tetrahydro-9-phenyl-10-aza-phenanthren

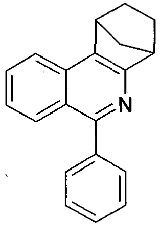

Ein Gemisch aus 26.1 g (100 mmol) 2-Bromphenyl-phenyl-methanon [13047-06-8], 11.1 g (100 mmol) (1R,2R,4S)-Bicyclo[2.2.1]-heptan-2-amin [7242-92-4] und 23.3 ml (105 mmol) Tetraethoxysilan [78-10-4] wird mit einem Tropfen konz. Schwefelsäure versetzt und dann 16 h am Wasserabscheider bei 160 °C erhitzt, wobei das Ethanol abdestilliert. Nach Erkalten versetzt man den Rückstand mit 500 ml Diethylether, wäscht zweimal mit je 100 ml gesättigter Natriumhydrogencarbonat-Lösung und zweimal mit je 300 ml Wasser und trocknet dann über Magnesiumsulfat. Nach Entfernen des Diethylethers versetzt man den öligen Rückstand mit 27.6 g (200 mmol) Kaliumcarbonat, 5 g Palladium-Kohle (5 Gew.-%ig), 2.6 g (10 mmol) Triphenylphosphin, 100 g Glaskugeln (3 mm Durchmesser) und 300 ml Mesitylen und erhitzt erneut 16 h unter Rückfluss. Nach Erkalten saugt man von den Salzen über eine Celite-Schicht ab, wäscht diese mit 500 ml Toluol nach und engt die vereinigten Filtrate im Vakuum zur Trockene ein. Der Rückstand wird dreimal aus DMF / Ethanol umkristallisiert und abschließend durch fraktionierte Sublimation (p ca. 10⁻⁴ - 10⁻⁵ mbar, T ca. 230 °C) von Leichtsiedern und nicht flüchtigen Nebenkomponenten befreit. Ausbeute: 14.9 g (55 mmol), 55%; Reinheit: ca. 99.5%ig nach ¹H NMR.

Analog können folgende Derivate dargestellt werden:

| **Bsp.** | **Edukt** | **Produkt** | **Ausbeute** |
|---|---|---|---|
| LB36 | 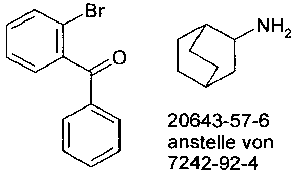 | 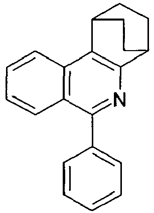 | 35% |

### Beispiel LB37:

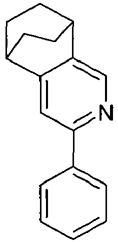

Darstellung analog M. Ohashi et al., J. Am. Chem. Soc, 2011, 133, 18018. Ein Gemisch aus 13.4 g (100 mmol) 2.3-Dimethylen-bicycol[2.2.2]octan [36439-79-9], 51.5 g (50 mmol) Benzonitril [100-47-0], 1.4 g (5 mmol) Biscyclooctadien-nickel(0) [1295-35-8], 5.6 g (20 mmol) Tricycohexylphosphin [2622-14-2] und 200 ml o-Xylol wird unter Einleiten eines schwachen Argonstroms 30 h unter schwachem Rückfluss erhitzt. Nach Erkalten filtriert man über ein Celite-Bett ab, entfernt das Lösungsmittel im Vakuum. Der Rückstand wird zweimal Kugelrohr-Destilliert. Ausbeute: 6.4 g (27 mmol), 54 %; Reinheit: ca. 98% ig nach ¹H NMR.

Analog können folgende Verbindungen dargestellt werden:

| **Bsp.** | **Olefin** | **Nitril** | **Produkt** | **Ausbeute** |
|---|---|---|---|---|
| LH35 | 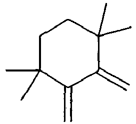 | 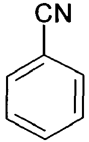 | 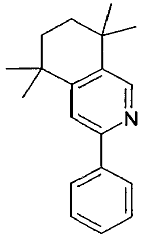 | 22% |
| | 153495-32-0 | 100-47-0 | | |
| LH36 | 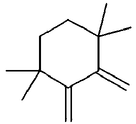 | 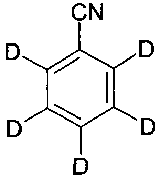 | | 18% |
| | 153495-32-0 | 2102-15-0 | 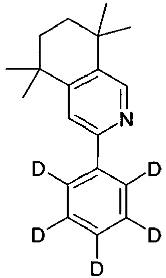 | |
| LH37 | 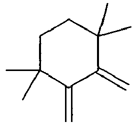 | 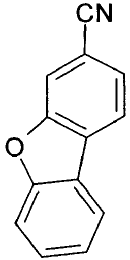 | | 24% |
| | 153495-32-0 | 29021-90-7 | 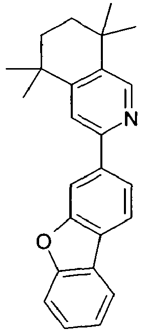 | |
| LH38 | 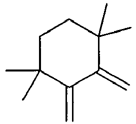 | 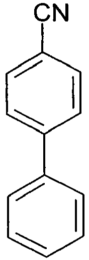 | | 20% |
| | 153495-32-0 | 2920-38-9 | 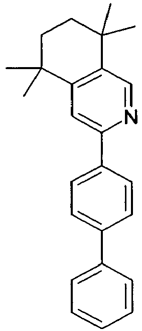 | |
| LH39 | 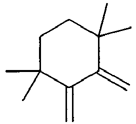 | 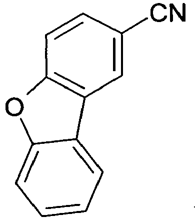 | | 19% |
| | 153495-32-0 | 20927 -96-2 | 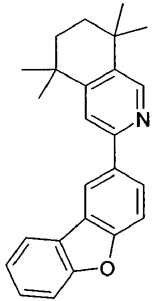 | |
| LH40 | 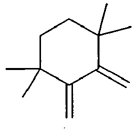 | 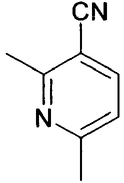 | 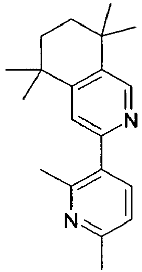 | 17% |
| | 153495-32-0 | 1721-24-0 | | |
| LH41 | 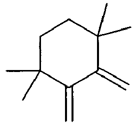 | 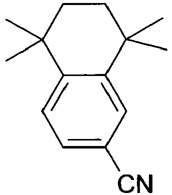 | | 20% |
| | 153495-32-0 | SH14 | 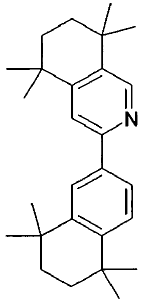 | |
| LH42 | 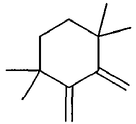 | 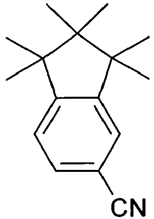 | | 22% |
| | 153495-32-0 | SP27 | 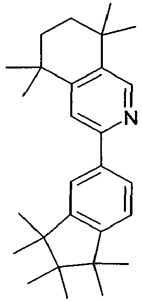 | |
| LB38 | 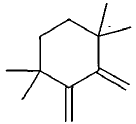 | 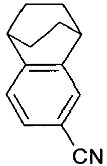 | | 24% |
| | 153495-32-0 | SB17 | 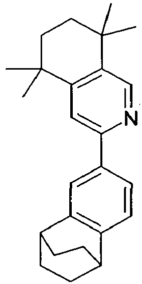 | |

### Beispiel LH43: Tetradentate Liganden

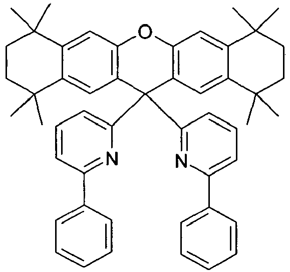

Ein Gemisch aus 71.5 g (100 mmol) SH16, 61.2 g (230 mmol) Phenylboronsäure [24388-23-6], 42.4 g (400 mmol) Natriumcarbonat, 1.2 g (1 mmol) Tetrakis-triphenylphosphino-palladium(0), 300 ml Toluol, 200 ml Dioxan und 300 ml Wasser wird 30 h unter Rückfluss erhitzt. Nach Erkalten wird die organische Phase abgetrennt, über ein Celite-Bett filtriert, wobei das Celite mit 300 ml Toluol nachgewaschen wird, die vereinigten Filtrate werden dreimal mit je 300 ml Wasser gewaschen, über Magnesiumsulfat getrocknet und dann im Vakuum vom Toluol befreit. Der Rückstand wird dreimal aus Ethanol unter Zusatz von wenig Ethylacetat umkristallisiert und abschließend durch fraktionierte Sublimation (p ca. 10⁻⁵ mbar, T ca. 310 °C) von Leichtsiedern und nicht flüchtigen Nebenkomponenten befreit. Ausbeute: 33.3 g (47 mmol), 47%; Reinheit: ca. 99.5%ig nach ¹H NMR.

Analog können folgende Verbindungen dargestellt werden:

| Bsp. | Edukt | Edukt | Produkt | Ausbeute |
|---|---|---|---|---|
| LH44 | 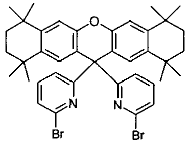 | 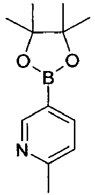 | | 46% |
| | SH16 | 610768-32-6 | 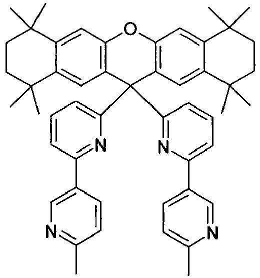 | |
| LH45 | 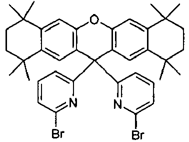 | 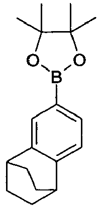 | 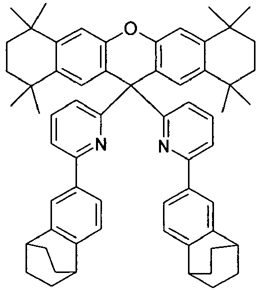 | 42% |
| | SH16 | SB1 | | |

### Beispiel LH46: Tetradentate Liganden

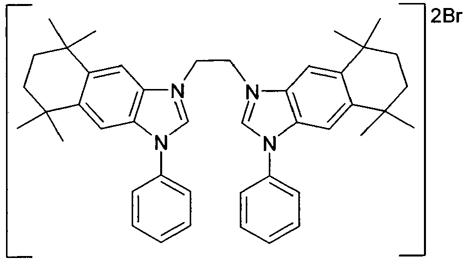

Durchführung analog C. Cao et al., Synth. Commun. 2012, 42, 380. Ein Gemisch aus 15.2 g (50 mmol) LH23 B) und 4.7 g (25 mmol) 1,2-Dibromethan [106-93-4] wird in einem Autoklaven 6 h auf 120 °C erhitzt. Nach Erkalten nimmt man die feste Masse in 100 ml tert-Butyl-methyl-ether auf, homogeniert unter Rühren, filtriert vom weißen Feststoff ab, wäscht diesen zweimal mit je 50 ml tert-Butyl-methyl-ether und trocknet im Vakuum. Ausbeute: 15.1 g (19 mmol), 76%; Reinheit: ca. 98.0%ig nach ¹H NMR.

Analog können folgende Verbindungen dargestellt werden:

| Bsp. | Imidazol | Ligand | Ausbeute |
|---|---|---|---|
| LH47 | 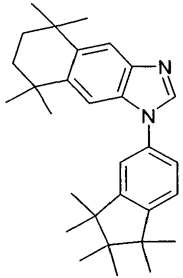 | 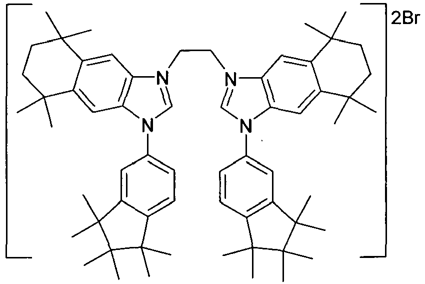 | 73% |
| | LH24 B) | | |

### Beispiel LH48: Hexadentate Liganden

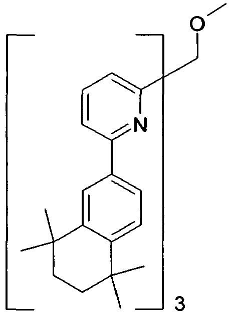

Ein Gemisch aus 51.4 g (100 mmol) Tris(6-brom-pyridin-2-yl)methoxy-methan [336158-91-9], 103.7 g (330 mmol) SH1, 42.4 g (400 mmol) Natriumcarbonat, 1.2 g (1 mmol) Tetrakis-triphenylphoshino-palladium(O), 500 ml Toluol, 300 ml Dioxan und 500 ml Wasser wird 36 h unter Rückfluss erhitzt. Nach Erkalten wird die organische Phase abgetrennt, über ein Celite-Bett filtriert, wobei das Celite mit 400 ml Toluol nachgewaschen wird, die vereinigten Filtrate werden dreimal mit je 300 ml Wasser gewaschen, über Magnesiumsulfat getrocknet und dann im Vakuum vom Toluol befreit. Der Rückstand wird dreimal aus iso-Propanol unter Zusatz von wenig Ethylacetat umkristallisiert und abschließend durch fraktionierte Sublimation (p ca. 10⁻⁵ mbar, T ca. 310 °C) von Leichtsiedern und nicht flüchtigen Nebenkomponenten befreit. Ausbeute: 38.7 g (44 mmol), 44%; Reinheit: ca. 99.5%ig nach ¹H NMR.

Analog können folgende Verbindungen dargestellt werden:

| Bsp. | Edukt | Edukt | Produkt | Ausbeute |
|---|---|---|---|---|
| LH49 | 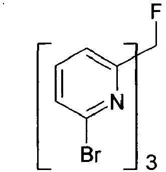 | 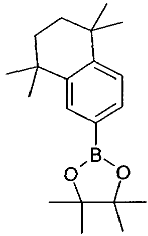 | 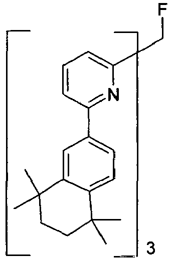 | 47% |
| | 760177 -68-2 | SH1 | | |
| LH50 | 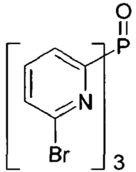 | 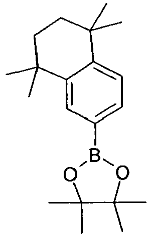 | 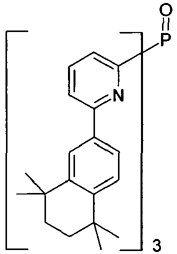 | 40% |
| | 197776-47-9 | SH1 | | |

### Beispiel LH51: Hexadentate Liganden

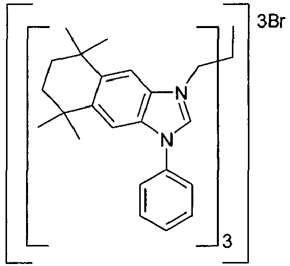

Durchführung analog LH46, wobei das 1,2-Dibromethan durch 5.2 g (16.7 mmol) 1,1,1-Tris(brommethyl)ethan [60111-68-4] ersetzt wird. Ausbeute: 14.8 g (12 mmol), 72%; Reinheit: ca. 99.0%ig nach ¹H NMR.

Analog kann Verbindung LH52 dargestellt werden:

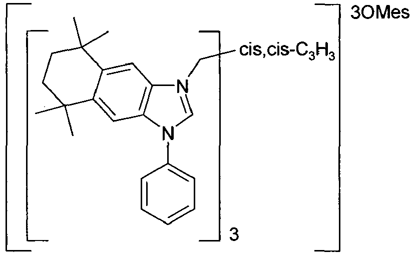

1,1,1-Tris(brommethyl)ethan wird durch 6.1 g (16.7 mmol) cis, cis-1,2,3-Cyclopropantrimethanol-tri-methansulfonsäureester [945230-85-3] ersetzt. Ausbeute: 14.8 g (11.5 mmol), 69%; Reinheit: ca. 99.0%ig nach ¹H NMR.

### Beispiel LH1: 2-(5,5,8,8-Tetramethyl-5,6,7,8-tetrahydro-naphthalin-2-yl)pyridine, LP1

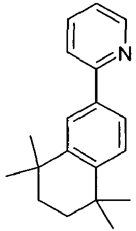

Ein Gemisch aus 16.4 g (100 mmol) 1,1,4,4-Tertramethyl-2,3-dimethylen-cyclohexan [153495-32-0], 12.4 g (120 mmol) 2-Ethynyl-pyridin [1945-84-2] und 50 ml Chlorbenzol wird 16 bei 120 °C gerührt. Dann fügt man 26.1 g (300 mmol) aktiviertes Mangan(II)oxid zu und rührt weiter 3 h bei 120 °C. Nach Erkalten erweitert man mit 200 ml Ethylacetat, filtriert über ein Celite-Bett an und entfernt das Lösungsmittel und überschüssiges 2-Ethynyl-pyridin im Vakuum. Der ölige Rückstand wird zweimal Kugelrohr-destilliert (p ca. 10⁻⁴ mbar, T ca. 190 °C). Ausbeute: 18.8 g (71 mmol), 71%; Reinheit: ca. 99.0%ig nach ¹H NMR.

Analog können folgende Verbindungen dargestellt werden:

| Bsp. | Edukt | Edukt | Produkt | Ausbeute |
|---|---|---|---|---|
| LH57 | 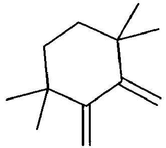 | 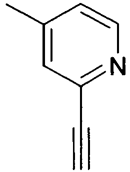 | 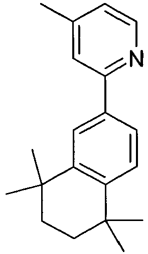 | 68% |
| | | 30413-54-8 | | |
| LH7 | 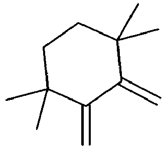 | 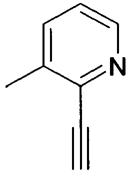 | 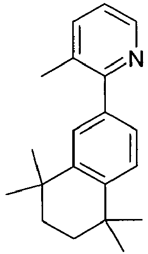 | 65% |
| | | 30413-59-3 | | |
| LH58 | 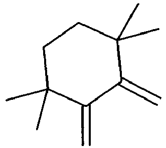 | 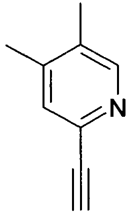 | 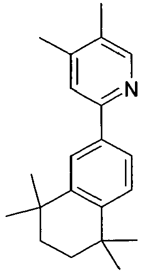 | 73% |
| | | 512197 -95-4 | | |
| LH59 | 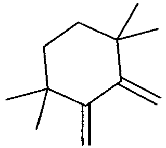 | 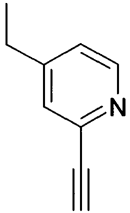 | 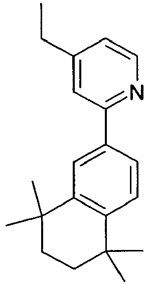 | 70% |
| | | 512197-93-2 | | |
| LH60 | 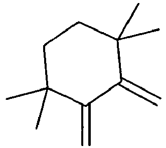 | 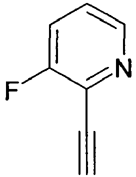 | 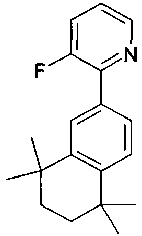 | 63% |
| | | 1401685-43-5 | | |
| LH61 | 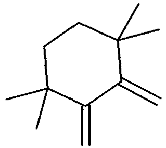 | 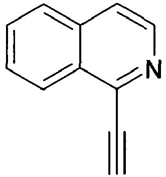 | 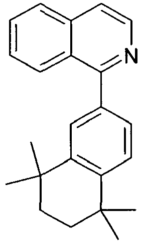 | 78% |
| | | 86520-96-9 | | |

### C: Synthese der Metallkomplexe

### 1) Homoleptische tris-faciale Iridium-Komplexe vom Phenyl-Pyridin-, Phenyl-Imidazol- bzw. Phenyl-Benzimidazol-Typ:

### Variante A: Tris-acetylacetonato-iridium(III) als Iridium-Edukt

Ein Gemisch aus 10 mmol Tris-acetylacetonato-iridium(III) [15635-87-7] und 40-60 mmol (bevorzugt 40 mmol) des Liganden L, gegebenenfalls 1 - 10 g - typischerweise 3 g - eines inerten hochsiedenden Zusatzes als Schmelzhilfe bzw. Lösungsmittel, z. B. Hexadecan, m-Terphenyl, Triphenylen, Bis-phenylether, 3-Phenoxy-toluol, 1,2-, 1,3-, 1,4-Bis-phenoxybenzol, Triphenylphosphinoxid, Sulfolan, 18-Krone-6, Triethylenglykol, Glycerin, Polyethylenglykole, Phenol, 1-Naphthol, Hydrochinon, etc., und ein glasummantelter Magnetrührkern werden unter Vakuum (10⁻⁵ mbar) in eine dickwandige 50 ml Glasampulle abgeschmolzen. Die Ampulle wird für die angegebene Zeit bei der angegebenen Temperatur getempert, wobei das aufgeschmolzene Gemisch mit Hilfe eines Magnetrührers gerührt wird. Um eine Sublimation der Liganden an kältere Stellen der Ampulle zu vermeiden, muss die gesamte Ampulle die angegebene Temperatur besitzen. Alternativ kann die Synthese in einem Rührautoklaven mit Glaseinsatz erfolgen. Nach Erkalten (ACHTUNG: die Ampullen stehen meist unter Druck!) wird die Ampulle geöffnet, der Sinterkuchen wird mit 100 g Glaskugeln (3 mm Durchmesser) in 100 ml eines Suspensionsmittels (das Suspensionsmittel wird so gewählt, dass der Ligand gut, der Metallkomplex jedoch schlecht darin löslich ist, typische Suspensionsmittel sind Methanol, Ethanol, Dichlormethan, Aceton, THF, Ethylacetat, Toluol, etc.) 3 h gerührt und dabei mechanisch aufgeschlossen. Man dekantiert die feine Suspension von den Glaskugeln ab, saugt den Feststoff ab, wäscht mit 50 ml des Suspensionsmittels nach und trocknet diesen im Vakuum. Der trockene Feststoff wird in einem kontinuierlichen Heißextraktor auf einem 3-5 cm hohen Alox-Bett (Alox, basisch Aktivitätsstufe 1) platziert und dann mit einem Extraktionsmittel (Vorlagemenge ca. 500 ml, das Extraktionsmittel wird so gewählt, dass der Komplex darin in der Hitze gut und in der Kälte schlecht löslich ist, besonders geeignete Extraktionsmittel sind Kohlenwasserstoffe wie Toluol, Xylole, Mesitylen, Naphthalin, o-Dichlorbenzol, halogenierte aliphatische Kohlenwasserstoffe sind in der Regel ungeeignet, da sie die Komplexe gegebenenfalls halogenieren oder zersetzen) extrahiert. Nach beendeter Extraktion wird das Extraktionsmittel im Vakuum auf ca. 100 ml eingeengt. Metallkomplexe, die im Extraktionsmittel eine zu gute Löslichkeit aufweisen, werden durch Zutropfen von 200 ml Methanol zur Kristallisation gebracht. Der Feststoff der so erhaltenen Suspensionen wird abgesaugt, einmal mit ca. 50 ml Methanol gewaschen und getrocknet. Nach Trocknen wird die Reinheit des Metallkomplexes mittels NMR und / oder HPLC bestimmt. Liegt die Reinheit unter 99.5% wird der Heißextraktionsschritt wiederholt, wobei ab der 2. Extraktion das Alox-Bett weggelassen wird. Ist eine Reinheit von 99.5 - 99.9% erreicht, wird der Metallkomplex getempert oder sublimiert. Das Tempern erfolgt im Hochvakuum (p ca. 10⁻⁶ mbar) im Temperaturbereich von ca. 200 - 300 °C, bevorzugt für Komplexe mit Molmassen größer ca. 1300 g/mol. Die Sublimation erfolgt im Hochvakuum (p ca. 10⁻⁶ mbar) im Temperaturbereich von ca. 230 - 400 °C, wobei die Sublimation bevorzugt in Form einer fraktionierten Sublimation durchgeführt wird. Gut in organischen Lösungsmitteln lösliche Komplexe können alternativ auch an Kieselgel chromatograpiert werden.

Werden chirale Liganden eingesetzt, fallen die abgeleiteten fac-Metallkomplexe als Diastereomerenmischung an. Die Enantiomere Λ,Δ der Punktgruppe C3 weisen in der Regel eine deutlich geringere Löslichkeit im Extraktionsmittel auf als die Enatiomeren der Punktgruppe C1, die sich folglich in der Mutterlauge anreichern. Eine Trennung der C3- von den C1-Diasteromeren auf diesem Wege ist häufig möglich. Daneben können die Diastereomeren auch chromatographisch getrennt werden. Werden Liganden der Punktgruppe C1 enantiomerenrein eingesetzt, entsteht ein Diasteromerenpaar Λ,Δ der Punktgruppe C3. Die Diastereomeren können durch Kristallisation oder Chromatographie getrennt und damit als enantiomerenreine Verbindungen erhalten werden.

### Variante B: Tris-(2,2,6,6-tetramethyl-3,5-heptandionato)iridium(III) als Iridium-Edukt

Durchführung analog zu Variante A, wobei anstelle von 10 mmol Tris-acetylacetonato-iridium(III) [15635-87-7] 10 mmol Tris-(2,2,6,6-tetramethyl-3,5-heptandionato)iridium [99581-86-9] eingesetzt werden. Die Verwendung dieses Edukts ist vorteilhaft, da die Reinheit der erhaltenen Rohprodukte häufig besser ist als bei Variante A. Außerdem ist der Druckaufbau in der Ampulle häufig nicht so ausgeprägt.

### Vaiante C: Natrium[cis-,trans-di-chloro-(bis-acetylacetonato]iridat(III) als Iridium-Edukt

Ein Gemisch aus 10 mmol Natrium[cis-,trans-di-chloro-(bis-acetyl-acetonato]iridat(III) [876296-21-8] und 60 mmol das Liganden in 50 ml Ethylen-, Proylen- oder Diethylenglykol wird unter einem leichten Argonstrom für die angegebene Zeit unter schwachem Rückfluss erhitzt. Nach Erkalten auf 60 °C verdünnt man unter Rühren mit einem Gemisch aus 50 ml Ethanol und 50 ml 2 N Salzsäure, rührt 1 h nach, saugt vom ausgefallenen Feststoff ab, wäscht diesen dreimal mit je 30 ml Ethanol und trocknet dann im Vakuum. Reinigung durch Heißextraktion oder Chromatographie und fraktionierte Sublimation, wie unter A beschrieben.

| **Bsp.** | **Ligand L** | **Ir-Komplex Diastereomer** | **Variante Reaktionsmedium Schmelzhilfe Reaktionstemp. Reaktionszeit Suspensionsmittel Extraktionsmittel** | **Ausbeute** |
|---|---|---|---|---|
| Ir(LH1)₃ | LH1 | 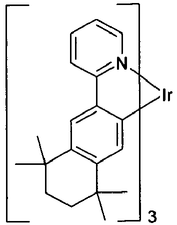 | A | 46% |
| | | | --- | |
| | | | --- | |
| | | | 270 °C | |
| | | | 24 h | |
| | | | EtOH | |
| | | | Ethylacetat | |
| Ir(LH1)₃ | LH1 | 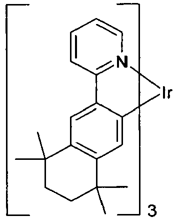 | C | 37% |
| | | | Propylenglykol | |
| | | | --- | |
| | | | RF | |
| | | | 100 h | |
| | | | --- | |
| | | | o-Xylol | |
| Ir(LH2)₃ | LH2 | 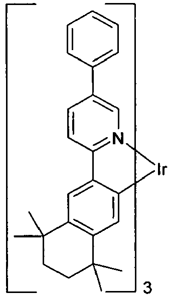 | A | 52% |
| | | | --- | |
| | | | --- | |
| | | | 270 °C | |
| | | | 24 h | |
| | | | EtOH | |
| | | | Ethylacetat | |
| Ir(LH3)₃ | LH3 | 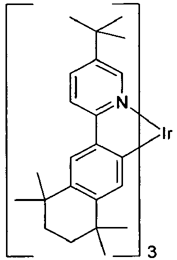 | wie Ir(LH2)₃ | 50% |
| Ir(LH4)₃ | LH4 | 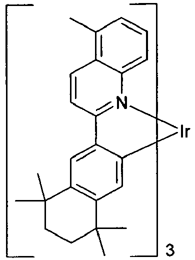 | A | 9% |
| | | | --- | |
| | | | Hydrochinon | |
| | | | 280 °C | |
| | | | 40 h | |
| | | | EtOH | |
| | | | Ethylacetat | |
| Ir(LH5)₃ | LH5 | 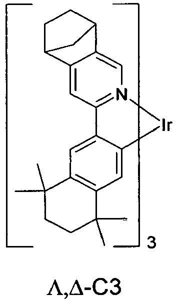 | wie Ir(LH2)₃ | 18% |
| Ir(LH6)₃ | LH6 | 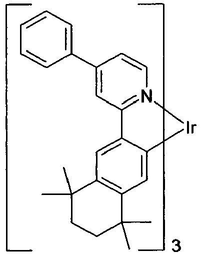 | wie Ir(LH2)₃ | 43% |
| Ir(LH7)₃ | LH7 | 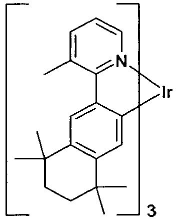 | wie Ir(LH2)₃ | 37% |
| Ir(LH8)₃ | LH8 | 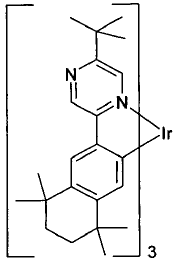 | A | 24% |
| | | | --- | |
| | | | Hydrochinon | |
| | | | 280 °C | |
| | | | 40 h | |
| | | | EtOH | |
| | | | Ethylacetat | |
| Ir(LH9)₃ | LH9 | 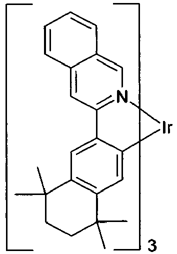 | wie Ir(LH2)₃ | 37% |
| Ir(LH10)₃ | LH10 | 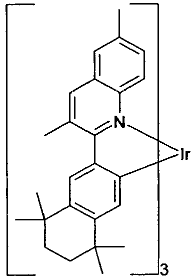 | wie Ir(LH4)₃ | 10% |
| Ir(LH11)₃ | LH11 | 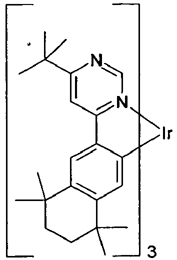 | wie Ir(LH8)₃ | 31% |
| Ir(LH12)₃ | LH12 | 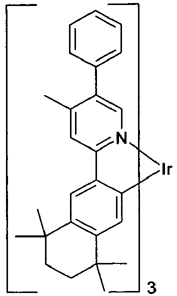 | wie Ir(LH2)₃ | 35% |
| Ir(LH13)₃ | LH13 | 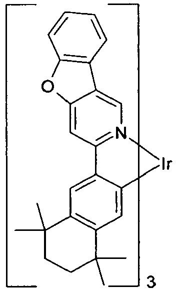 | wie Ir(LH2)₃ | 32% |
| Ir(LH14)₃ | LH14 | 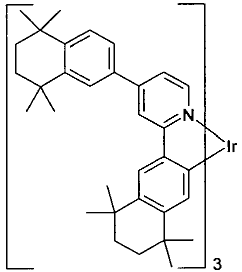 | wie Ir(LH2)₃ Chromatographie Kieselgel n-Heptan:DCM 8:1 | 40% |
| Ir(LH15)₃ | LH15 | 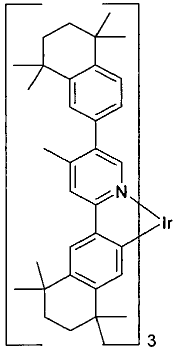 | wie Ir(LH2)₃ Chromatographie Kieselgel n-Heptan:DCM 8:1 | 37% |
| Ir(LH16)₃ | LH16 | 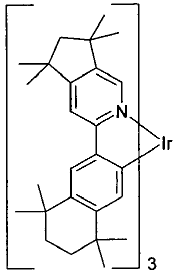 | wie Ir(LH2)₃ | 39% |
| Ir(LH20)₃ | LH20 | 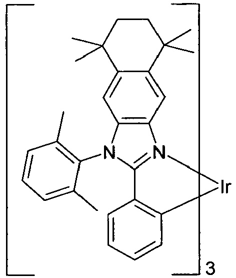 | A | 40% |
| | | | --- | |
| | | | --- | |
| | | | 280 °C | |
| | | | 30 h | |
| | | | EtOH | |
| | | | Toluol | |
| Ir(LH21)₃ | LH21 | 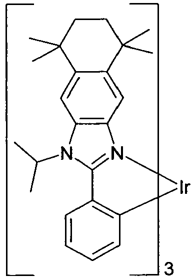 | wie Ir(LH20)₃ | 34% |
| Ir(LH22)₃ | LH22 | 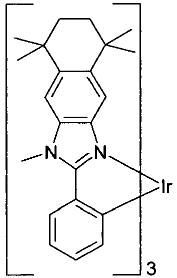 | wie Ir(LH20)₃ | 30% |
| Ir(LH26)₃ | LH26 | 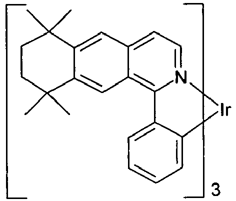 | wie Ir(LH2)₃ | 41% |
| Ir(LH27)₃ | LH27 | 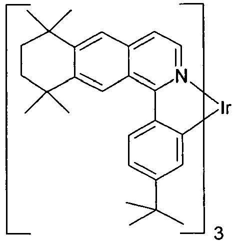 | wie Ir(LH2)₃ | 43% |
| Ir(LH28)₃ | LH28 | 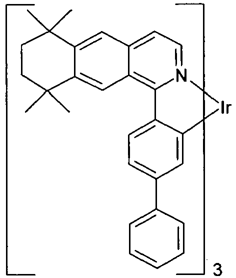 | wie Ir(LH2)₃ | 42% |
| Ir(LH29)₃ | LH29 | 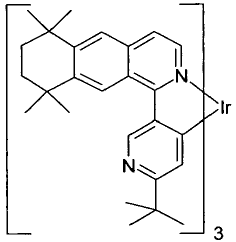 | A | 28% |
| | | | --- | |
| | | | --- | |
| | | | 280 °C | |
| | | | 30 h | |
| | | | Aceton | |
| | | | Toluol | |
| Ir(LH30)₃ | LH30 | 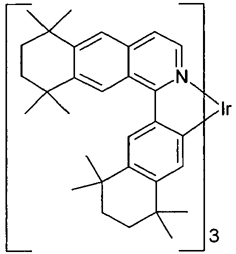 | wie Ir(LH2)₃ Chromatographie Kieselgel n-Heptan:DCM 8:1 | 30% |
| Ir(LH31)₃ | LH31 | 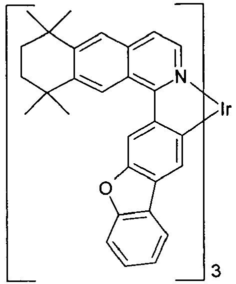 | wie Ir(LH2)₃ | 36% |
| Ir(LH32)₃ | LH32 | 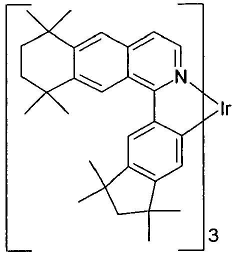 | wie Ir(LH2)₃ Chromatographie Kieselgel n-Heptan:DCM 8:1 | 35% |
| Ir(LH33)₃ | LH33 | 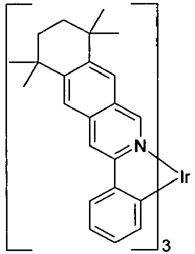 | wie Ir(LH2)₃ | 41% |
| Ir(LH34)₃ | LH34 | 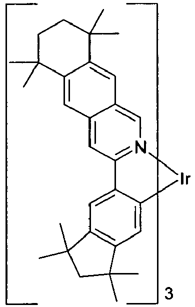 | wie Ir(LH2)₃ | 40% |
| Ir(LH35)₃ | LH35 | 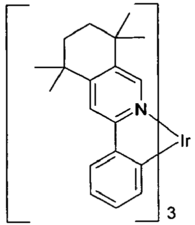 | wie Ir(LH2)₃ | 40% |
| Ir(LH36)₃ | LH36 | 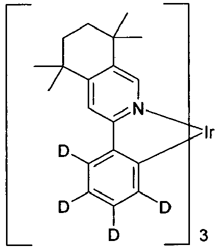 | wie Ir(LH2)₃ | 28% |
| Ir(LH37)₃ | LH37 | 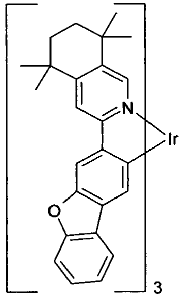 | wie Ir(LH2)₃ | 40% |
| Ir(LH38)₃ | LH38 | 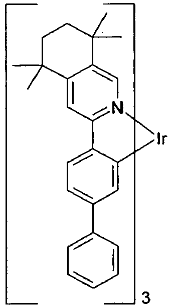 | wie Ir(LH2)₃ | 44% |
| Ir(LH39)₃ | LH39 | 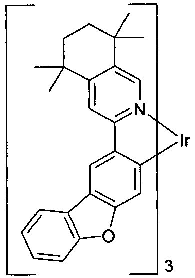 | wie Ir(LH2)₃ | 38% |
| Ir(LH40)₃ | LH40 | | A | 30% |
| | | | --- | |
| | | | Hydrochinon | |
| | | 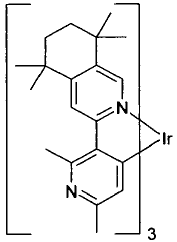 | 280 °C | |
| | | | 35 h | |
| | | | Toluol | |
| | | | Ethylacetat | |
| Ir(LH41)₃ | LH41 | 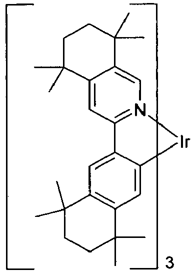 | wie Ir(LH2)₃ Chromatographie Kieselgel Toluol | 42% |
| Ir(LH42)₃ | LH42 | 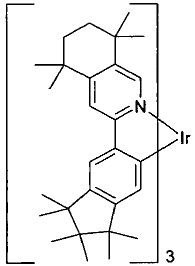 | wie Ir(LH2)₃ Chromatographie Kieselgel Toluol | 39% |
| Ir(LH53)₃ | LH53 | 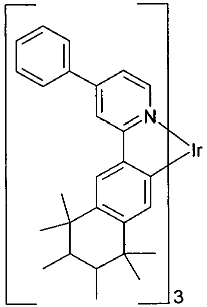 | A | 38% |
| | | | --- | |
| | | | --- | |
| | | | 270 °C | |
| | | | 24 h | |
| | | | EtOH | |
| | | | Acetonitril | |
| Ir(LH54)₃ | LH54 | 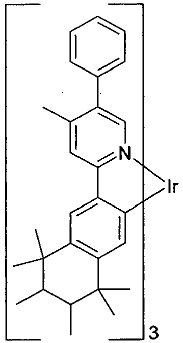 | wie Ir(L53)₃ | 44% |
| Ir(LH55)₃ | LH55 | 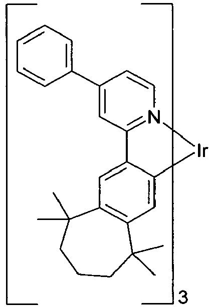 | wie Ir(LH2)₃ Chromatographie Kieselgel Toluol | 33% |
| Ir(LH56)₃ | LH56 | 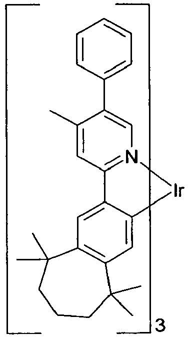 | wie Ir(LH2)₃ Chromatographie Kieselgel Toluol | 37% |
| Ir(LH57)₃ | LH57 | 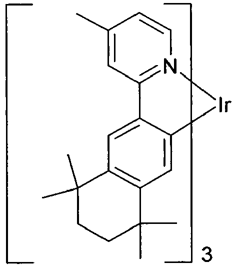 | wie Ir(L53)₃ | 46% |
| Ir(LH58)₃ | LH58 | 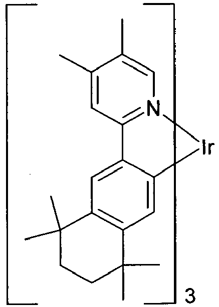 | wie Ir(L53)₃ | 43% |
| Ir(LH59)₃ | LH59 | 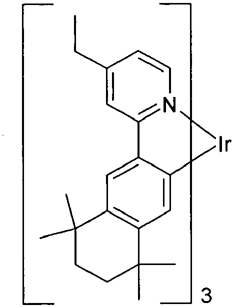 | wie Ir(L53)₃ | 37% |
| Ir(LH60)₃ | LH60 | 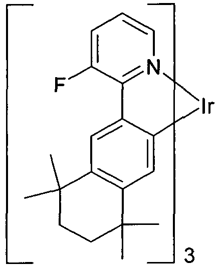 | wie Ir(L53)₃ | 41% |
| Ir(LH61)₃ | LH61 | 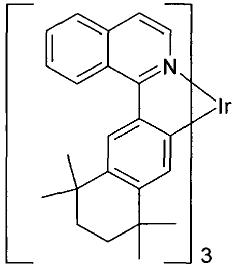 | wie Ir(L2)₃ | 47% |

### 2) Homoleptische Iridium-Komplexe vom Arduengo-Carben-Typ:

Darstellung analog K. Tsuchiya, et al., Eur. J. Inorg. Chem., 2010, 926. Ein Gemisch aus 10 mmol des Liganden, 3 mmol Iridium(III)chlorid-Hydrat, 10 mmol Silbercarbonat, 10 mmol Natriumcarbonat in 75 ml 2-Ethoxyethanol wird 24 h unter Rückfluss erwärmt. Nach Erkalten gibt man 300 ml Wasser zu, saugt vom ausgefallenen Feststoff ab, wäscht diesen einmal mit 30 ml Wasser und dreimal mit je 15 ml Ethanol und trocknet im Vakuum. Das so erhaltene fac-/mer-Isomerengemisch wird an Kieselgel chromatographiert. Die Isomeren werden anschließend fraktioniert sublimiert bzw. im Hochvakuum vom Lösungsmittel befreit.

| **Bsp.** | **Ligand L** | **Ir-Komplex Diastereomer** | **Ausbeute** |
|---|---|---|---|
| fac-Ir(LH23)₃ | LH23 | 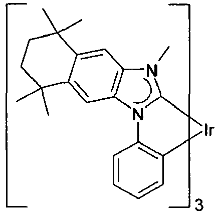 | 35% |
| mer-Ir(LH23)₃ | | | 10% |
| fac-Ir(LH24)₃ | LH24 | 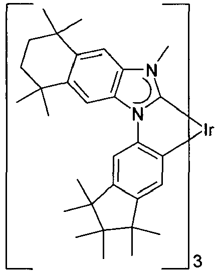 | 37% |
| mer-Ir(LH24)₃ | | | 12% |
| fac-Ir(LH25)₃ | LH25 | 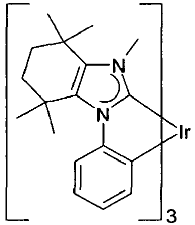 | 33% |
| fac-Ir(LB29)₃ | LB29 | 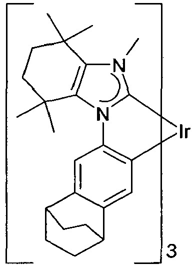 | 29% |

### 3) Iridium-Komplexe vom Typ [Ir(L)₂Cl]₂

### Variante A:

Ein Gemisch aus 22 mmol des Liganden, 10 mmol Iridium(III)chlorid-Hydrat, 75 ml 2-Ethoxyethanol und 25 ml Wasser wird unter gutem Rühren 16 - 24 h unter Rückfluss erhitzt. Falls sich der Ligand nicht oder nicht vollständig im Lösungsmittelgemisch unter Rückfluss löst, wird so lange 1,4-Dioxan zugesetzt, bis eine Lösung entstanden ist. Nach Erkalten saugt man vom ausgefallenen Feststoff ab, wäscht diesen zweimal mit Ethanol/ Wasser (1:1, vv) und trocknet dann im Vakuum. Das so erhaltene Chloro-Dimer der Formel [Ir(L)₂Cl]₂ wird ohne Reinigung weiter umgesetzt.

### Variante B:

Ein Gemisch aus 10 mmol Natrium-bis-acetylacetonato-dichloro-iridat(III) [770720-50-8], 24 mmol des Liganden L und ein glasummantelter Magnetrührkern werden unter Vakuum (10⁻⁵ mbar) in eine dickwandige 50 ml Glasampulle abgeschmolzen. Die Ampulle wird für die angegebene Zeit bei der angegebenen Temperatur getempert, wobei das aufgeschmolzene Gemisch mit Hilfe eines Magnetrührers gerührt wird. Nach Erkalten - ACHTUNG: die Ampullen stehen meist unter Druck! - wird die Ampulle geöffnet, der Sinterkuchen wird mit 100 g Glaskugeln (3 mm Durchmesser) in 100 ml des angegebenen Suspensionsmittels (das Suspensionsmittel wird so gewählt, dass der Ligand gut, das Chloro-Dimer der Formel [Ir(L)₂Cl]₂ jedoch schlecht darin löslich ist, typische Suspensionsmittel sind Dichlormethan, Aceton, Ethylacetat, Toluol, etc.) 3 h gerührt und dabei mechanisch aufgeschlossen. Man dekantiert die feine Suspension von den Glaskugeln ab, saugt den Feststoff [Ir(L)₂Cl]₂, der noch ca. 2 eq NaCl enthält, nachfolgend das rohe Chloro-Dimer genannt, ab und trocknet diesen im Vakuum. Das so erhaltene rohe Chloro-Dimer der Formel [Ir(L)₂Cl]₂ wird ohne Reinigung weiter umgesetzt.

| **Bsp.** | **Ligand L** | **Ir-Komplex Variante Temp./Zeit Diastereomer** | **Ausbeute** |
|---|---|---|---|
| [Ir(LP1)₂C)]₂ | L1 | 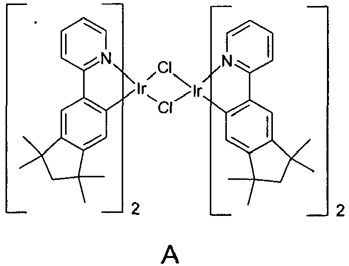 | 76% |
| [Ir(LP2) ₂Cl]₂ | L2 | Ir[(LP2)Cl]₂ | 81% |
| | | A | |
| [Ir(LH1)₂Cl]₂ | LH1 | 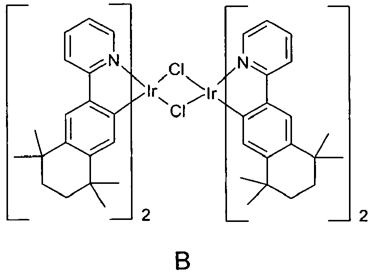 | 76% |
| | | 245 °C/48 h | |
| [Ir(LH2)₂Cl]₂ | LH2 | [Ir(LH2)₂Cl]₂ | 80% |
| | | wie [Ir(LH1)₂Cl]₂ | |
| [Ir(LH3)₂Cl]₂ | LH3 | [)r(LH3)₂C)]₂ | 78% |
| | | wie [Ir(LH1)₂Cl]₂ | |
| [Ir(LH4)₂Cl]₂ | LH4 | [Ir(LH4)₂Cl]₂ | 81% |
| | | wie [Ir(LH1)₂Cl]₂ | |
| [Ir(LH5)₂Cl]₂ | LH5 | [Ir(LH5)₂Cl]₂ | 80% |
| | | wie [Ir(LH1)₂Cl]₂ | |
| [Ir(LH6)₂Cl]₂ | LH6 | [Ir(LH6)₂Cl]₂ | 75% |
| | | wie [Ir(LH1)₂Cl]₂ | |
| [Ir(LH7)₂Cl]₂ | LH7 | [Ir(LH7)₂Cl]₂ | 77% |
| | | wie [Ir(LH1)₂Cl]₂ | |
| [Ir(LH9)₂Cl]₂ | LH9 | [Ir(LH9)₂Cl]₂ | 81% |
| | | wie [Ir(LH1)₂Cl]₂ | |
| [Ir(LH10)₂Cl]₂ | LH10 | [Ir(LH10)₂Cl]₂ | 80% |
| | | wie [Ir(LH1)₂Cl]₂ | |
| [Ir(LH12)₂Cl]₂ | LH12 | [Ir(LH12)₂Cl]₂ | 76% |
| | | wie [Ir(LH1)₂Cl]₂ | |
| [Ir(LH14)₂Cl]₂ | LH14 | [Ir(LH14)₂Cl]₂ | 78% |
| | | wie [Ir(LH1)₂Cl]₂ | |
| [Ir(LH15)₂Cl]₂ | LH15 | [Ir(LH15)₂Cl]₂ | 78% |
| | | wie [Ir(LH1)₂Cl]₂ | |
| [Ir(LH16)₂Cl]₂ | LH16 | [Ir(LH16)₂Cl]₂ | 79% |
| | | wie [Ir(LH1)₂Cl]₂ | |
| [Ir(LH17)₂Cl]₂ | LH17 | [Ir(LH17)₂Cl]₂ | 46% |
| | | wie [Ir(LH1)₂Cl]₂ | |
| [Ir(LH18)₂Cl]₂ | LH18 | [Ir(LH18)₂Cl]₂ | 38% |
| | | wie [Ir(LH1)₂Cl]₂ | |
| [Ir(LH19)₂Cl]₂ | LH19 | [Ir(LH19)₂Cl]₂ | 40% |
| | | wie [Ir(LH1)₂Cl]₂ | |
| [Ir(LH20)₂Cl]₂ | LH20 | 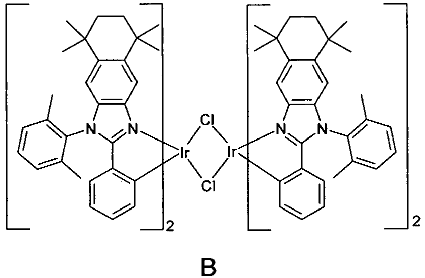 | 84% |
| | | 250 °C / 80 h | |
| [Ir(LH21)₂Cl]₂ | LH21 | [Ir(LH21)₂Cl]₂ | 86% |
| | | wie [Ir(LH20)₂Cl]₂ | |
| [Ir(LH22)₂Cl]₂ | LH22 | [Ir(LH22)₂Cl]₂ | 83% |
| | | wie [Ir(LH20)₂Cl]₂ | |
| [Ir(LH26)₂Cl]₂ | LH26 | 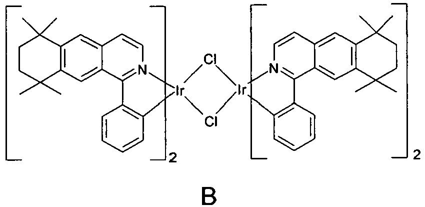 | 85% |
| | | 240 °C / 60 h | |
| [Ir(LH27)₂Cl]₂ | LH27 | [Ir(LH27)₂Cl]₂ | 85% |
| | | wie [Ir(LH26)₂Cl]₂ | |
| [Ir(LH28)₂Cl]₂ | LH28 | [Ir(LH28)₂Cl]₂ | 83% |
| | | wie [Ir(LH26)₂Cl]₂ | |
| [Ir(LH29)₂Cl]₂ | LH29 | [Ir(LH29)₂Cl]₂ | 67% |
| | | wie [Ir(LH26)₂Cl]₂ | |
| [Ir(LH30)₂Cl]₂ | LH30 | [Ir(LH30)₂Cl]₂ | 83% |
| | | wie [Ir(LH26)₂Cl]₂ | |
| [Ir(LH31)₂Cl]₂ | LH31 | [Ir(LH31)₂Cl]₂ | 85% |
| | | wie [Ir(LH26)₂Cl]₂ | |
| [Ir(LH32)₂Cl]₂ | LH32 | [Ir(LH32)₂Cl]₂ | 86% |
| | | wie [Ir(LH26)₂Cl]₂ | |
| [Ir(LH33)₂Cl]₂ | LH33 | [Ir(LH32)₂Cl]₂ | 86% |
| | | B | |
| | | 260 °C / 30 h | |
| [Ir(LH34)₂Cl]₂ | LH34 | [Ir(LH34)₂C)]₂ | 88% |
| | | wie [Ir(LH33)₂C)]₂ | |
| [Ir(LH35)₂Cl]₂ | LH35 | 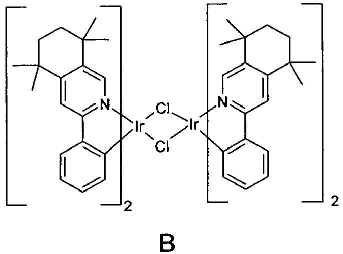 | 86% |
| | | 255 °C / 25 h | |
| [Ir(LH36)₂Cl]₂ | LH36 | [Ir(LH36)₂Cl]₂ | 90% |
| | | wie [Ir(LH35)₂Cl]₂ | |
| [Ir(LH37)₂Cl]₂ | LH37 | [Ir(LH37)₂Cl]₂ | 88% |
| | | wie [Ir(LH35)₂Cl]₂ | |
| [Ir(LH38)₂Cl]₂ | LH38 | [Ir(LH38)₂Cl]₂ | 89% |
| | | wie [Ir(LH35)₂Cl]₂ | |
| [Ir(LH39)₂Cl]₂ | LH39 | [Ir(LH39)₂Cl]₂ | 87% |
| | | wie [Ir(LH35)₂Cl]₂ | |
| [Ir(LH40)₂Cl]₂ | LH40 | [Ir(LH40)₂Cl]₂ | 63% |
| | | B | |
| | | 265 °C / 35 h | |
| [Ir(LH41)₂Cl]₂ | LH41 | [Ir(LH41)₂Cl]₂ | 89% |
| | | wie [Ir(LH35)₂Cl]₂ | |
| [Ir(LH42)₂Cl]₂ | LH42 | [Ir(LH42)₂Cl]₂ | 89% |
| | | wie [Ir(LH35)₂Cl]₂ | |
| [Ir(LB1)₂Cl]₂ | LB1 | 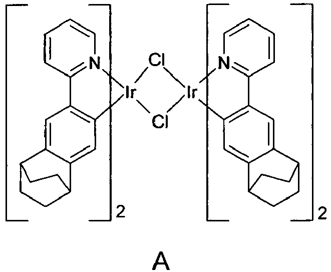 | 76% |
| [Ir(LB2)₂Cl]₂ | LB2 | 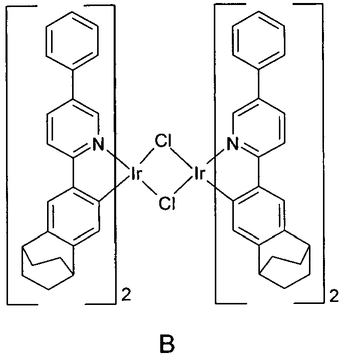 | 76% |
| | | 240 °C / 20 h | |
| [Ir(LB5)₂C)]₂ | LB5 | [Ir(LB5)₂Cl]₂ | 79% |
| | | wie [Ir(LB1)₂Cl]₂ | |
| [Ir(LB9)₂Cl]₂ | LB9 | [Ir(LB9)₂Cl]₂ | 81% |
| | | wie [Ir(LB2)₂Cl]₂ | |
| [Ir(LB10)₂Cl]₂ | LB10 | [Ir(LB10)₂Cl]₂ | 76% |
| | | wie [Ir(LB1)₂Cl]₂ | |
| [Ir(LB16)₂Cl]₂ | LB16 | [Ir(LB16)₂Cl]₂ | 82% |
| | | wie [Ir(LB2)₂Cl]₂ | |
| [Ir(LB26)₂Cl]₂ | LB26 | 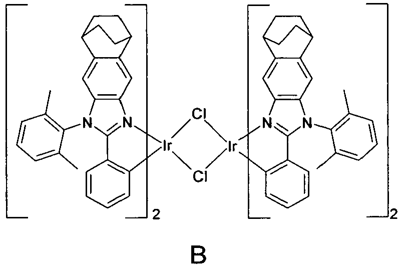 | 75% |
| | | 270 °C / 60 h | |
| [Ir(LB30)₂Cl]₂ | LB30 | 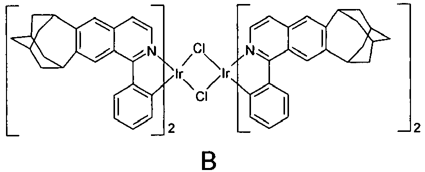 | 83% |
| | | 245 °C / 24 h | |
| [Ir(LB31)₂Cl]₂ | LB31 | 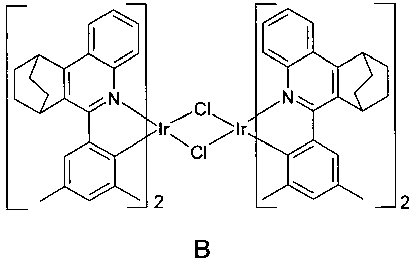 | 81% |
| | | 250 °C / 50 h | |
| [Ir(LB33)₂Cl]₂ | LB33 | 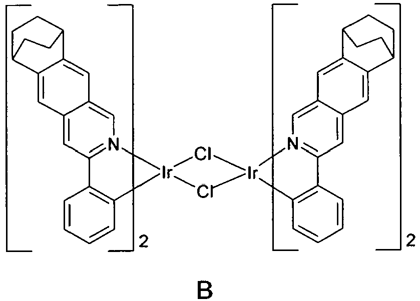 | 88% |
| | | 260 °C / 30 h | |
| [Ir(LB36)₂Cl]₂ | LB36 | 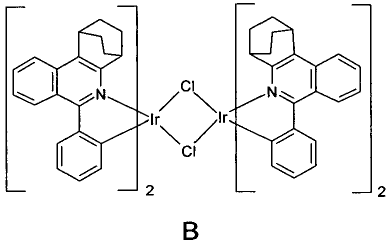 | 53% |
| | | 280 °C / 40 h | |
| [Ir(LB37)₂Cl)₂ | LB37 | 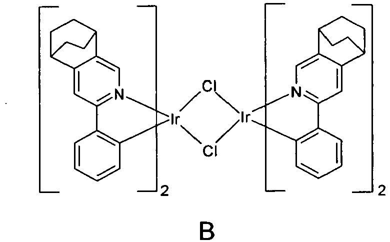 | 88% |
| | | 260 °C / 30 h | |
| [Ir(LB38)₂Cl]₂ | LH42 | [Ir(LB38)₂Cl]₂ wie [Ir(LH35)₂Cl]₂ | 87% |

### 4) Iridium-Komplexe vom Typ [Ir(L)₂(HOMe)₂]OTf

Eine Suspension von 5 mmol des Chloro-Dimers [Ir(L)₂Cl]₂ in 150 ml Dichlormethan wird mit 5 ml Methanol und dann mit 10 mmol Silber(I)trifluormethansulfonat [2923-28-6] versetzt und 18 h bei Raumtemperatur gerührt. Man saugt vom ausgefallenen Silber(I)chlorid über ein Celite-Bett ab, engt das Filtrat zur Trockene ein, nimmt den gelben Rückstand in 30 ml Toluol oder Cyclohexan auf, filtriert vom Feststoff ab, wäscht diesen mit n-Heptan und trocknet im Vakuum. Das so erhaltene Produkt der Formel [Ir(L)₂(HOMe)₂]OTf wird ohne Reinigung weiter umgesetzt.

| **Bsp.** | **[Ir(L)₂Cl]₂** | **[Ir(L)₂(HOMe)₂]OTf** | **Aus beute** |
|---|---|---|---|
| [Ir(LP1)₂(HOMe)₂]OTf | Ir[(LP1)Cl]₂ | 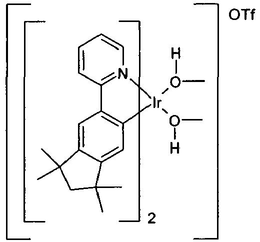 | 81% |
| [Ir(LP2)₂(HOMe)₂]OTf | [Ir(LP2) ₂Cl]₂ | [Ir(LP2)₂(HOMe)₂]OTf | 79% |
| [Ir(LH1)₂(HOMe)₂]OTf | [Ir(LH1)₂Cl]₂ | 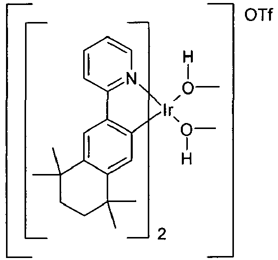 | |
| | | Ir(LH1)₂(HOMe)₂]OTf | |
| [Ir(LH2)₂(HOMe)₂₂OTf | [Ir(LH2)₂Cl]₂ | [Ir(LH2)₂(HOMe)₂]OTf | 80% |
| [Ir(LH3)₂(HOMe)₂]OTf | [Ir(LH3)₂Cl]₂ | [Ir(LH3)₂(HOMe)₂]OTf | 78% |
| [Ir(LH4)₂(HOMe)₂]OTf | [Ir(LH4)₂Cl]₂ | [Ir(LH4)₂(HOMe)₂]OTf | 81% |
| [Ir(LH5)₂(HOMe)₂]OTf | [Ir(LH5)₂Cl]₂ | [Ir(LH5)₂(HOMe)₂]OTf | 83% |
| [Ir(LH6)₂(HOMe)₂]OTf | [Ir(LH6)₂Cl]₂ | [Ir(LH6)₂(HOMe)₂]OTf | 80% |
| [Ir(LH7)₂(HOMe)₂]OTf | [Ir(LH7)₂Cl]₂ | [Ir(LH7)₂(HOMe)₂]OTf | 81% |
| [Ir(LH9)₂(HOMe)₂]OTf | [Ir(LH9)₂Cl]₂ | [Ir(LH9)₂(HOMe)₂]OTf | 81% |
| [Ir(LH10)₂(HOMe)₂]OTf | [Ir(LH10)₂Cl]₂ | [Ir(LH10)₂(HOMe)₂]OTf | 86% |
| [Ir(LH12)₂(HOMe)₂]OTf | [Ir(LH12)₂Cl]₂ | [Ir(LH12)₂(HOMe)₂]OTf | 79% |
| [Ir(LH14)₂(HOMe)₂]OTf | [Ir(LH14)₂Cl]₂ | [Ir(LH14)₂(HOMe)₂]OTf | 80% |
| [Ir(LH15)₂(HOMe)₂]OTf | [Ir(LH15)₂Cl]₂ | [Ir(LH15)₂(HOMe)₂]OTf | 83% |
| [Ir(LH16)₂(HOMe)₂]OTf | [Ir(LH16)₂Cl]₂ | [Ir(LH16)₂(HOMe)₂]OTf | 78% |
| [Ir(LH17)₂(HOMe)₂]OTf | [Ir(LH17)₂Cl]₂ | [Ir(LH17)₂(HOMe)₂]OTf | 80% |
| [Ir(LH18)₂(HOMe)₂]OTf | [Ir(LH18)₂Cl]₂ | [Ir(LH18)₂(HOMe)₂]OTf | 82% |
| [Ir(LH19)₂(HOMe)₂]OTf | [Ir(LH19)₂Cl]₂ | [Ir(LH19)₂(HOMe)₂]OTf | 80% |
| [Ir(LH20)₂(HOMe)₂]OTf | [Ir(LH20)₂Cl]₂ | [Ir(LH20)₂(HOMe)₂]OTf | 85% |
| [Ir(LH21)₂(HOMe)₂]OTf | [Ir(LH21)₂Cl]₂ | [Ir(LH21)₂(HOMe)₂]OTf | 86% |
| [Ir(LH22)₂(HOMe)₂]OTf | [Ir(LH22)₂Cl]₂ | [Ir(LH22)₂(HOMe)₂]OTf | 80% |
| [Ir(LH26)₂(HOMe)₂]OTf | [Ir(LH26)₂Cl]₂ | [Ir(LH26)₂(HOMe)₂]OTf | 85% |
| [Ir(LH27)₂(HOMe)₂]OTf | [Ir(LH27)₂Cl]₂ | [Ir(LH27)₂(HOMe)₂]OTf | 84% |
| [Ir(LH28)₂(HOMe)₂]OTf | [Ir(LH28)₂Cl]₂ | [Ir(LH28)₂(HOMe)₂]OTf | 82% |
| [Ir(LH29)₂(HOMe)₂]OTf | [Ir(LH29)₂Cl]₂ | [Ir(LH29)₂(HOMe)₂]OTf | 85% |
| [Ir(LH30)₂(HOMe)₂]OTf | [Ir(LH30)₂Cl]₂ | [Ir(LH30)₂(HOMe)₂]OTf | 84% |
| [Ir(LH31)₂(HOMe)₂]OTf | [Ir(LH31)₂Cl]₂ | [Ir(LH31)₂(HOMe)₂]OTf | 79% |
| [Ir(LH32)₂(HOMe)₂]OTf | [Ir(LH32)₂Cl]₂ | [Ir(LH32)₂(HOMe)₂]OTf | 80% |
| [Ir(LH33)₂(HOMe)₂]OTf | [Ir(LH33)₂Cl]₂ | [Ir(LH33)₂(HOMe)₂]OTf | 82% |
| [Ir(LH34)₂(HOMe)₂]OTf | [Ir(LH34)₂Cl]₂ | [Ir(LH34)₂(HOMe)₂]OTf | 83% |
| [Ir(LH35)₂(HOMe)₂]OTf | [Ir(LH35)₂Cl]₂ | [Ir(LH35)₂(HOMe)₂]OTf | 85% |
| [Ir(LH36)₂(HOMe)₂]OTf | [Ir(LH36)₂Cl]₂ | [Ir(LH36)₂(HOMe)₂]OTf | 81% |
| [Ir(LH37)₂(HOMe)₂]OTf | [Ir(LH37)₂Cl]₂ | [Ir(LH37)₂(HOMe)₂]OTf | 80% |
| [Ir(LH38)₂(HOMe)₂]OTf | [Ir(LH38)₂Cl]₂ | [Ir(LH38)₂(HOMe)₂]OTf | 85% |
| [Ir(LH39)₂(HOMe)₂]OTf | [Ir(LH39)₂Cl]₂ | [Ir(LH39)₂(HOMe)₂]OTf | 80% |
| [Ir(LH40)₂(HOMe)₂]OTf | [Ir(LH40)₂Cl]₂ | [Ir(LH40)₂(HOMe)₂]OTf | 84% |
| [Ir(LH41)₂(HOMe)₂]OTf | [Ir(LH41)₂Cl]₂ | [Ir(LH41)₂(HOMe)₂]OTf | 84% |
| [Ir(LH42)₂(HOMe)₂]OTf | [Ir(LH42)₂Cl]₂ | [Ir(LH42)₂(HOMe)₂]OTf | 86% |
| [Ir(LB1)₂(HOMe)₂]OTf | [Ir(LB1)₂Cl]₂ | 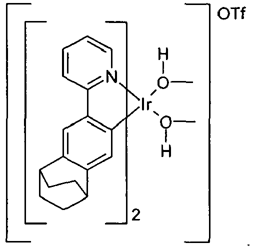 | 82% |
| | | [Ir(LB1)₂(HOMe)₂]OTf | |
| [Ir(LB2)₂(HOMe)₂]OTf | [Ir(LB2)₂Cl]₂ | [Ir(LB2)₂(HOMe)₂]OTf | 75% |
| [Ir(LB5)₂(HOMe)₂]OTf | [Ir(LB5)₂Cl]₂ | [Ir(LB5)₂(HOMe)₂]OTf | 78% |
| [Ir(LB9)₂(HOMe)₂]OTf | [Ir(LB9)₂Cl]₂ | [Ir(LB9)₂(HOMe)₂]OTf | 79% |
| [Ir(LB10)₂(HOMe)₂]OTf | [Ir(LB10)₂Cl]₂ | [Ir(LB10)₂(HOMe)₂]OTf | 80% |
| [Ir(LB16)₂(HOMe)₂]OTf | [Ir(LB16)₂Cl]₂ | [Ir(LB16)₂(HOMe)₂]OTf | 78% |
| [Ir(LB26)₂(HOMe)₂]OTf | [Ir(LB26)₂Cl]₂ | [Ir(LB26)₂(HOMe)₂]OTf | 78% |
| [Ir(LB30)₂(HOMe)₂]OTf | [Ir(LB30)₂Cl]₂ | [Ir(LB30)₂(HOMe)₂]OTf | 82% |
| [Ir(LB31)₂(HOMe)₂]OTf | [Ir(LB31)₂Cl]₂ | [Ir(LB31)₂(HOMe)₂]OTf | 82% |
| [Ir(LB33)₂(HOMe)₂]OTf | [Ir(LB33)₂Cl]₂ | [Ir(LB33)₂(HOMe)₂]OTf | 76% |
| [Ir(LB36)₂(HOMe)₂]OTf | [Ir(LB36)₂Cl]₂ | [Ir(LB36)₂(HOMe)₂]OTf | 75% |
| [Ir(LB37)₂(HOMe)₂]OTf | [Ir(LB37)₂Cl]₂ | [Ir(LB37)₂(HOMe)₂]OTf | 77% |
| [Ir(LB38)₂(HOMe)₂]OTf | [Ir(LB38)₂Cl]₂ | [Ir(LB38)₂(HOMe)₂]OTf | 74% |

### 5) Heteroleptische Iridium-Komplexe vom Phenylpyridin-, Phenylimidazol- bzw. Phenylbenzimidazol-Typ :

Ein Gemisch aus 10 mmol des Liganden L, 10 mmol Bis(methanol)bis[2-(2-pyridinyl-κN]phenyl-κC]iridium(III)-trifluormethansulfonat [1215692-14-0] bzw. Bis(methanol)bis[2-(6-methyl-2-pyridinyl-κN]phenyl-κC]iridium(III)-trifluormethansulfonat [1215692-29-7] bzw. erfindungsgemäße Iridium-Komplexe vom Typ [Ir(L)₂(HOMe)_{2]}OTf, 11 mmol 2,6-Dimethylpryridin und 150 ml Ethanol wird 40 h unter Rückfluss erhitzt. Nach Erkalten saugt man vom ausgefallenen Feststoff ab, wäscht diesen dreimal mit je 30 ml Ethanol und trocknet im Vakuum. Das so erhaltene Rohprodukt wird an Kieselgel (Lösemittel bzw. deren Gemische, z.B. DCM, THF, Toluol, n-Heptan, Cyclohexan) chromatographiert, und wie unter 1) Variante A beschrieben fraktioniert sublimiert.

| **Bsp.** | **[Ir(L)₂(HOMe)₂]OTf Ligand L** | **Ir-Komplex Diastereomer** | **Ausbeute** |
|---|---|---|---|
| Ir500 | 1215692-14-0 LH1 | 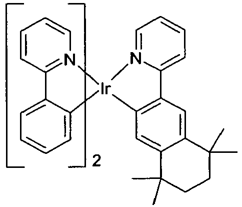 | 44% |
| Ir501 | 1215692-14-0 LH2 | 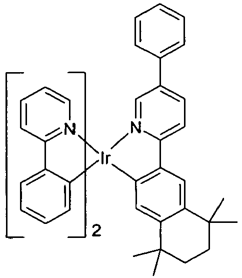 | 43% |
| Ir502 | 1215692-14-0 LH3 | 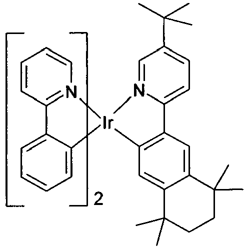 | 45% |
| Ir503 | 1215692-29-7 LH4 | 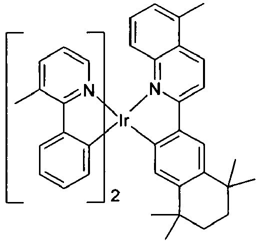 | 27% |
| Ir504 | 1215692-14-0 LH5 | 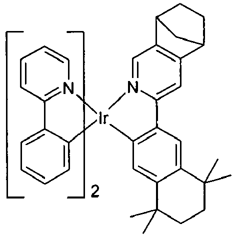 | 38% |
| | | Diastereomerengemisch | |
| Ir505 | 1215692-14-0 LH6 | 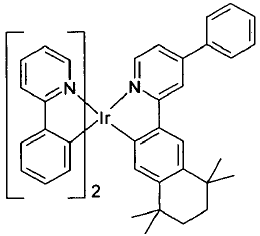 | 50% |
| Ir506 | 1215692-14-0 LH7 | 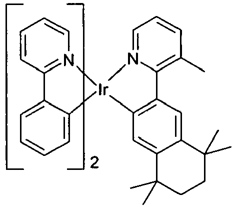 | 48% |
| Ir507 | 1215692-14-0 LH8 | 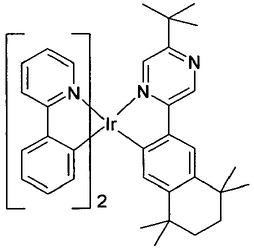 | 24% |
| IR508 | 1215692-14-0 LH9 | 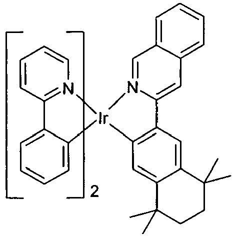 | 42% |
| Ir509 | 1215692-14-0 LH10 | 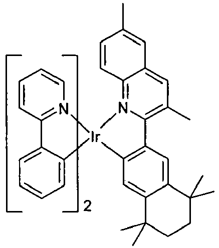 | 23% |
| Ir510 | 1215692-14-0 LH11 | 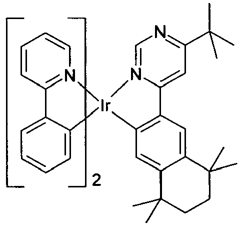 | 26% |
| Ir511 | 1215692-29-7 LH12 | 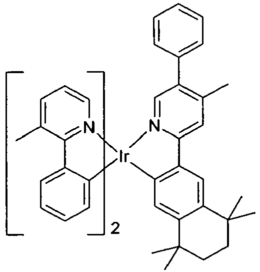 | 44% |
| Ir512 | 1215692-29-7 LH13 | 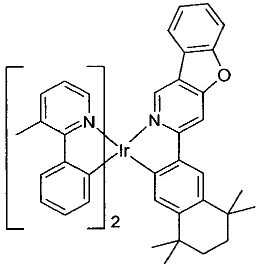 | 46% |
| Ir513 | 1215692-14-0 LH14 | 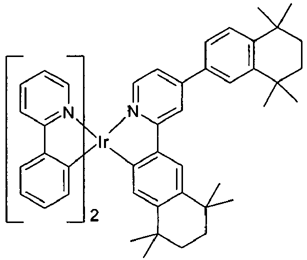 | 43% |
| Ir514 | 1215692-14-0 LH15 | 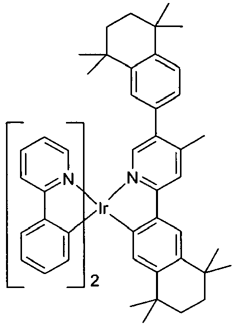 | 52% |
| Ir515 | 1215692-14-0 LH16 | 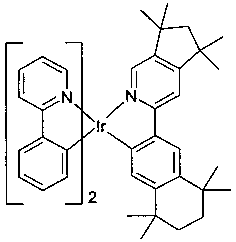 | 40% |
| Ir516 | 1215692-14-0 LH17 | 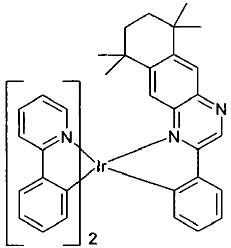 | 23% |
| Ir517 | 1215692-14-0 LH18 | 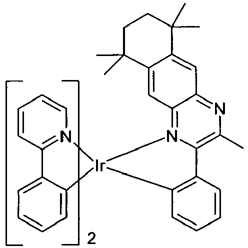 | 21% |
| Ir518 | 1215692-14-0 LH19 | 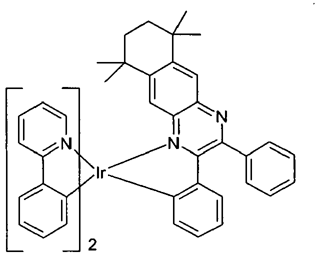 | 25% |
| Ir519 | 1215692-14-0 LH20 | 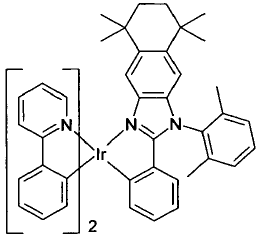 | 25% |
| Ir520 | 1215692-14-0 LH26 | 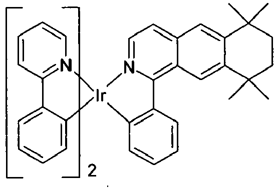 | 45% |
| Ir521 | 1215692-14-0 LH27 | 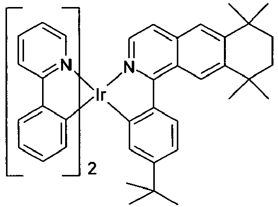 | 41% |
| Ir522 | 1215692-14-0 LH30 | 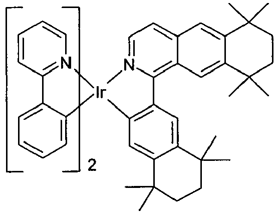 | 38% |
| Ir523 | 1215692-14-0 LH31 | 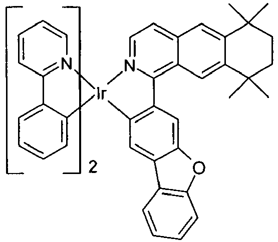 | 43% |
| Ir524 | 1215692-14-0 LH33 | 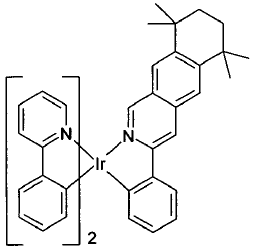 | 43% |
| Ir525 | 1215692-14-0 LH34 | 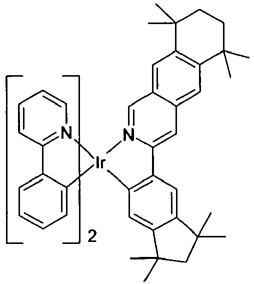 | 43% |
| Ir526 | 1215692-14-0 LH35 | 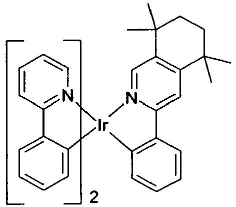 | 43% |
| Ir527 | 1215692-14-0 LH36 | 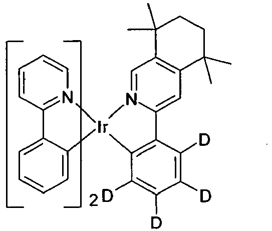 | 43% |
| Ir528 | 1215692-14-0 LH37 | 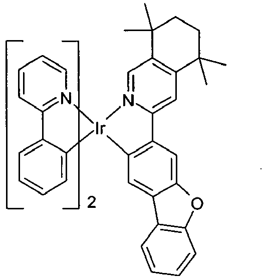 | 43% |
| Ir529 | 1215692-14-0 LH41 | 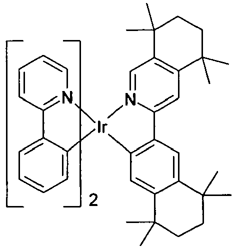 | 43% |
| Ir530 | 1215692-14-0 LH42 | 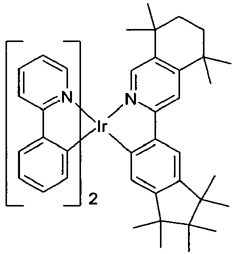 | 43% |
| Ir531 | 1215692-14-0 LB38 | 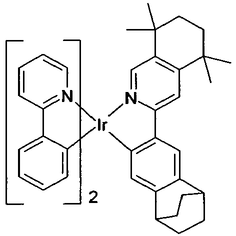 | 43% |
| Ir532 | [Ir(LP1)₂(HOMe)₂]OTf LH1 | 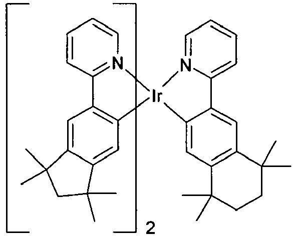 | 46% |
| Ir533 | [Ir(LP2)₂(HOMe)₂]OTf LH2 | 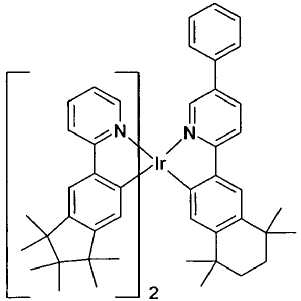 | 44% |
| Ir534 | [Ir(LH1)₂(HOMe)₂]OTf 1008-89-56 | 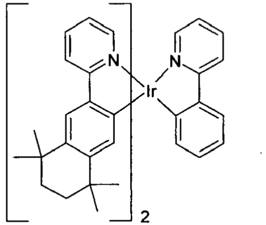 | 46% |
| Ir535 | [Ir(LH2)₂(HOMe)₂]OTf 1008-89-56 | 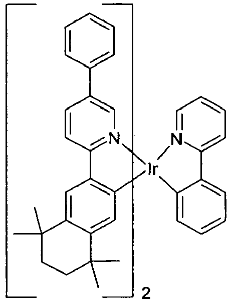 | 50% |
| Ir536 | [Ir(LH3)₂(HOMe)₂]OTf 1008-89-56 | 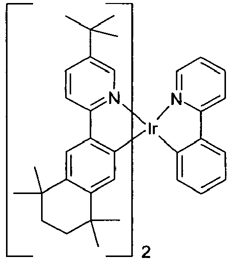 | 43% |
| Ir537 | [Ir(LH6)₂(HOMe)₂]OTf 10273-90-2 | 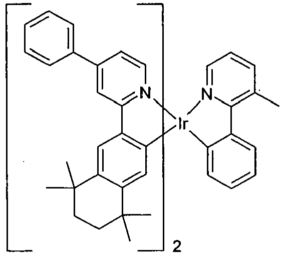 | 45% |
| Ir538 | [Ir(LH7)₂(HOMe)₂]OTf 10273-90-2 | 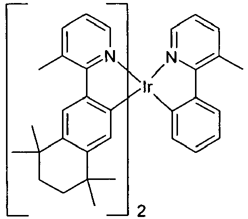 | 38% |
| Ir539 | [Ir(LH9)₂(HOMe)₂]OTf 458541-39-4 | 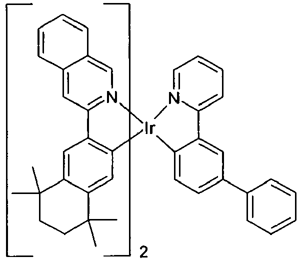 | 46% |
| Ir540 | [Ir(LH12)₂(HOMe)₂]OTf 1008-89-56 | 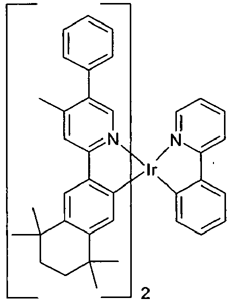 | 45% |
| Ir541 | [Ir(LH14)₂(HOMe)₂]OTf 1008-89-56 | 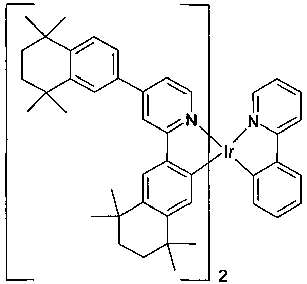 | 40% |
| Ir542 | [Ir(LH15)₂(HOMe)₂]OTf 1008-89-56 | 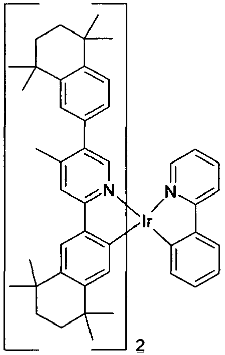 | 40% |
| Ir543 | [Ir(LH16)₂(HOMe)₂]OTf LH1 | 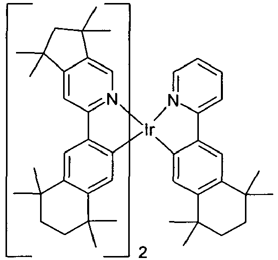 | 42% |
| Ir544 | [Ir(LH20)₂(HOMe)₂]OTf 340026-65-5 | 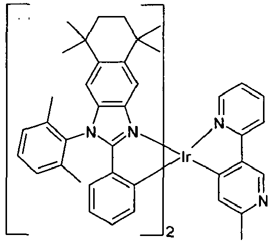 | 20% |
| Ir545 | [Ir(LH21)₂(HOMe)₂]OTf 1008-89-56 | 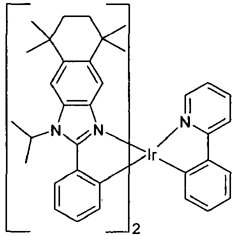 | 26% |
| Ir546 | [Ir(LH22)₂(HOMe)₂]OTf 4350-51-0 | 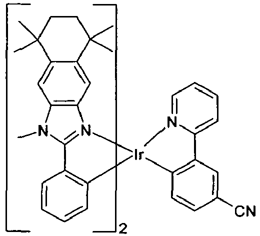 | 29% |
| Ir547 | [Ir(LH26)₂(HOMe)₂]OTf 1008-89-56 | 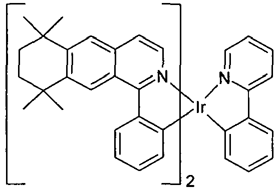 | 45% |
| Ir548 | [Ir(LH27)₂(HOMe)₂]OTf 37993-76-3 | 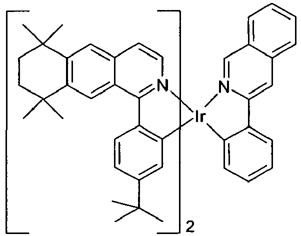 | 43% |
| Ir549 | [Ir(LH28)₂(HOMe)₂]OTf 37993-76-3 | 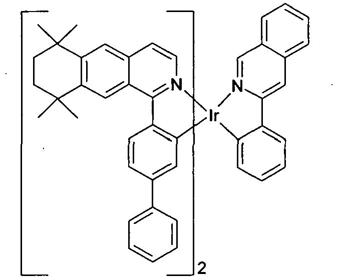 | 43% |
| Ir550 | [Ir(LH29)₂(HOMe)₂]OTf 230-27-3 | 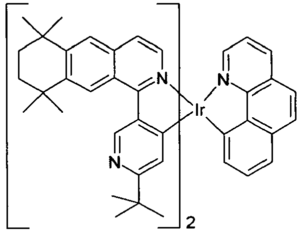 | 21% |
| Ir551 | [Ir(LH30)₂(HOMe)₂]OTf LP2 | 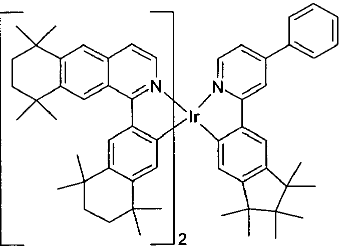 | 38% |
| Ir552 | [Ir(LH31)₂(HOMe)₂]OTf LB18 | 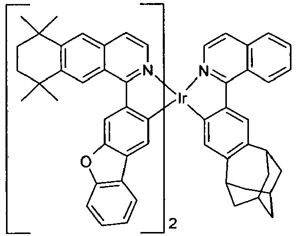 | 36% |
| Ir553 | [Ir(LH32)₂(HOMe)₂]OTf LB19 | 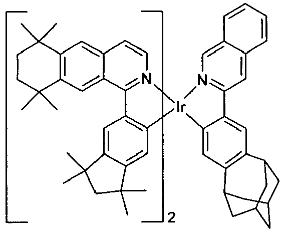 | 39% |
| Ir554 | [Ir(LH33)₂(HOMe)₂]OTf 1008-89-56 | 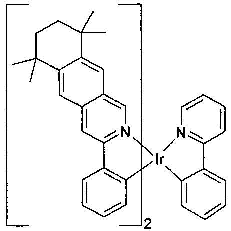 | 48% |
| Ir555 | [Ir(LH34)₂(HOMe)₂]OTf LH33 | 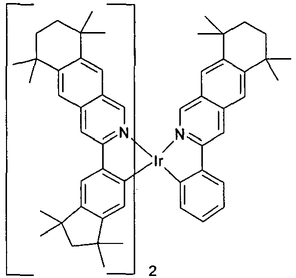 | 45% |
| Ir556 | [Ir(LH35)₂(HOMe)₂]OTf 1008-89-56 | 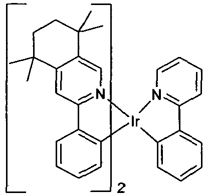 | 47% |
| Ir557 | [Ir(LH36)₂(HOMe)₂]OTf LH1 | 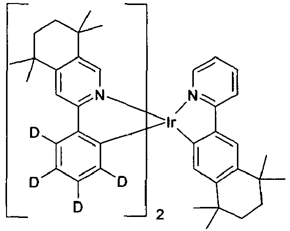 | 36% |
| Ir558 | [Ir(LH37)₂(HOMe)₂]OTf 26274-35-1 | 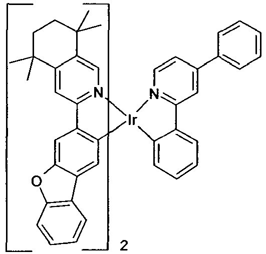 | 41% |
| Ir559 | [Ir(LH)38₂(HOMe)₂]OTf LB37 | 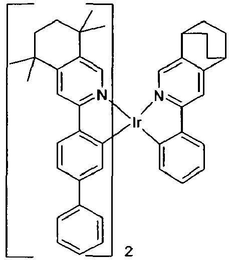 | 45% |
| Ir560 | [Ir(LH39)₂(HOMe)₂]OTf LH6 | 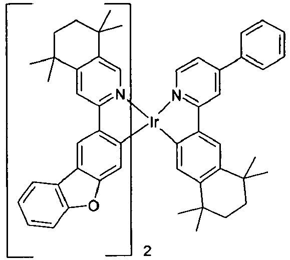 | 42% |
| Ir561 | [Ir(LH40)₂(HOMe)₂]OTf 4350-51-0 | 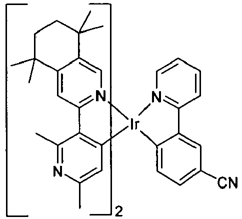 | 31% |
| Ir562 | [Ir(LH41)₂(HOMe)₂]OTf 1008-89-56 | 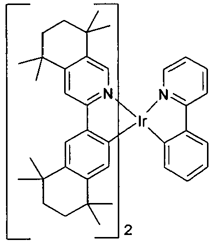 | 46% |
| Ir563 | [Ir(LH42)₂(HOMe)₂]OTf 1008-89-56 | 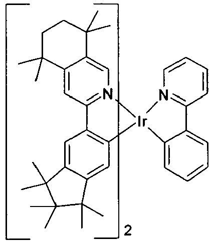 | 45% |
| Ir564 | [Ir(LB1)₂(HOMe)₂]OTf LH1 | 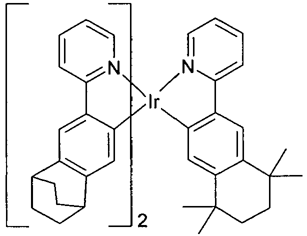 | 44% |
| Ir565 | [Ir(LB2)₂(HOMe)₂]OTf LH38 | 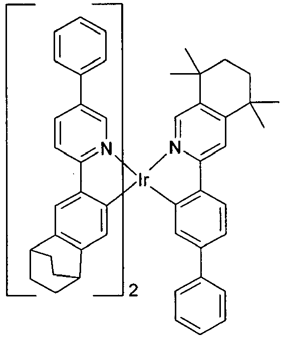 | 39% |
| Ir566 | [Ir(LB3)₂(HOMe)₂]OTf LH35 | 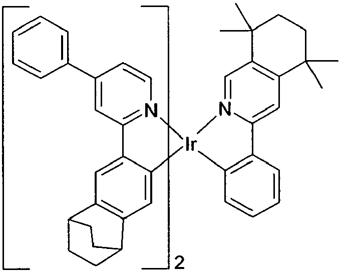 | 40% |
| Ir567 | [Ir(LB1O)₂(HOMe)₂]OTf LH35 | 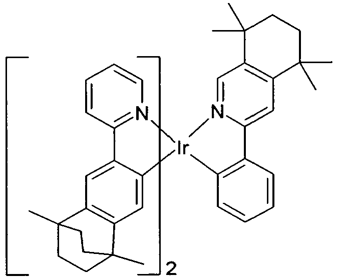 | 41% |
| Ir568 | [Ir(LB16)₂(HOMe)₂]OTf LH38 | 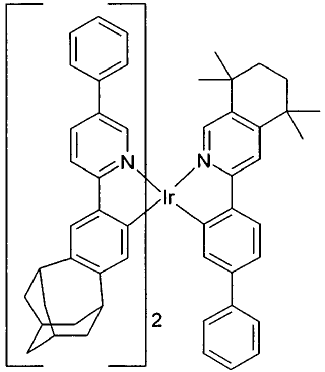 | 39% |
| Ir569 | [Ir(LB33)₂(HOMe)₂]OTf LH1 | 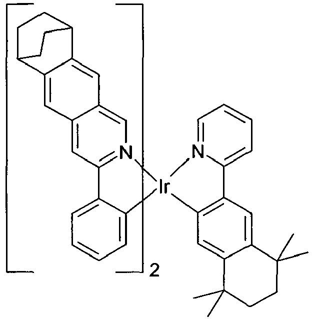 | 40% |
| Ir570 | [Ir(LB37)₂(HOMe)₂]OTf LH35 | 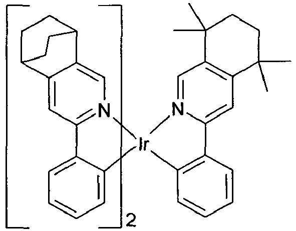 | 45% |
| Ir571 | [Ir(LB38)₂(HOMe)₂]OTf 1008-89-56 | 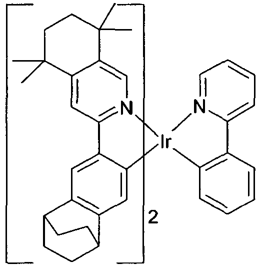 | 47% |

### 6) Heteroleptische tris-faciale Iridium-Komplexe enthaltend Liganden vom Arduengo-Carben-Typ:

Darstellung analog A. G. Tennyson et al., Inorg. Chem., 2009, 48, 6924. Ein Gemisch aus 22 mmol des Liganden, 10 mmol Iridium-Chloro-Dimer [Ir(L)₂Cl]₂, 10 mmol Siber(I)oxid und 300 ml 1,2-Dichlorethan wird 30 h bei 90 °C gerührt. Nach Erkalten saugt man vom ausgefallenen Feststoff über ein Celite-Bett ab, wäscht diesen einmal mit 30 ml 1,2-Dichlorethan und engt das Filtrat im Vakuum zur Trockene ein. Das so erhaltene Rohprodukt wird an Kieselgel (Lösemittel bzw. deren Gemische, z. B. Dichlormethan, THF, Toluol, n-Heptan, Cyclohexan) chromatographiert, und wie unter 1) Variante A beschrieben fraktioniert sublimiert.

| **Bsp.** | **[Ir(L)₂Cl]₂ Ligand L** | **Ir-Komplex Diastereomer** | **Ausbeute** |
|---|---|---|---|
| Ir572 | [Ir(PPy)₂Cl]₂ 603109-48-4 LH23 | 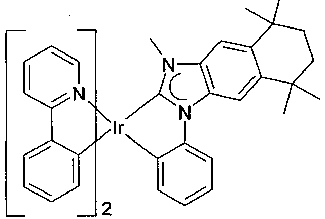 | 43% |
| Ir573 | [Ir(LH20)₂Cl]₂ LH24 | 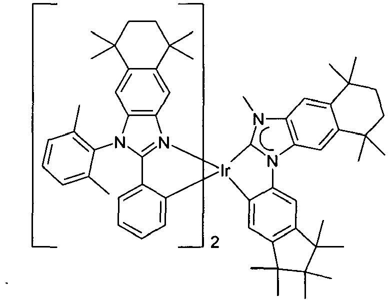 | 45% |

### 7) Platin-Komplexe tetradentater Liganden:

Ein Gemisch aus 10 mmol des Liganden L, 10 mmol K₂PtCl₄, 400 mmol Lithiumacetat, wasserfrei, und 200 ml Eisessig wird 60 h unter Rückfluss erhitzt. Nach Erkalten und Zugabe von 200 ml Wasser extrahiert man zweimal mit je 250 ml Toluol, trocknet über Magnesiumsulfat, filtriert über ein Celite-Bett ab, wäscht das Celite mit 200 ml Toluol nach und entfernt dann das Toluol im Vakuum. Der so erhaltene Feststoff wird wie unter 1) Variante A beschrieben durch Heißextraktion gereinigt und dann fraktioniert sublimiert.

| **Bsp.** | **Ligand L** | **Pt-Komplex** | **Extraktionsmittel** | **Ausbeute** |
|---|---|---|---|---|
| Pt(LH43) | LH43 | 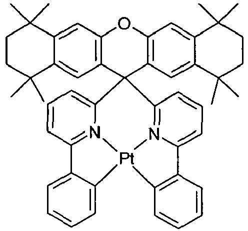 | Toluol | 40% |
| Pt(LH44) | LH44 | Pt(LH44) | Toluol | 19% |
| Pt(LH45) | LH45 | Pt(LH45) | Cyclohexan | 37% |

### 10) Platin-Komplexe tetradentater Liganden vom Arduengo-Carben-Typ:

Ein Gemisch aus 10 mmol des Liganden, 10 mmol Silber(I)oxid und 200 ml Dioxan wird 16 h bei Raumtemperatur gerührt, dann mit 100 ml Butanon, 20 mmol Natriumcarbonat und 10 mmol Cyclooctadienyl-platin-dichlorid versetzt und 16 h unter Rückfluss erhitzt. Nach Entfernen des Lösungsmittels wird der Feststoff mit 500 ml heißem Toluol ausgerührt, die Suspension wird über ein Celite-Bett filtriert und das Filtrat wird zur Trockene eingeengt. Der so erhaltene Feststoff wird an Kieselgel mit DCM chromatographiert und dann wie unter 1) Variante A beschrieben fraktioniert sublimiert.

| **Bsp.** | **Ligand** | **Pt-Komplex** | **Ausbeute** |
|---|---|---|---|
| Pt(LH46) | LH46 | 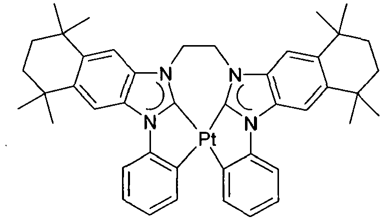 | 25% |
| Pt(LH47) | LH47 | Pt(LH47) | 28% |

### 11) Iridium-Komplexe hexadentater Liganden:

Ein Gemisch aus 10 mmol des Liganden L, 10 mmol Natrium-bis-acetylacetonato-dichloro-iridat(III) [770720-50-8] und 200 ml Triethylenglycoldimethylether wird 48 h bei 210 °C am Wasserabscheider (das Acetylaceton und thermische Spaltprodukte des Lösungsmittel destillieren ab) erhitzt. Nach Erkalten und Zugabe von 200 ml Wasser saugt man vom ausgefallenen Feststoff ab und trocknet im Vakuum. Der Festoff wird mit 500 ml heißem THF ausgerührt, die Suspension wird noch heiß über ein Celite-Bett abfiltriert, das Celite wird mit 200 ml THF nachgewaschen und die vereinigten Filtrate werden zur Trockene eingeengt. Der so erhaltene Feststoff wird wie unter 1) Variante A beschrieben durch Heißextraktion mit Toluol gereinigt und dann fraktioniert sublimiert.

| **Bsp.** | **Ligand** | **Ir-Komplex** | **Ausbeute** |
|---|---|---|---|
| Ir(LH48) | LH48 | 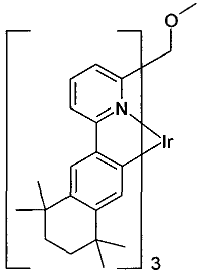 | 21% |
| Ir(LH49) | LH49 | Ir(LH49) | 22% |
| Ir(LH50) | LH50 | Ir(LH50) | 19% |

### 12) Iridium-Komplexe hexadentater Liganden vom Arduengo-Carben-Typ:

Darstellung analog K. Tsuchiya et al., Eur. J. Inorg. Chem. 2010, 926. Ein Gemisch aus 3 mmol des Liganden, 3 mmol Iridium(III)chlorid-Hydrat, 10 mmol Silbercarbonat und 10 mmol Natriumcarbonat in 75 ml 2-Ethoxyethanol wird 48 h unter Rückfluss erwärmt. Nach Erkalten gibt man 300 ml Wasser zu, saugt vom ausgefallenen Feststoff ab, wäscht diesen einmal mit 30 ml Wasser und dreimal mit je 15 ml Ethanol und trocknet im Vakuum. Das so erhaltene Rohprodukt wird an Kieselgel (DCM) chromatographiert und dann wie unter 1) Variante A beschrieben fraktioniert sublimiert.

| **Bsp.** | **Ligand** | **Ir-Komplex** | **Ausbeute** |
|---|---|---|---|
| Ir(LH51) | LH51 | 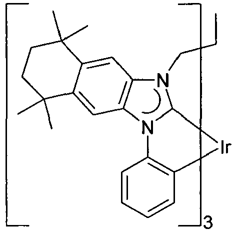 | 23% |
| Ir(LH52) | LH52 | Ir(LH52) | 17% |

### Derivatisierung der Metallkomplexe

### 1) Halogenierung der fac-Iridium-Komplexe:

Eine Lösung bzw. Suspension von 10 mmol eines Komplexes, der in para-Position zum Iridium A x C-H-Gruppen (mit A = 1, 2 oder 3) trägt, in 500 ml Dichlormethan wird unter Licht- und Luftausschluss bei 30 °C mit A x 10.5 mmol N-Halogensuccinimid (Halogen: Cl, Br, I) versetzt und 20 h gerührt. In DCM schlecht lösliche Komplexe können auch in anderen Lösungsmitteln (TCE, THF, DMF, etc.) und bei erhöhter Temperatur umgesetzt werden. Anschließend wird das Lösungsmittel im Vakuum weitgehend entfernt. Der Rückstand wird mit 100 ml Methanol ausgekocht, der Feststoff wird abgesaugt, dreimal mit 30 ml Methanol gewaschen und dann im Vakuum getrocknet. Man erhält so die in para-Position zum Iridium bromierten fac-Iridium-Komplexe.

### Synthese von Ir(LH35-Br)₃:

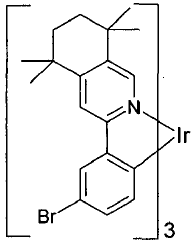

Eine bei 30 °C gerührte Suspension von 9.8 g (10 mmol) Ir(LH35)₃ in 500 ml DCM wird auf ein Mal mit 5.6 g (31.5 mmol) N-Bromsuccinimid versetzt und dann weitere 20 h gerührt. Nach Entfernen von ca. 450 ml des DCMs im Vakuum wird die gelbe Suspension mit 100 ml Methanol versetzt, der Feststoff wird abgesaugt, dreimal mit ca. 30 ml Methanol gewaschen und dann im Vakuum getrocknet. Ausbeute: 11.4 g (9.3 mmol) 93%; Reinheit: > 99.0 %ig nach NMR.

Analog können folgende Verbindungen dargestellt werden:

| Bsp. | Komplex | Bromierter Komplex | Ausbeute |
|---|---|---|---|
| Ir(LH20-Br)₃ | 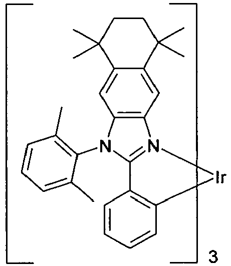 | 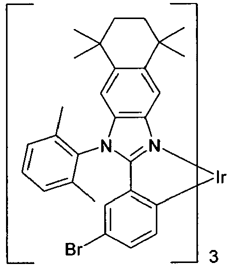 | 90% |
| | Ir(LH20)₃ | Ir(LH20-Br)₃ | |
| Ir(LH23-Br)₃ | 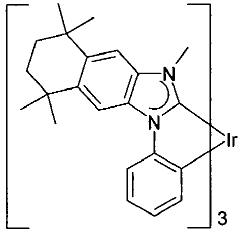 | 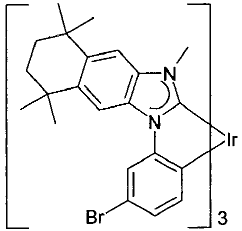 | 88% |
| | Ir(LH23)₃ | Ir(LH23-Br)₃ | |
| Ir(LH26-Br)₃ | 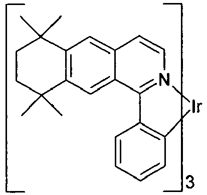 | 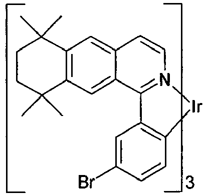 | 85% |
| | Ir(LH26)₃ | Ir(LH26-Br)₃ | |
| Ir(LH33-Br)₃ | 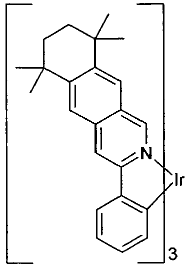 | 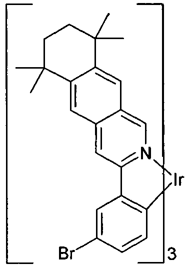 | 87% |
| | Ir(LH33)₃ | Ir(LH33-Br)₃ | |
| Ir(LH38-Br)₃ | 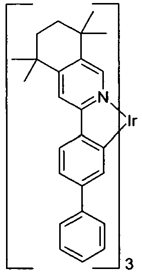 | 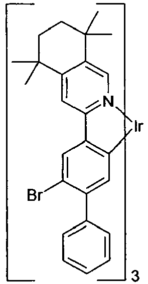 | 90% |
| | Ir(LH38)₃ | Ir(LH38-Br)₃ | |
| Ir500-Br₂ | 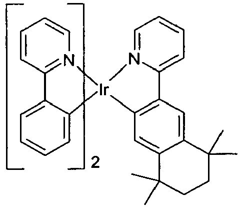 | 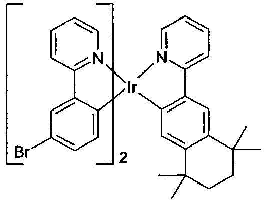 | 85% |
| | Ir500 | Ir500-Br₂ | |
| Ir501-Br₂ | 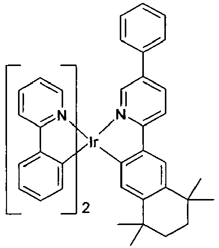 | 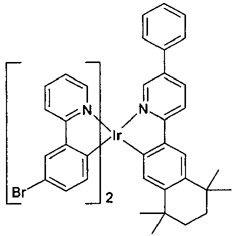 | 91% |
| | Ir501 | Ir501-Br₂ | |
| Ir505-Br₂ | 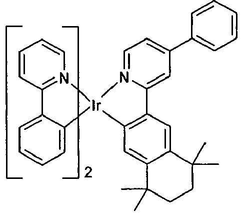 | 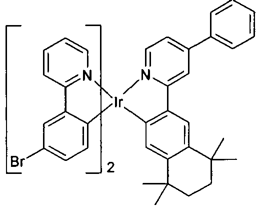 | 90% |
| | Ir505 | Ir505-Br₂ | |
| Ir529-Br₂ | 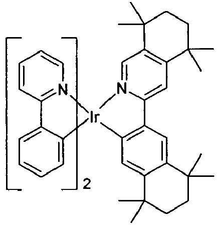 | 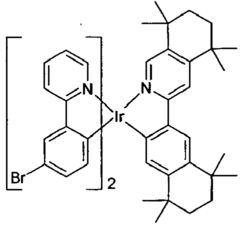 | 88% |
| | Ir529 | Ir529-Br₂ | |
| Ir534-Br | 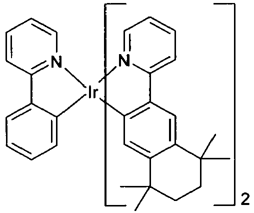 | 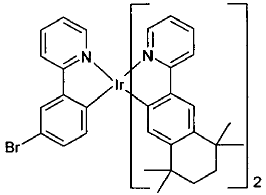 | 89% |
| | Ir534 | Ir534-Br | |
| Ir535-Br | 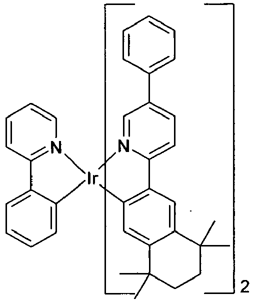 | 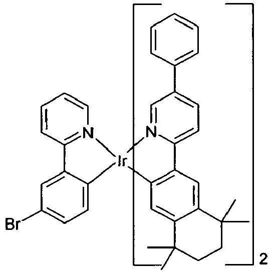 | 91% |
| | Ir535 | Ir535-Br | |
| Ir541-Br | 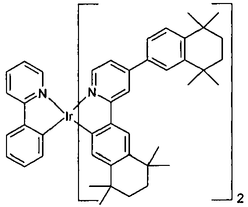 | 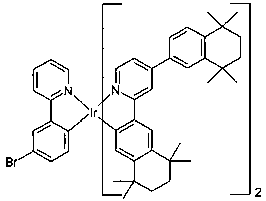 | 85% |
| | Ir541 | Ir541-Br | |
| Ir563-Br | 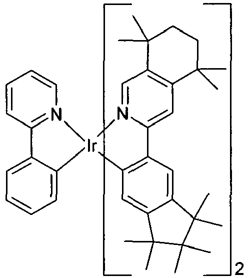 | 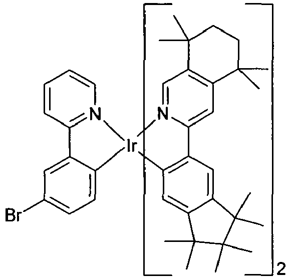 | 87% |
| | Ir563 | Ir563-Br | |

### 2) Suzuki-Kupplung an den bromierten fac-Iridium-Komplexen: Variante A, zweiphasige Reaktionsmischung:

Eine Suspension von 10 mmol eines bromierten Komplexes, 12-20 mmol Boronsäure bzw. Boronsäureester pro Br-Funktion und 40 - 80 mmol Trikaliumphosphat in einem Gemisch aus 300 ml Toluol, 100 ml Dioxan und 300 ml Wasser wird mit 0.6 mmol Tri-o-tolylphosphin und dann mit 0.1 mmol Palladium(II)acetat versetzt und 16 h unter Rückfluss erhitzt. Nach Erkalten gibt man 500 ml Wasser und 200 ml Toluol zu, trennt die wässrige Phase ab, wäscht die organische Phase dreimal mit 200 ml Wasser, einmal mit 200 ml gesättigter Kochsalzlösung und trocknet über Magnesiumsulfat. Man filtriert über ein Celite-Bett ab, wäscht dieses mit Toluol nach, entfernt das Toluol fast vollständig im Vakuum, gibt 300 ml Methanol zu, saugt vom ausgefallenen Rohprodukt ab, wäscht dieses dreimal mit je 50 ml Methanol und trocknet im Vakuum. Das Rohprodukt wird zweimal an Kieselgel gesäult. Der Metallkomplex wird abschließend getempert oder sublimiert. Das Tempern erfolgt im Hochvakuum (p ca. 10⁻⁶ mbar) im Temperaturbereich von ca. 200 - 300 °C. Die Sublimation erfolgt im Hochvakuum (p ca. 10⁻⁶ mbar) im Temperaturbereich von ca. 300 - 400 °C, wobei die Sublimation bevorzugt in Form einer fraktionierten Sublimation durchgeführt wird.

### Variante B, einphasige Reaktionsmischung:

Eine Suspension von 10 mmol eines bromierten Komplexes, 12-20 mmol Boronsäure bzw. Boronsäureester pro Br-Funktion und 60 - 100 mmol der Base (Kaliumfluorid, Trikaliumphosphat (wasserfrei oder Monohydrat oder Trihydrat), Kaliumcarbonat, Cäsiumcarbonat etc.) und 100 g Glaskugeln (3 mm Durchmesser) in 100 ml - 500 ml eines aprotischen Lösungsmittels (THF, Dioxan, Xylol, Mesitylen, Dimethylacetamid, NMP, DMSO, etc.) wird mit 0.6 mmol Tri-o-tolylphosphin und dann mit 0.1 mmol Palladium(II)acetat versetzt und 1 - 24 h unter Rückfluss erhitzt. Alternativ können andere Phosphine wie Tri-tert-butylphosphin, SPhos, XPhos, RuPhos, XanthPhos, etc. eingesetzt werden, wobei bei diesen Phosphinen das bevorzugte Phosphin : Palladium Verhältnis 2:1 bis 1.2:1 beträgt. Man entfernt das Lösungsmittel im Vakuum, nimmt das Produkt in einem geeigneten Lösungsmittel (Toluol, Dichlormethan, Ethylacetat, etc.) auf und reinigt wie unter Variante A beschrieben.

### Synthese von Ir600:

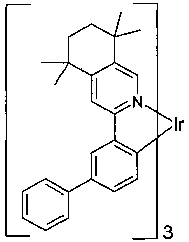

### Variante A:

Einsatz von 12.2 g (10.0 mmol) Ir(LH35-Br)₃ und 4.9 g (40.0 mmol) Phenylboronsäure [98-80-6], 17.7 (60 mmol) Trikaliumphosphat (wasserfrei), 183 mg (0.6 mmol) Tri-o-tolylphosphin [6163-58-2], 23 mg (0.1 mmol) Palladium(II)acetat, 300 ml Toluol, 100 ml Dioxan und 300 ml Wasser, 100 °C, 12 h. Zweimalige chromatographische Trennung an Kieselgel mit Toluol/Ethylacetat (90:10, vv). Ausbeute: 6.3 g (5.2 mmol) 52 %; Reinheit: ca. 99.9 %ig nach HPLC.

Analog können folgende Verbindungen dargestellt werden:

| Bsp. | Komplex Boronsäure Variante | Produkt | Ausbeute |
|---|---|---|---|
| Ir601 | Ir(LH38-Br)₃ | 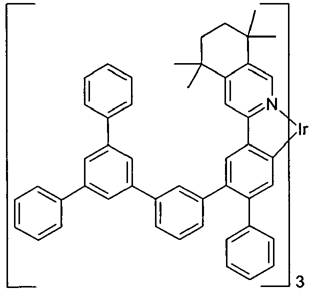 | 57% |
| | 1233200-59-3 | | |
| | A | | |
| | chromatographische Trennung mit Toluol | | |
| Ir602 | Ir(LH33-Br)₃ | 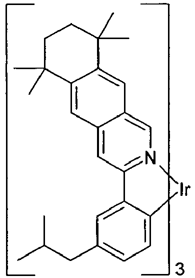 | 53% |
| | 84110-40-7 | | |
| | B | | |
| | SPhos:Pd(ac)₂ / 2:1 | | |
| | K₃PO₄ * 3H₂O | | |
| | Toluol chromatographische Trennung mit Toluol | | |
| Ir603 | Ir(LH26-Br)₃ | 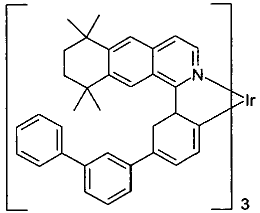 | 64% |
| | 5122-95-2 | | |
| | A | | |
| | chromatographische Trennung mit Toluol | | |
| Ir604 | Ir(LH20-Br)₃ | 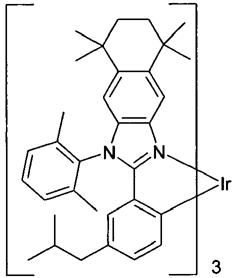 | 61% |
| | 84110-40-7 | | |
| | B | | |
| | SPhos:Pd(ac)₂ / 2:1 | | |
| | K₃PO₄ * 3H₂O | | |
| | Toluol chromatographische Trennung mit Toluol | | |
| Ir605 | Ir500-Br₂ | 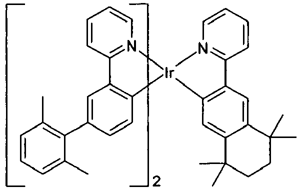 | 33% |
| | 100379-00-8 | | |
| | B | | |
| | SPhos:Pd(ac)₂ / 2:1 | | |
| | Cs₂CO₃ / Dioxan chromatog raphische Trennung mit Tol/DCM (95:5 vv) | | |
| Ir606 | Ir529-Br₂ | 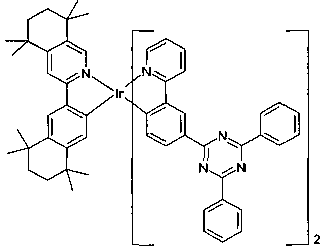 | 58% |
| | 1251825-65-6 | | |
| | A | | |
| | chromatographische Trennung mit n-Heptan/EE (90:10) | | |
| Ir607 | Ir535-Br | 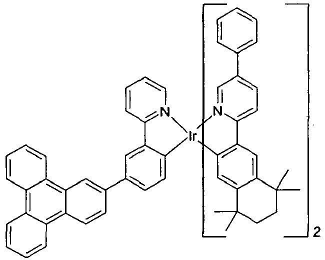 | 51% |
| | 654664-63-8 | | |
| | A | | |
| | chromatographische Trennung mit n-Heptan/DCM (90:10) | | |

### 3) Buchwald-Kupplung an den Iridium-Komplexen:

Ein Gemisch aus 10 mmol des bromierten Komplexes, 12-20 mmol des Diarylamins oder Carbazols pro Brom-Funktion, 1.1 molare Menge an Natrium-tert-butylat pro eingesetztem Amin bzw. 80 mmol Trikaliumphosphat (wasserfrei) bei Carbazolen, 100 g Glaskugeln (3 mm Durchmesser) und 300 - 500 ml Toluol bzw. o-Xylol bei Carbazolen wird mit 0.4 mmol Tri-tert-butylphosphin und dann mit 0.3 mmol Palladium(II)acetat versetzt und unter gutem Rühren 16 - 30 h unter Rückfluss erhitzt. Nach Erkalten gibt man 500 ml Wasser zu, trennt die wässrige Phase ab, wäscht die organische Phase zweimal mit 200 ml Wasser, einmal mit 200 ml gesättigter Kochsalzlösung und trocknet über Magnesiumsulfat. Man filtriert über ein Celite-Bett ab, wäscht dieses mit Toluol bzw. o-Xylol nach, entfernt das Lösungsmittel fast vollständig im Vakuum, gibt 300 ml Ethanol zu, saugt vom ausgefallenen Rohprodukt ab, wäscht dieses dreimal mit je 50 ml EtOH und trocknet im Vakuum. Das Rohprodukt wird zweimal an Kieselgel chromatographisch gereinigt. Der Metallkomplex wird abschließend getempert oder sublimiert. Das Tempern erfolgt im Hochvakuum (p ca. 10⁻⁶ mbar) im Temperaturbereich von ca. 200 - 300 °C. Die Sublimation erfolgt im Hochvakuum (p ca. 10⁻⁶ mbar) im Temperaturbereich von ca. 300 - 400 °C, wobei die Sublimation bevorzugt in Form einer fraktionierten Sublimation durchgeführt wird.

### Synthese von Ir700:

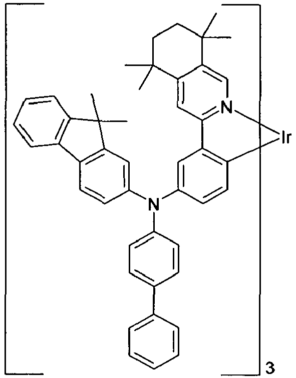

Einsatz von 12.2 g (10 mmol) Ir(LH35-Br)₃ und 14.5 g (40 mmol) N-[1,1'-biphenyl]-4-yl-9,9-dimethyl-9H-fluoren-2-amin [897671-69-1]. Tempern. Ausbeute: 8.5 g (4.1 mmol) 41 %; Reinheit: ca. 99.8 %ig nach HPLC.

Analog können folgende Verbindungen dargestellt werden:

| Bsp. | Produkt | Ausbeute |
|---|---|---|
| | Edukt | |
| | Amin oder Carbazol | |
| Ir701 | 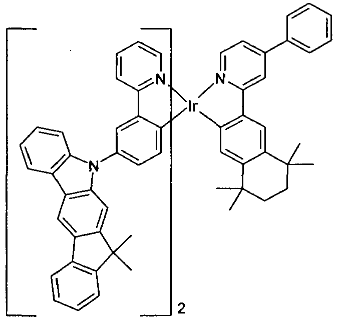 | 40% |
| | Ir505-Br₂ | |
| | [1257220-47-5] | |
| Ir702 | 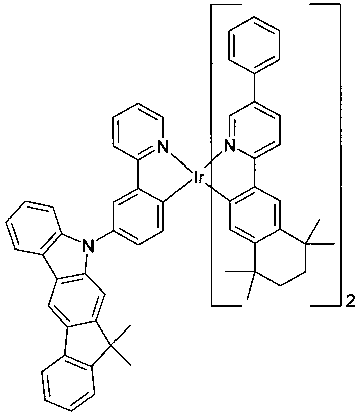 | 45% |
| | Ir535-Br | |
| | [1257220-47-5] | |
| Ir703 | 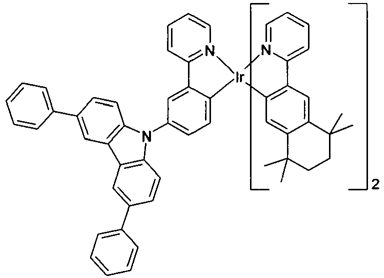 | 47% |
| | Ir534-Br | |
| | [56525-79-2] | |
| Ir704 | 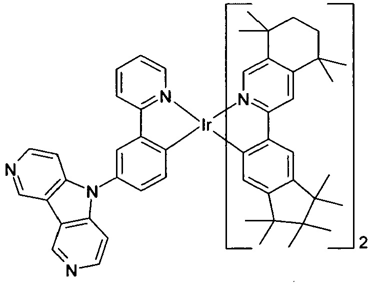 | 37% |
| | Ir563-Br | |
| | [244-78-0] | |

### 4) Cyanierung der Iridium-Komplexe:

Ein Gemisch aus 10 mmol des bromierten Komplexes, 13 mmol Kupfer(I)-cyanid pro Brom-Funktion und 300 ml NMP wird 20 h bei 200 °C gerührt.

Nach Erkalten entfernt man das Lösungsmittel im Vakuum, nimmt den den Rückstand in 500 ml Dichlormethan auf, filtriert über Celite von den Kupfersalzen ab, engt das Dichlormethan im Vakuum fast bis zur Trockene ein, gibt 100 ml Ethanol zu, saugt vom ausgefallenen Feststoff ab, wäscht diesen zweimal mit je 50 ml Ethanol und trocknet im Vakuum. Chromatographie oder Heißextraktion und fraktionierte Sublimation des Rohprodukts wie in C: Synthese der Metallkomplexe, 1) Homoleptische tris-faciale Iridium-Komplexe vom Phenyl-Pyridin-, Phenyl-Imidazol- bzw. Phenyl-Benzimidazol-Typ: Variante A beschrieben.

### Synthese von Ir800:

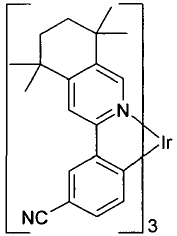

Einsatz von 12.2 g (10 mmol) Ir(LH35-Br)₃ und 3.5 g (39) mmol) Kupfer(I)-cyanid. Sublimation. Ausbeute: 4.6 g (4.3 mmol) 43 %; Reinheit: ca. 99.8 %ig nach HPLC.

Analog können folgende Verbindungen dargestellt werden:

| Bsp. | Produkt Edukt | Ausbeute |
|---|---|---|
| Ir801 | 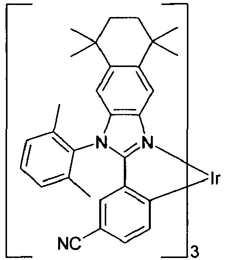 | 35% |
| | Ir(LH20-Br)₃ | |
| Ir802 | 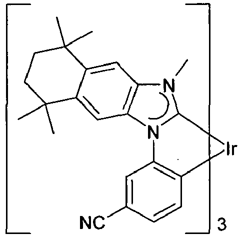 | 37% |
| | fac-Ir(LH23-Br)₃ | |
| Ir803 | 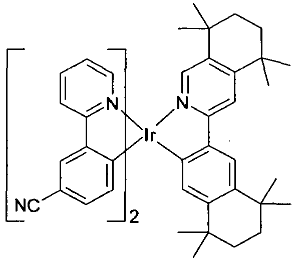 | 44% |
| | Ir529-Br₂ | |

### 5) Borylierung der Iridium-Komplexe:

Ein Gemisch von 10 mmol des bromierten Komplexes, 12 mmol Bis-(pinacolato)diboran [73183-34-3] pro Brom-Funktion, 30 mmol Kaliumacetat, wasserfrei pro Bromfunktion, 0.2 mmol Tricyclohexylphosphin, 0.1 mmol Palladium(II)acetat und 300 ml Lösungsmittel (Dioxan, DMSO, NMP, etc.) wird 4-16 h bei 80-160 °C gerührt. Nach Entfernen des Lösungsmittels im Vakuum wird der Rückstand in 300 ml Dichlormethan, THF oder Ethylacetat aufgenommen, über ein Celite-Bett filtriert, das Filtrat wird bis zur beginnenden Kristallisation im Vakuum eingeengt und abschließend noch tropfenweise mit ca. 100 ml Methanol versetzt, um die Kristallisation zu vervollständigen. Die Verbindungen können aus Dichlormethan, Ethylacetat oder THF unter Zusatz von Methanol oder alternativ aus Cyclohexan umkristallisiert werden.

### Synthese von Ir900:

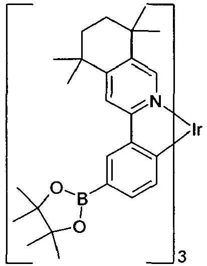

Einsatz von 12.2 g (10 mmol) Ir(LH35-Br)₃ und 9.1 g (36 mmol) Bis(pinacolato)diboran [73183-34-3], DMSO, 120 °C, 6 h, aufnehmen und Celite-Filtration in THF, Umkristallisation aus THF:Methanol. Ausbeute: 6.8 g (5.0 mmol) 50%; Reinheit: ca. 99.8 %ig nach HPLC.

Analog können folgende Verbindungen dargestellt werden:

| Bsp. | Edukt | Produkt | Ausbeute |
|---|---|---|---|
| Ir901 | 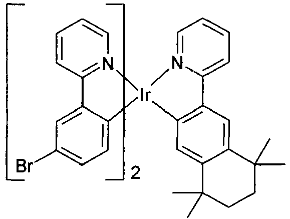 | 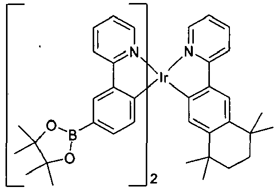 | 60% |
| | Ir500-Br₂ | Ir901 | |
| Ir902 | 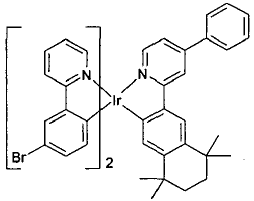 | 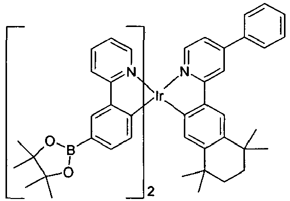 | 64% |
| | Ir505-Br₂ | Ir902 | |

### 6) Suzuki-Kupplung an den borylierten fac-Iridium-Komplexen: Variante A, zweiphasige Reaktionsmischung:

Eine Suspension von 10 mmol eines borylieren Komplexes, 12-20 mmol Arylbromid pro (RO)₂B-Funktion und 80 mmol Trikaliumphosphat in einem Gemisch aus 300 ml Toluol, 100 ml Dioxan und 300 ml Wasser wird mit 0.6 mmol Tri-o-tolylphosphin und dann mit 0.1 mmol Palladium(II)acetat versetzt und 16 h unter Rückfluss erhitzt. Nach Erkalten gibt man 500 ml Wasser und 200 ml Toluol zu, trennt die wässrige Phase ab, wäscht die organische Phase dreimal mit 200 ml Wasser, einmal mit 200 ml gesättigter Kochsalzlösung und trocknet über Magnesiumsulfat. Man filtriert über ein Celite-Bett ab, wäscht dieses mit Toluol nach, entfernt das Toluol fast vollständig im Vakuum, gibt 300 ml Methanol zu, saugt vom ausgefallenen Rohprodukt ab, wäscht dieses dreimal mit je 50 ml Methanol und trocknet im Vakuum. Das Rohprodukt wird zweimal an Kieselgel gesäult. Der Metallkomplex wird abschließend getempert oder sublimiert. Das Tempern erfolgt im Hochvakuum (p ca. 10⁻⁶ mbar) im Temperaturbereich von ca. 200 - 300 °C. Die Sublimation erfolgt im Hochvakuum (p ca. 10⁻⁶ mbar) im Temperaturbereich von ca. 300 - 400 °C, wobei die Sublimation bevorzugt in Form einer fraktionierten Sublimation durchgeführt wird.

### Variante B, einphasige Reaktionsmischung:

Eine Suspension von 10 mmol eines borylieren Komplexes, 12-20 mmol Arylbromid pro (RO)₂B-Funktion und 60 - 100 mmol der Base (Kaliumfluorid, Trikaliumphosphat (wasserfrei, Monohydrat oder Trihydrat), Kaliumcarbonat, Cäsiumcarbonat etc.) und 100 g Glaskugeln (3 mm Durchmesser) in 100 ml - 500 ml eines aprotischen Lösungsmittels (THF, Dioxan, Xylol, Mesitylen, Dimethylacetamid, NMP, DMSO, etc.) wird mit 0.6 mmol Tri-o-tolylphosphin und dann mit 0.1 mmol Palladium(II)acetat versetzt und 1 - 24 h unter Rückfluss erhitzt. Alternativ können andere Phosphine wir Tri-tert-butylphosphin, SPhos, XPhos, RuPhos, XanthPhos, etc. eingesetzt werden, wobei bei diesen Phosphinen das bevorzugte Phosphin : Palladium Verhältnis 2:1 bis 1.2:1 beträgt. Man entfernt das Lösungsmittel im Vakuum, nimmt das Produkt in einem geeigneten Lösungsmittel (Toluol, Dichlormethan, Ethylacetat, etc.) auf und reinigt wie unter Variante A beschrieben.

### Synthese von Ir600:

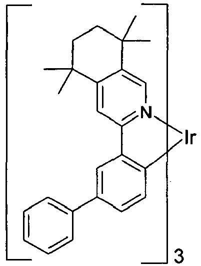

### Variante A:

Einsatz von 13.6 g (10.0 mmol) Ir900 und 4.2 ml (40.0 mmol) Brombenzol [108-86-1], 17.7 (60 mmol) Trikaliumphosphat (wasserfrei), 183 mg (0.6 mmol) Tri-o-tolylphosphin [6163-58-2], 23 mg (0.1 mmol) Palladium(II)-acetat, 300 ml Toluol, 100 ml Dioxan und 300 ml Wasser, 100 °C, 12 h. Zweimalige chromatographische Trennung an Kieselgel mit Toluol/Ethylacetat (90:10, vv). Ausbeute: 6.3 g (5.2 mmol) 52 %; Reinheit: ca. 99.9 %ig nach HPLC.

Analog können folgende Verbindungen dargestellt werden:

| Bsp. | Komplex Boronsäure Variante | Produkt | Ausbeute |
|---|---|---|---|
| Ir608 | Ir901 | 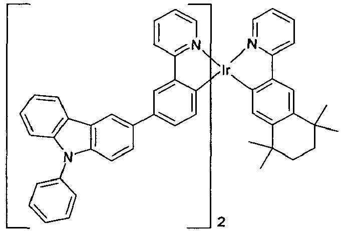 | 63% |
| | 1153-85-1 | | |
| | A | | |
| | chromatographische Trennung mit Toluol | | |
| | | Ir608 | |
| Ir609 | Ir902 | 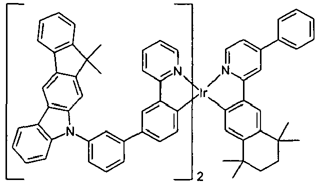 | 55% |
| | 1369587-63-2 | | |
| | A | | |
| | chromatographische Trennung mit Toluol | | |
| | | Ir609 | |

### Polymere enthaltend die Metallkomplexe:

### Allgemeine Polymerisationsvorschrift für die Bromide bzw. Boronsäure-Derivate als polymerisierbare Gruppe, Suzuki-Polymerisation Variante A - Zweiphasiges Reaktionsgemisch:

Die Monomere (Bromide und Boronsäuren bzw. Boronsäureester, Reinheit nach HPLC > 99.8 % ig) werden in der in der Tabelle angegebenen Zusammensetzung in einer Gesamtkonzentration von ca. 100 mmol/L in einem Gemisch aus 2 Volumenteilen Toluol : 6 Volumenteilen Dioxan : 1 Volumenteil Wasser gelöst bzw. suspendiert. Dann gibt man 2 mol Äquivalente Tri-kalium-phosphat pro eingesetzter Br-Funktionalität zu, rührt 5 min. nach, fügt dann 0.03 bis 0.003 mol Äquivalente Tri-ortho-tolylphosphin und dann 0.005 bis 0.0005 mol Äquivalente Palladium(II)acetat (Verhältnis Phosphin zu Pd bevorzugt 6:1) pro eingesetzter Br-Funktionalität zu und erhitzt unter sehr gutem Rühren 2-3 h unter Rückfluss. Falls die Viskosität der Mischung zu stark ansteigt, kann mit einem Gemisch aus 2 Volumenteilen Toluol: 3 Volumenteilen Dioxan verdünnt werden. Nach insgesamt 4-6 h Reaktionszeit fügt man zum end-capping 0.05 mol Aquivalente pro eingesetzter Boronsäure-Funktionalität eines Monobromaromaten und dann 30 min. danach 0.05 mol Äquivalente pro eingesetzter Br-Funktionalität einer Monoboronsäure bzw. eines Monoboronsäureesters zu und kocht weitere 1 h nach. Nach Erkalten verdünnt man mit 300 ml Toluol, trennt die wässrige Phase ab, wäscht die organische Phase zweimal mit je 300 ml Wasser, trocknet über Magnesiumsulfat, filtriert über ein Celite-Bett ab, um Palladium zu entfernen und engt dann zur Trockene ein. Man löst das Rohpolymer in THF (Konzentration ca. 10 - 30 g/L) und lässt die Lösung unter sehr gutem Rühren langsam in das doppelte Volumen Methanol einlaufen. Das Polymer wird abgesaugt und dreimal mit Methanol gewaschen. Der Umfällvorgang wird fünfmal wiederholt, danach wird das Polymer im Vakuum bis zur Gewichtskonstanz bei 30 - 50 °C getrocknet.

### Variante B - Einphasiges Reaktionsgemisch:

Die Monomere (Bromide und Boronsäuren bzw. Boronsäureester, Reinheit nach HPLC > 99.8 % ig) werden in der in Tabelle angegebenen Zusammensetzung in einer Gesamtkonzentration von ca. 100 mmol/L in einem Lösemittel (THF, Dioxan, Xyylol, Mesitylen, Dimethylacetamid, NMP, DMSO, etc.) gelöst bzw. suspendiert. Dann gibt man 3 mol Äquivalente Base (Kaliumfluorid, Trikaliumphosphat (wasserfrei, Monohydrat oder Trihydrat), Kaliumcarbonat, Cäsiumcarbonat etc. jeweils wasserfrei) pro Br-Funktionalität und das Gewichtsäquivalent Glaskugeln (3 mm Durchmesser) zu, rührt 5 min. nach, fügt dann 0.03 bis 0.003 mol Äquivalente Tri-ortho-tolylphosphin und dann 0.005 bis 0.0005 mol Äquivalente Palladium(II)acetat (Verhältnis Phosphin zu Pd bevorzugt 6:1) pro Br-Funktionalität zu und erhitzt unter sehr gutem Rühren 2-3 h unter Rückfluss. Alternativ können andere Phosphine wir Tri-tert-butylphosphin, SPhos, XPhos, RuPhos, XanthPhos, etc. eingesetzt werden, wobei bei diesen Phosphinen das bevorzugte Phosphin : Palladium Verhältnis 2:1 bis 1.3:1 beträgt. Nach insgesamt 4-12 h Reaktionszeit fügt man zum end-capping 0.05 mol Aquivalente eines Monobromaromaten und dann 30 min. danach 0.05 mol Äquivalente einer Monoboronsäure bzw. eines Monoboronsäureesters zu und kocht weiter 1 h nach. Man entfernt das Lösungsmittel weitgehend im Vakuum, nimmt den Rückstand in Toluol auf, und reinigt das Polymer wie unter Variante A beschrieben.

### Monomere M / Endcapper E:

| | |
|---|---|
| 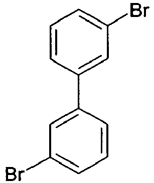 | 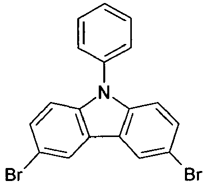 |
| 16400-51-4 | 57103-20-5 |
| M1 | M2 |
| 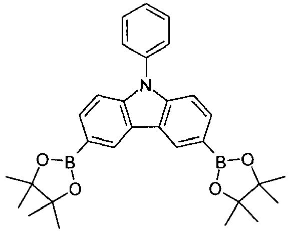 | 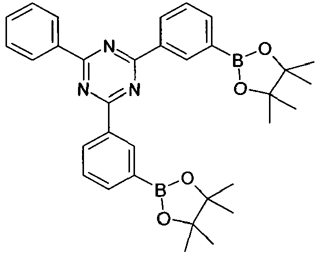 |
| 618442-57-2 | 1238752-26-5 |
| M3 | M4 |
| 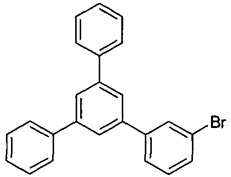 | 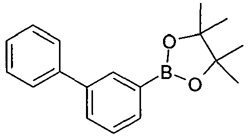 |
| 1233200-57-1 | 912844-88-3 |
| E1 | E2 |

### Polymere:

Zusammensetzung der Polymere, mol %:

| **Polymer** | **M1 [%]** | **M2 [%]** | **M3 [%]** | **M4 [%]** | **Ir-Komplex / [%]** |
|---|---|---|---|---|---|
| P1 | --- | 30 | --- | 45 | Ir(LH35-Br)₃ / 10 |
| P2 | --- | 30 | --- | 40 | Ir500-Br₂ / 10 |
| P3 | 20 | 30 | 25 | 20 | Ir902 / 5 |

Molekulargewichte und Ausbeute der erfindungsgemäßen Polymere:

| Polymer | Mn [gmol⁻¹] | Polydispersität | Ausbeute |
|---|---|---|---|
| P1 | 180.000 | 4.8 | 56% |
| P2 | 250.000 | 2.3 | 61% |
| P3 | 310.000 | 2.4 | 66% |

### Vergleich der Löslichkeit der Komplexe in organischen Lösemitteln

Die erfindungsgemäßen Komplexe weisen die in der Tabelle ausgewiesene Löslichkeit, in den angegebenen Lösungsmitteln bei 25 °C, auf. Der Vergleich mit den Komplexen ohne erfindungsgemäßen Cyclus zeigt, dass die Löslichkeit der erfindungsgemäßen Komplexe deutlich (Faktor ca. 5 - 50) größer ist.

| **Bsp.** | **Lösungsmittel** | **Vergleichskomplex Löslichkeit** | **Komplex Löslichkeit [g/ml]** |
|---|---|---|---|
| Lös1 | Toluol | 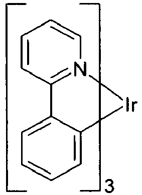 | 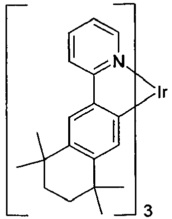 |
| | | 94928-86-6 | Ir(LH1)₃ |
| | | << 1 mg/ml | > 15 mg/ml |
| Lös2 | o-Xylol | 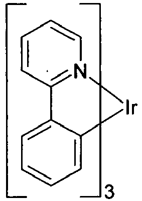 | 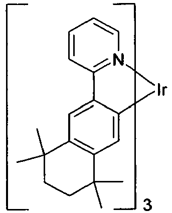 |
| | | 94928-86-6 | Ir(LH1)₃ |
| | | << 1 mg/ml | > 25 mg/ml |
| Lös3 | 3-Phenoxytoluol | 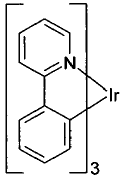 | 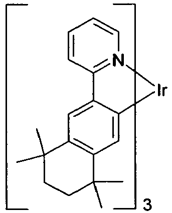 |
| | | 94928-86-6 | Ir(LH1)₃ |
| | | < 5 mg/ml | > 35 mg/ml |
| Lös4 | Toluol | 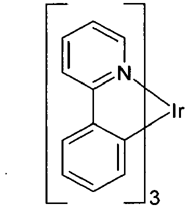 | 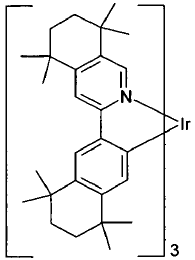 |
| | | 94928-86-6 | Ir(LH41)₃ |
| | | << 1 mg/ml | > 50 mg/ml |
| Lös5 | Toluol | 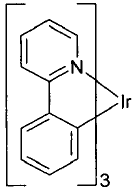 | 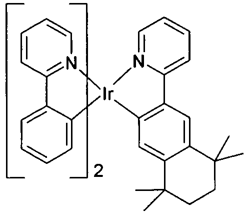 |
| | | 94928-86-6 | Ir500 |
| | | << 1 mg/ml | > 10 mg/ml |
| Lös6 | Toluol | 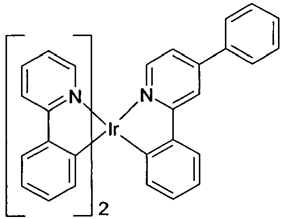 | 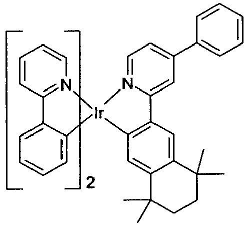 |
| | | 1215281-24-5 | Ir505 |
| | | < 20 mg/ml | > 80 mg/ml |
| Lös7 | Toluol | 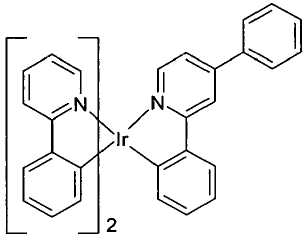 | 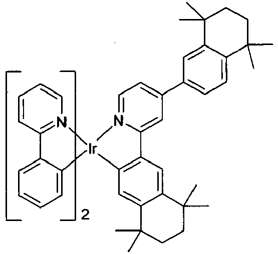 |
| | | 1215281-24-5 | Ir513 |
| | | < 20 mg/ml | >> 200 mg/ml |
| Lös8 | Toluol | 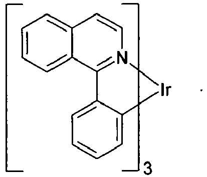 | 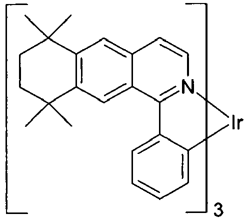 |
| | | 435293-93-9 | Ir(LH26)₃ |
| | | < 2 mg/ml | > 15 mg/ml |
| Lös9 | Toluol | 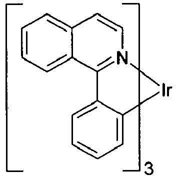 | 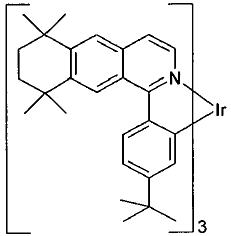 |
| | | 435293-93-9 | Ir(LH27)₃ |
| | | < 2 mg/ml | > 25 mg/ml |
| Lös10 | Toluol | 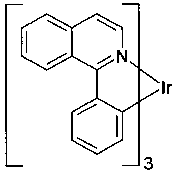 | 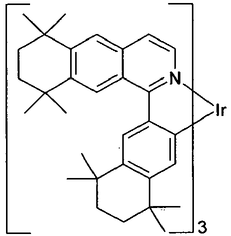 |
| | | 435293-93-9 | Ir(LH30)₃ |
| | | < 2 mg/ml | > 50 mg/ml |
| Lös11 | Cyclohexan | 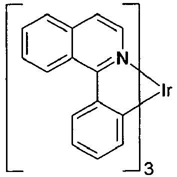 | 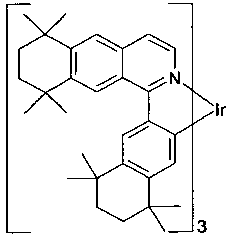 |
| | | 435293-93-9 | Ir(LH30)₃ |
| | | << 1 mg/ml | > 10 mg/ml |
| Lös12 | Toluol | 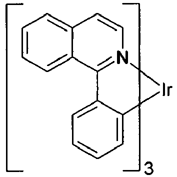 | 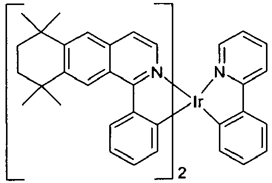 |
| | | 435293-93-9 | Ir547 |
| | | < 2 mg/ml | > 50 mg/ml |
| Lös13 | Toluol | 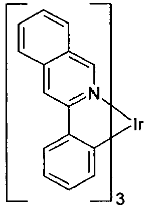 | 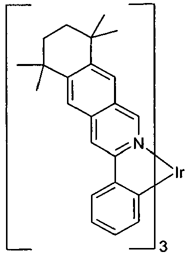 |
| | | 863567-55-9 | Ir(LH33)₃ |
| | | < 2 mg/ml | > 25 mg/ml |
| Lös14 | Toluol | 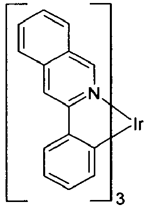 | 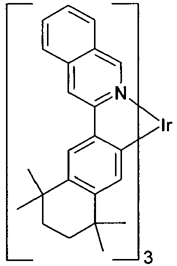 |
| | | 863567-55-9 | Ir(LH9)₃ |
| | | < 2 mg/ml | > 20 mg/ml |
| Lös15 | Toluol | 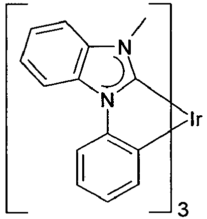 | 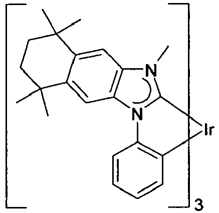 |
| | | 869486-05-5 | Ir(LH23)₃ |
| | | < 2 mg/ml | > 20 mg/ml |
| Lös16 | Toluol | 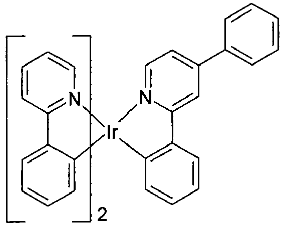 | 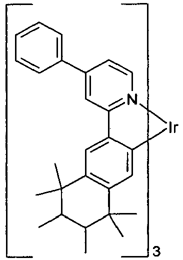 |
| | | 1215281-24-5 | Ir(LH53)₃ |
| | | < 20 mg/ml | > 70 mg/ml |
| Lös17 | Toluol | 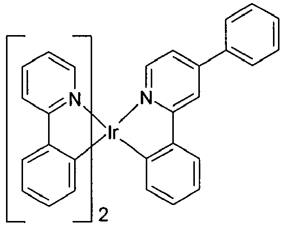 | 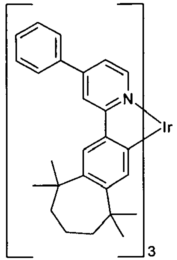 |
| | | 1215281-24-5 | Ir(LH55)₃ |
| | | < 20 mg/ml | > 90 mg/ml |

### Sublimation der Komplexe

Die erfindungsgemäßen Komplexe weisen die in der Tabelle ausgewiesene Sublimationstemperatur und Rate bei einem Basisdruck von ca. 10⁻⁵ mbar auf. Der Vergleich mit Komplexen ohne erfindungsgemäßen Cyclus zeigt, dass die Sublimationstemperatur der erfindungsgemäßen Komplexe geringer und die Sublimationsrate deutlich größer ist. Außerdem sind die erfindungsgemäßen Komplexe unter den Sublimationsbedingungen stabil.

| **Bsp.** | **Vergleichskomplex** | **Komplex** |
|---|---|---|
| Sub1 | 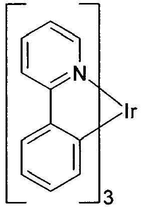 | 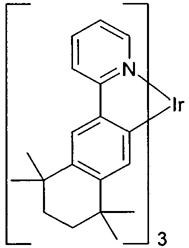 |
| | 94928-86-6 | Ir(LH1)₃ |
| | T, subl.: 330 - 340 °C | T, subl.: 315 °C |
| | Rate: ca. 5 g/h | Rate: ca. 9 g/h |
| Sub2 | 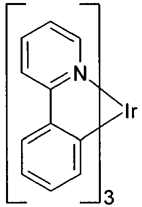 | 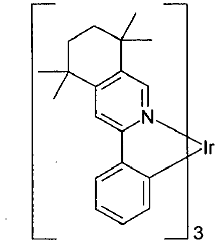 |
| | 94928-86-6 | Ir(LH35)₃ |
| | T, subl.: 330 - 340 °C | T, subl.: 310 °C |
| | Rate: ca. 5 g/h | Rate: ca. 8 g/h |
| Sub3 | 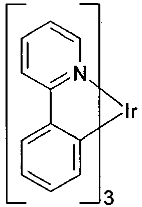 | 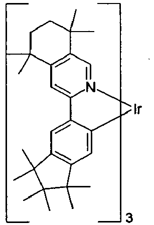 |
| | 94928-86-6 | Ir(LH42)₃ |
| | T, subl.: 330 - 340 °C | T, subl.: 345 °C |
| | Rate: ca. 5 g/h | Rate: ca. 12 g/h |
| Sub4 | 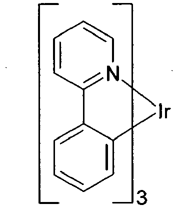 | 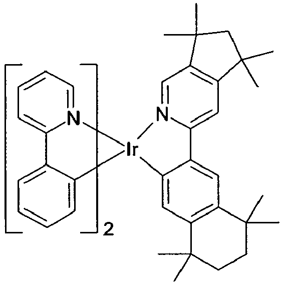 |
| | 94928-86-6 | Ir515 |
| | T, subl.: 330 - 340 °C | T, subl.: 325 °C |
| | Rate: ca. 5 g/h | Rate: ca. 10 g/h |
| Sub5 | 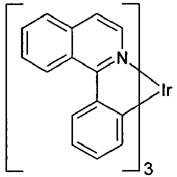 | 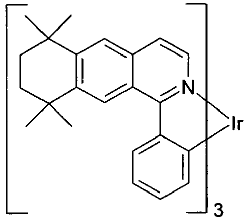 |
| | 435293-93-9 | |
| | T, subl.: 390 °C | Ir(LH26)₃ |
| | Rate: < 0.5 g/h | T, subl.: 380 °C |
| | partielle Zersetzung | Rate: ∼ 4 g/h |
| | | keine Zersetzung |
| Sub6 | 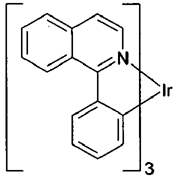 | 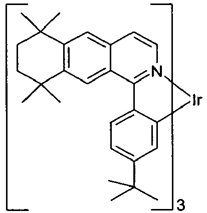 |
| | 435293-93-9 | Ir(LH27)₃ |
| | T, subl.: 390 °C | T, subl.: 370 °C |
| | Rate: < 0.5 g/h | Rate: ∼ 3 g/h |
| | partielle Zersetzung | keine Zersetzung |
| Sub7 | 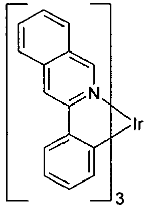 | 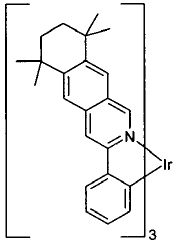 |
| | 863567-55-9 | Ir(LH33)₃ |
| | T, subl.: 390 °C | T, subl.: 375 °C |
| | Rate: < 0.5 g/h | Rate: - 3 g/h |
| | partielle Zersetzung | keine Zersetzung |
| Sub8 | 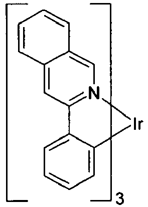 | 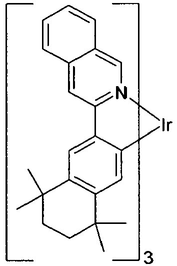 |
| | 863567-55-9 | Ir(LH9)₃ |
| | T, subl.: 390 °C | T, subl.: 365 °C |
| | Rate: < 0.5 g/h | Rate: ∼ 5 g/h |
| | partielle Zersetzung | keine Zersetzung |
| Sub9 | 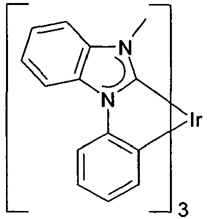 | 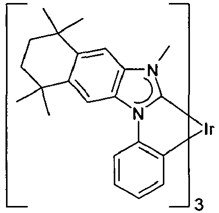 |
| | Ir(LH23)₃ | Ir(LH23)₃ |
| | T, subl.: 370 °C | T, subl.: 360 °C |
| | Rate: < 1 g/h | Rate: ∼ 3 g/h |
| | partielle Zersetzung | keine Zersetzung |
| | und fac > mer | keine fac > mer |
| | Isomerisierung | Isomerisierung |

### Beispiel: Herstellung der OLEDs

### 1) Vakuum-prozessierte Devices:

Die Herstellung von erfindungsgemäßen OLEDs sowie OLEDs nach dem Stand der Technik erfolgt nach einem allgemeinen Verfahren gemäß WO 2004/058911, das auf die hier beschriebenen Gegebenheiten (Schichtdickenvariation, verwendete Materialien) angepasst wird.

In den folgenden Beispielen werden die Ergebnisse verschiedener OLEDs vorgestellt. Glasplättchen, mit strukturiertem ITO (50 nm, Indium-ZinnOxid) bilden die Substrate, auf welche die OLEDs aufgebracht werden. Die OLEDs haben prinzipiell folgenden Schichtaufbau: Substrat / Lochtransportschicht 1 (HTL1) bestehend aus HTM dotiert mit 3 % NDP-9 (kommerziell erhältlich von der Fa. Novaled), 20 nm / Lochtransportschicht 2 (HTL2) / optionale Elektronenblockerschicht (EBL) / Emissionsschicht (EML) / optionale Lochblockierschicht (HBL) / Elektronentransportschicht (ETL) / optionale Elektroneninjektionsschicht (EIL) und abschließend eine Kathode. Die Kathode wird durch eine 100 nm dicke Aluminiumschicht gebildet.

Zunächst werden vakuumprozessierte OLEDs beschrieben. Hierfür werden alle Materialien in einer Vakuumkammer thermisch aufgedampft. Dabei besteht die Emissionsschicht immer aus mindestens einem Matrixmaterial (Hostmaterial, Wirtsmaterial) und einem emittierenden Dotierstoff (Dotand, Emitter), der dem Matrixmaterial bzw. den Matrixmaterialien durch Co₋verdampfung in einem bestimmten Volumenanteil beigemischt wird. Eine Angabe wie M3:M2:Ir(LH1)₃ (55%:35%:10%) bedeutet hierbei, dass das Material M3 in einem Volumenanteil von 55%, M2 in einem Anteil von 35% und Ir(LH1)₃ in einem Anteil von 10% in der Schicht vorliegt. Analog kann auch die Elektronentransportschicht aus einer Mischung zweier Materialien bestehen. Der genaue Aufbau der OLEDs ist Tabelle 1 zu entnehmen. Die zur Herstellung der OLEDs verwendeten Materialien sind in Tabelle 7 gezeigt.

Die OLEDs werden standardmäßig charakterisiert. Hierfür werden die Elektrolumineszenzspektren, die Stromeffizienz (gemessen in cd/A) und die Spannung (gemessen bei 1000 cd/m² in V) bestimmt aus Strom-Spannungs-Helligkeits-Kennlinien (IUL-Kennlinien). Für ausgewählte Versuche wird die Lebensdauer bestimmt. Als Lebensdauer wird die Zeit definiert, nach der die Leuchtdichte von einer bestimmten Startleuchtdichte aus auf einen gewissen Anteil abgesunken ist. Die Angabe LD50 bedeutet, dass es sich bei der genannten Lebensdauer um die Zeit handelt, bei der die Leuchtdichte auf 50% der Startleuchtdichte abgefallen ist, also von z.B. 1000 cd/m² auf 500 cd/m². Je nach Emissionsfarbe wurden unterschiedliche Starthelligkeiten gewählt. Die Werte für die Lebensdauer können mit Hilfe dem Fachmann bekannten Umrechnungsformeln auf eine Angabe für andere Startleuchtdichten umgerechnet werden. Hierbei ist die Lebensdauer für eine Startleuchtdichte von 1000 cd/m² eine übliche Angabe.

### Verwendung von erfindungsgemäßen Verbindungen als Emittermaterialien in phosphoreszierenden OLEDs

Die erfindungsgemäßen Verbindungen lassen sich unter anderem als phosphoreszierende Emittermaterialien in der Emissionsschicht in OLEDs einsetzen. Als Vergleich gemäß dem Stand der Technik werden die Iridium-Verbindungen gemäß Tabelle 3 verwendet. Die Ergebnisse der OLEDs sind in Tabelle 2 zusammengefasst.

**Tabelle 1: Aufbau der OLEDs**

| **Bsp.** | **HTL2 Dicke** | **EBL Dicke** | **EML Dicke** | **HBL Dicke** | **ETL Dicke** |
|---|---|---|---|---|---|
| **Orange - Rote OLEDs** | | | | | |
| D-IrR1 | HTM 270 nm | --- | M7:M8:Ir-R1 (65%:30%:5%) 35 nm | --- | ETM1:ETM2 (50%:50%) 35 nm |
| D-IrR2 | HTM 270 nm | --- | M7:M8:Ir-R2 (60%:30%:10%) 35 nm | --- | ETM1:ETM2 (50%:50%) 35 nm |
| D-IrR3 | HTM 270 nm | --- | M7:M8:Ir-R3 (60%:30%:10%) 35 nm | --- | ETM1:ETM2 (50%:50%) 35 nm |
| D-Ir(LH4)₃ | HTM 270 nm | --- | M7:M8:Ir(LH4)₃ (65%:30%:5%) 35 nm | --- | ETM1:ETM2 (50%:50%) 35 nm |
| D-Ir(LH9)₃ | HTM 270 nm | --- | M7:M8:Ir(LH9)₃ (65%:30%:5%) 35 nm | --- | ETM1:ETM2 (50%:50%) 35 nm |
| D-Ir(LH10)₃ | HTM 270 nm | --- | M7:M8:Ir(LH10)₃ (65%:30%:5%) 35 nm | --- | ETM1:ETM2 (50%:50%) 35 nm |
| D-Ir(LH26)₃ | HTM 270 nm | --- | M7:M8:Ir(LH26)₃ (65%:30%:5%) 35 nm | --- | ETM1:ETM2 (50%:50%) 35 nm |
| D-Ir(LH27)₃ | HTM 270 nm | --- | M7:M8:Ir(LH27)₃ (65%:30%:5%) 35 nm | --- | ETM1:ETM2 (50%:50%) 35 nm |
| D-Ir(LH32)₃ | HTM 270 nm | --- | M7:M8:Ir(LH32)₃ (65%:30%:5%) 35 nm | --- | ETM1:ETM2 (50%:50%) 35 nm |
| D-Ir(LH33)₃ | HTM 270 nm | --- | M7:M8:Ir(LH33)₃ (65%:30%:5%) 35 nm | --- | ETM1:ETM2 (50%:50%) 35 nm |
| D-Ir(LH61)₃ | HTM 270 nm | --- | M7:M8:Ir(LH61)₃ (60%:30%:10%) 35 nm | --- | ETM1:ETM2 (50%:50%) 35 nm |
| D-Ir503 | HTM 270 nm | --- | M7:M8:Ir503 (65%:30%:5%) 35 nm | --- | ETM1:ETM2 (50%:50%) 35 nm |
| D-Ir509 | HTM 270 nm | --- | M7:M8:Ir509 (65%:30%:5%) 35 nm | --- | ETM1:ETM2 (50%:50%) 35 nm |
| D-Ir516 | HTM 270 nm | --- | M7:M8:Ir516 (65%:30%:5%) 35 nm | --- | ETM1:ETM2 (50%:50%) 35 nm |
| D-Ir517 | HTM 270 nm | --- | M7:M8:Ir517 (65%:30%:5%) 35 nm | --- | ETM1:ETM2 (50%:50%) 35 nm |
| D-Ir520 | HTM 270 nm | --- | M7:M8:Ir520 (65%:30%:5%) 35 nm | --- | ETM1:ETM2 (50%:50%) 35 nm |
| D-Ir521 | HTM 270 nm | --- | M7:M8:Ir521 (65%:30%:5%) 35 nm | --- | ETM1:ETM2 (50%:50%) 35 nm |
| D-Ir522 | HTM 270 nm | --- | M7:M8:Ir522 (65%:30%:5%) 35 nm | --- | ETM1:ETM2 (50%:50%) 35 nm |
| D-Ir523 | HTM 270 nm | --- | M7:M8:Ir523 (65%:30%:5%) 35 nm | --- | ETM1:ETM2 (50%:50%) 35 nm |
| D-Ir524 | HTM 270 nm | --- | M7:M8:Ir524 (65%:30%:5%) 35 nm | --- | ETM1:ETM2 (50%:50%) 35 nm |
| D-Ir539 | HTM 270 nm | --- | M7:M8:Ir539 (65%:30%:5%) 35 nm | --- | ETM1:ETM2 (50%:50%) 35 nm |
| D-Ir547 | HTM 270 nm | --- | M7:M8:Ir547 (65%:30%:5%) 35 nm | --- | ETM1:ETM2 (50%:50%) 35 nm |
| D-Ir548 | HTM 270 nm | --- | M7:M8:Ir548 (65%:30%:5%) 35 nm | --- | ETM1:ETM2 (50%:50%) 35 nm |
| D-Ir554 | HTM 270 nm | --- | M7:M8:Ir554 (65%:30%:5%) 35 nm | --- | ETM1:ETM2 (50%:50%) 35 nm |

| **Gelbe OLEDs** | | | | | |
|---|---|---|---|---|---|
| D-Ir-Y1 | HTM 240 nm | --- | M7:M8:Ir-Y1 (58%:30%:12%) 25 nm | --- | ETM1:ETM2 (50%:50%) 40 nm |
| D-Ir-Y2 | HTM 240 nm | --- | M7:M8:Ir-Y2 (62%:30%:8%) 25 nm | --- | ETM1:ETM2 (50%:50%) 40 nm |
| D-Ir(LH6)₃ | HTM 240 nm | --- | M7:M8:Ir(LH6)₃ (62%:30%:8%) 25 nm | --- | ETM1:ETM2 (50%:50%) 40 nm |
| D-Ir(LH8)₃ | HTM 240 nm | --- | M7:M8:Ir(LH8)₃ (60%:30%:10%) 25 nm | --- | ETM1:ETM2 (50%:50%) 40 nm |
| D-Ir505 | HTM 240 nm | --- | M7:M8:Ir505 (62%:30%:8%) 25 nm | --- | ETM1:ETM2 (50%:50%) 40 nm |
| D-Ir508 | HTM 240 nm | --- | M7:M8:Ir508 (62%:30%:8%) 25 nm | --- | ETM1:ETM2 (50%:50%) 40 nm |
| D-Ir512 | HTM 240 nm | --- | M7:M8:Ir512 (62%:30%:8%) 25 nm | --- | ETM1:ETM2 (50%:50%) 40 nm |
| D-Ir537 | HTM 240 nm | --- | M7:M8:Ir537 (62%:30%:8%) 25 nm | --- | ETM1:ETM2 (50%:50%) 40 nm |

| **Grüne OLEDs** | | | | | |
|---|---|---|---|---|---|
| D-Ir-G1 | HTM 220 nm | --- | M7:M8:Ir-G1 (65%:30%:5%) 25 nm | HBM2 10 nm | ETM1:ETM2 (50%:50%) 30 nm |
| D-Ir-G2 | HTM 220 nm | --- | M7:M8:Ir-G2 (65%:30%:5%) 25 nm | HBM2 10 nm | ETM1:ETM2 (50%:50%) 30 nm |
| D-Ir-G4 | HTM 220 nm | --- | M7:M8:Ir-G4 (65%:30%:5%) 25 nm | HBM2 10 nm | ETM1:ETM2 (50%:50%) 30 nm |
| D-Ir-G4b | NPB 40 nm | --- | CBP:Ir-G4 (80%:20%) 30 nm | BCP 10 nm | AIQ (20 nm) LiQ (2 nm) |
| D-Ir(LH1)₃ | HTM 220 nm | --- | M7:M8:Ir(LH1)₃ (65%:30%:5%) 25 nm | HBM2 10 nm | ETM1:ETM2 (50%:50%) 30 nm |
| D-Ir(LH1)₃ | HTM 220 nm | --- | M7:M8:Ir(LH1)₃ (55%:30%:15%) 25 nm | HBM2 10 nm | ETM1:ETM2 (50%:50%) 30 nm |
| D-Ir(LH3)₃ | HTM 220 nm | --- | M7:M8:Ir(LH3)₃ (65%:30%:5%) 25 nm | HBM2 10 nm | ETM1:ETM2 (50%:50%) 30 nm |
| D-Ir(LH7)₃ | HTM 220 nm | --- | M7:M8:Ir(LH7)₃ (65%:30%:5%) 25 nm | HBM2 10 nm | ETM1:ETM2 (50%:50%) 30 nm |
| | | | | | |
| D-Ir(LH16)₃ | HTM 220 nm | --- | M7:M8:Ir(LH16)₃ (65%:30%:5%) 25 nm | HBM2 10 nm | ETM1:ETM2 (50%:50%) 30 nm |
| D-Ir(LH35)₃ | HTM 220 nm | --- | M7:M8:Ir(LH35)₃ (65%:30%:5%) 25 nm | HBM2 10 nm | ETM1:ETM2 (50%:50%) 30 nm |
| D-Ir(LH36)₃ | HTM 220 nm | --- | M7:M8:Ir(LH36)₃ (65%:30%:5%) 25 nm | MBM2 10 nm | ETM1:ETM2 (50%:50%) 30 nm |
| D-Ir(LH41)₃ | HTM 220 nm | --- | M7:M8:Ir(LH41 )₃ (65%:30%:5%) 25 nm | HBM2 10 nm | ETM1:ETM2 (50%:50%) 30 nm |
| D-Ir(LH42)₃ | HTM 220 nm | --- | M7:M8:Ir(LH42)₃ (65%:30%:5%) 25 nm | HBM2 10 nm | ETM1:ETM2 (50%:50%) 30 nm |
| D-Ir(LH49)₃ | HTM 220 nm | --- | M7:M8:Ir(LH49)₃ (62%:30%:8%) 30 nm | HBM2 10 nm | ETM1:ETM2 (50%:50%) 30 nm |
| D-Ir(LH57)₃ | HTM 220 nm | --- | M7:M8:Ir(LH57)₃ (62%:30%:8%) 30 nm | HBM2 10 nm | ETM1:ETM2 (50%:50%) 30 nm |
| D-Ir(LH58)₃ | HTM 220 nm | --- | M7:M8:Ir(LH58)₃ (62%:30%:8%) 30 nm | HBM2 10 nm | ETM1:ETM2 (50%:50%) 30 nm |
| D-Ir(LH59)₃ | HTM 220 nm | --- | M7:M8:Ir(LH59)₃ (62%:30%:8%) 30 nm | HBM2 10 nm | ETM1:ETM2 (50%:50%) 30 nm |
| D-Ir(LH60)₃ | HTM 220 nm | --- | M7:M8:Ir(LH60)₃ (62%:30%:8%) 30 nm | HBM2 10 nm | ETM1:ETM2 (50%:50%) 30 nm |
| D-Ir500 | HTM 220 nm | --- | M7:M8:Ir500 (65%:30%:5%) 25 nm | HBM2 10nm | ETM1:ETM2 (50%:50%) 30 nm |
| D-Ir501 | HTM 220 nm | --- | M7:M8:Ir501 (65%:30%:5%) 25 nm | HBM2 10nm | ETM1:ETM2 (50%:50%) 30 nm |
| D-Ir502 | HTM 220 nm | --- | M7:M8:Ir502 (65%:30%:5%) 25 nm | HBM2 10nm | ETM1:ETM2 (50%:50%) 30 nm |
| D-Ir506 | HTM 220 nm | --- | M7:M8:Ir506 (65%:30%:5%) 25 nm | HBM2 10nm | ETM1:ETM2 (50%:50%) 30 nm |
| D-Ir507 | HTM 220 nm | --- | M7:M8:Ir507 (65%:30%:5%) 25 nm | HBM2 10nm | ETM1:ETM2 (50%:50%) 30 nm |
| D-Ir510 | HTM 220 nm | --- | M7:M8:Ir510 (65%:30%:5%) 25 nm | HBM2 10 nm | ETM1:ETM2 (50%:50%) 30 nm |
| D-Ir511 | HTM 220 nm | --- | M7:M8:Ir511 (65%:30%:5%) 25 nm | HRM2 10 nm | ETM1:ETM2 (50%:50%) 30 nm |
| D-Ir519 | HTM 220 nm | --- | M7:M8:Ir519 (65%:30%:5%) 25 nm | HBM2 10nm | ETM1:ETM2 (50%:50%) 30 nm |
| D-Ir526 | HTM 220 nm | --- | M7:M8:Ir526 (65%:30%:5%) 25 nm | HBM2 10nm | ETM1:ETM2 (50%:50%) 30 nm |
| D-Ir527 | HTM 220 nm | --- | M7:M8:Ir527 (65%:30%:5%) 25 nm | HBM2 10 nm | ETM1:ETM2 (50%:50%) 30 nm |
| D-Ir529 | HTM 220 nm | --- | M7:M8:Ir529 (65%:30%:5%) 25 nm | HBM2 10 nm | ETM1:ETM2 (50%:50%) 30 nm |
| D-Ir530 | HTM 220 nm | --- | M7:M8:Ir530 (65%:30%:5%) 25 nm | HBM2 10 nm | ETM1:ETM2 (50%:50%) 30 nm |
| D-Ir531 | HTM 220 nm | --- | M7:M8:Ir531 (65%:30%:5%) 25 nm | HBM2 10 nm | ETM1:ETM2 (50%:50%) 30 nm |
| D-Ir532 | HTM 220 nm | --- | M7:M8:Ir532 (65%:30%:5%) 25 nm | HBM2 10 nm | ETM1:ETM2 (50%:50%) 30 nm |
| D-Ir533 | HTM 220 nm | --- | M7:M8:Ir533 (65%:30%:5%) 25 nm | HBM2 10nm | ETM1:ETM2 (50%:50%) 30 nm |
| D-Ir534 | HTM 220 nm | --- | M7:M8:Ir534 (65%:30%:5%) 25 nm | HBM2 10 nm | ETM1:ETM2 (50%:50%) 30 nm |
| D-Ir536 | HTM 220 nm | --- | M7:M8:Ir536 (65%:30%:5%) 25 nm | HBM2 10nm | ETM1:ETM2 (50%:50%) 30 nm |
| D-Ir538 | HTM 220 nm | --- | M7:M8:Ir538 (65%:30%:5%) 25 nm | HBM2 10 nm | ETM1:ETM2 (50%:50%) 30 nm |
| D-Ir543 | HTM 220 nm | --- | M7:M8:Ir543 (65%:30%:5%) 25 nm | HBM2 10 nm | ETM1: ETM2 (50%:50%) 30 nm |
| D-Ir556 | HTM 220 nm | --- | M7:M8:Ir556 (65%:30%:5%) 25 nm | HBM2 10nm | ETM1:ETM2 (50%:50%) 30 nm |
| D-Ir557 | HTM 220 nm | --- | M7:M8:Ir557 (65%:30%:5%) 25 nm | HBM2 10 nm | ETM1:ETM2 (50%:50%) 80nm |
| D-Ir562 | HTM 220 nm | --- | M7:M8:Ir562 (65%:30%:5%) 25 nm | HBM2 10 nm | ETM1:ETM2 (50%:50%) 30 nm |
| D-Ir563 | HTM 220 nm | --- | M7:M8:Ir563 (65%:30%:5%) 25 nm | HBM2 10nm | ETM1:ETM2 (50%:50%) 30 nm |
| D-Ir570 | HTM 220 nm | --- | M7:M8:Ir570 (65%:30%:5%) 25 nm | HBM2 10nm | ETM1:ETM2 (50%:50%) 30 nm |
| D-Ir571 | HTM 220 nm | --- | M7:M8:Ir571 (65%:30%:5%) 25 nm | HBM2 10nm | ETM1:ETM2 (50%:50%) 30 nm |
| D-Ir572 | HTM 220 nm | --- | M7:M8:Ir572 (65%:30%:5%) 25 nm | HBM2 10 nm | ETM1:ETM2 (50%:50%) 30 nm |
| D-Pt(LH43) | HTM 220 nm | --- | M7:M8:Pt(LH43) (60%:30%:10%) 30 nm | HBM2 10nm | ETM1:ETM2 (50%:50%) 30 nm |
| D-Pt(LH45) | HTM 220 nm | --- | M7:M8:Pt(LH45) (60%:30%:10%) 30 nm | HBM2 10 nm | ETM1:ETM2 (50%:50%) 30 nm |

| **Blaue OLEDs** | | | | | |
|---|---|---|---|---|---|
| D-Ir-B1 | HTM 180 nm | EBM 10 nm | M1:M4:Ir-B1 (60%:35%:5%) 25 nm | HBM1 10 nm | ETM1:ETM2 (50%:50%) 20 nm |
| D-Ir-B2 | HTM 180 nm | EBM 10 nm | M10:M4:Ir-B2 (45%:45%:10%) 25 nm | HBM1 10 nm | ETM1:ETM2 (50%:50%) 20 nm |
| D-Ir(LH23)₃ | HTM 180 nm | EBM 10 nm | M10:M4:fac-Ir(LH23)₃ (45%:45%:10%) 25 nm | HBM1 10 nm | ETM1:ETM2 (50%:50%) 20 nm |
| D-Ir(LH25)₃ | HTM 180 nm | EBM 10 nm | M10:M4:fac-Ir(LH25)₃ (45%:45%:10%) 25 nm | HBM1 10 nm | ETM1:ETM2 (50%:50%) 20 nm |
| D-Ir(LH40)₃ | HTM 180 nm | EBM 10 nm | M1:M4:Ir(LH40)₃ (60%:35%:5%) 25 nm | HBM1 10 nm | ETM1:ETM2 (50%:50%) 20 nm |
| D-Ir561 | HTM 180 nm | EBM 10 nm | M1:M4:Ir561 (60%:35%:5%) 25 nm | HBM1 10 nm | ETM1:ETM2 (50%:50%) 20 nm |
| D-Pt(LH44) | HTM 180 nm | EBM 10 nm | M10:M4:Pt(LH44) (45%:45%:10%) 25 nm | HBM1 10 nm | ETM1:ETM2 (50%:50%) 20 nm |
| D-Pt(LH46) | HTM 180 nm | EBM 10 nm | M10:M4:Pt(LH46) (45%:45%:10%) 25 nm | HBM1 10 nm | ETM1:ETM2 (50%:50%) 20 nm |
| D-Pt(LH47) | HTM 180 nm | EBM 10 nm | M10:M4 Pt(LH47) (45%:45%:10%) 25 nm | HBM1 10 nm | ETM1:ETM2 (50%:50%) 20 nm |
| D-Ir(LH51) | HTM 180 nm | EBM 10 nm | M10:M4:Ir(LH51) (45%:45%:10%) 25 nm | HBM1 10 nm | ETM1:ETM2 (50%:50%) 20 nm |
| D-Ir(LH52) | HTM 180 nm | EBM 10 nm | M10:M4:Ir(LH52) (45%:45%:10%) 25 nm | HBM1 10 nm | ETM1:ETM2 (50%:50%) 20 nm |

**Tabelle 2: Ergebnisse der Vakuum-prozessierten OLEDs**

| **Bsp.** | **EQE (%) 1000 cd/m²** | **Spannung (V) 1000 cd/m²** | **CIE x/y 1000 cd/m²** | **LD80 (h) 1000 cd/m²** |
|---|---|---|---|---|
| **Orange - Rote OLEDs** | | | | |
| D-IrR1 | 13.2 | 2.9 | 0.67/0.33 | 13000 |
| D-IrR2 | 19.1 | 3.2 | 0.66/0.35 | 23000 |
| D-IrR3 | 15.1 | 3.3 | 0.68/0.31 | 8000 |
| D-Ir(LH4)₃ | 18.5 | 3.1 | 0.69/0.30 | --- |
| D-Ir(LH9)₃ | 19.6 | 3.0 | 0.65/0.34 | 17000 |
| D-Ir(LH10)₃ | 18.9 | 3.1 | 0.69/0.30 | --- |
| D-Ir(LH26)₃ | 18.5 | 3.0 | 0.69/0.30 | 19000 |
| D-Ir(LH27)₃ | 18.4 | 3.0 | 0.69/0.30 | 18000 |
| D-Ir(LH32)₃ | 18.9 | 3.2 | 0.70/0.30 | 18000 |
| D-Ir(LH33)₃ | 19.2 | 3.1 | 0.64/0.35 | 14000 |
| D-Ir(LH61)₃ | 18.0 | 3.0 | 0.70/0.30 | 21000 |
| D-Ir503 | 19.3 | 3.0 | 0.64/0.35 | 22000 |
| D-Ir509 | 19.5 | 3.1 | 0.64/0.35 | 23000 |
| D-Ir516 | 17.1 | 3.1 | 0.63/0.36 | --- |
| D-Ir517 | 17.4 | 3.2 | 0.65/0.34 | 11000 |
| D-Ir520 | 17.2 | 3.1 | 0.63/0.36 | 18000 |
| D-Ir521 | 17.8 | 3.1 | 0.63/0.36 | 18000 |
| D-Ir522 | 18.2 | 3.1 | 0.63/0.36 | 20000 |
| D-Ir523 | 18.0 | 3.0 | 0.66/0.33 | 22000 |
| D-Ir524 | 19.3 | 3.0 | 0.65/0.34 | 21000 |
| D-Ir539 | 19.5 | 3.1 | 0.66/0.34 | --- |
| D-Ir547 | 18.9 | 3.0 | 0.67/0.31 | 20000 |
| D-Ir548 | 19.5 | 3.0 | 0.68/0.32 | 22000 |
| D-Ir554 | 19.688 | 3.0 | 0.64/0.35 | 19000 |

| **Gelbe OLEDs** | | | | |
|---|---|---|---|---|
| D-Ir-Y1 | 19.6 | 2.8 | 0.39/0.62 | 35000 |
| D-Ir-Y2 | 22.1 | 2.9 | 0.44/0.56 | 34000 |
| D-Ir(LH6)₃ | 23.7 | 3.0 | 0.47/0.52 | 38000 |
| D-Ir(LH8)₃ | 21.3 | 3.0 | 0.45/0.55 | --- |
| D-Ir505 | 23.9 | 2.9 | 0.44/0.55 | 41000 |
| D-Ir508 | 22.6 | 3.0 | 0.59/0.38 | --- |
| D-Ir537 | 22.1 | 2.9 | 0.46/0.52 | 40000 |

| **Grüne OLEDs** | | | | |
|---|---|---|---|---|
| D-Ir-G1 | 18.1 | 3.3 | 0.32/0.64 | 7000 |
| D-Ir-G2 | 19.2 | 3.2 | 0.35/0.62 | 16000 |
| D-Ir-G4 | 16.3 | 3.7 | 0.34/0.63 | 600 |
| D-Ir-G4b | 14.6 | 5.8 | 0.34/0.63 | 160 |
| D-Ir(LH1)₃ | 23.3 | 3.2 | 0.33/0.64 | 18000 |
| D-Ir(LH1)₃ | 22.9 | 3.3 | 0.36/0.61 | 16000 |
| D-Ir(LH3)₃ | 24.1 | 3.3 | 0.35/0.62 | 20000 |
| D-Ir(LH7)₃ | 23.7 | 3.3 | 0.34/0.64 | 21000 |
| D-Ir(LH16)₃ | 24.3 | 3.3 | 0.35/0.63 | 24000 |
| D-Ir(LH35)₃ | 22.8 | 3.2 | 0.33/0.64 | 22000 |
| D-Ir(LH36)₃ | 23.4 | 3.2 | 0.33/0.65 | 25000 |
| D-Ir(LH41)₃ | 24.5 | 3.3 | 0.35/0.62 | 25000 |
| D-Ir(LH42)₃ | 24.3 | 3.3 | 0.35/0.61 | 24000 |
| D-Ir(LH49)₃ | 20.7 | 3.4 | 0.41/0.56 | --- |
| D-Ir(LH57)₃ | 22.3 | 3.3 | 0.34/0.64 | 21000 |
| D-Ir(LH58)₃ | 23.0 | 3.2 | 0.32/0.65 | 23000 |
| D-Ir(LH59)₃ | 22.9 | 3.3 | 0.34/0.63 | --- |
| D-Ir(LH60)₃ | 21.4 | 3.3 | 0.39/0.58 | --- |
| D-Ir500 | 23.3 | 3.2 | 0.33/0.63 | 22000 |
| D-Ir501 | 24.0 | 3.1 | 0.35/0.62 | 27000 |
| D-Ir502 | 23.9 | 3.2 | 0.33/0.63 | 20000 |
| D-Ir506 | 24.0 | 3.1 | 0.33/0.63 | 20000 |
| D-Ir507 | 22.8 | 3.2 | 0.38/0.59 | 20000 |
| D-Ir510 | 23.3 | 3.3 | 0.39/0.58 | 18000 |
| D-Ir511 | 24.1 | 3.2 | 0.34/0.63 | 23000 |
| D-Ir519 | 23.1 | 3.4 | 0.18/0.53 | --- |
| D-Ir526 | 24.4 | 3.2 | 0.34/0.63 | 23000 |
| D-Ir527 | 24.5 | 3.2 | 0.34/0.62 | 24000 |
| D-Ir529 | 24.3 | 3.2 | 0.33/0.63 | 25000 |
| D-Ir530 | 24.2 | 3.2 | 0.33/0.63 | 24000 |
| D-Ir531 | 24.4 | 3.2 | 0.33/0.63 | 25000 |
| D-Ir532 | 24.6 | 3.2 | 0.33/0.63 | 23000 |
| D-Ir533 | 24.5 | 3.1 | 0.35/0.62 | 26000 |
| D-Ir534 | 24.1 | 3.2 | 0.33/0.63 | --- |
| D-Ir536 | 24.4 | 3.2 | 0.33/0.62 | 25000 |
| D-Ir538 | 24.0 | 3.2 | 0.35/0.61 | 24000 |
| D-Ir543 | 24.3 | 3.3 | 0.33/0.63 | 25000 |
| D-Ir556 | 22.8 | 3.2 | 0.33/0.62 | 22000 |
| D-Ir557 | 23.9 | 3.2 | 0.33/0.62 | 22000 |
| D-Ir562 | 24.0 | 3.3 | 0.33/0.63 | 25000 |
| D-Ir563 | 24.3 | 3.3 | 0.33/0.63 | --- |
| D-Ir570 | 23.9 | 3.2 | 0.33/0.62 | 20000 |
| D-Ir571 | 24.1 | 3.2 | 0.34/0.62 | 22000 |
| D-Ir572 | 20.4 | 3.3 | 0.26/0.51 | --- |
| D-Pt(LH43) | 19.9 | 3.2 | 0.35/0.61 | 16000 |
| D-Pt(LH45) | 20.9 | 3.2 | 0.35/0.61 | 18000 |

| **Blaue OLEDs** | | | | |
|---|---|---|---|---|
| | | | | **LD50 (h) 1000 cd/m²** |
| D-Ir-B1 | 16.1 | 4.9 | 0.18/0.37 | 1100 |
| D-Ir-B2 | 3.0 | 5.2 | 0.16/0.07 | 60 |
| D-Ir(LH23)₃ | 9.4 | 5.4 | 0.15/0.17 | 100 |
| D-Ir(LH25)₃ | 6.5 | 5.9 | 0.15/0.11 | --- |
| D-Ir(LH40)₃ | 21.9 | 4.1 | 0.15/0.26 | 500 |
| D-Ir561 | 21.0 | 4.3 | 0.16/0.29 | 700 |
| D-Pt(LH44) | 19.5 | 3.5 | 0.18/0.38 | 16000 |
| D-Pt(LH46) | 12.5 | 5.3 | 0.16/0.25 | --- |
| D-Pt(LH47) | 12.1 | 5.1 | 0.16/0.26 | --- |
| D-Ir(LH51) | 13.9 | 5.1 | 0.15/0.23 | --- |
| D-Ir(LH52) | 14.4 | 5.0 | 0.15/0.22 | --- |

### 2) Lösungs-prozessierte Devices:

### A: Aus löslichen Funktionsmaterialien

Die erfindungsgemäßen Iridium-Komplexe können auch aus Lösung verarbeitet werden und führen dort zu prozesstechnisch wesentlich einfacheren OLEDs, im Vergleich zu den vakuumprozessierten OLEDs, mit dennoch guten Eigenschaften. Die Herstellung solcher Bauteile lehnt sich an die Herstellung polymerer Leuchtdioden (PLEDs) an, die in der Literatur bereits vielfach beschrieben ist (z. B. in der WO 2004/037887). Der Aufbau setzt sich aus Substrat / ITO / PEDOT (80 nm) / Interlayer (80 nm) / Emissionsschicht (80 nm) / Kathode zusammen. Dazu werden Substrate der Firma Technoprint (Sodalimeglas) verwendet, auf weiche die ITO-Struktur (Indium-Zinn-Oxid, eine transparente, leitfähige Anode) aufgebracht wird. Die Substrate werden im Reinraum mit DI Wasser und einem Detergens (Deconex 15 PF) gereinigt und dann durch eine UV/Ozon-Plasmabehandlung aktiviert. Danach wird ebenfalls im Reinraum als Pufferschicht eine 80 nm Schicht PEDOT (PEDOT ist ein Polythiophen-Derivat (Baytron P VAI 4083sp.) von H. C. Starck, Goslar, das als wässrige Dispersion geliefert wird) durch Spin-Coating aufgebracht. Die benötigte Spinrate hängt vom Verdünnungsgrad und der spezifischen Spin-Coater-Geometrie ab (typisch für 80 nm: 4500 rpm). Um Restwasser aus der Schicht zu entfernen, werden die Substrate für 10 Minuten bei 180 °C auf einer Heizplatte ausgeheizt. Die verwendete Interlayer dient der Lochinjektion, in diesem Fall wird HIL-012 von Merck verwendet. Die Interlayer kann alternativ auch durch eine oder mehrere Schichten ersetzt werden, die lediglich die Bedingung erfüllen müssen, durch den nachgelagerten Prozessierungsschritt der EML-Abscheidung aus Lösung nicht wieder abgelöst zu werden. Zur Herstellung der Emissionsschicht werden die erfindungsgemäßen Emitter zusammen mit den Matrixmaterialien in Toluol gelöst. Der typische Feststoffgehalt solcher Lösungen liegt zwischen 16 und 25 g/L, wenn, wie hier, die für eine Device typische Schichtdicke von 80 nm mittels Spincoating erzielt werden soll. Die lösungsprozessierten Devices vom Typ1 enthalten eine Emissionsschicht aus (Polystyrol):M5:M6:Ir(LH)₃ (20%:35%:35%:10%), die vom Typ2 enthalten eine Emissionsschicht aus (Polystyrol):M5:M6:Ir(LH6)₃:Ir(LH)₃ (20%:25%:40%:10%:5%). Die Emissionsschicht wird in einer Inertgasatmosphäre, im vorliegenden Fall Argon, aufgeschleudert und 30 min bei 130 °C ausgeheizt. Zuletzt wird eine Kathode aus Barium (5 nm) und dann Aluminium (100 nm) (hochreine Metalle von Aldrich, besonders Barium 99.99 % (Best-Nr. 474711); Aufdampfanlagen von Lesker o.a., typischer Aufdampfdruck 5 x 10⁻⁶ mbar) aufgedampft. Optional kann zunächst eine Lockblockierschicht und dann eine Eletronentransportschicht und dann erst die Kathode (z.B. Al oder LiF/Al) im Vakuum aufgedampft werden. Um das Device vor Luft und Luftfeuchtigkeit zu schützen, wird die Vorrichtung abschließend verkapselt und dann charakterisiert. Die genannten OLED-Beispiele sind noch nicht optimiert, Tabelle 4 fasst die erhaltenen Daten zusammen.

**Tabelle 3: Ergebnisse mit aus Lösung prozessierten Materialien**

| **Bsp.** | **Emitter Device** | **EQE (%) 1000 cd/m²** | **Spannung (V) 1000 cd/m²** | **CIE x/y** | **LD50 (h) 1000 cd/m²** |
|---|---|---|---|---|---|
| **Orange und Rote OLEDs** | | | | | |
| Sol-D-Ir-R2 | Ir-R2 | 18.8 | 3.6 | 0.67/0.33 | 20000 |
| | Typ2 | | | | |
| Sol-D-Ir(LH28)₃ | Ir(LH28)₃ | 18.8 | 3.9 | 0.65/0.35 | 150000 |
| | Typ1 | | | | |
| Sol-D-Ir(LH29)₃ | Ir(LH29)₃ | 19.5 | 3.7 | 0.61/0.38 | --- |
| | Typ1 | | | | |
| Sol-D-Ir(LH30)₃ | Ir(LH30)₃ | 19.1 | 3.7 | 0.69/0.30 | 180000 |
| | Typ2 | | | | |
| Sol-D-Ir(LH31)₃ | Ir(LH31)₃ | 19.5 | 3.6 | 0.68/0.31 | --- |
| | Typ1 | | | | |
| Sol-D-Ir(LH34)₃ | Ir(LH34)₃ | 19.9 | 3.7 | 0.65/0.35 | --- |
| | Typ1 | | | | |
| Sol-D-Ir518 | Ir518 | 17.1 | 3.7 | 0.70/0.30 | --- |
| | Typ1 | | | | |
| Sol-D-Ir523 | Ir523 | 19.1 | 3.8 | 0.64/0.35 | 160000 |
| | Typ2 | | | | |
| Sol-D-Ir525 | Ir525 | 19.8 | 3.8 | 0.63/0.36 | --- |
| | Typ2 | | | | |
| Sol-D-Ir549 | Ir549 | 19.5 | 3.8 | 0.65/0.35 | --- |
| | Typ2 | | | | |
| Sol-D-Ir550 | Ir550 | 19.0 | 3.9 | 0.62/0.35 | 170000 |
| | Typ2 | | | | |
| Sol-D-I r551 | Ir551 | 20.0 | 3.8 | 0.67/0.33 | 200000 |
| | Typ2 | | | | |
| Sol-D-Ir552 | Ir552 | 19.7 | 3.9 | 0.68/0.32 | --- |
| | Typ2 | | | | |
| Sol-D-Ir553 | Ir553 | 20.0 | 3.9 | 0.68/0.32 | --- |
| | Typ2 | | | | |
| Sol-D-Ir555 | Ir555 | 20.5 | 3.8 | 0.65/0.34 | --- |
| | Typ2 | | | | |
| Sol-D-Ir569 | Ir569 | 20.2 | 3.8 | 0.65/0.33 | --- |
| | Typ2 | | | | |
| Sol-D-Ir602 | Ir602 | 19.0 | 4.0 | 0.63/0.36 | --- |
| | Typ2 | | | | |
| Sol-D-Ir603 | Ir603 | 18.1 | 3.9 | 0.66/0.33 | --- |
| | Typ2 | | | | |
| Sol-D-Ir700 | Ir700 | 17.0 | 3.7 | 0.62/0.37 | --- |
| | Typ2 | | | | |
| | | | | | |

| **Gelbe OLEDs vom Typ1** | | | | | |
|---|---|---|---|---|---|
| Sol-D-Ir-Y3 | Ir-Y3 | 19.7 | 3.9 | 0.48/0.49 | 120000 |
| Sol-D-Ir(LH6)₃ | Ir(LH6)₃ | 21.5 | 4.1 | 0.45/0.54 | 200000 |
| Sol-D-Ir(LH11)₃ | Ir(L11)₃ | 22.1 | 4.3 | 0.53/0.46 | --- |
| Sol-D-Ir(LH53)₃ | Ir(L53)₃ | 21.0 | 4.3 | 0.44 /0.54 | 140000 |
| Sol-D-Ir(LH55)₃ | Ir(L55)₃ | 21.2 | 4.4 | 0.43/0.55 | --- |
| Sol-D-Ir513 | Ir513 | 22.4 | 4.2 | 0.44/0.55 | 250000 |
| Sol-D-Ir541 | Ir541 | 22.1 | 4.1 | 0.45/0.54 | --- |
| Sol-D-Ir558 | Ir558 | 21.4 | 4.1 | 0.46/0.53 | --- |
| Sol-D-Ir560 | Ir560 | 21.7 | 4.1 | 0.47/0.48 | --- |
| Sol-D-Ir566 | Ir566 | 21.9 | 4.1 | 0.46/0.53 | --- |
| Sol-D-Ir608 | Ir608 | 19.1 | 3.9 | 0.38/0.57 | --- |
| Sol-D-Ir609 | Ir609 | 20.9 | 4.2 | 0.42/0.54 | --- |
| Sol-D-Ir701 | Ir701 | 19.8 | 4.0 | 0.41/0.56 | 220000 |

| **Grüne - Blaugrüne OLEDs vom Typ1** | | | | | |
|---|---|---|---|---|---|
| Sol-D-Ir-G3 | Ir-G3 | 18.8 | 4.4 | 0.33/0.63 | 100000 |
| Sol-D-Ir-G5 | Ir-G5 | 18.3 | 4.6 | 0.34/0.62 | 3000 |
| Sol-D-Ir-G6 | Ir-G6 | 21.3 | 4.7 | 0.33/0.63 | 27000 |
| Sol-D-Ir-G7 | Ir-G7 | 21.6 | 4.7 | 0.33/0.63 | 60000 |
| Sol-D-Ir(LH1)₃ | Ir(LH1)₃ | 22.2 | 4.6 | 0.33/0.65 | 190000 |
| Sol-D-Ir(LH5)₃ | Ir(LH5)₃ | 22.7 | 4.7 | 0.33/0.64 | 220000 |
| Sol-D-Ir(LH12)₃ | Ir(LH12)₃ | 21.9 | 4.6 | 0.34/0.62 | --- |
| Sol-D-Ir(LH13)₃ | Ir(LH13)₃ | 21.8 | 4.6 | 0.44/0.52 | 220000 |
| Sol-D-Ir(LH15)₃ | Ir(LH15)₃ | 22.1 | 4.6 | 0.34/0.61 | 200000 |
| Sol-D-Ir(LH20)₃ | Ir(LH20)₃ | 19.3 | 4.6 | 0.22/0.42 | --- |
| Sol-D-Ir(LH21)₃ | Ir(LH21)₃ | 19,.1 | 4.7 | 0.21/0.43 | --- |
| Sol-D-Ir(LH37)₃ | Ir(LH37)₃ | 21.1 | 4.6 | 0.36/0.61 | 190000 |
| Sol-D-Ir(LH38)₃ | Ir(LH38)₃ | 21.6 | 4.6 | 0.35/0.63 | --- |
| Sol-D-Ir(LH39)₃ | Ir(LH39)₃ | 21.3 | 4.6 | 0.37/0.61 | --- |
| Sol-D-Ir(LH54)₃ | Ir(LH54)₃ | 21.6 | 4.6 | 0.34/0.63 | 200000 |
| Sol-D-Ir(LH56)₃ | Ir(LH56)₃ | 21.7 | 4.7 | 0.35/0.62 | 210000 |
| Sol-D-Ir514 | Ir514 | 22.3 | 4.5 | 0.34/0.63 | 210000 |
| Sol-D-Ir515 | Ir515 | 22.1 | 4.6 | 0.34/0.63 | --- |
| Sol-D-Ir528 | Ir528 | 21.5 | 4.7 | 0.35/0.62 | --- |
| Sol-D-Ir535 | Ir535 | 21.8 | 4.7 | 0.36/0.61 | --- |
| Sol-D-Ir540 | Ir540 | 22.2 | 4.6 | 0.34/0.63 | --- |
| Sol-D-Ir542 | Ir542 | 22.5 | 4.6 | 0.34/0.63 | --- |
| Sol-D-Ir545 | Ir545 | 21.4 | 4.6 | 0.28/0.49 | --- |
| Sol-D-Ir546 | Ir546 | 20.5 | 4.5 | 0.23/0.46 | --- |
| Sol-D-Ir564 | Ir564 | 21.8 | 4.6 | 0.33/0.64 | --- |
| Sol-D-Ir565 | Ir565 | 21.3 | 4.5 | 0.45/0.52 | --- |
| Sol-D-Ir567 | Ir567 | 22.3 | 4.7 | 0.33/0.63 | 180000 |
| Sol-D-Ir568 | Ir568 | 21.5 | 4.6 | 0.45/0.52 | --- |
| Sol-D-Ir600 | Ir600 | 20.2 | 4.5 | 0.34/0.64 | --- |
| Sol-D-Ir601 | Ir601 | 20.0 | 4.6 | 0.35/0.63 | --- |
| Sol-D-Ir604 | Ir604 | 19.8 | 4.6 | 0.23/0.46 | --- |
| Sol-D-Ir605 | Ir605 | 21.8 | 4.6 | 0.33/0.63 | --- |
| Sol-D-Ir606 | Ir606 | 20.9 | 4.5 | 0.23/0.46 | --- |
| Sol-D-Ir607 | Ir607 | 19.9 | 4.5 | 0.35/0.62 | --- |
| Sol-D-Ir702 | Ir702 | 20.8 | 4.6 | 0.45/0.52 | --- |
| Sol-D-Ir703 | Ir703 | 20.3 | 4.6 | 0.33/0.63 | --- |
| Sol-D-Ir704 | Ir704 | 19.7 | 4.4 | 0.32/0.62 | --- |
| Sol-D-Ir800 | Ir800 | 16.1 | 4.3 | 0.16/0.35 | --- |
| Sol-D-Ir801 | Ir801 | 16.7 | 4.5 | 0.17/0.40 | --- |
| Sol-D-Ir803 | Ir803 | 19.2 | 4.5 | 0.17/0.38 | --- |

### B: Aus polymeren Funktionsmaterialien:

Herstellung der OLEDs wie unter A: beschrieben. Zur Herstellung der Emissionsschicht werden die erfindungsgemäßen Polymere in Toluol gelöst. Der typische Feststoffgehalt solcher Lösungen liegt zwischen 10 und 15 g/L, wenn, wie hier, die für eine Device typische Schichtdicke von 80 nm mittels Spincoating erzielt werden soll. Die genannten OLED-Beispiele sind noch nicht optimiert, Tabelle 5 fasst die erhaltenen Daten zusammen.

**Tabelle 4: Ergebnisse mit aus Lösung prozessierten Materialien**

| **Bsp.** | **Polymer** | **EQE (%) 1000 cd/m²** | **Spannung (V) 1000 cd/m²** | **CIE x/y 1000 cd/m²** |
|---|---|---|---|---|
| **Gelbe OLEDs** | | | | |
| D-P3 | P3 | 20.1 | 3.7 | 0.42/0.57 |

| **Grüne OLEDs** | | | | |
|---|---|---|---|---|
| D-P1 | P1 | 20.5 | 4.0 | 0.33/0.61 |
| D-P2 | P2 | 20.6 | 4.1 | 0.32/0.63 |

### 3) Weiß emittierende OLEDs

Gemäß den allgemeinen Verfahren aus 1) wird eine weiß emittierende OLED mit folgendem Schichtaufbau hergestellt:

**Tabelle 5: Aufbau der weißen OLEDs**

| **Bsp.** | **HTL2** | **EML** | **EML** | **EML** | **HBL** | **ETL** |
|---|---|---|---|---|---|---|
| | | **Rot** | **Blau** | **Grün** | | |
| | **Dicke** | **Dicke** | **Dicke** | **Dicke** | **Dicke** | **Dicke** |
| D-W1 | HTM | EBM:Ir521 | M1:M4:Ir(LH40)₃ | M3:Ir(LH1)₃ | M3 | ETM1:ETM2 |
| | | (97%:3%) | (65%:30%:5%) | (95%:5%) | | (50%:50%) |
| | 230 nm | 10 nm | 8 nm | 7 nm | 10 nm | 30 nm |

**Tabelle 6: Deviceergebnisse**

| **Bsp.** | **EQE (%)** | **Spannung (V)** | **CIE x/y** | **LD50 (h)** |
|---|---|---|---|---|
| | **1000 cd/m²** | **1000 cd/m²** | **1000 cd/m²** | **1000 cd/m²** |
| D-W1 | 20.9 | 5.7 | 0.42/0.38 | 5000 |

**Tabelle 7: Strukturformeln der verwendeten Materialien**

| | |
|---|---|
| 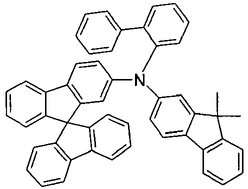 | 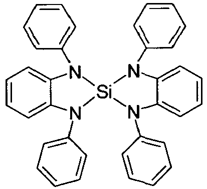 |
| HTM | EBM = M10 |
| 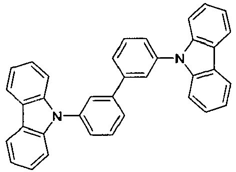 | 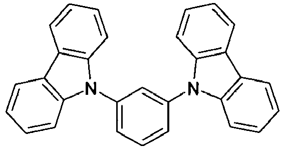 |
| M1 | M2 |
| 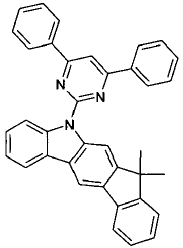 | 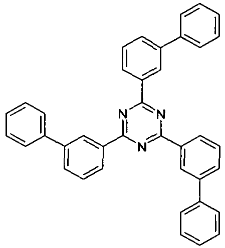 |
| M3 = HBM2 | M4 = HBM1 |
| 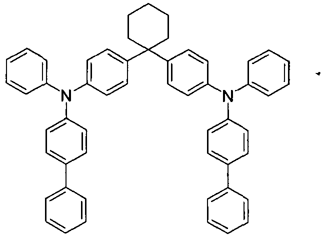 | 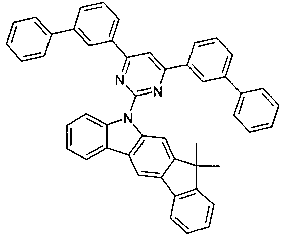 |
| M5 | M6 |
| 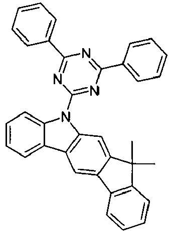 | 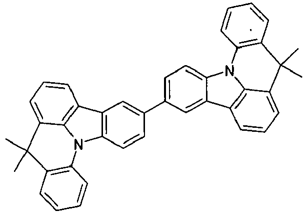 |
| M7 | M8 |
| 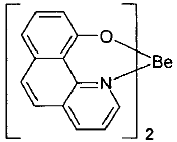 | |
| 148896-39-3 | |
| M9 | |
| 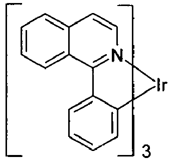 | 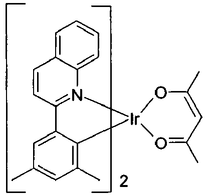 |
| 435293-93-9 | 1056874-46-4 |
| Ir-R1 | Ir-R2 |
| 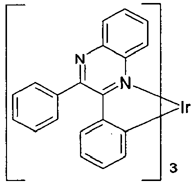 | 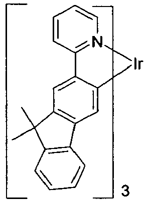 |
| 863714-61-8 | 458532-65-5 |
| Ir-R3 | Ir-Y1 |
| 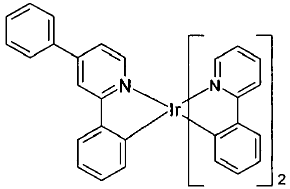 | 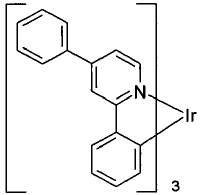 |
| 1215281-24-5 | 459133-57-4 |
| Ir-Y2 | Ir-Y3 |
| 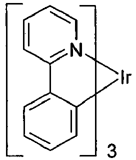 | 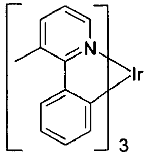 |
| 693794-98-8 | 359014-71-4 |
| Ir-G1 | Ir-G2 |
| 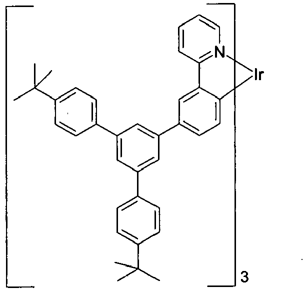 | 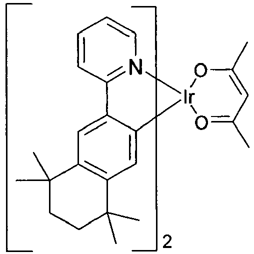 |
| 856219-87-9 | |
| Ir-G3 | Ir-G4 |
| 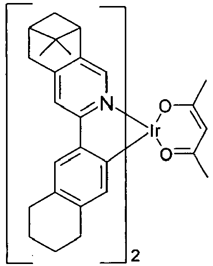 | 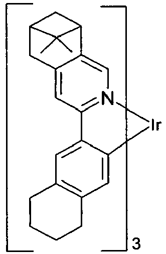 |
| 951661-21-5 | 952594-15-9 |
| Ir-G5 | Ir-G6 |
| 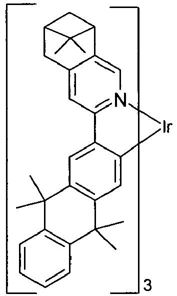 | |
| Ir-G7 | |
| 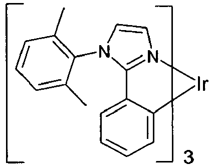 | 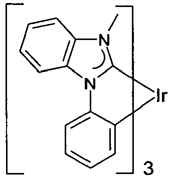 |
| 1013022-35-9 | 869486-05-5 |
| Ir-B1 | Ir-B2 |
| 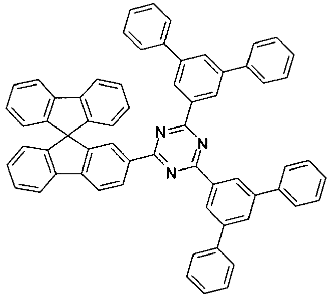 | 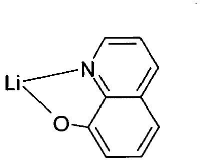 |
| 1233200-52-6 | 25387-93-3 |
| ETM1 | ETM2 / Liq |
| 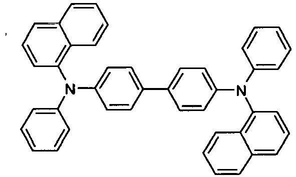 | 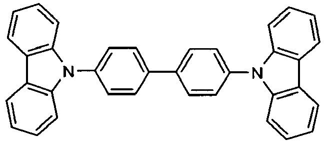 |
| 123847-85-8 | 58328-31-7 |
| NPB | CBP |
| 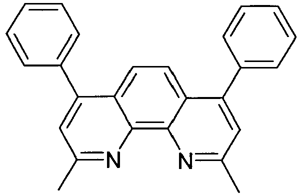 | 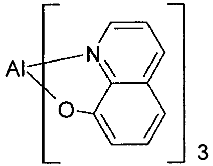 |
| 4733-39-5 | |
| BCP | Alq₃ |

## Patentansprüche

1. Verbindung gemäß Formel (1),
M(L)ₙ(L')ₘ Formel (1)
enthaltend eine Teilstruktur M(L)ₙ der Formel (2): 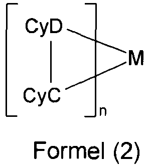 wobei für die verwendeten Symbole und Indizes gilt:
M ist Iridium oder Platin;
CyC ist eine Aryl- oder Heteroarylgruppe mit 5 bis 18 aromatischen Ringatomen oder eine Fluorengruppe, welche jeweils über ein Kohlenstoffatom an M koordiniert und welche jeweils mit einem oder mehreren Resten R substituiert sein kann und welche jeweils über eine kovalente Bindung mit CyD verbunden ist;
CyD ist eine Heteroarylgruppe mit 5 bis 18 aromatischen Ringatomen, welche über ein neutrales Stickstoffatom oder über ein Carben-Kohlenstoffatom an M koordiniert und welche mit einem oder mehreren Resten R substituiert sein kann und welche über eine kovalente Bindung mit CyC verbunden ist;
R ist bei jedem Auftreten gleich oder verschieden H, D, F, Cl, Br, I, N(R¹)₂, CN, NO₂, OH, COOH, C(=O)N(R¹)₂, Si(R¹)₃, B(OR¹)₂, C(=O)R¹, P(=O)(R¹)₂, S(=O)R¹, S(=O)₂R¹, OSO₂R¹, eine geradkettige Alkyl-, Alkoxy- oder Thioalkoxygruppe mit 1 bis 20 C-Atomen oder eine Alkenyl- oder Alkinylgruppe mit 2 bis 20 C-Atomen oder eine verzweigte oder cyclische Alkyl-, Alkoxy- oder Thioalkoxygruppe mit 3 bis 20 C-Atomen, die jeweils mit einem oder mehreren Resten R¹ substituiert sein kann, wobei eine oder mehrere nicht benachbarte CH₂-Gruppen durch R¹C=CR¹, C≡C, Si(R¹)₂, C=O, NR¹, O, S oder CONR¹ ersetzt sein können und wobei ein oder mehrere H-Atome durch D, F, Cl, Br, I oder CN ersetzt sein können, oder ein aromatisches oder heteroaromatisches Ringsystem mit 5 bis 60 aromatischen Ringatomen, das jeweils durch einen oder mehrere Reste R¹ substituiert sein kann, oder eine Aryloxy- oder Heteroaryloxygruppe mit 5 bis 40 aromatischen Ringatomen, die durch einen oder mehrere Reste R¹ substituiert sein kann, oder eine Aralkyl- oder Heteroaralkylgruppe mit 5 bis 40 aromatischen Ringatomen, die durch einen oder mehrere Reste R¹ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R¹ substituiert sein kann; dabei können zwei benachbarte Reste R auch miteinander ein mono- oder polycyclisches, aliphatisches, aromatisches oder heteroaromatisches Ringsystem bilden, wobei benachbarte Reste entweder Reste sind, die an dasselbe Kohlenstoffatom gebunden sind, oder Reste, die an benachbarte Kohlenstoffatome gebunden sind, wobei benachbarte Kohlenstoffatome bedeutet, dass die Kohlenstoffatome direkt aneinander gebunden sind;
R¹ ist bei jedem Auftreten gleich oder verschieden H, D, F, Cl, Br, I, N(R²)₂, CN, NO₂, Si(R²)₃, B(OR²)₂, C(=O)R², P(=O)(R²)₂, S(=O)R², S(=O)₂R², OSO₂R², eine geradkettige Alkyl-, Alkoxy- oder Thioalkoxygruppe mit 1 bis 20 C-Atomen oder eine Alkenyl- oder Alkinylgruppe mit 2 bis 20 C-Atomen oder eine verzweigte oder cyclische Alkyl-, Alkoxy- oder Thioalkoxygruppe mit 3 bis 20 C-Atomen, die jeweils mit einem oder mehreren Resten R² substituiert sein kann, wobei eine oder mehrere nicht benachbarte CH₂-Gruppen durch R²C=CR², C≡C, Si(R²)₂, C=O, NR², O, S oder CONR² ersetzt sein können und wobei ein oder mehrere H-Atome durch D, F, Cl, Br, I, CN oder NO₂ ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 40 aromatischen Ringatomen, die durch einen oder mehrere Reste R² substituiert sein kann, oder eine Aralkyl- oder Heteroaralkylgruppe mit 5 bis 40 aromatischen Ringatomen, die durch einen oder mehrere Reste R² substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R² substituiert sein kann; dabei können zwei oder mehrere benachbarte Reste R¹ miteinander ein monooder polycyclisches, aliphatisches Ringsystem bilden, wobei benachbarte Reste entweder Reste sind, die an dasselbe Kohlenstoffatom gebunden sind, oder Reste, die an benachbarte Kohlenstoffatome gebunden sind, wobei benachbarte Kohlenstoffatome bedeutet, dass die Kohlenstoffatome direkt aneinander gebunden sind;
R² ist bei jedem Auftreten gleich oder verschieden H, D, F oder ein aliphatischer, aromatischer und/oder heteroaromatischer Kohlenwasserstoffrest mit 1 bis 20 C-Atomen, in dem auch ein oder mehrere H-Atome durch F ersetzt sein können; dabei können zwei oder mehrere Substituenten R² auch miteinander ein mono- oder polycyclisches, aliphatisches Ringsystem bilden;
L' ist gleich oder verschieden bei jedem Auftreten ein bidentater Ligand, der über ein Kohlenstoffatom und ein Stickstoffatom oder über zwei Kohlenstoffatome an M bindet;
n ist 1, 2 oder 3 für M = Iridium und ist 1 oder 2 für M = Platin;
m ist 0, 1 oder 2 für M = Iridium und ist 0 oder 1 für M = Platin;
dabei können CyC und CyD auch über eine Gruppe ausgewählt aus C(R¹)₂, C(R¹)₂-C(R¹)₂, NR¹, O oder S miteinander verknüpft sein;
dabei können auch mehrere Liganden L miteinander oder L mit L' über eine Einfachbindung oder eine bivalente oder trivalente Brücke verknüpft sein und so ein tetradentates oder hexadentates Ligandensystem aufspannen;
**dadurch gekennzeichnet, dass** CyD und/oder CyC zwei benachbarte Kohlenstoffatome aufweist, die jeweils mit Resten R substituiert sind, wobei die jeweiligen Reste R zusammen mit den C-Atomen einen Ring der folgenden Formel (3) aufspannen, 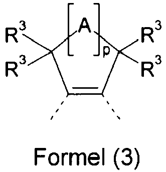 wobei R¹ und R² die oben genannten Bedeutungen aufweisen, die gestrichelten Bindungen die Verknüpfung der beiden Kohlenstoffatome im Liganden andeuten und weiterhin gilt:
A ist gleich oder verschieden bei jedem Auftreten C(R¹)₂, O, S, NR³ oder C(=O) mit der Maßgabe, dass in der Gruppe -(A)ₚ- nicht zwei Heteroatome direkt aneinander gebunden sind;
R³ ist gleich oder verschieden bei jedem Auftreten eine geradkettige Alkyl- oder Alkoxygruppe mit 1 bis 20 C-Atomen, eine verzweigte oder cyclische Alkyl- oder Alkoxygruppe mit 3 bis 20 C-Atomen, die jeweils mit einem oder mehreren Resten R² substituiert sein kann, wobei eine oder mehrere nicht benachbarte CH₂-Gruppen durch R²C=CR², C≡C, Si(R²)₂, C=O, NR², O, S oder CONR² ersetzt sein können und wobei ein oder mehrere H-Atome durch D oder F ersetzt sein können, oder ein aromatisches oder heteroaromatisches Ringsystem mit 5 bis 24 aromatischen Ringatomen, das jeweils durch einen oder mehrere Reste R² substituiert sein kann, oder eine Aryloxy- oder Heteroaryloxygruppe mit 5 bis 24 aromatischen Ringatomen, die durch einen oder mehrere Reste R² substituiert sein kann, oder eine Aralkyl- oder Heteroaralkylgruppe mit 5 bis 24 aromatischen Ringatomen, die durch einen oder mehrere Reste R² substituiert sein kann; dabei können zwei Reste R³, welche an dasselbe Kohlenstoffatom gebunden sind, miteinander ein aliphatisches oder aromatisches Ringsystem bilden und so ein Spirosystem aufspannen; weiterhin kann R³ mit einem benachbarten Rest R oder R¹ ein aliphatisches Ringsystem bilden;
p ist gleich oder verschieden bei jedem Auftreten 2 oder 3.

2. Verbindung nach Anspruch 1, **dadurch gekennzeichnet, dass** die Gruppe CyC ausgewählt ist aus den Strukturen der Formeln (CyC-1) bis (CyC-19), wobei die Gruppe CyC jeweils an der durch # gekennzeichneten Position an CyD bindet und an der durch * gekennzeichneten Position an M koordiniert, 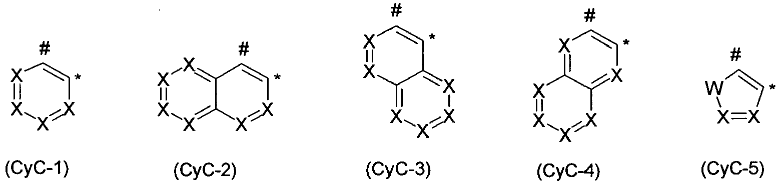 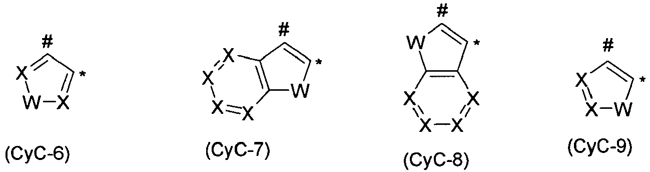 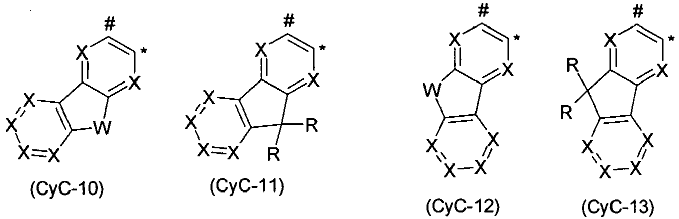 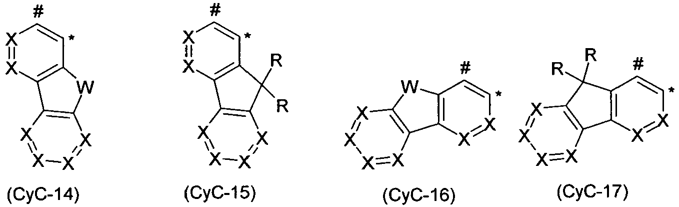 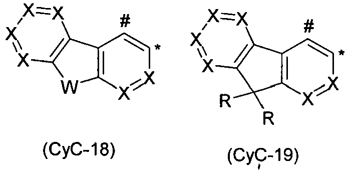 und dass CyD ausgewählt ist aus den Strukturen der Formeln (CyD-1) bis (CyD-10), wobei die Gruppe CyD jeweils an der durch # gekennzeichneten Position an CyC bindet und an der durch * gekennzeichneten Position an M koordiniert, 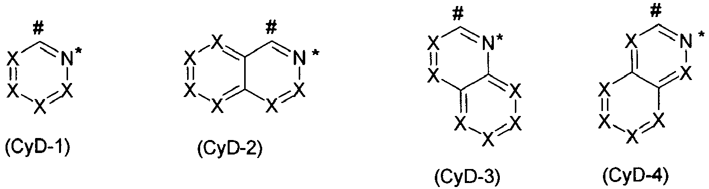 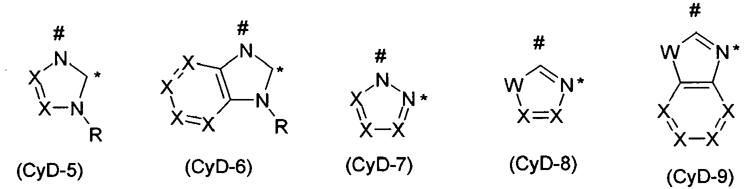 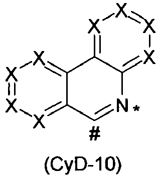 wobei R die in Anspruch 1 genannten Bedeutungen aufweist und für die weiteren verwendeten Symbole gilt:
X ist bei jedem Auftreten gleich oder verschieden CR oder N;
W ist bei jedem Auftreten gleich oder verschieden NR, O oder S;
dabei stehen in CyC und/oder in CyD zwei benachbarte Gruppen X für CR und bilden zusammen mit den Resten R, die an diese Kohlenstoffatome gebunden sind, eine Gruppe der Formel (3).

3. Verbindung Anspruch 1 oder 2, **dadurch gekennzeichnet, dass** die Gruppe CyC ausgewählt ist aus den Strukturen der Formeln (CyC-1a) bis (CyC-19a), wobei die Gruppe CyC jeweils an der durch # gekennzeichneten Position an CyD bindet und an der durch * gekennzeichneten Position an M koordiniert, 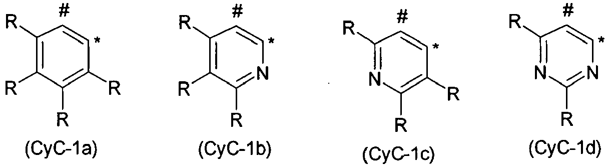 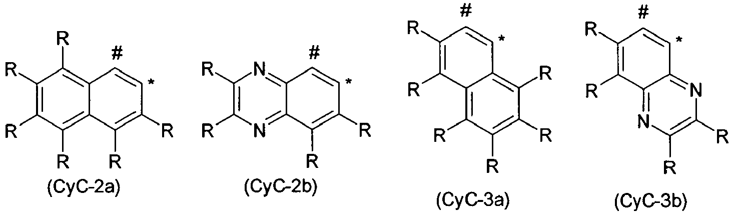 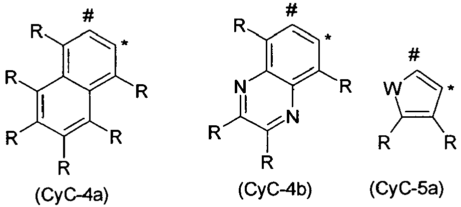 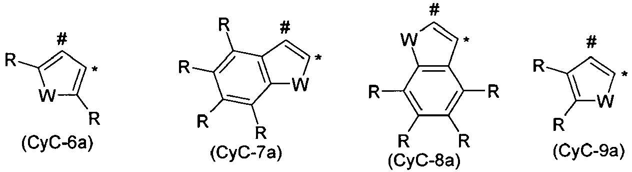 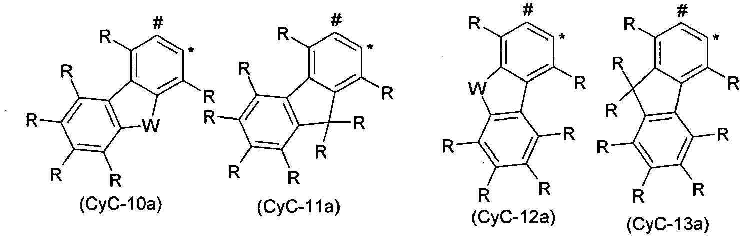 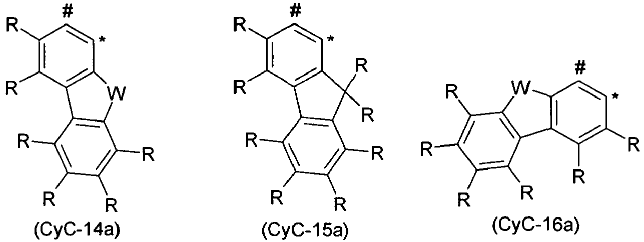 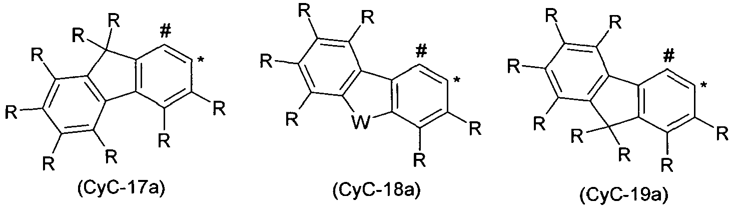 und dass die Gruppe CyD ausgewählt ist aus den Gruppen der Formeln (CyD-1a) bis (CyD-10a), wobei die Gruppe CyD jeweils an der durch # gekennzeichneten Position an CyC bindet und an der durch * gekennzeichneten Position an M koordiniert, 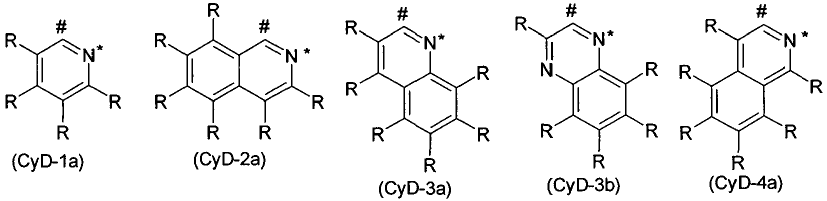 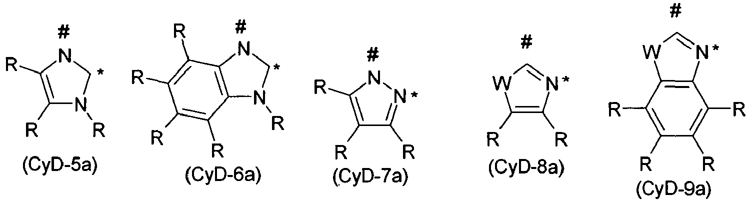 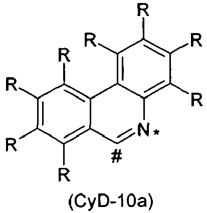 wobei die verwendeten Symbole die in den Ansprüchen 1 und 2 genannten Bedeutungen aufweisen und in mindestens einer der Gruppen CyC und/oder CyD zwei benachbarte Reste R zusammen mit den Kohlenstoffatomen, an die sie binden, einen Ring der Formel (3) aufspannen.

4. Verbindung nach einem oder mehreren der Ansprüche 1 bis 3, **dadurch gekennzeichnet, dass** der Ligand L entweder genau eine Gruppe der Formel (3) enthält oder dass er zwei Gruppen der Formel (3) enthält, von denen eine an CyC und die andere an CyD gebunden ist.

5. Verbindung nach einem oder mehreren der Ansprüche 1 bis 4, **dadurch gekennzeichnet, dass** CyC ausgewählt ist aus den Gruppen (CyC-1-1) bis (CyC-19-1) und/oder dass CyD ausgewählt ist aus den Gruppen (CyD-1-1) bis (CyD-10-1), 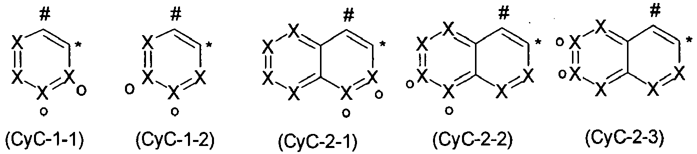 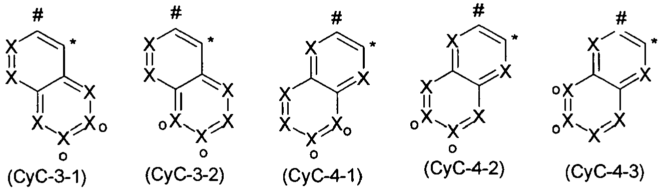 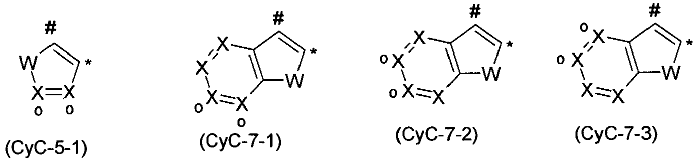 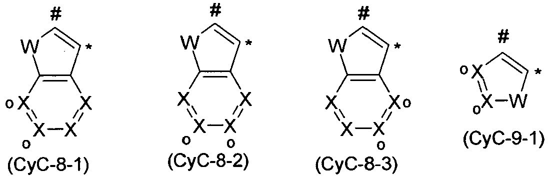 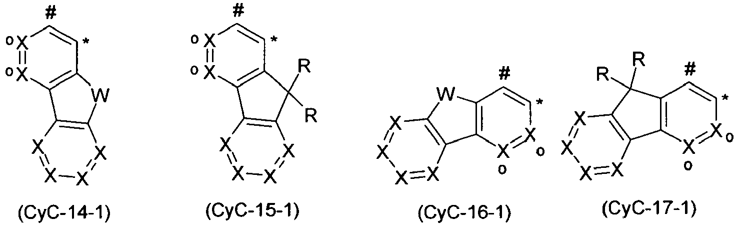 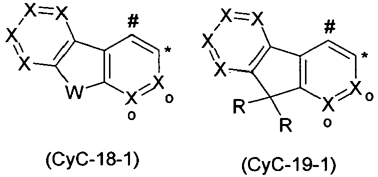 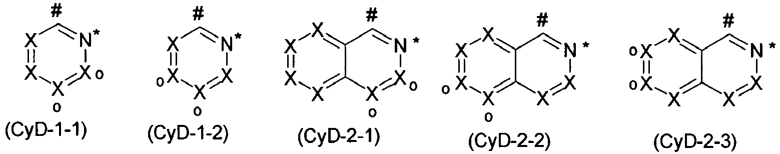 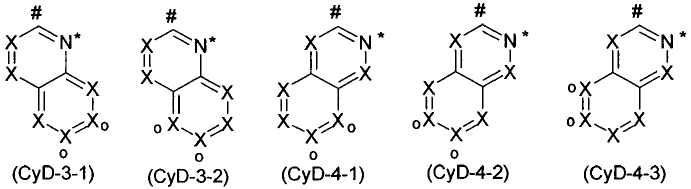 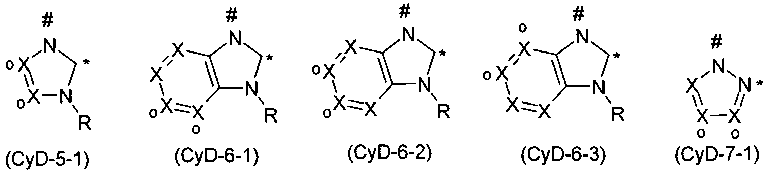 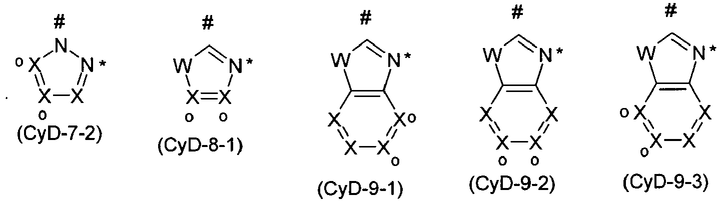 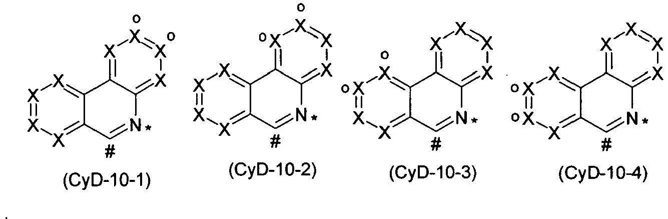 wobei die verwendeten Symbole und Indizes die die in den Ansprüchen 1 und 2 genannten Bedeutungen aufweisen und ° jeweils die Positionen kennzeichnet, die für CR stehen, wobei die jeweiligen Reste R zusammen mit den C-Atomen, an die sie gebunden sind, einen Ring der Formel (3) aufspannen.

6. Verbindung nach einem oder mehreren der Ansprüche 1 bis 5, **dadurch gekennzeichnet, dass** die Gruppe der Formel (3) für p = 2 ausgewählt ist aus den Strukturen der Formeln (4-A) und (4-B) und für p = 3 ausgewählt ist aus den Strukturen der Formeln (5-A), (5-B) und (5-C), 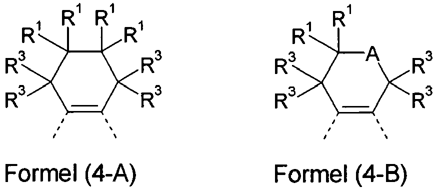 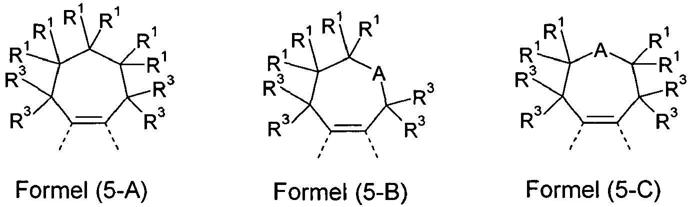 wobei R¹ und R³ die in Anspruch 1 genannten Bedeutungen aufweisen und A für O oder NR³ steht.

7. Verbindung nach einem oder mehreren der Ansprüche 1 bis 6, **dadurch gekennzeichnet, dass** R¹ in Formel (3), (4-A), (4-B), (5-A), (5-B) und (5-C) gleich oder verschieden bei jedem Auftreten für H, D oder eine Alkylgruppe mit 1 bis 5 C-Atomen steht, in der auch ein oder mehrere H-Atome durch F ersetzt sein können, wobei zwei oder mehrere benachbarte Reste R¹ miteinander ein aliphatisches Ringsystem bilden können.

8. Verbindung nach einem oder mehreren der Ansprüche 1 bis 7, ausgewählt aus Verbindungen der Formeln (6) bis (11), 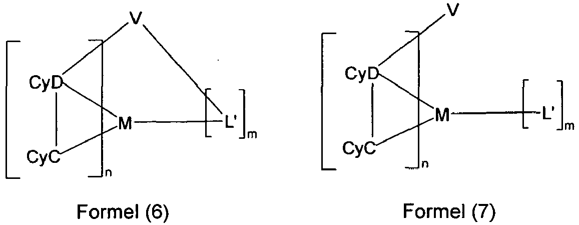 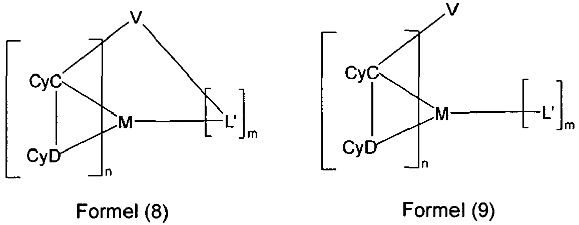 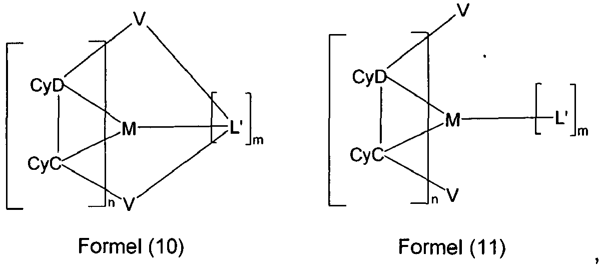 wobei die verwendeten Symbole und Indizes die in Anspruch 1 genannten Bedeutungen aufweisen und V eine Einfachbindung oder eine verbrückende Einheit, enthaltend 1 bis 80 Atome aus der dritten, vierten, fünften und/oder sechsten Hauptgruppe oder einen 3- bis 6-gliedrigen Homo- oder Heterocyclus darstellt, die die Teilliganden L miteinander oder L mit L' miteinander kovalent verbindet.

9. Verbindung nach einem oder mehreren der Ansprüche 1 bis 8, **dadurch gekennzeichnet, dass** L' ein monoanionischer bidentater Ligand ist, der über ein neutrales Stickstoffatom und ein negativ geladenes Kohlenstoffatom oder über ein neutrales Kohlenstoffatom und ein negativ geladenes Kohlenstoffatom an M bindet, insbesondere ausgewählt aus einer Kombination aus zwei Gruppen der Formeln (27) bis (50), 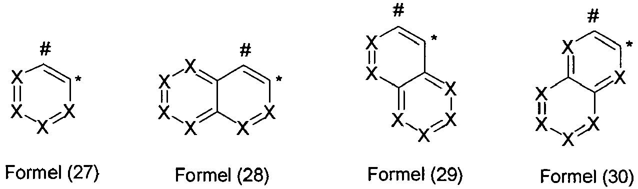 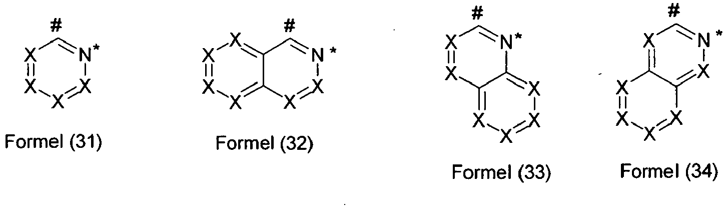 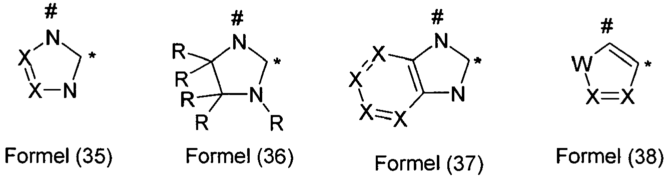 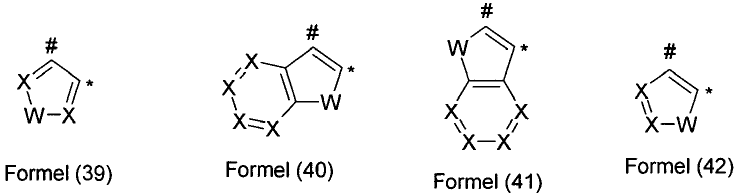 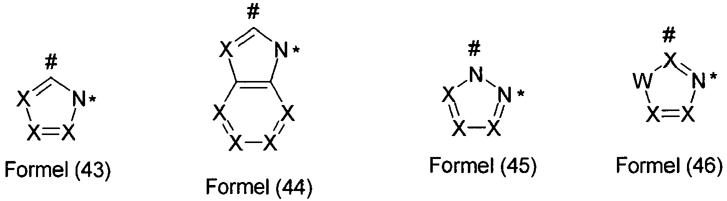 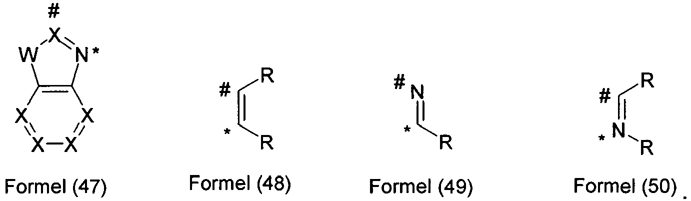 wobei zwei Gruppen jeweils an der durch # gekennzeichneten Position aneinander binden und der der durch * gekennzeichneten Position an M koordineren; W hat die in Anspruch 2 genannten Bedeutungen; X steht bei jedem Auftreten gleich oder verschieden für CR oder N; R hat dieselbe Bedeutung wie in Anspruch 1 beschrieben, wobei hier auch zwei Reste R, die an zwei unterschiedlichen Cyclen der Formeln (27) bis (59) gebunden sind, miteinander auch ein aromatisches Ringsystem bilden können.

10. Verfahren zur Herstellung einer Verbindung nach einem oder mehreren der Ansprüche 1 bis 9 durch Umsetzung des freien Liganden L und gegebenenfalls L' mit Metallalkoholaten der Formel (67), mit Metallketoketonaten der Formel (68), mit Metallhalogeniden der Formel (69), mit dimeren Metallkomplexen der Formel (70) oder mit Metallkomplexen der Formel (71),
M(OR)ₙ Formel (67) 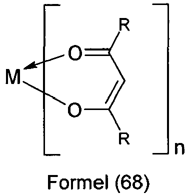
MHalₙ Formel (69) 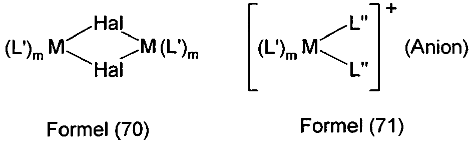
oder mit Metallverbindungen, die sowohl Alkoholat- und/oder Halogenid- und/oder Hydroxy- wie auch Ketoketonatreste tragen,
wobei die Symbole M, m, n und R die in Anspruch 1 angegebenen Bedeutungen haben, Hal = F, Cl, Br oder I ist, L" für einen Alkohol oder ein Nitril steht und (Anion) ein nicht-koordinierendes Anion ist;.

11. Oligomer, Polymer oder Dendrimer enthaltend eine oder mehrere Verbindungen nach einem oder mehreren der Ansprüche 1 bis 9, wobei ein oder mehrere Bindungen der Verbindung zum Polymer, Oligomer oder Dendrimer vorhanden sind.

12. Formulierung, enthaltend eine oder mehrere Verbindungen nach einem oder mehreren der Ansprüche 1 bis 9 oder ein Polymer, Oligomer oder Dendrimer nach Anspruch 11 und mindestens eine weitere Verbindung, insbesondere ein Lösemittel.

13. Verwendung einer Verbindung nach einem oder mehreren der Ansprüche 1 bis 9 oder eines Polymers, Oligomers oder Dendrimers nach Anspruch 11 in einer elektronischen Vorrichtung oder zur Erzeugung von Singulett-Sauerstoff oder in der Photokatalyse.

14. Elektronische Vorrichtung, insbesondere ausgewählt aus der Gruppe bestehend aus organischen Elektrolumineszenzvorrichtungen, organischen integrierten Schaltungen, organischen Feld-Effekt-Transistoren, organischen Dünnfilmtransistoren, organischen lichtemittierenden Transistoren, organischen Solarzellen, organischen optischen Detektoren, organischen Photorezeptoren, organischen Feld-Quench-Devices, lichtemittierenden elektrochemischen Zellen oder organischen Laserdioden, enthaltend in mindestens einer Schicht mindestens eine Verbindungen nach einem oder mehreren der Ansprüche 1 bis 9 oder ein Polymer, Oligomer oder Dendrimer nach Anspruch 11.

15. Elektronische Vorrichtung nach Anspruch 14, **dadurch gekennzeichnet, dass** es sich um eine organische Elektrolumineszenzvorrichtung handelt und die Verbindung nach einem oder mehreren der Ansprüche 1 bis 9 oder das Polymer, Oligomer oder Dendrimer nach Anspruch 11 als emittierende Verbindung in einer oder mehreren emittierenden Schichten eingesetzt wird.

16. Elektronische Vorrichtung nach Anspruch 15, **dadurch gekennzeichnet, dass** die emittierende Schicht ein oder mehrere Matrixmaterialien enthält, ausgewählt aus der Gruppe bestehend aus Ketonen, Phosphinoxiden, Sulfoxiden, Sulfonen, Triarylaminen, Carbazolen, Indolocarbazolen, Indenocarbazolen, Azacarbazolen, bipolaren Matrixmaterialien, Silanen, Azaborolen, Boronestern, Diazasilolen, Diazaphospholen, Triazinen, Zinkkomplexen, Dibenzofuranen oder verbrückten Carbazolen.

## Claims

1. Compound of the formula (1),
M(L)ₙ(L')ₘ formula (1)
containing a moiety M(L)ₙ of the formula (2): 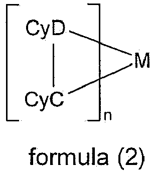 where the following applies to the symbols and indices used:
M is iridium or platinum;
CyC is an aryl or heteroaryl group having 5 to 18 aromatic ring atoms or a fluorene group, which is in each case coordinated to M via a carbon atom and which may in each case be substituted by one or more radicals R and which is in each case connected to CyD via a covalent bond;
CyD is a heteroaryl group having 5 to 18 aromatic ring atoms, which is coordinated to M via a neutral nitrogen atom or via a carbene carbon atom and which may be substituted by one or more radicals R and which is connected to CyC via a covalent bond;
R is on each occurrence, identically or differently, H, D, F, Cl, Br, I, N(R¹)₂, CN, NO₂, OH, COOH, C(=O)N(R¹)₂, Si(R¹)₃, B(OR¹)₂, C(=O)R¹, P(=O)(R¹)₂, S(=O)R¹, S(=O)₂R¹, OSO₂R¹, a straight-chain alkyl, alkoxy or thioalkoxy group having 1 to 20 C atoms or an alkenyl or alkynyl group having 2 to 20 C atoms or a branched or cyclic alkyl, alkoxy or thioalkoxy group having 3 to 20 C atoms, which may in each case be substituted by one or more radicals R¹, where one or more non-adjacent CH₂ groups may be replaced by R¹C=CR¹, C≡C, Si(R¹)₂, C=O, NR¹, O, S or CONR¹ and where one or more H atoms may be replaced by D, F, Cl, Br, I or CN, or an aromatic or heteroaromatic ring system having 5 to 60 aromatic ring atoms, which may in each case be substituted by one or more radicals R¹, or an aryloxy or heteroaryloxy group having 5 to 40 aromatic ring atoms, which may be substituted by one or more radicals R¹, or an aralkyl or heteroaralkyl group having 5 to 40 aromatic ring atoms, which may be substituted by one or more radicals R¹, or a diarylamino group, diheteroarylamino group or arylheteroarylamino group having 10 to 40 aromatic ring atoms, which may be substituted by one or more radicals R¹; two adjacent radicals R may also form a mono- or polycyclic, aliphatic, aromatic or heteroaromatic ring system with one another, where adjacent radicals are either radicals which are bonded to the same carbon atom or radicals which are bonded to adjacent carbon atoms, where adjacent carbon radicals means that the carbon atoms are bonded directly to one another;
R¹ is on each occurrence, identically or differently, H, D, F, Cl, Br, I, N(R²)₂, CN, NO₂, Si(R²)₃, B(OR²)₂, C(=O)R², P(=O)(R²)₂, S(=O)R², S(=O)₂R², OSO₂R², a straight-chain alkyl, alkoxy or thioalkoxy group having 1 to 20 C atoms or an alkenyl or alkynyl group having 2 to 20 C atoms or a branched or cyclic alkyl, alkoxy or thioalkoxy group having 3 to 20 C atoms, which may in each case be substituted by one or more radicals R², where one or more non-adjacent CH₂ groups may be replaced by R²C=CR², C≡C, Si(R²)₂, C=O, NR², O, S oder CONR² and where one or more H atoms may be replaced by D, F, Cl, Br, I, CN or NO₂, or an aromatic or heteroaromatic ring system having 5 to 60 aromatic ring atoms, which may in each case be substituted by one or more radicals R², or an aryloxy or heteroaryloxy group having 5 to 40 aromatic ring atoms, which may be substituted by one or more radicals R², or an aralkyl or heteroaralkyl group having 5 to 40 aromatic ring atoms, which may be substituted by one or more radicals R², or a diarylamino group, diheteroarylamino group or arylheteroarylamino group having 10 to 40 aromatic ring atoms, which may be substituted by one or more radicals R²; two or more adjacent radicals R¹ may form a mono- or polycyclic, aliphatic ring system with one another, where adjacent radicals are either radicals which are bonded to the same carbon atom or radicals which are bonded to adjacent carbon atoms, where adjacent carbon radicals means that the carbon atoms are bonded directly to one another;
R² is on each occurrence, identically or differently, H, D, F or an aliphatic, aromatic and/or heteroaromatic hydrocarbon radical having 1 to 20 C atoms, in which, in addition, one or more H atoms may be replaced by F; two or more substituents R² may also form a mono- or polycyclic, aliphatic ring system with one another;
L' is, identically or differently on each occurrence, a bidentate ligand which is bonded to M via one carbon atom and one nitrogen atom or via two carbon atoms;
n is 1, 2 or 3 for M = iridium and is 1 or 2 for M = platinum;
m is 0, 1 or 2 for M = iridium and is 0 or 1 for M = platinum;
CyC and CyD may also be linked to one another via a group selected from C(R¹)₂, C(R¹)₂-C(R¹)₂, NR¹, O or S;
a plurality of ligands L may also be linked to one another or L may be linked to L' via a single bond or a divalent or trivalent bridge and thus form a tetradentate or hexadentate ligand system;
**characterised in that** CyD and/or CyC contain two adjacent carbon atoms which are in each case substituted by radicals R, where the respective radicals R, together with the C atoms, form a ring of the following formula (3): 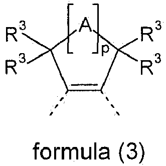 where R¹ and R² have the meanings given above, the dashed bonds indicate the linking of the two carbon atoms in the ligand, and furthermore:
A is, identically or differently on each occurrence, C(R¹)₂, O, S, NR³ or C(=O), with the proviso that two heteroatoms in the group -(A)ₚ- are not bonded directly to one another;
R³ is, identically or differently on each occurrence, a straight-chain alkyl or alkoxy group having 1 to 20 C atoms, a branched or cyclic alkyl or alkoxy group having 3 to 20 C atoms, which may in each case be substituted by one or more radicals R², where one or more non-adjacent CH₂ groups may be replaced by R²C=CR², C≡C, Si(R²)₂, C=O, NR², O, S or CONR² and where one or more H atoms may be replaced by D or F, or an aromatic or heteroaromatic ring system having 5 to 24 aromatic ring atoms, which may in each case be substituted by one or more radicals R², or an aryloxy or heteroaryloxy group having 5 to 24 aromatic ring atoms, which may be substituted by one or more radicals R², or an aralkyl or heteroaralkyl group having 5 to 24 aromatic ring atoms, which may be substituted by one or more radicals R²; two radicals R³ which are bonded to the same carbon atom may form an aliphatic or aromatic ring system with one another and thus form a spiro system; furthermore, R³ may form an aliphatic ring system with an adjacent radical R or R¹;
p is, identically or differently on each occurrence, 2 or 3.

2. Compound according to Claim 1, **characterised in that** the group CyC is selected from the structures of the formulae (CyC-1) to (CyC-19), where the group CyC is in each case bonded to CyD at the position denoted by # and coordinated to M at the position denoted by *, 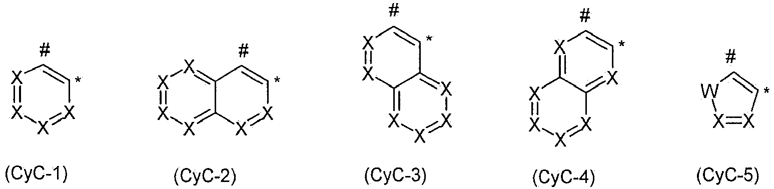 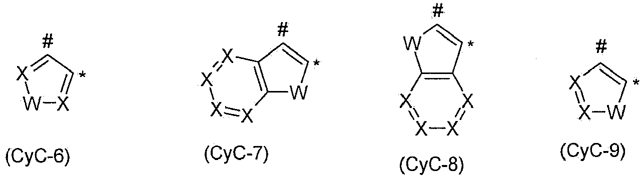 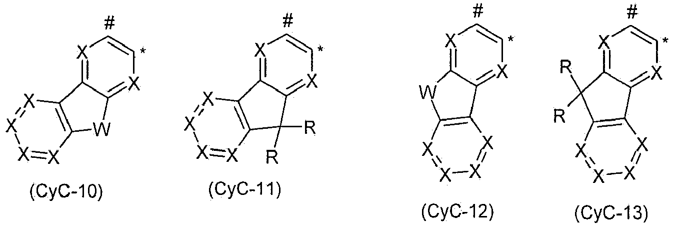 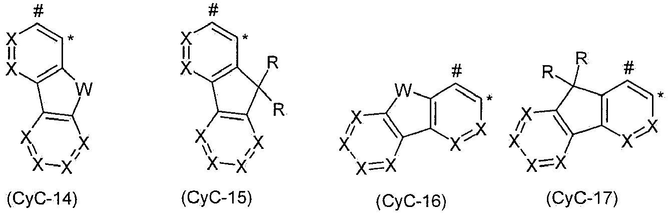 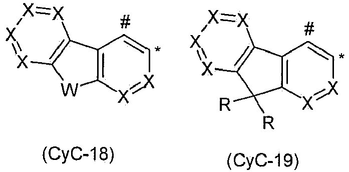 and **in that** CyD is selected from the structures of the formulae (CyD-1) to (CyD-10), where the group CyD is in each case bonded to CyC at the position denoted by # and coordinated to M at the position denoted by *, 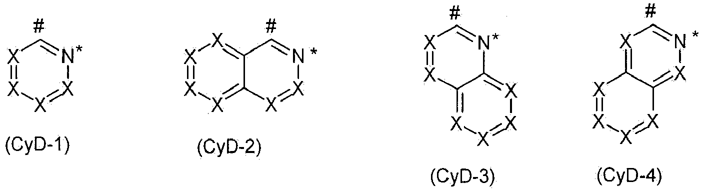 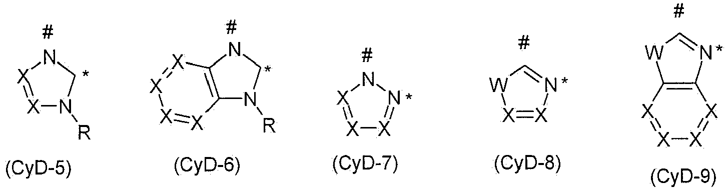 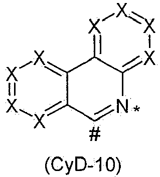 where R has the meanings given in Claim 1, and the following applies to the other symbols used:
X is on each occurrence, identically or differently, CR or N;
W is on each occurrence, identically or differently, NR, O or S;
two adjacent groups X in CyC and/or in CyD here stand for CR and, together with the radicals R which are bonded to these carbon atoms, form a group of the formula (3).

3. Compound according to Claim 1 or 2, **characterised in that** the group CyC is selected from the structures of the formulae (CyC-1a) to (CyC-19a), where the group CyC is in each case bonded to CyD at the position denoted by # and coordinated to M at the position denoted by *, 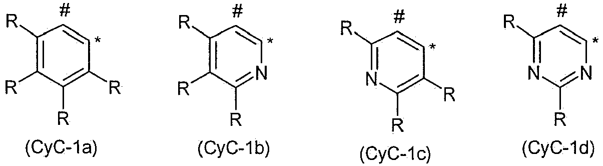 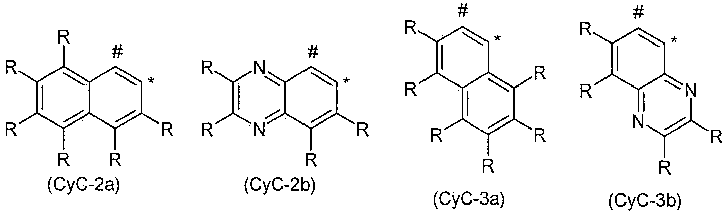 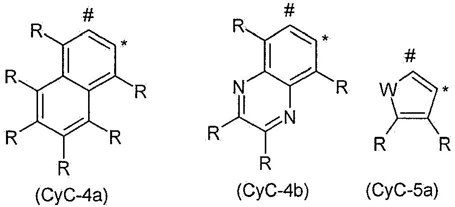 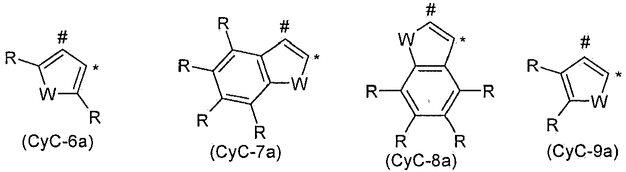 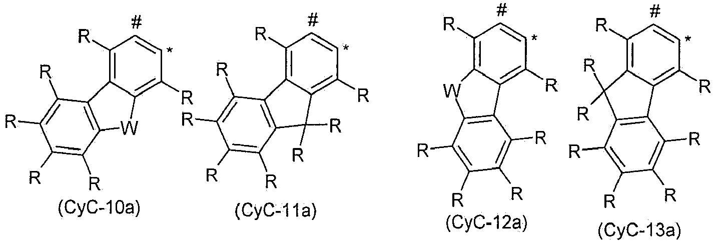 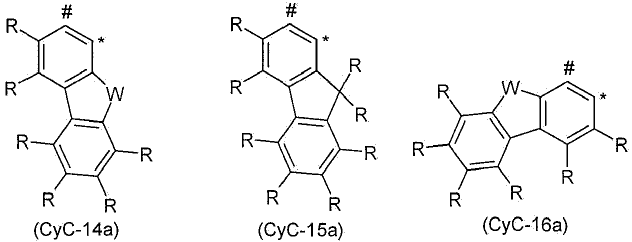 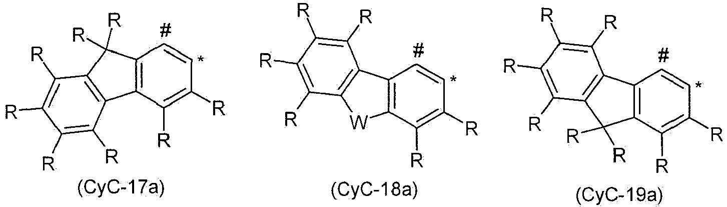 and **in that** the group CyD is selected from the groups of the formulae (CyD-1a) to (CyD-10a), where the group CyD is in each case bonded to CyC at the position denoted by # and coordinated to M at the position denoted by *, 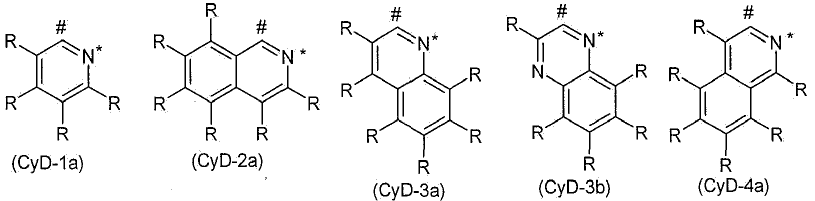 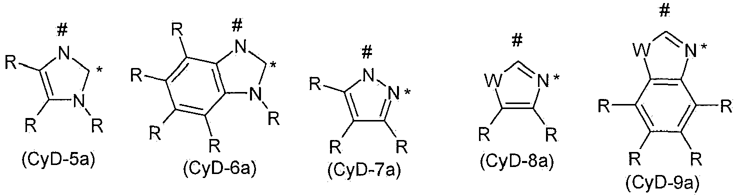 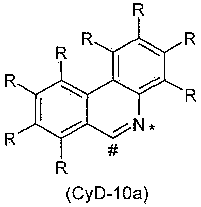 where the symbols used have the meanings given in Claims 1 and 2, and two adjacent radicals R in at least one of the groups CyC and/or CyD, together with the carbon atoms to which they are bonded, form a ring of the formula (3).

4. Compound according to one or more of Claims 1 to 3, **characterised in that** the ligand L either contains precisely one group of the formula (3) or **in that** it contains two groups of the formula (3), one of which is bonded to CyC and the other is bonded to CyD.

5. Compound according to one or more of Claims 1 to 4, **characterised in that** CyC is selected from the groups (CyC-1-1) to (CyC-19-1) and/or **in that** CyD is selected from the groups (CyD-1-1) to (CyD-10-1), 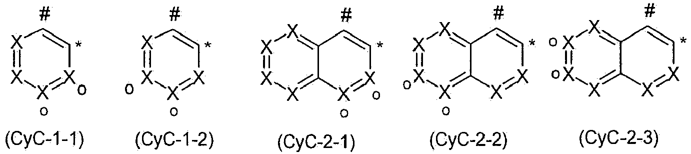 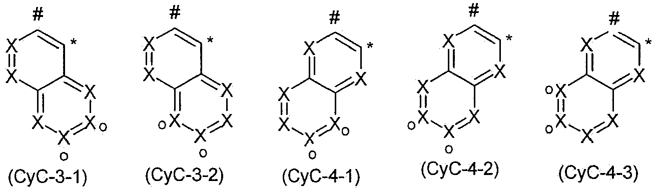 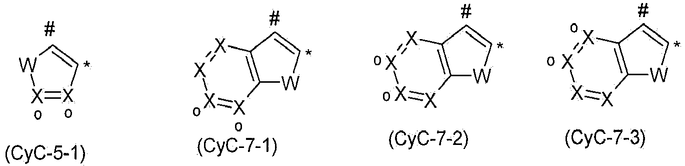 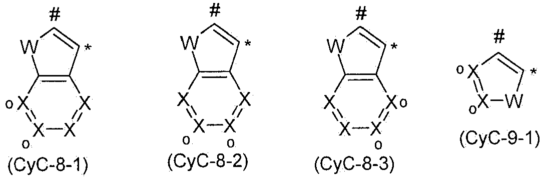 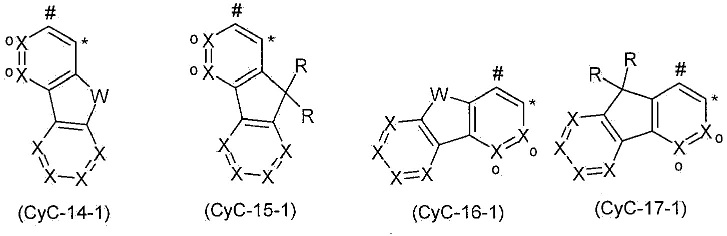 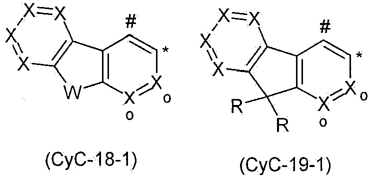 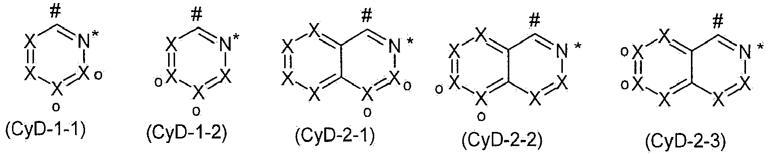 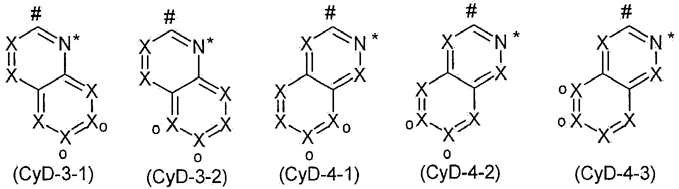 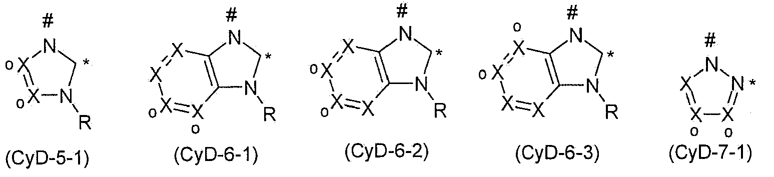 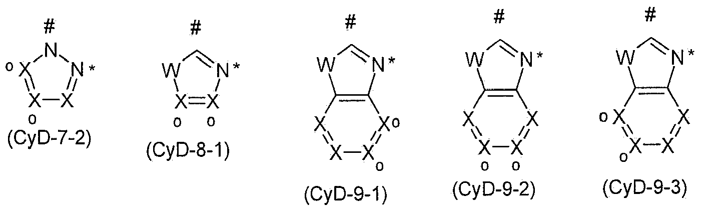 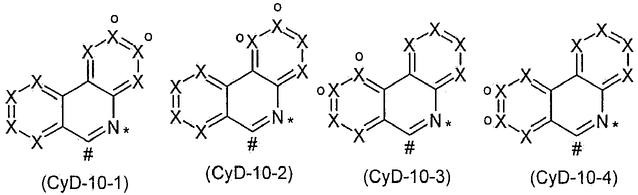 where the symbols and indices used have the meanings given in Claims 1 and 2, and ° in each case denotes the positions which stand for CR, where the respective radicals R, together with the C atoms to which they are bonded, form a ring of the formula (3).

6. Compound according to one or more of Claims 1 to 5, **characterised in that** the group of the formula (3), for p = 2, is selected from the structures of the formulae (4-A) and (4-B) and, for p = 3, is selected from the structures of the formulae (5-A), (5-B) and (5-C), 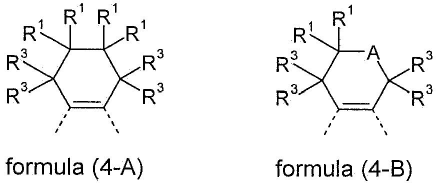 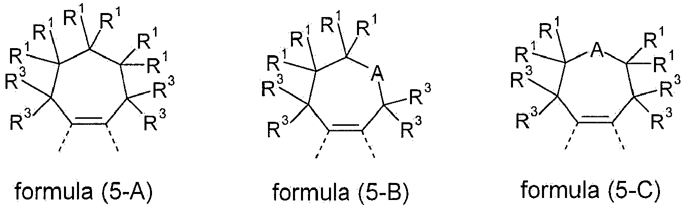 where R¹ and R³ have the meanings given in Claim 1, and A stands for O or NR³.

7. Compound according to one or more of Claims 1 to 6, **characterised in that** R¹ in formulae (3), (4-A), (4-B), (5-A), (5-B) and (5-C) stands, identically or differently on each occurrence, for H, D or an alkyl group having 1 to 5 C atoms, in which, in addition, one or more H atoms may be replaced by F, where two or more adjacent radicals R¹ may form an aliphatic ring system with one another.

8. Compound according to one or more of Claims 1 to 7, selected from compounds of the formulae (6) to (11), 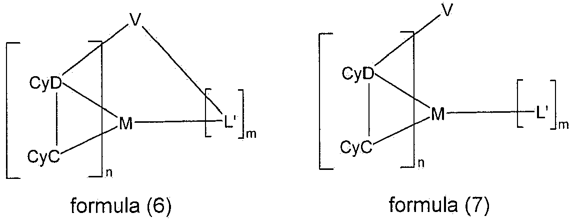 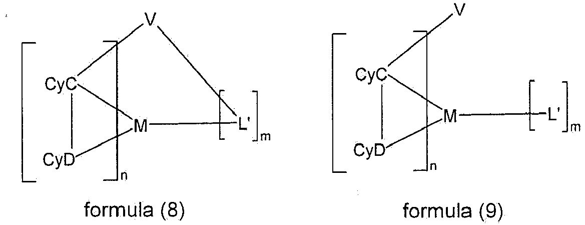 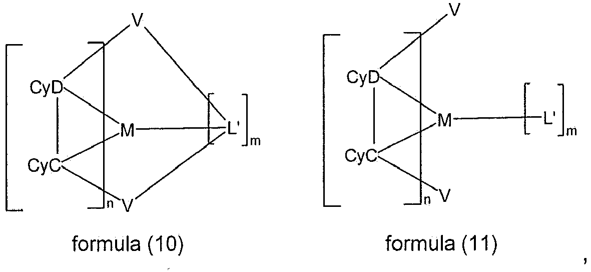 where the symbols and indices used have the meanings given in Claim 1, and V represents a single bond or a bridging unit containing 1 to 80 atoms from the third, fourth, fifth and/or sixth main group or a 3- to 6-membered homo- or heterocycle which covalently bonds the sub-ligands L to one another or covalently bonds L to L'.

9. Compound according to one or more of Claims 1 to 8, **characterised in that** L' is a monoanionic bidentate ligand which is bonded to M via a neutral nitrogen atom and a negatively charged carbon atom or via a neutral carbon atom and a negatively charged carbon atom, in particular selected from a combination of two groups of the formulae (27) to (50), 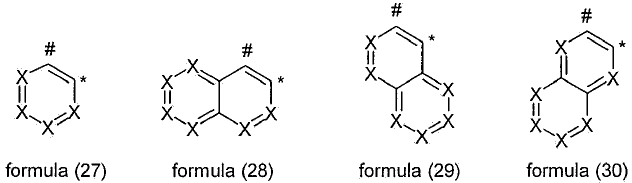 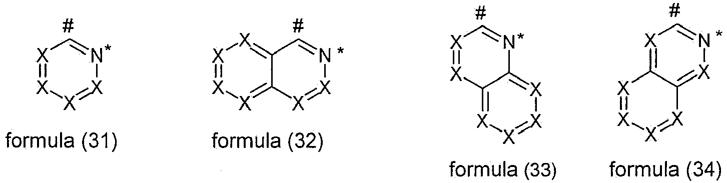 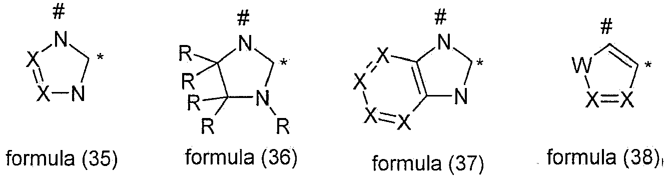 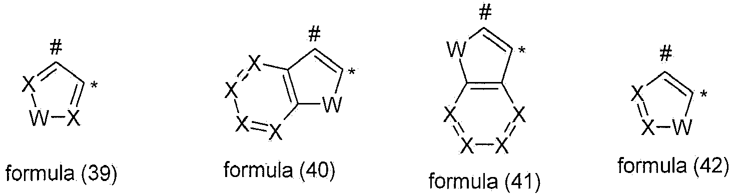 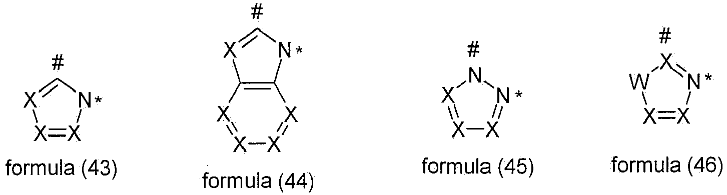 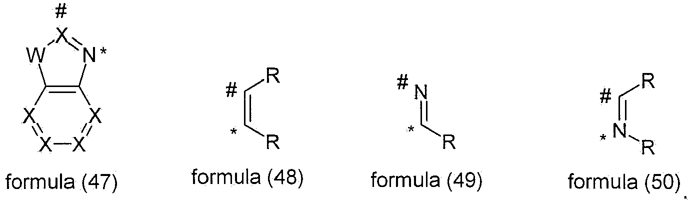 where two groups are in each case bonded to one another at the position denoted by # and coordinated to M at the position denoted by *; W has the meanings given in Claim 2; X stands on each occurrence, identically or differently, for CR or N; R has the same meaning as described in Claim 1, where two radicals R which are bonded to two different rings of the formulae (27) to (59) may here too also form an aromatic ring system with one another.

10. Process for the preparation of a compound according to one or more of Claims 1 to 9 by reaction of the free ligands L and optionally L' with metal alkoxides of the formula (67), with metal ketoketonates of the formula (68), with metal halides of the formula (69), with dimeric metal complexes of the formula (70) or with metal complexes of the formula (71),
M(OR)ₙ formula (67) 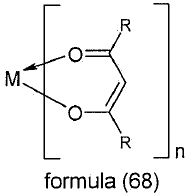
MHalₙ formula (69) 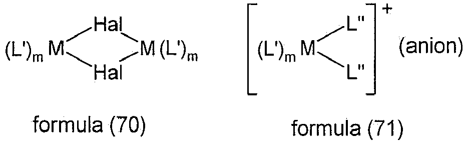
or with metal compounds which carry both alkoxide and/or halide and/or hydroxyl and also ketoketonate radicals,
where the symbols M, m, n and R have the meanings indicated in Claim 1, Hal = F, Cl, Br or I, L" stands for an alcohol or a nitrile, and (anion) is a non-coordinating anion.

11. Oligomer, polymer or dendrimer containing one or more compounds according to one or more of Claims 1 to 9, where one or more bonds are present from the compound to the polymer, oligomer or dendrimer.

12. Formulation comprising one or more compounds according to one or more of Claims 1 to 9 or a polymer, oligomer or dendrimer according to Claim 11 and at least one further compound, in particular a solvent.

13. Use of a compound according to one or more of Claims 1 to 9 or a polymer, oligomer or dendrimer according to Claim 11 in an electronic device or for the generation of singlet oxygen or in photocatalysis.

14. Electronic device, in particular selected from the group consisting of organic electroluminescent devices, organic integrated circuits, organic field-effect transistors, organic thin-film transistors, organic light-emitting transistors, organic solar cells, organic optical detectors, organic photoreceptors, organic field-quench devices, light-emitting electrochemical cells or organic laser diodes, comprising in at least one layer at least one compound according to one or more of Claims 1 to 9 or a polymer, oligomer or dendrimer according to Claim 11.

15. Electronic device according to Claim 14, **characterised in that** it is an organic electroluminescent device, and the compound according to one or more of Claims 1 to 9 or the polymer, oligomer or dendrimer according to Claim 11 is employed as emitting compound in one or more emitting layers.

16. Electronic device according to Claim 15, **characterised in that** the emitting layer comprises one or more matrix materials selected from the group consisting of ketones, phosphine oxides, sulfoxides, sulfones, triarylamines, carbazoles, indolocarbazoles, indenocarbazoles, aza-carbazoles, bipolar matrix materials, silanes, azaboroles, boronic esters, diazasiloles, diazaphospholes, triazines, zinc complexes, dibenzofurans and bridged carbazoles.

## Revendications

1. Composé de la formule (1) :
M(L)ₙ(L')ₘ formule (1)
qui contient une moitié M(L)ₙ de la formule (2) : 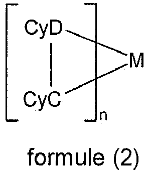 dans lesquelles ce qui suit s'applique aux symboles et aux indices qui sont utilisés :
M est iridium ou platine;
CyC est un groupe aryle ou hétéroaryle qui comporte de 5 à 18 atomes de cycle aromatique ou un groupe fluorène, lequel est dans chaque cas coordonné sur M via un atome de carbone et lequel peut dans chaque cas être substitué par un radical ou par plusieurs radicaux R et lequel est dans chaque cas connecté à CyD via une liaison covalente ;
CyD est un groupe hétéroaryle qui comporte de 5 à 18 atomes de cycle aromatique, lequel est coordonné sur M via un atome d'azote neutre ou via un atome de carbone carbène et lequel peut être substitué par un radical ou par plusieurs radicaux R et lequel est connecté à CyC via une liaison covalente ;
R est pour chaque occurrence, de manière identique ou différente, H, D, F, Cl, Br, I, N(R¹)₂, CN, NO₂, OH, COOH, C(=O)N(R¹)₂, Si(R¹)₃, B(OR¹)₂, C(=O)R¹, P(=O)(R¹)₂, S(=O)R¹, S(=O)₂R¹, OSO₂R¹, un groupe alkyle, alcoxy ou thioalcoxy en chaîne droite qui comporte de 1 à 20 atome(s) de C ou un groupe alkényle ou alkynyle qui comporte de 2 à 20 atomes de C ou un groupe alkyle, alcoxy ou thioalcoxy ramifié ou cyclique qui comporte de 3 à 20 atomes de C, lequel peut dans chaque cas être substitué par un radical ou par plusieurs radicaux R¹, où un ou plusieurs groupe(s) CH₂ non adjacents peut/peuvent être remplacé(s) par R¹C=CR¹, C≡C, Si(R¹)₂, C=O, NR¹, O, S ou CONR¹ et où un ou plusieurs atome(s) de H peut/peuvent être remplacé(s) par D, F, Cl, Br, I ou CN, ou un système de cycle aromatique ou hétéroaromatique qui comporte de 5 à 60 atomes de cycle aromatique, lequel peut dans chaque cas être substitué par un radical ou par plusieurs radicaux R¹, ou un groupe aryloxy ou hétéroaryloxy qui comporte de 5 à 40 atomes de cycle aromatique, lequel peut être substitué par un radical ou par plusieurs radicaux R¹, ou un groupe aralkyle ou hétéroaralkyle qui comporte de 5 à 40 atomes de cycle aromatique, lequel peut être substitué par un radical ou par plusieurs radicaux R¹, ou un groupe diarylamino, un groupe dihétéroarylamino ou un groupe arylhétéroarylamino qui comporte de 10 à 40 atomes de cycle aromatique, lequel peut être substitué par un radical ou par plusieurs radicaux R¹ ; deux radicaux R adjacents peuvent également former un système de cycle aliphatique, aromatique ou hétéroaromatique monoou polycyclique l'un avec l'autre, où des radicaux adjacents sont soit des radicaux qui sont liés au même atome de carbone, soit des radicaux qui sont liés à des atomes de carbone adjacents, où l'expression "des radicaux de carbone adjacents" signifie que les atomes de carbone sont liés directement les uns aux autres ;
R¹ est pour chaque occurrence, de manière identique ou différente, H, D, F, Cl, Br, I, N(R²)₂, CN, NO₂, Si(R²)₃, B(OR²)₂, C(=O)R², P(=O)(R²)₂, S(=O)R², S(=O)₂R², OSO₂R², un groupe alkyle, alcoxy ou thioalcoxy en chaîne droite qui comporte de 1 à 20 atome(s) de C ou un groupe alkényle ou alkynyle qui comporte de 2 à 20 atomes de C ou un groupe alkyle, alcoxy ou thioalcoxy ramifié ou cyclique qui comporte de 3 à 20 atomes de C, lequel peut dans chaque cas être substitué par un radical ou par plusieurs radicaux R², où un ou plusieurs groupe(s) CH₂ non adjacents peut/peuvent être remplacé(s) par R²C=CR², C≡C, Si(R²)₂, C=O, NR², O, S ou CONR² et où un ou plusieurs atome(s) de H peut/peuvent être remplacé(s) par D, F, Cl, Br, I, CN ou NO₂, ou un système de cycle aromatique ou hétéroaromatique qui comporte de 5 à 60 atomes de cycle aromatique, lequel peut dans chaque cas être substitué par un radical ou par plusieurs radicaux R², ou un groupe aryloxy ou hétéroaryloxy qui comporte de 5 à 40 atomes de cycle aromatique, lequel peut être substitué par un radical ou par plusieurs radicaux R², ou un groupe aralkyle ou hétéroaralkyle qui comporte de 5 à 40 atomes de cycle aromatique, lequel peut être substitué par un radical ou par plusieurs radicaux R², ou un groupe diarylamino, un groupe dihétéroarylamino ou un groupe arylhétéroarylamino qui comporte de 10 à 40 atomes de cycle aromatique, lequel peut être substitué par un radical ou par plusieurs radicaux R² ; deux radicaux R¹ adjacents ou plus peuvent former un système de cycle aliphatique mono- ou polycyclique l'un avec l'autre ou les uns avec les autres, où des radicaux adjacents sont soit des radicaux qui sont liés sur le même atome de carbone, soit des radicaux qui sont liés sur des atomes de carbone adjacents, où l'expression "des radicaux de carbone adjacents" signifie que les atomes de carbone sont liés directement les uns aux autres ;
R² est pour chaque occurrence, de manière identique ou différente, H, D, F ou un radical hydrocarbone aliphatique, aromatique et/ou hétéroaromatique qui comporte de 1 à 20 atome(s) de C, où, en outre, un ou plusieurs atome(s) de H peut/peuvent être remplacé(s) par F ; deux substituants R² ou plus peuvent également former un système de cycle aliphatique mono- ou polycyclique l'un avec l'autre ou les uns avec les autres ;
L' est, de manière identique ou différente pour chaque occurrence, un ligand bidenté qui est lié à M via un atome de carbone et un atome d'azote ou via deux atomes de carbone ;
n est 1, 2 ou 3 pour M = iridium et est 1 ou 2 pour M = platine ;
m est 0, 1 ou 2 pour M = iridium et est 0 ou 1 pour M = platine ;
CyC et CyD peuvent également être liés l'un à l'autre via un groupe qui est sélectionné parmi C(R¹)₂, C(R¹)₂-C(R¹)₂, NR¹, O ou S ;
les ligands d'une pluralité de ligands L peuvent également être liés les uns aux autres ou L peut être lié L' via une liaison simple ou un pont divalent ou trivalent et peuvent ainsi former un système de ligand(s) tétradenté ou hexadenté ;
**caractérisé en ce que** CyD et/ou CyC contient/contiennent deux atomes de carbone adjacents qui sont dans chaque cas substitués par des radicaux R, où les radicaux R respectifs, en association avec les atomes de C, forment un cycle de la formule (3) qui suit : 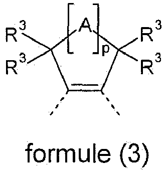 dans laquelle R¹ et R² présentent les significations qui ont été données ci-avant, les liens en pointillés indiquent la liaison des deux atomes de carbone dans le ligand, et en outre :
A est, de manière identique ou différente pour chaque occurrence, C(R¹)₂, O, S, NR³ ou C(=O), étant entendu que deux hétéroatomes dans le groupe -(A)ₚ- ne sont pas liés directement l'un à l'autre ;
R³ est, de manière identique ou différente pour chaque occurrence, un groupe alkyle ou alcoxy en chaîne droite qui comporte de 1 à 20 atome(s) de C, un groupe alkyle ou alcoxy ramifié ou cyclique qui comporte de 3 à 20 atomes de C, lequel peut dans chaque cas être substitué par un radical ou par plusieurs radicaux R², où un ou plusieurs groupe(s) CH₂ non adjacents peut/peuvent être remplacé(s) par R²C=CR², C≡C, Si(R²)₂, C=O, NR², O, S ou CONR² et où un ou plusieurs atome(s) de H peut/peuvent être remplacé(s) par D ou F, ou un système de cycle aromatique ou hétéroaromatique qui comporte de 5 à 24 atomes de cycle aromatique, lequel peut dans chaque cas être substitué par un radical ou par plusieurs radicaux R², ou un groupe aryloxy ou hétéroaryloxy qui comporte de 5 à 24 atomes de cycle aromatique, lequel peut être substitué par un radical ou par plusieurs radicaux R², ou un groupe aralkyle ou hétéroaralkyle qui comporte de 5 à 24 atomes de cycle aromatique, lequel peut être substitué par un radical ou par plusieurs radicaux R² ; deux radicaux R³ qui sont liés au même atome de carbone peuvent former un système de cycle aliphatique ou aromatique l'un avec l'autre et peuvent ainsi former un système spiro ; en outre, R³ peut former un système de cycle aliphatique avec un radical R ou R¹ adjacent ;
p est, de manière identique ou différente pour chaque occurrence, 2 ou 3.

2. Composé selon la revendication 1, **caractérisé en ce que** le groupe CyC est sélectionné parmi les structures des formules (CyC-1) à (CyC-19), où le groupe CyC est dans chaque cas lié à CyD au niveau de la position qui est indiquée au moyen de # et est coordonné sur M au niveau de la position qui est indiquée au moyen de * ; 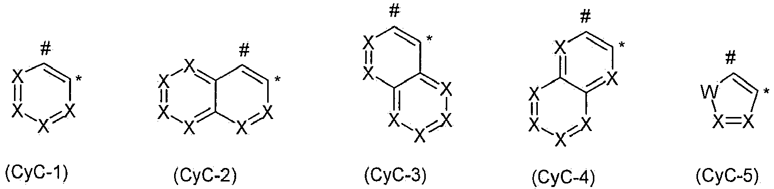 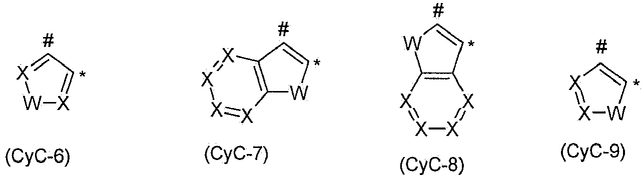 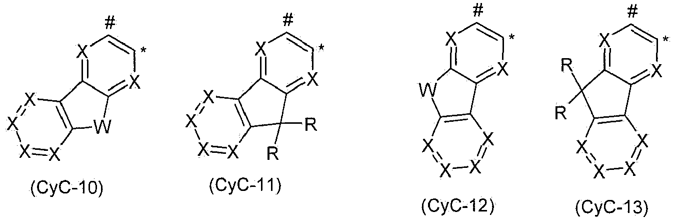 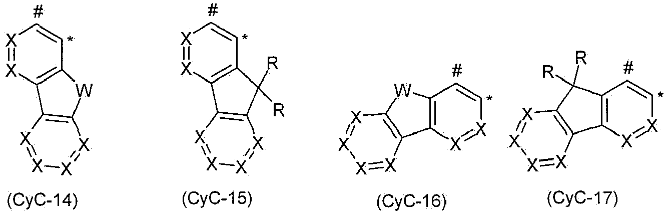 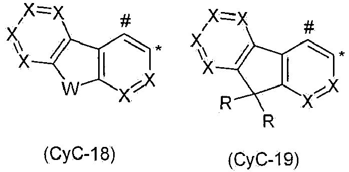 et **caractérisé en ce que** CyD est sélectionné parmi les structures des formules (CyD-1) à (CyD-10), où le groupe CyD est dans chaque cas lié à CyC au niveau de la position qui est indiquée au moyen de # et est coordonné sur M au niveau de la position qui est indiquée au moyen de * ; 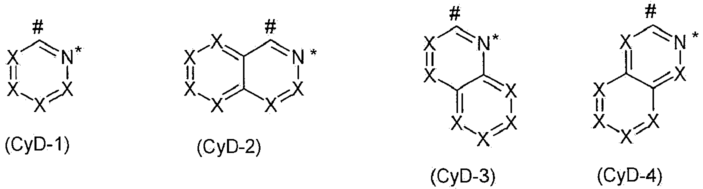 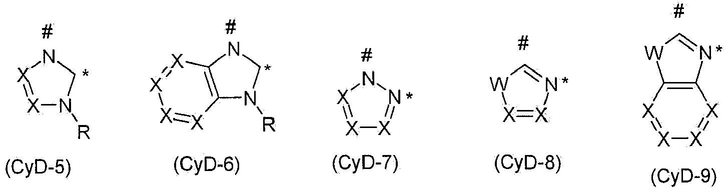 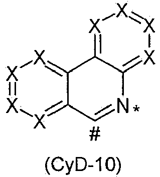 dans lesquelles R présente les significations qui ont été indiquées selon la revendication 1, et ce qui suit s'applique aux autres symboles qui sont utilisés :
X est pour chaque occurrence, de manière identique ou différente, CR ou N ;
W est pour chaque occurrence, de manière identique ou différente, NR, O ou S ;
deux groupes X adjacents dans CyC et/ou dans CyD représentent ici CR et, en association avec les radicaux R qui sont liés à ces atomes de carbone, ils forment un groupe de la formule (3).

3. Composé selon la revendication 1 ou 2, **caractérisé en ce que** le groupe CyC est sélectionné parmi les structures des formules (CyC-1a) à (CyC-19a), où le groupe CyC est dans chaque cas lié à CyD au niveau de la position qui est indiquée au moyen de # et est coordonné sur M au niveau de la position qui est indiquée au moyen de * ; 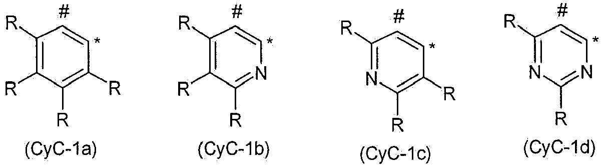 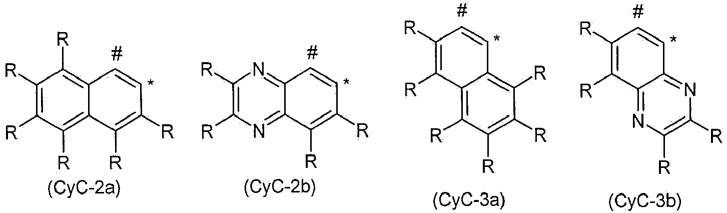 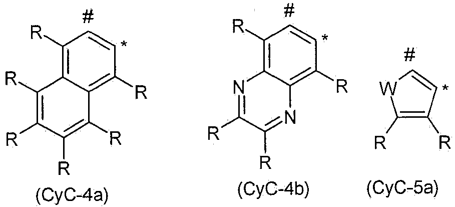 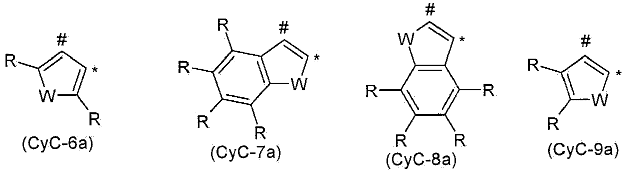 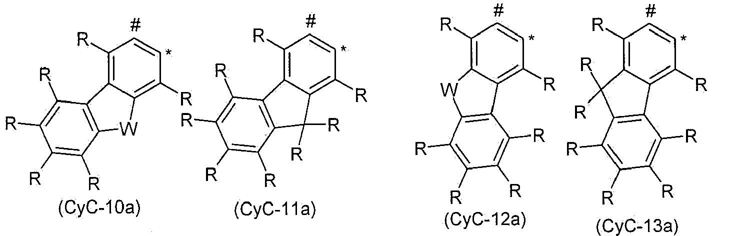 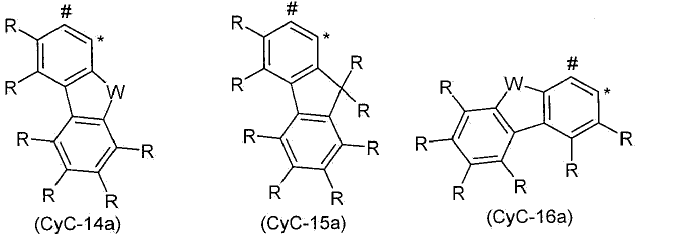 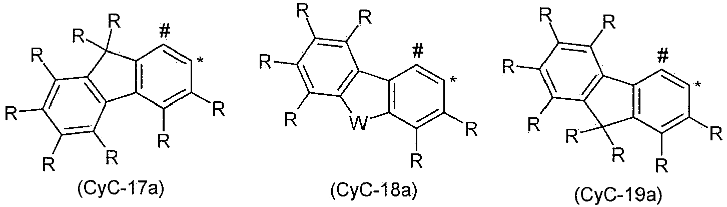 et **caractérisé en ce que** le groupe CyD est sélectionné parmi les groupes des formules (CyD-1a) à (CyD-10a), où le groupe CyD est dans chaque cas lié à CyC au niveau de la position qui est indiquée au moyen de # et est coordonné sur M au niveau de la position qui est indiquée au moyen de * ; 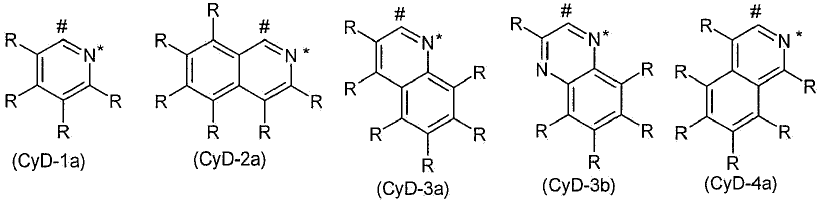 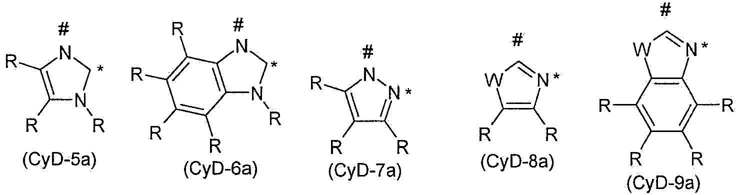 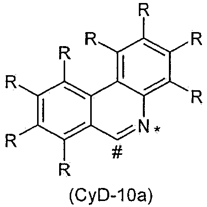 dans lesquelles les symboles qui sont utilisés présentent les significations qui ont été données selon les revendications 1 et 2, et deux radicaux R adjacents dans au moins l'un des groupes CyC et/ou CyD, en association avec les atomes de carbone auxquels ils sont liés, forment un cycle de la formule (3).

4. Composé selon une ou plusieurs des revendications 1 à 3, caractérisé soit en ce que le ligand L contient précisément un seul groupe de la formule (3), soit en ce qu'il contient deux groupes de la formule (3), dont l'un est lié à CyC et dont l'autre est lié à CyD.

5. Composé selon une ou plusieurs des revendications 1 à 4, **caractérisé en ce que** CyC est sélectionné parmi les groupes (CyC-1-1) à (CyC-19-1) et/ou **en ce que** CyD est sélectionné parmi les groupes (CyD-1-1) à (CyD-10-1) : 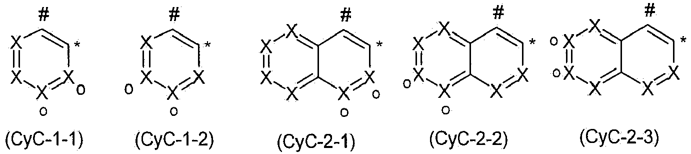 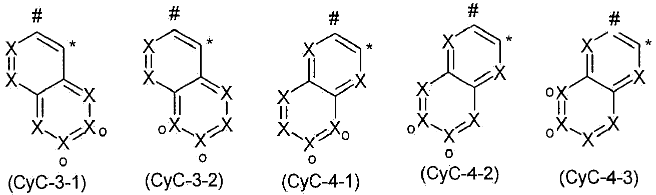 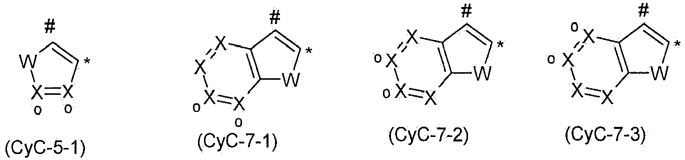 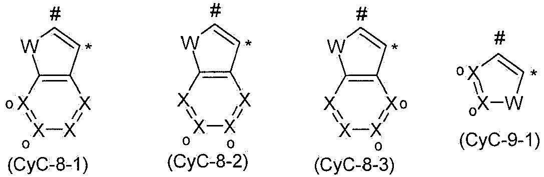 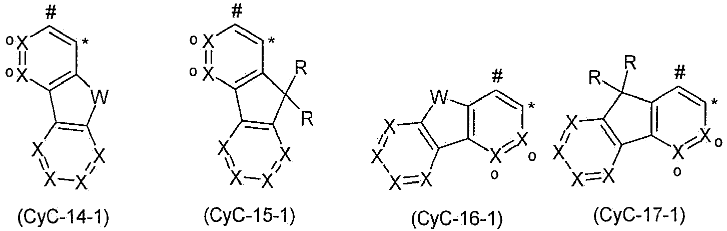 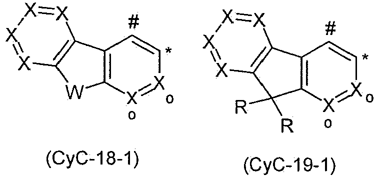 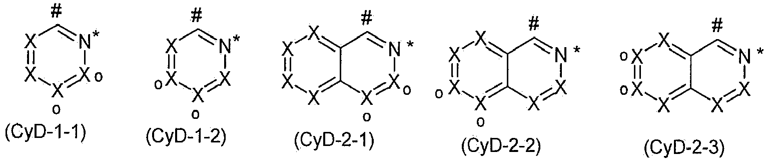 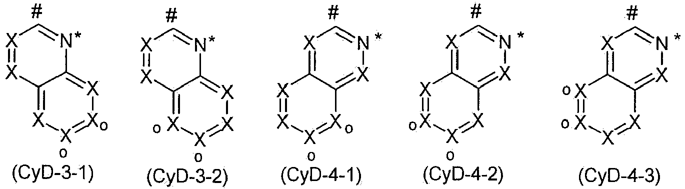 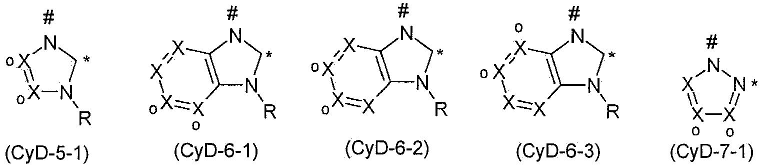 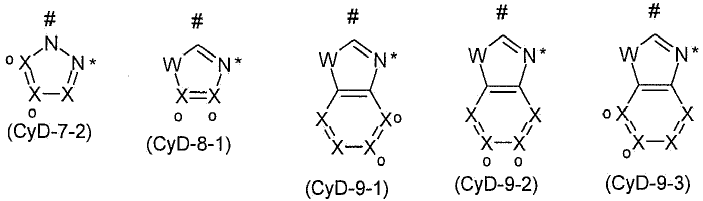 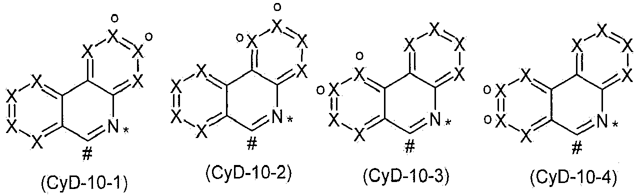 dans lesquels les symboles et les indices qui sont utilisés présentent les significations qui ont été données selon les revendications 1 et 2, et ° représente dans chaque cas les positions qui représentent CR, où les radicaux R respectifs, en association avec les atomes de C auxquels ils sont liés, forment un cycle de la formule (3).

6. Composé selon une ou plusieurs des revendications 1 à 5, **caractérisé en ce que** le groupe de la formule (3), pour p = 2, est sélectionné parmi les structures des formules (4-A) et (4-B) et, pour p = 3, est sélectionné parmi les structures des formules (5-A), (5-B) et (5-C) : 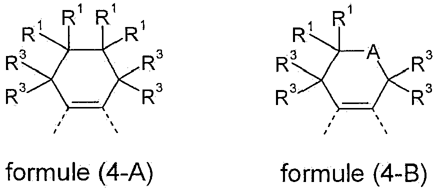 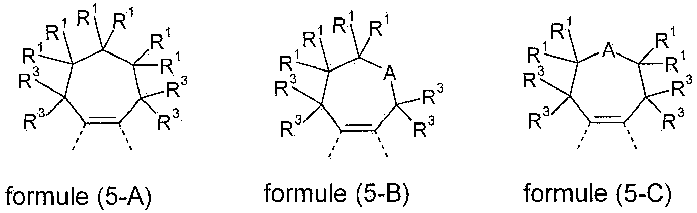 dans lesquelles R¹ et R³ présentent les significations qui ont été données selon la revendication 1, et A représente O ou NR³.

7. Composé selon une ou plusieurs des revendications 1 à 6, **caractérisé en ce que** R¹ dans les formules (3), (4-A), (4-B), (5-A), (5-B) et (5-C) représente, de manière identique ou différente pour chaque occurrence, H, D ou un groupe alkyle qui comporte de 1 à 5 atome(s) de C, où, en outre, un ou plusieurs atome(s) de H peut/peuvent être remplacé(s) par F, où deux radicaux R¹ adjacents ou plus peuvent former un système de cycle aliphatique l'un avec l'autre ou les uns avec les autres.

8. Composé selon une ou plusieurs des revendications 1 à 7, sélectionné parmi les composés des formules (6) à (11) : 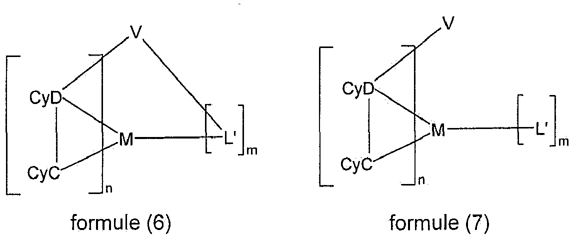 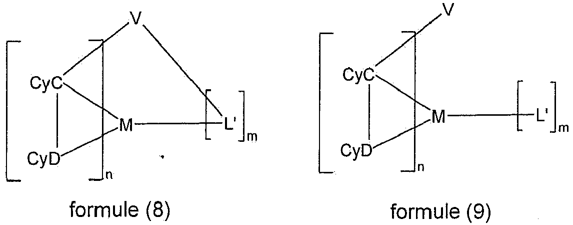 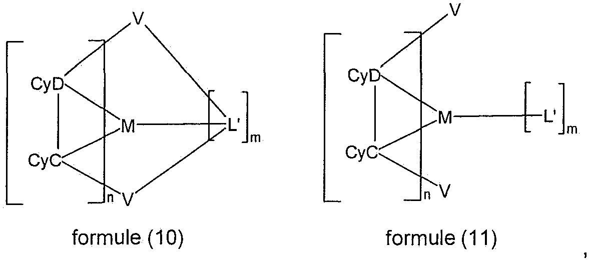 dans lesquelles les symboles et les indices qui sont utilisés présentent les significations qui ont été données selon la revendication 1, et V représente une liaison simple ou une unité de pontage qui contient de 1 à 80 atome(s) dont l'origine est les troisième, quatrième, cinquième et/ou sixième groupe(s) principal/principaux ou un homocycle ou hétérocycle à 3 à 6 éléments qui lie de façon covalente les sous-ligands L les uns aux autres ou qui lie de façon covalente L à L'.

9. Composé selon une ou plusieurs des revendications 1 à 8, **caractérisé en ce que** L' est un ligand bidenté monoanionique qui est lié à M via un atome d'azote neutre et un atome de carbone chargé négativement ou via un atome de carbone neutre et un atome de carbone chargé négativement, en particulier sélectionné parmi une combinaison de deux groupes des formules (27) à (50) : 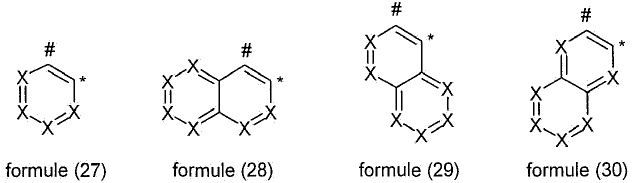 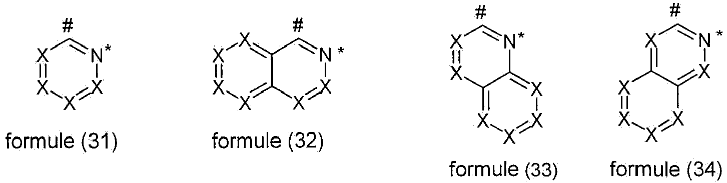 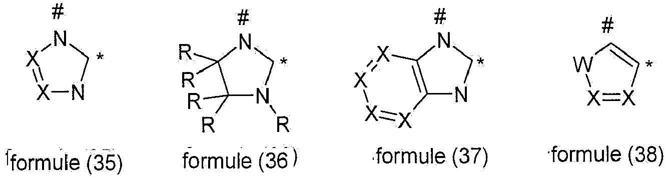 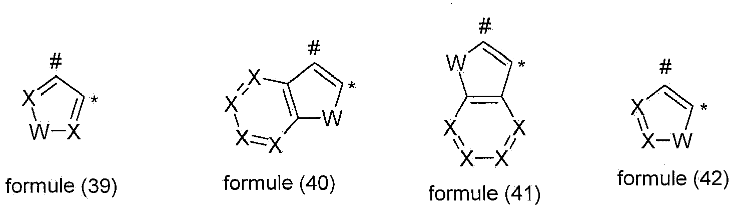 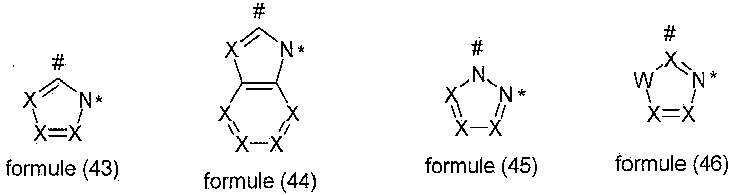 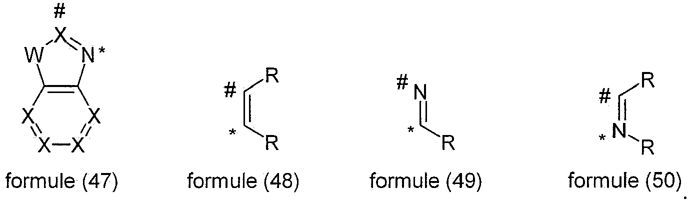 dans lesquelles deux groupes sont dans chaque cas liés l'un à l'autre au niveau de la position qui est indiquée au moyen de # et sont coordonnés sur M au niveau de la position qui est indiquée au moyen de * ; W présente les significations qui ont été données selon la revendication 2 ; X représente pour chaque occurrence, de manière identique ou différente, CR ou N ; R présente la même signification que celle qui a été décrite selon la revendication 1, où deux radicaux R qui sont liés à deux cycles différents des formules (27) à (59) peuvent ici également former un système de cycle aromatique l'un avec l'autre.

10. Procédé pour la préparation d'un composé selon une ou plusieurs des revendications 1 à 9 au moyen de la réaction des ligands libres L et en option L' avec des alcoxydes de métal/métaux de la formule (67), avec des cétocétonates de métal/métaux de la formule (68), avec des halogénures de métal/métaux de la formule (69), avec des complexes de métal/métaux dimériques de la formule (70) ou avec des complexes de métal/métaux de la formule (71) :
M(OR)ₙ formule (67) 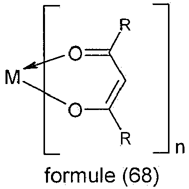
MHalₙ formule (69) 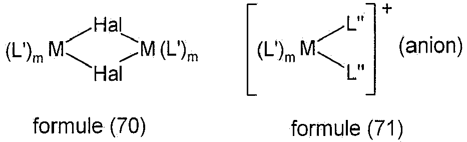
ou avec des composés de métal/métaux qui sont porteurs à la fois de radicaux alcoxyde et/ou halogénure et/ou hydroxyle et également cétocétonate ;
dans lesquelles les symboles M, m, n et R présentent les significations qui ont été indiquées selon la revendication 1, Hal = F, Cl, Br ou I, L" représente un alcool ou un nitrile, et (anion) est un anion de non coordination.

11. Oligomère, polymère ou dendrimère contenant un ou plusieurs composé(s) selon une ou plusieurs des revendications 1 à 9, où une ou plusieurs liaison(s) est/sont présente(s) depuis le composé jusqu'au polymère, jusqu'à l'oligomère ou jusqu'au dendrimère.

12. Formulation comprenant un ou plusieurs composé(s) selon une ou plusieurs des revendications 1 à 9 ou un polymère, un oligomère ou un dendrimère selon la revendication 11 et au moins un autre composé, en particulier un solvant.

13. Utilisation d'un composé selon une ou plusieurs des revendications 1 à 9 ou d'un polymère, d'un oligomère ou d'un dendrimère selon la revendication 11 dans un dispositif électronique ou pour la génération d'un oxygène singulet ou au niveau d'une photocatalyse.

14. Dispositif électronique, en particulier sélectionné parmi le groupe qui est constitué par les dispositif électroluminescents organiques, les circuits intégrés organiques, les transistors à effet de champ organiques, les transistors à film mince organiques, les transistors à émission de lumière organiques, les cellules solaires organiques, les détecteurs optiques organiques, les photorécepteurs organiques, les dispositifs à extinction de champ organiques, les cellules électrochimiques à émission de lumière ou les diodes laser organiques, comprenant, dans au moins une couche, au moins un composé selon une ou plusieurs des revendications 1 à 9 ou un polymère, un oligomère ou un dendrimère selon la revendication 11.

15. Dispositif électronique selon la revendication 14, **caractérisé en ce qu'**il s'agit d'un dispositif électroluminescent organique, et le composé selon une ou plusieurs des revendications 1 à 9 ou le polymère, l'oligomère ou le dendrimère selon la revendication 11 est utilisé en tant que composé d'émission dans une ou plusieurs couche(s) d'émission.

16. Dispositif électronique selon la revendication 15, **caractérisé en ce que** la couche d'émission comprend un ou plusieurs matériau(x) de matrice qui est/sont sélectionné(s) parmi le groupe qui est constitué par les cétones, les oxydes de phosphine, les sulfoxydes, les sulfones, les triarylamines, les carbazoles, les indolocarbazoles, les indénocarbazoles, les azacarbazoles, les matériaux de matrices bipolaires, les silanes, les azaboroles, les esters boroniques, les diazasiloles, les diazaphospholes, les triazines, les complexes de zinc, les dibenzofuranes et les carbazoles pontés.
